# EUROPEAN PATENT SPECIFICATION

(11) **EP 4 702 428 B1**
(45) Date of publication and mention of the grant of the patent: **11.11.2026**
(21) Application number: 24721150.1
(22) Date of filing: 24.04.2024
(51) Int. Cl.: G06F 8/41

(54) **HIGH-PERFORMANCE CODE PARALLELIZATION COMPILER WITH LOOP-LEVEL PARALLELIZATION**
HOCHLEISTUNGS-CODE-PARALLELISIERUNGS-COMPILER MIT PARALLELISIERUNG AUF SCHLEIFEBENE
COMPILATEUR HAUTE-PERFORMANCE POUR PARALLELISER DU CODE UTILISANT UNE PARALLELISATION AU NIVEAU DE BOUCLES

(30) Priority: 24.04.2023 WO PCT/EP2023/060677
(43) Date of publication of application: 04.03.2026
(73) Proprietor: mynatix AG, 4052 Basel (CH)
(72) Inventor: GARTMANN, Andres, 4052 Basel (CH); HAAS, Lukas, 4051 Basel (CH)
(74) Representative: Leimgruber, Fabian Alfred Rupert
(86) International application number: PCT/EP2024/061271
(87) International publication number: WO 2024/223676

(56) References cited:
- US-A1- 2008 263 530

## Description

### Field of the Invention

This invention relates generally to the design and manufacture of integrated circuitry (IC) and more particularly to a system and a method of maximizing manufacturing yield as well as chip performance and processing speed by using IC layout optimization driven by integrated circuit fabrication process simulation. Furthermore, the current invention generally relates to the design and manufacture of integrated circuitry (IC) for multi-processor systems, in particular multi-core systems and parallel computing systems allowing multiprocessing. In a multi-core IC, two or more processors or cores work together to execute multiple program codes and/or processor instruction sets simultaneously, wherein in the IC for multi-processor systems or parallel-computing systems, the IC comprising a number of central processing units integrated on the IC and linked together to enable said multiprocessing or parallel processing to take place. Further, it relates to a system and a method of maximizing manufacturing yield, IC processing performance and processing speed in respect to a specific, parallelized code, for execution in the described, specifically architectured and optimized multi-processor architecture systems. More particular, it further relates to mutual optimization of the parallelization of code and optimization of a respective IC design. In the technical field of multiprocessor systems, important characteristics and classifications arise inter alia, from way, how processor memory access is handled and whether system processors are of a single type or various ones in the system architecture.

### Background of the Invention

In the last years, a fundamental change in computer architecture has been observed that will impact every facet of data processing and operation of every electronic device from cell phone to supercomputer, since it introduces parallelism of unprecedented scale, which confronts traditional technical approaches of code optimization and parallelization. In particular, it creates the technical requirement for computer and processor-specific code parallelization to achieve a true optimization. Whereas the conventional multicore approach (2, 4, and even 32 cores) adopted by the computing industry came slowly to a performance plateau, technology moves to higher performance per watt and per chip area using manycore technology (hundreds or even thousands of cores). However, fully unleashing the potential of the manycore approach to ensure future advances in sustained computational performance will require fundamental advances in computer architecture and programming techniques which can be even compared to reinventing computing. The new technological trends in the microprocessor industry have important impacts for the design of the next generation of computing systems, in particular of so called High Performance Computing (HPC) systems as the petaflop scale is achieved. The need to switch to a geometric growth path in system concurrency is leading to reconsideration of interconnect design, memory balance, and I/O system design that will have dramatic consequences for the design of future HPC applications and algorithms, in particular the parallelization and architecture specific adaption of future applications and algorithms. The required reengineering of existing application codes will likely be as dramatic and technically challenging as the migration from vector HPC systems to Massively Parallel Processors (MPPs) that occurred in the 90's. Such comprehensive code reengineering took nearly a decade, so there are in the prior art serious concerns about undertaking yet another major transition in the software infrastructure in use.

One of the technical challenges and difficulties comes also from the various different technical fields, suddenly confronted by their interconnected impact on the performance optimization of the new systems, as circuit design, computer architecture, embedded hardware/software, programming languages, compilers, applied math to HPC etc. and the technical object on how current constraints on device physics at the silicon level can be considered to further optimize CPU design, system architecture, and programming models for future and current systems. If these technical challenges cannot be overcome by appropriate systems, in particular code optimization and parallelization systems, this would even lead to the question if multicore (or manycore) or multi-processor is in fact a reasonable response to the underlying constraints to future IC designs. The present invention allows solving the technical need for new optimization systems induced by these changes in the context of computer architecture, system architecture, and programming models for future computing systems, as e.g. HPC systems.

According to the Moore's law, which still holds (likely until 2023 according to latest results), it is possible to integrate twice as many components onto an integrated circuit every 18 months at fixed cost. However, the traditional sources of performance improvements such as exploiting instruction level parallelism (ILP) and clock frequency scaling have been flattening since 2003. In particular, the improvements in processor performance as measured by the SPEC benchmark over the period from 1975 to present has improved by 52 percent per year with remarkable consistency since 1986 (e.g. see J. L. Hennessy, D.A. Patterson, "Computer Architecture: A Quantitative Approach", fourth edition, Morgan Kaufmann, San Francisco, 2006). During that period, as process geometries scaled according to Moore's law, the active capacitance of circuits scaled down so that supply voltages could be kept constant or even dropped modestly in order to allow manufacturers to increase clock-speeds. This approach, known as "constant *electric field"* frequency scaling fed the relentless increases in CPU clock-rates over the past decade and a half. However, below the 90nm scale for silicon lithography, this technique began to hit its limits as static power dissipation from leakage current began to surpass dynamic power dissipation from circuit switching. Power density has now become the dominant constraint in the design of new processing elements, and ultimately limits clock-frequency growth for future microprocessors. The direct result of power constraints has been a stall in clock frequency that is reflected in the flattening of the performance growth rates starting in 2002. In the following years, individual processor cores have become nearly a factor of three slower than if progress had continued at the historical rate of the preceding decade. Other approaches for extracting more performance by exploiting Instruction Level Parallelism (ILP) with out-of-order instruction processing have also reached a limit. Having exhausted other well-understood avenues to extract more performance from a uniprocessor, the mainstream microprocessor industry has responded by halting further improvements in clock frequency and increasing the number of cores on the chip. Estimates show that the number of cores per chip doubled every 18-24 months from there on. Therefore, a new kind of parallelization systems and processor-architecture specific optimizing programming structures are needed to stay ahead of a wave of geometrically increasing system concurrency causing a tsunami of parallelism. The stall in clock frequencies and the industry's comparatively straightforward response of doubling cores has led to the emerge of alternative approaches to computing such as Field Programmable Gate Arrays (FPGAs), Graphics Processing Units (GPU), or dataflow-like tiled array architectures such as TRIPS. The principle impediment to adapting such more radical approach to hardware architecture is that, in the technical field, it is even less known about how to program efficiently such devices for diverse applications than it is known for parallel machines composed of multiple CPU cores.

### (i) Background to the technical field of chip design

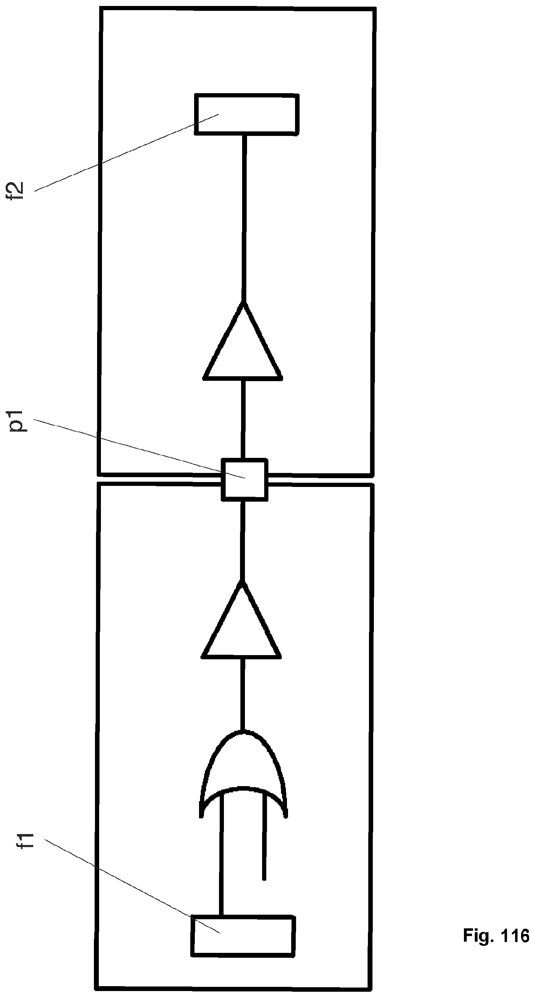

Architecting and physical implementation tools for integrated circuits (ICs) are typically used to improve the performance of a design and the predictability of the design flow, and in doing so, these tools improve the productivity of the IC designer. IC designers typically require early feedback regarding the feasibility of various design styles and floorplans during design exploration. A fast and accurate prediction of the best IC-physical-optimization and IC design can ( 1) reduce the turn-around time of floorplan redesign, (2) reduce the number of design iterations, and (3) eliminate early and late design-cycle surprises. Hence, it is desirable to obtain a fast and accurate prediction of the best IC-physical-optimization and IC design (i.e., pre-, and post-physical synthesis) of the design. Moreover, large designs ( e.g., greater than five million gates) often cannot be optimized in a flat layout due to computing resources constraints. These designs are often partitioned or designed hierarchically, so that smaller sub-designs can be optimized individually. One key task during the partitioning process is budgeting, which involves properly assigning timing constraints to the sub-designs so that the sub-designs are neither over-constrained nor under-constrained. For example, as shown by fig. 116, while optimizing the path between flip-flops f1-f2, if the path between flip-flop f1 and point p1 is easy to optimize, while the path between point p1 to flip-flop f2 is hard to optimize, a timing budgeter typically assigns a more stringent timing constraint to the former path, while assigning a more lenient timing constraint to the latter path. A quick and accurate IC-physical-optimization prediction should be able to quantify the "potential for optimization" of a path, which would facilitate more accurate time budgeting. However, this is technically challenging and has often to be post-processed manually. Typically, during operation, the system receives a netlist for the IC design, wherein the netlist specifies the placement of cells within the IC design. Next, the system estimates capacitances for cells within the IC design based on physical modelling of the cells. The system then estimates the IC-physical-optimization of the IC design based on different netlists, capacitances, and the physical modelling, wherein the IC-physical-optimization necessarily needs to be estimated without performing physical optimization. In the prior art, such netlists typically include logic that has been already optimized using a pre-placement-based logic optimization technique that does not account for the placement of logic while performing logic optimization. While generating the modelling of the cells, the system generates a physical model for each logical function within the IC design. After generating the physical modelling for each logical function, the system generates a load-delay structure of the logical function which returns the minimum delay achievable for the logical function for a given output load. The system then generates a load-capacitance model of the logical function which returns the input capacitance of a cell that achieves the minimum delay for a given output load.

Further, time latency optimization can be achieved by having good placement of cells and hard macros. In the state of the art, timing-driven placement places cells together that have large delays between them, which reduces the delays. A timing-driven placer typically considers the "potential for optimization" of the nets and cells, so that nets that are hard to optimize are shortened, and cells that are hard to optimize are placed together. Presently, the best way to determine the IC physical-optimization of an IC design is to first perform physical optimization on the IC design. Unfortunately, physical optimization can sometimes take days to complete. If an error or additional potential for optimization is discovered after performing physical optimization, the design must be changed before physical optimization is performed again. This iterative process is costly. Hence, what is needed is an apparatus and method for determining the possibly most optimized IC design without the problems described above.

In the prior art, the design of Integrated Circuits can be described by Hardware Description Language (HDL). This enables the simulation and the synthesis to a netlist (physical electronic components and how they are connected). Such a language abstracts the layout of the IC-design and in the process of digital circuit design, the Register Transfer Level (RTL) models the flow of a digital signal (data) between hardware registers. Popular HDLs are Verilog and VHDL. Handcrafted designs are denser and faster than synthesized designs. Nevertheless, today the process and tools, e.g. for place and route are for the majority of application-specific integrated circuits (ASICs) successfully based on RTL code used. High-Level synthesis (HLS) names the automated design process to get from abstract behavioral specification of a digital system and finding the register-transfer level structure. The novel method enables a novel form of HLS and generating an optimized RTL description to be placed and routed on a silicon area, on Field Programmable Gate Arrays (FPGA) or Application Specific Integrated Circuits (ASIC).

By including dopants in pure silicon, the valence electrons - normally bounded - gets free to transmit. The basic components for integrated circuits are transistors, simplified electronic switches, which can switch an output depending on two input signals. By different dopants - so called p-type and n-type silicon -they can be composed to form a diode together - an electronic switch. Metal-Oxide-Semiconductor (MOS) are sandwich-like structures of insulating and conducting materials. In CMOS there a n-type transistor (nMOS) and p-type transistor (pMOS). A transistor consists of a conducting gate, an insulated layer of glass and a silicon wafer. An nMOS is built with a p-type body and regions of n-type semiconductor connected to the gate. The "entry" is the source and the "output" the drain. The body is typically grounded in contrast to pMOS, which is the vis-versa (p-type source and drain with n-type body). The gate can control the electrical current between the source and drain.

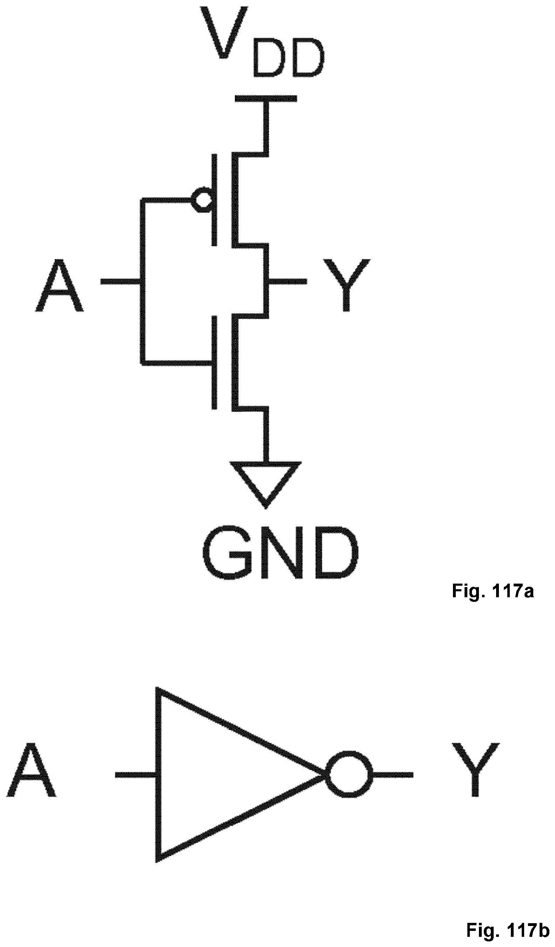

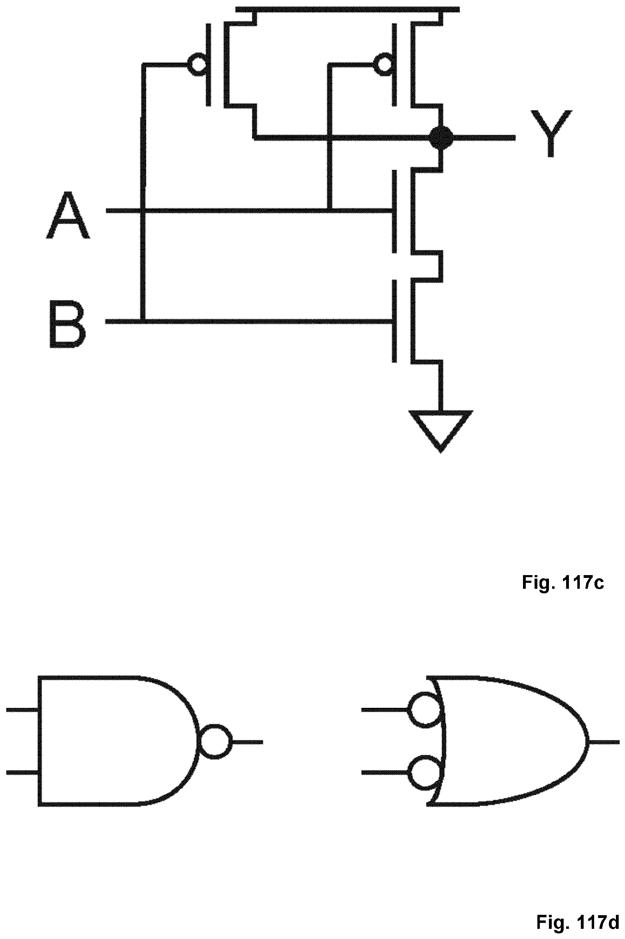

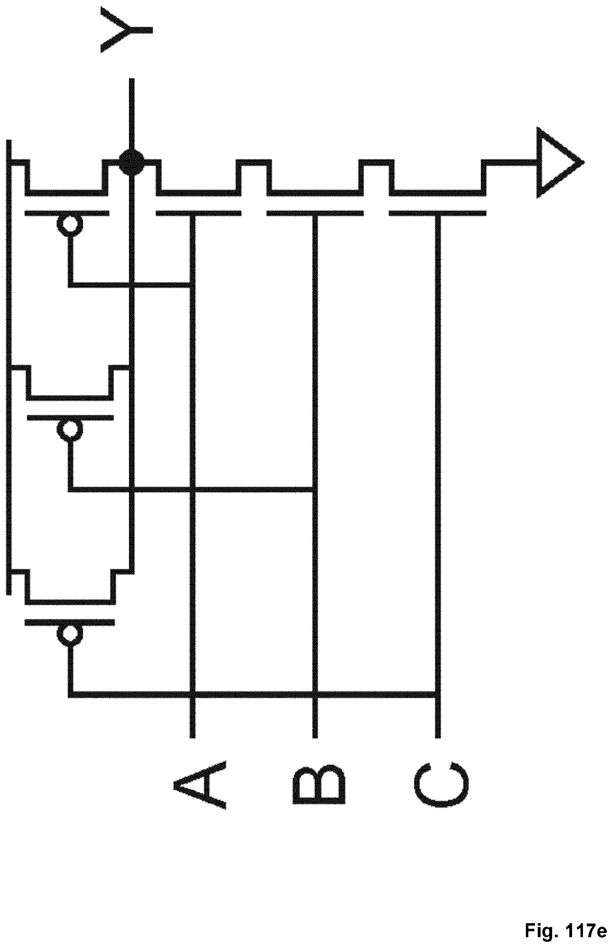

Using transistors, different logical gates can be built. A logic gate can perform a Boolean function. Using NAND gates (4 transistors) and inverters (2 transistor) many series of Boolean functions can be built - therefore they are elementary basic gates, see figures 117. Basic means that mostly every logic expression can be built by these two basic gates (but not automatically given is the optimal electronic circuit - this is influenced by many more factors). More complex combinations enable to arithmetic operations: addition, subtraction, multiplication, and division with the binary logic. With compounded gates more com-plex logic functions can be generated, such as arithmetic operations, like exponential or logarithmic functions. All they can be built by the basic arithmetic operations.

A single parameter *λ* characterizes the resolution of the production process. It is half of the minimum of the distance between source and drain of a transistor - depending on the polysilicon wire width. By using this scaling factor *λ* distance properties can be placed into the scaling of the target wafer resolution. Single elements to place are called cell, which describes the area of an element of gates or memory elements. Stick diagrams are a method to approximate the area *A_{silicon}* needed for a cell. By minimal standard, the area can be make depending on the amount of metal tracks to the cell. Between the wires is space needed and can be used to place transistors. By counting the vertical and horizontal tracks to the cell and multiplying these by 8 *λ*, the vertical and horizontal space for a given logic gate combination can be approximated. The same can done for wires, where for a width of a wire of 4 *λ* needs additional spacing to the next wire of 4 *λ* forming a routing track. For cells with signal with a wider bit-width (higher resolution of numbers / characters), the needed area *A_{silicon}* for routing tracks increases.

For both, cells and wires, there exists simple approximation to approximate the needed silicon area *A_{silicon}* expressed as scaling of the target resolution with the parameter *λ*.

Besides the basic Boolean gates forming compound gates to compute binary solutions, additional cell types exist:
- Tristates: This type switches between two inputs, meaning if the input is 1, the output gets equal the input A, an if the input is 0 the output is "floating". This can be useful to switch between different clocks.
- Multiplexer (MUX): This cell type can choose from different inputs and select this input signal to the output.
- Latches: These are types for sequential circuits, where a clock signal is available. IF the clock signal is 1 the latch connects an input signal to the output, otherwise it blocks and can hold a current state.
- Flip-Flop: By combining two level-sensitive latches, this cell type can "read" an input signal when clock is 1 and passing when the signal goes to 0 to the output connections.

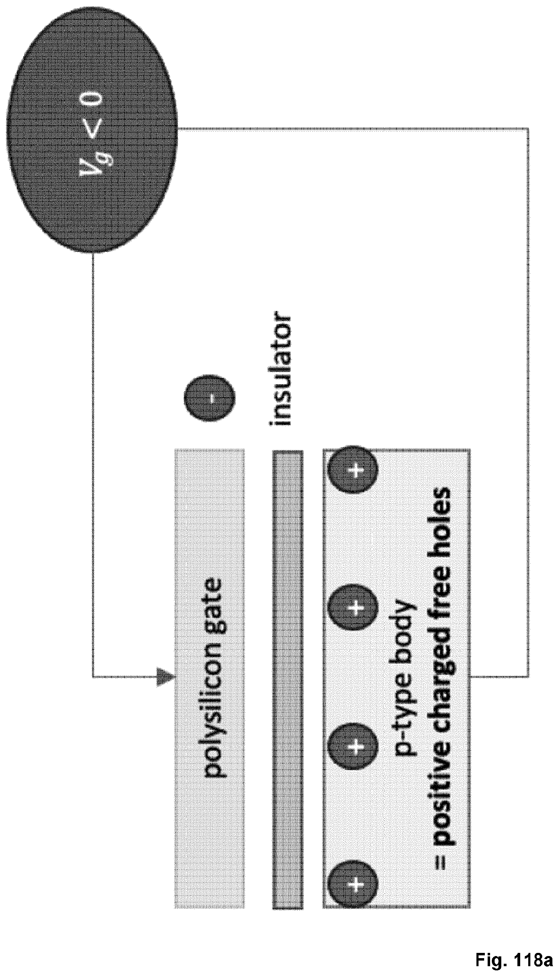

Regarding the I-V characteristics of MOS transistors, the block diagrams of figure 118a-c describe how a pMOS switch works as a function of the volt-age attached to the gate *V_{g}*.

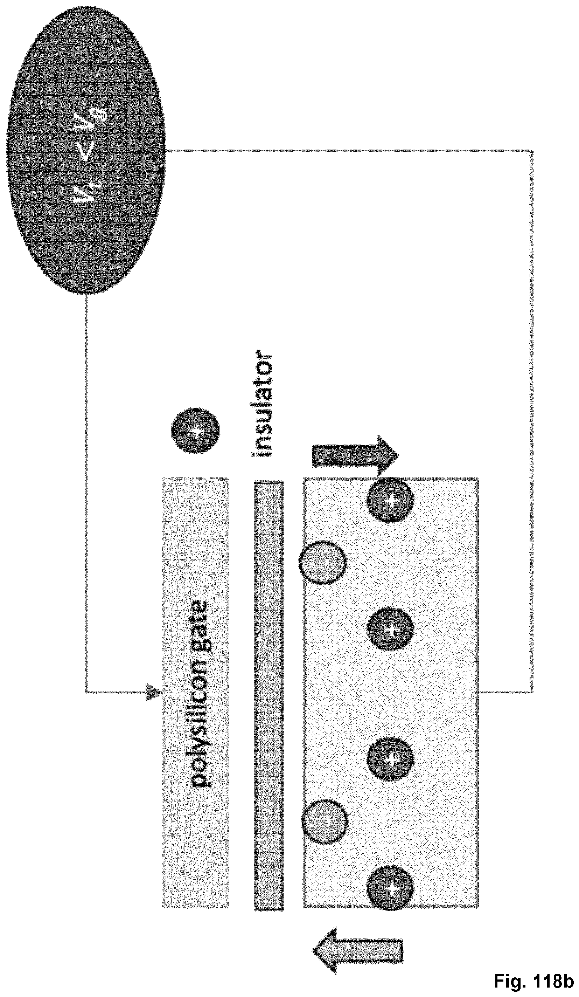

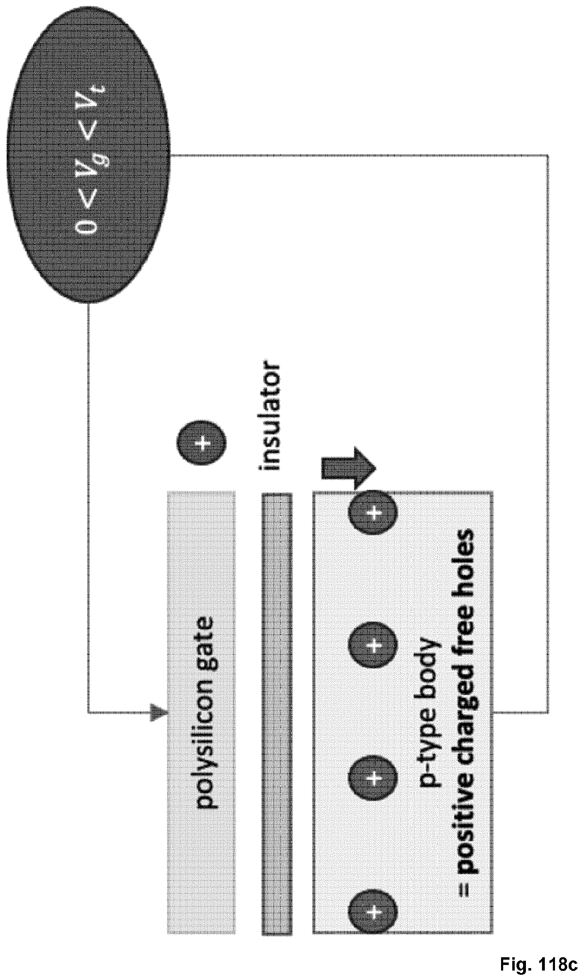

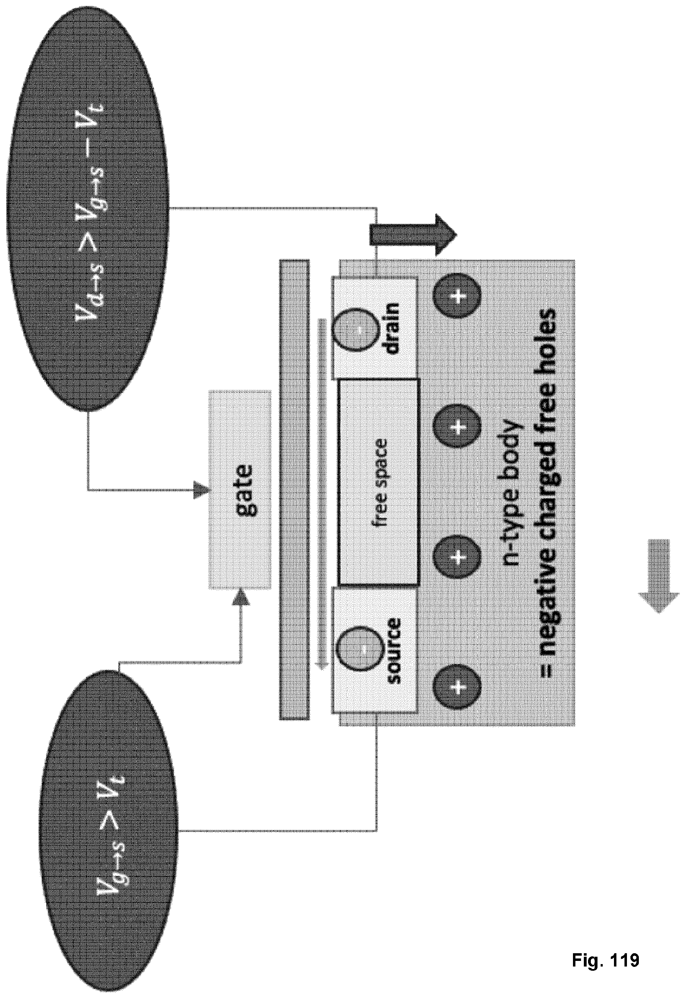

In particular, as shown in fig. 118a, between a p-type body and a polysilicon gate, a negative gate voltage is applied. The positive mobile positive charged holes are attracted to the insulator (by the negative voltage at the gate). As shown in fig. 118b, when a positive voltage is attached to the gate, the free positive holes are pushed away from the insulator. Finally, as shown in fig. 118c, when the positive voltage to the gate is higher than a critical voltage *Vₜ* the free positive holes are pushed farer away and some free electrons in the body are attracted to the insulator. Figure 119 shows an exemplary block diagram illustrating a nMOS transistor consists of a gate, a source, and a drain, with p-type body and n-type channels. The derive principle of an electronical switch from one of the figures 118 is used to build a nMOS transistor, see figure 119. As figure 119 shows, the same principle with a nMOS is that applying positive voltage to the gate results in "free" space by pushing away the positive holes and allowing a current I between drain -> source.

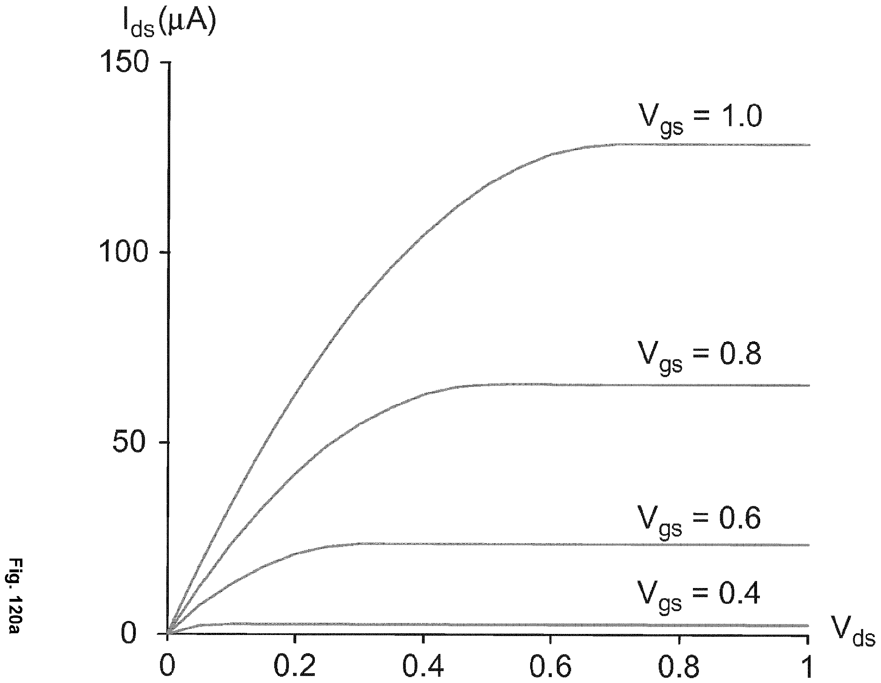

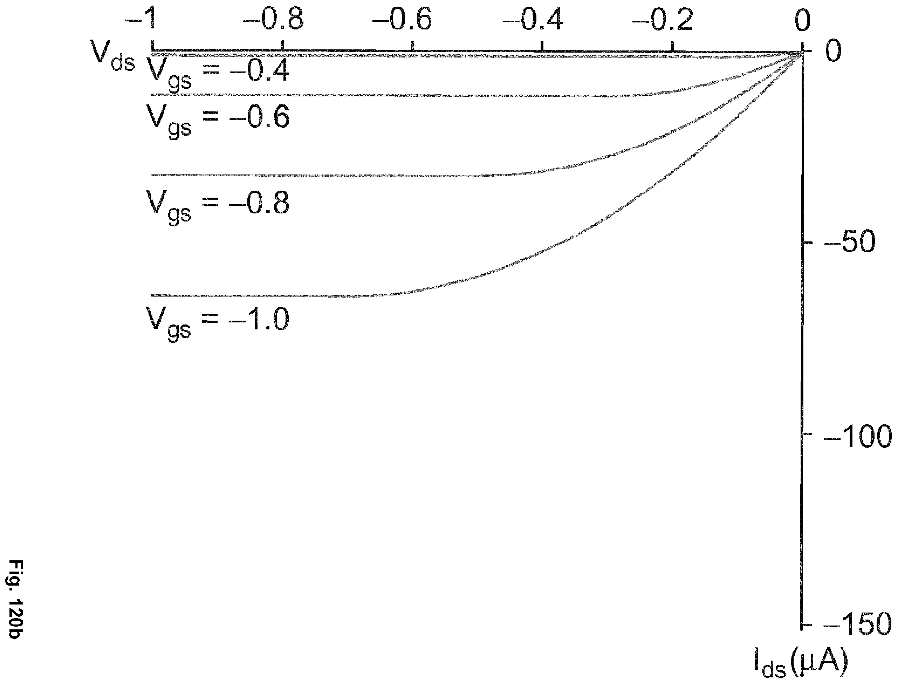

Between the gate and both the source and the drain channels, a capacity effect evolves as a function of the channel length L and width W: *C_{g} = Cₒₓ · W · L,* where *Cₒₓ* is the capacitance per unit area of the gate oxide. Therefore, the current from drain to source is a function of the voltage at the gate *V_{g}*. This leads to the following dependencies for the current: ${I}_{off} = 0 ; {I}_{on} = \frac{β}{2} \left({V}_{DD}-{V}_{t}\right)$ where *β* = *µ · Cₒₓ ·* W/I, and the positive voltage (POWER) *VDD = V_{ds} = V_{gs}.* This leads to I-V characteristic as in figures 120a/b. There are many more effects, which are skipped in this short overview about the I-V-characteristics of a transistor. These effects can be modelled and influence the illustrated curve in the I-V-graph in figures 120a/b. But "although the physics of nanometer-scale devices is complicated, the impact of nonideal I-V behavior is fairly easy to understand from the designer's viewpoint".

The latency time to switch between 0 and *VDD* can be calculated with the following relation: $t = \frac{C}{I} \cdot {V}_{DD}$

The dynamic power (capacitor / transistor is charged and discharged) is defined as: ${P}_{dynamic} = C \cdot {V}_{DD}^{2} \cdot f$

From leaking effects, a small amount of current *I_{static}* flows between power and ground occur also when the transistor is not switched, what leads to static power loss: ${P}_{static} = {I}_{static} \cdot {V}_{DD}$

The maximum time which is needed from the input signal crossing 50% to the output crossing 50% is called the propagation delay time *t_{pd}.* This is the time to compute a logical network of gates, meaning the *t_{compute}* per Computation Block node (CB), as described below in detail.

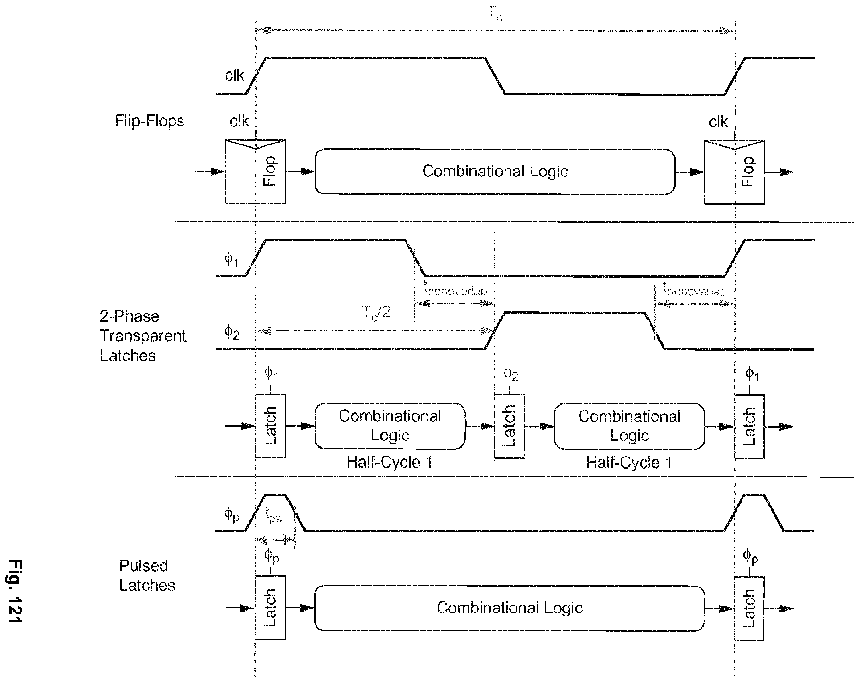

Regarding the timing, combinational circuits depending only on input to create a result defined by the propagation delay of the circuit *t_{pd}.* Sequential, respectively synchronous design depend on actual and previous input and such circuits are said to have states. Timing constraints by transfer delay in wires are very complex to model and forecast. It is evident for a circuit that the timing is correct (and many problems can occur, e.g. routing congestion, power, etc.). And it is a problem, for placing and routing to keep the timing constraints in a fully asynchronous design. By sequencing blocks of combinational logic, the results can be synchronized and determine timing constraints by appropriate clock-frequencies. In general, synchronous designs are much more stable than asynchronous designs. Using latches or flip-flops combinational logic gets static sequenced, see Figure 121.

Constraints in such designs can be modelled and appropriate clocking for a given design can be derived, also automatically. The delay of single combinational circuits can be modelled with high accuracy of state-of-the-art synthesis tools or by tabled values.

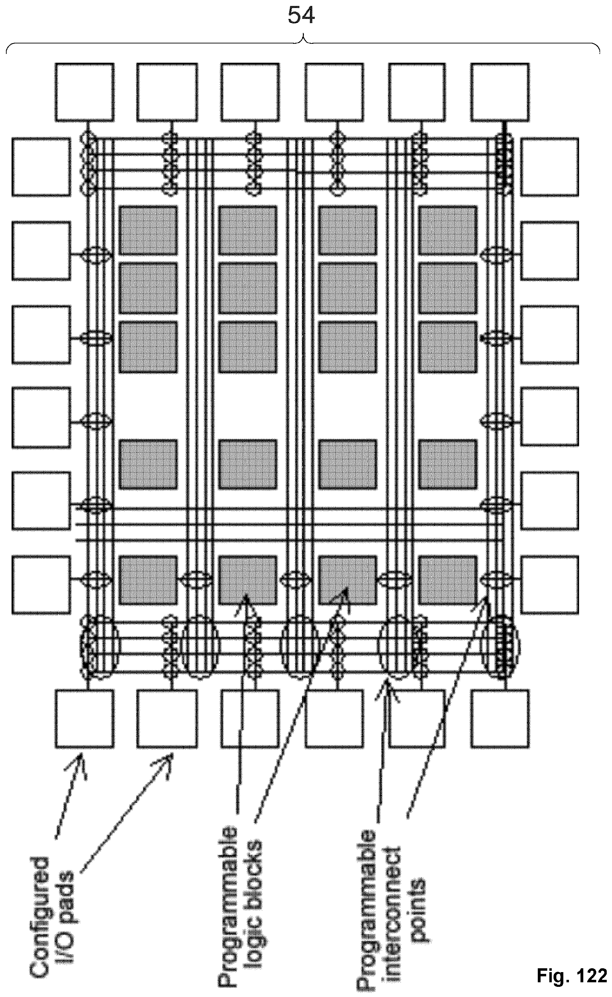

The placing is done by positioning logic blocks on e.g. an FPGA (Field Programmable Gate Array) trying to minimize the total length of interconnect required. Here the inventive method of the present application makes further improvements. Routing is a NP complete problem and modern tool-chains reaching with iterative algorithms from RTL-description workable IC-designs with good success - novel approaches could be done by reducing needed iterative steps to find the approximated optimal solution. In the technical field, FPGAs denote a type of configurable integrated circuit that can be programmed or reprogrammed after manufacturing. FPGAs are part of a broader set of logic devices referred to as programmable logic devices (PLDs). In other words, field programmable gate arrays (FPGA) denote specific integrated circuits that can be user-programmed. The FPGA contains versatile functions, configurable interconnects, and input/output interface to adapt to the user specification. FPGAs allow rapid prototyping using custom logic structures, and are popular for limited production products. Modern FPGA are extremely dense, with complexity of several millions of gates which enable the emulation of very complex hardware such as parallel microprocessors, mixture of processor and signal processing, etc. One key advantage of FPGA is their ability to be reprogrammed, in order to create a completely different hardware by modifying the logic gate array. A typical structure of a FPGA is shown in figure 122. Further, Application Specific Integrated Circuits (ASIC) differ from Field Programmable Gate Array (FPGA). The latter have given blocks which enabling to create a programmable design. Furthermore, ASIC need high volumes to be cost efficient. FPGA consists of different cell types: (1) Configurable Logic Block (CLB): implement logic functions, (ii) Programmable Interconnects: which implement routing of the cells with each other; and (iii) Programmable I/O Blocks: which connect the cells with external components / buses. On circuit and layout level for this application state-of-the-art compiler and synthesis tools are used. Different tools exist and often FPGA manufacturers have their proprietary synthesis tools.

For synthesis tools, one opensource toolchain is apio, which includes Yosys (Yosys Open SYnthesis Suite) a synthesis toolbox for RTL (register-transfer level) synthesis from Verilog and nextpnr (portable FPGA place and route tool) a timing driven place and route tool. Apio is a multiplatform toolbox with static pre-built packages to verify, synthesize, simulate, and upload a Verilog designs into the supported FPGA boards. Yosys is a framework for RTL synthesis tools. It currently has extensive Verilog-2005 support and provides a basic set of synthesis algorithms for various application domains. Further, nextpnr is a vendor neutral, timing driven, FOSS FPGA place and route tool, while the Free/Libre and Open-Source Software (FOSS/FLOSS) provides an ecosystem for digital hardware design (FPGA/ASIC). Finally, in the technical field of digital circuit design, register-transfer level (RTL) is a design abstraction which models a synchronous digital circuit in terms of the flow of digital signals (data) between hardware registers, and the logical operations performed on those signals. RTL is a first abstraction level in which circuits are represented as a graph of circuit elements (registers and combinatorial cells) and signals.

A general design flow for chip design can comprise:
1. Product requirement (Front End)
2. Behavioral / Functional specification (Front End)
3. Behavioral (RTL) synthesis (Front End)
4. Structural specification (Back End)
5. Physical synthesis (Back End)
6. Physical specification (Back End)
7. To CMOS Fabrication (Back End)

Complementary metal-oxide-semiconductor (CMOS) is a type of metal-oxide-semiconductor field-effect transistor (MOSFET) fabrication process that uses complementary and symmetrical pairs of p-type and n-type MOSFETs for logic functions. CMOS technology is used for constructing integrated circuit (IC) chips, including microprocessors, microcontrollers, memory chips (including CMOS BIOS), and other digital logic circuits. CMOS technology is also used for analog circuits such as image sensors(CMOS sensors), data converters, RF circuits (RF CMOS), and highly integrated transceivers for many types of communication.

The inventive system and method can simplify, respectively automatize the steps in the Front End, meaning automatically from a given code (product requirement) to a functioning RTL description. Information in the segmentation can be used to improve place and route, but place and route is a NP-hard problem. Any improvements in this field are possible to provide better start values for the iterative optimizing algorithms which can approximate optimal solutions. Furthermore, state-of-the-art tool-stacks enabling to retrieve functioning IC-designs from RTL description of a circuit. The novel, inventive method enables to derive from high programming languages (compiled and interpreted) to derive synchronous RTL-design fully automatically. Therefore, the novel method can be used as a novel High-level synthesis (HLS) approach. RTL-Description languages are Verilog and VHDL (Very High Speed Integrated Circuit Hardware Description Language, also VHSIC Hardware Description Language). Combined with the inventive method, this enables new limits to automatically transpile code from higher languages to synthesizable RTL-description and therefore improve known High-level synthesis (HLS) methods strongly by deriving de-signs from any high programming languages. It is to be noted, that Verilog, standardized as IEEE 1364, denotes a hardware description language (HDL) used to model electronic systems. It is typically used in the design and verification of digital circuits at the register-transfer level of abstraction. Verilog is also used in the verification of analog circuits and mixed-signal circuits, as well as in the design of genetic circuits. Further, VHDL denotes a hardware description language that is able to model the behavior and structure of digital systems at multiple levels of abstraction, ranging from the system level down to that of logic gates, for design entry, documentation, and verification purposes. The language has been standardized by the Institute of Electrical and Electronics Engineers (IEEE) as IEEE Std 1076. To model analog and mixed-signal systems, an IEEE-standardized HDL based on VHDL called VHDL-AMS (officially IEEE 1076.1) has been developed.

To detect problems in a design from the logic paths (from code, respectively to achieve a physical implementation of an instruction on a chip), the critical path is one critical property. The critical path can be at architectural, logical, circuit or layout level. In the gamma-graph, provided by the inventive system and method, the critical graph is detectable by the sum of the maximal parallel Computation Blocks *n*_{II} per graph-level.

Optimizing timing depends strongly on the microarchitectural level. To reach a good microarchitecture, it is essential to know how the algorithm has to be implemented and reflected by gates. The delay of the gate combination must fit with the clock cycle triggering the registers used for the synchronous design. This defines how fast the arithmetic can be performed and how fast data can be saved and are propagated along the wires. Parallelism in code is a significant property as it influences how many gates and which gates have to be available in parallel to compute all needed instructions in a code. Furthermore, it is evident to know how they are interconnected. All these information is contained in the gamma-graph, resulting from applying the inventive system and method on any code (as well from compiled as from code in interpreted languages).

### (ii) Background to the technical field of auto-parallelization of processing code

To run a program in parallel on a multi-core processor or multi-processor system today, its code must be rewritten to add by hand or through tools some OS parallelizing primitives such as pthread (POSIX Threads, known as pthreads, provide a parallel execution model structure. It allows a program to control multiple different flows of work that overlap in time. Each flow of work is referred to as a thread, and creation and control over these flows is achieved by making calls to the POSIX Threads API. POSIX Threads is an API defined by the standard POSIX. *1c*, *Threads extensions IEEE Std 1003.1c-1995)*)*.* Even with high level interfaces like OpenMP or MPI, parallelizing is not an easy job for two reasons: (i) if the resulting code is not enough synchronized, the computation is not deterministic and (ii) if it is too much synchronized, it is not parallel enough. However, threads make programs typically nondeterministic, and rely on programming style to constrain that nondeterminism to achieve deterministic aims. Instead of hand-parallelizing the code, the technical skilled person may rely on a compiler to automatically do, for example, loop vectorization or loop parallelization. It is to be noted that loop-level parallelization is one of the central aspects and technical challenges in HPC applications as loop-sections can introduce large computing demands. Opportunities to exploit parallelism is often in applications where data are stored in random access data structures. However, even simple example can often not be automatically parallelized by prior art compilers. Further, irregular code structures are a second problem. Below, it is detailed discussed how loops are parallelized by the present inventive system, using a just-in-time-loop-parallelization structure.

This leads to a third problem of parallelization which is the memory organization of the data. In the sum example, the array to be summed is declared for example as a global variable. Hence, it is centralized when the computation is distributed. As a result, each thread brings the array pieces it needs from DRAM, where it resides. Cache can help but neighbor cores are slowed down by memory contention and the cache miss rate is impacted by the array distribution. Moreover, in a program updating shared data, keeping caches coherent requires complex hardware which slows down average memory access time. Caches and memory hierarchy, as well as branch predictors, are hardware features that rely on the principle of locality, which in essence is founded on the centralization of data (caches) and fetched code (predictors). When the code and the data are distributed, it is the parallel locality which applies to data. The parallel locality principle is that a consumer should be as close as possible from its producer. The present inventive system also allows to optimize the producer to consumer distance for a parallelized code, which is another way to quantify the parallelization quality.

In the prior art, there are various trials to apply dataflow architecture differently to parallel computing frameworks and to auto-parallelization systems. Dataflow architecture is a dataflow-based computer architecture that directly contrasts the traditional von Neumann architecture or control flow architecture. However, dataflow architectures have no program counter, where in concept, the executability and execution of instructions is solely determined based on the availability of input arguments to the instructions, so that the order of instruction execution is unpredictable, i.e., behavior is nondeterministic. Thus, there is a need to provide dataflow architectures that are deterministic in nature enabling auto-parallelization compilers to manage complex technical tasks such as processor load balancing, synchronization, and accesses to common resources by considering the underlying system architecture.

In general, when processing code is executed in parallel in multi-core or multi-processor systems, this may lead to higher throughput. Multi-processor or multi-core systems (processor and core are for simplicity hereafter simply referred as processor) entail breaking of code into smaller code blocks and efficiently managing the execution of code. In order for the cores or processors to execute in parallel, data to each of the core or processors has to be independent. Instances of a same code block can be executed on several processors simultaneously to improve the through-put. If the processors need data from a previous execution or another process currently performing calculations, then parallel processing efficiency could decrease due to the latency occurring exchange data between and/or of the processor units. In general, when processors enter states in which the execution of a program is suspended or not executed, for whatever reason, and instructions belonging to it are not fetched from memory or executed, those states induce idle states of the processor affecting parallel processing efficiency. Data dependency needs to be considered when scheduling processors. Efficiently managing multiple processors and data dependency for higher throughput is challenging. It is desirable to have a method and system for efficient management of code blocks in computation rich applications. It is to be noted, that the problem of latency also exists in single processor systems, where, for example, latency oriented processor architecture is used to minimize the problem, which are microarchitecture of microprocessor designed to serve a serial computing thread with a low latency. These architectures, in general, aim to execute as many instructions as possible belonging to a single serial thread, in a given window of time, where the time to execute a single instruction completely from fetch to retire stages may vary from a few cycles to even a few hundred cycles in some cases. However, these techniques do not automatically apply to the latency problem of (massive) parallel computing systems.

Thus, parallel computing systems require efficient parallel coding or programming, where parallel programming becomes a programming paradigm. It comprises on the one hand methods to divide a computer program into individual sections that can be executed concurrently, and on the other hand methods to synchronize concurrent code sections. This is in contrast to classical sequential (or serial) programming and coding. Parallel execution of a program can be supported on the hardware side; the programming languages are then typically adapted to this. For example, parallel programming can be done explicitly by letting the programmer execute program parts in separate processes or threads, or it can be done automatically so that causally independent (parallelizable) sequences of instructions are executed side by side, i.e. parallel. This parallelization can be done automatically by a compiler system if a computer with a multi-core processor or a parallel computer is available as target platform. Some modern CPUs can also recognize such independence (in the machine code or microcode of a program) and distribute the instructions to different parts of the processor in such a way that they are executed simultaneously (out-of-order execution). However, as soon as the individual processes or threads communicate with each other, they are, in that sense, no longer concurrent as a whole since they influence each other, only individual sub-processes being still concurrent with each other. If the order of execution of the communication points of the individual processes or threads cannot be defined accordingly, conflicts can arise, especially so-called deadlocks, when two processes wait for each other (or block each other) or race-conditions, when two processes overwrite each other's results. In the prior art, to solve this problem, synchronization techniques are used, as e.g. mutual exclusion (Mutex) techniques. Though such techniques can prevent race conditions, they do not automatically allow an optimized parallel handling of the processes or threats with a minimal latency of the processor units.

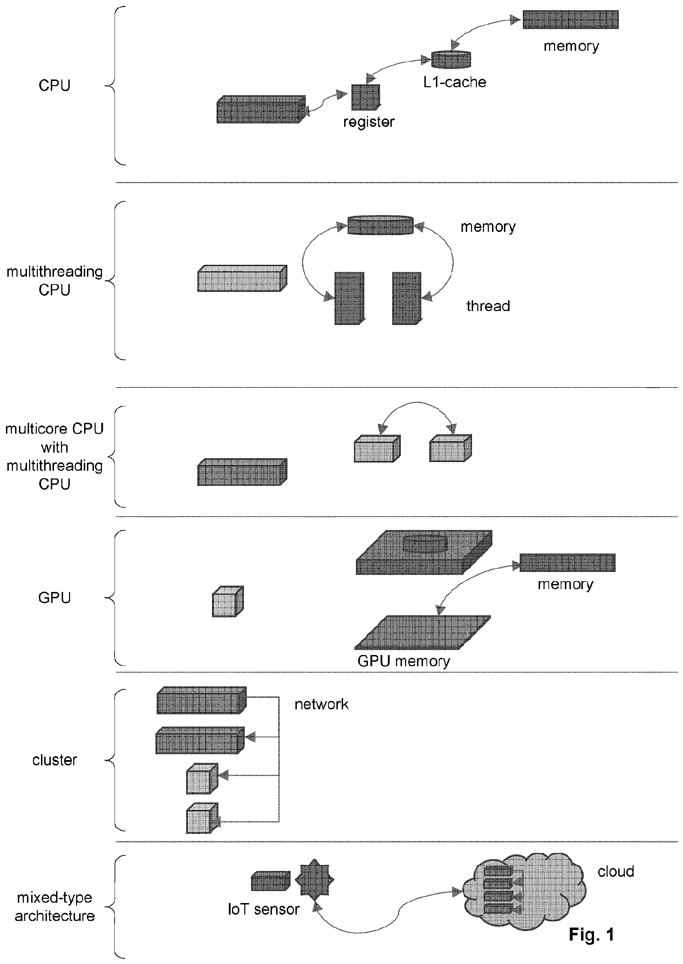

(Micro-)processors are based on integrated circuits, which make it possible to do arithmetic and logical operations based on two binary values (in the simplest 1/0). For this, the binary values must be available for the processor's calculating unit. A processor unit needs to get the two binary values to calculate the result of an expression a = b operand c. The time it takes to retrieve the data for these operations is known as the latency time. There is a wide hierarchical range for these latency times from the register, L1-cache, memory access, I/O Operation, or a network transfer, as well as processor configuration (e.g. CPU vs. GPU). As every single component has a latency time, the overall latency time for the calculation is a combination mainly of hardware components needed to get the data from one location to the other in a modern computation infrastructure. In modern architectures, also the different software layers (e.g. of an operating system) have large influences. The difference between fastest location for a CPU (or GPU) to get data and the slowest can be huge (in the range of factor >10⁹). Figure 1 illustrates the formation of latency times in modern computation infrastructures. As figure 1 shows, parallel computing machines have been developed with different distinct architecture. It is important to note, that parallel architecture enhances the conventional concepts of computer architecture with communication architecture. Computer architecture defines critical abstractions (like user-system boundary and hardware-software boundary) and organizational structure, whereas communication architecture defines the basic communication and synchronization operations. It also addresses the organizational structure.

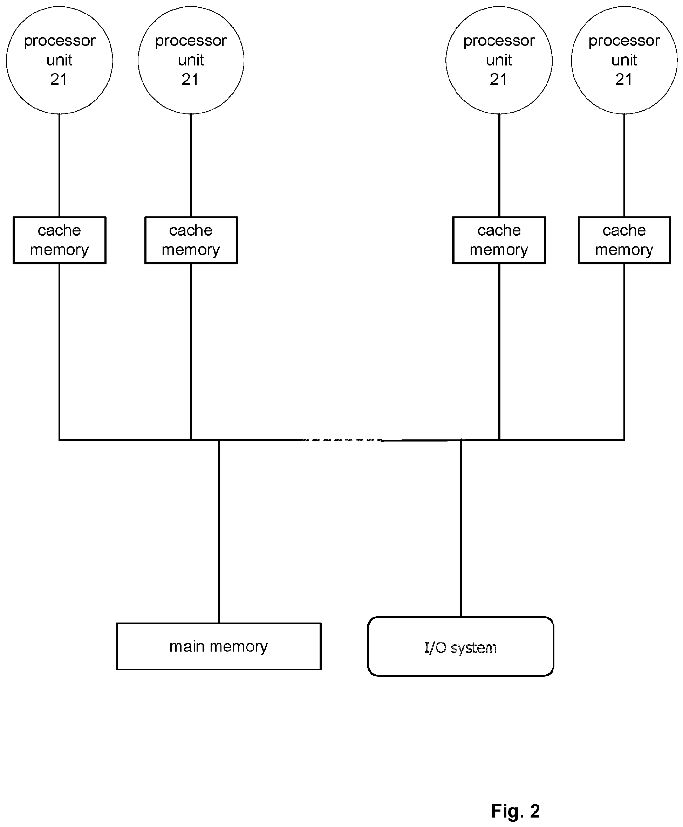

Computer applications are typically written in the top layer, i.e. in a high level language, being based on corresponding programming models. Various parallel programming models are known, as e.g. (i) shared address space, (ii) message passing, or (iii) data parallel programming referring to corresponding multi-processor system architectures. Shared memory multiprocessors are such a class of parallel machines. Shared memory multiprocessor systems give better throughput on multiprogramming workloads and supports parallel programs. In this case, the computer system allows a processor and a set of I/O controller to access a collection of memory modules by some hardware interconnection. The memory capacity is increased by adding memory modules and I/O capacity is increased by adding devices to I/O controller or by adding additional I/O controller. Processing capacity can be increased by implementing faster processors or by adding more processors. As illustrated in figure 2, the resources are organized around a central memory bus. Through the bus access mechanism, any processor can access any physical address in the system. As all the processors are assumed to be or in fact equidistant from all the memory locations, the access time or latency of all the processors is same on a memory location. This is called symmetric multiprocessor system.

The message passing architecture is another class of parallel machines and programming model. It provides communication among processors as explicit I/O operations. The communication is combined at the I/O level, instead of the memory system. In message passing architectures, user communication is executed by using operating system or library calls that perform lower level actions, which includes the actual communication operation. As a result, there is a distance between the programming model and the communication operations at the physical hardware level. Send and receive is the most common user level communication operations in message passing system. Send specifies a local data buffer (which is to be transmitted) and a receiving remote processor. Receive specifies a sending process and a local data buffer in which the transmitted data will be placed. In send operation, an identifier or a tag is attached to the message and the receiving operation specifies the matching rule like a specific tag from a specific processor or any tag from any processor. The combination of a send and a matching receive completes a memory-to-memory copy. Each end specifies its local data address and a pair wise synchronization event. Though, message passing and a shared address space traditionally represent two distinct programming models, each having an own paradigm for sharing, synchronization and communication, the basic machine structures have converged towards a common organization, today.

Finally the data parallel processing is a further class of parallel machines and programming model, also referred as processor arrays, data parallel architecture or single-instruction-multiple-data machines. The main feature of this programming model is that operations can be executed in parallel on each element of a large regular data structure (like array or matrix). Data parallel programming languages are usually enforced by viewing the local address space of a group of processes, one per processor, forming an explicit global space. As all the processors communicate together and there is a global view of all the operations, so either a shared address space or message passing can be used. However, the development of programming models only cannot increase the efficiency of the computer, nor can the development of hardware alone do it. Further, top level programming models necessarily introduce boundary conditions, as e.g. the model specific architecture, given by the programming model requirements. Since a parallel program consists of one or more threads operating on data, the underlying parallel programming model defines what data the threads require, which operations can be performed on the required data, and which order is followed by the operations. Thus, there are limitations on the optimization of machine codes for multi-processor systems, due to the boundaries of the underlying programming model. A parallel program must necessarily coordinate the activity of its threads to ensure that the dependencies between the programs are enforced.

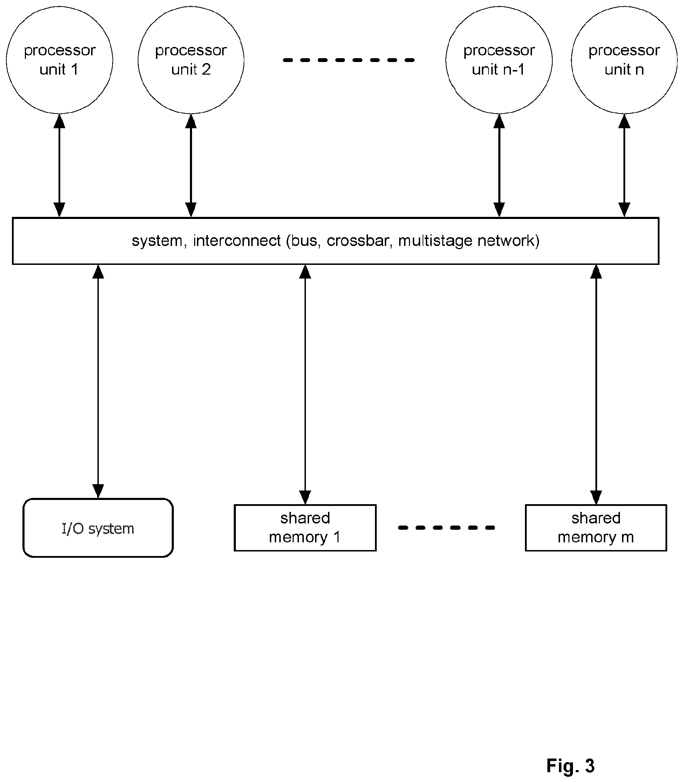

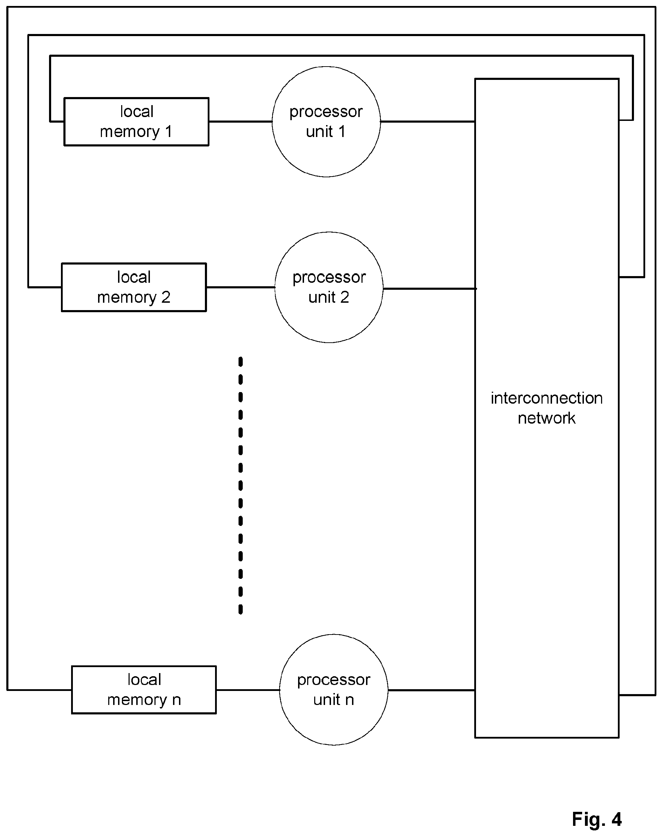

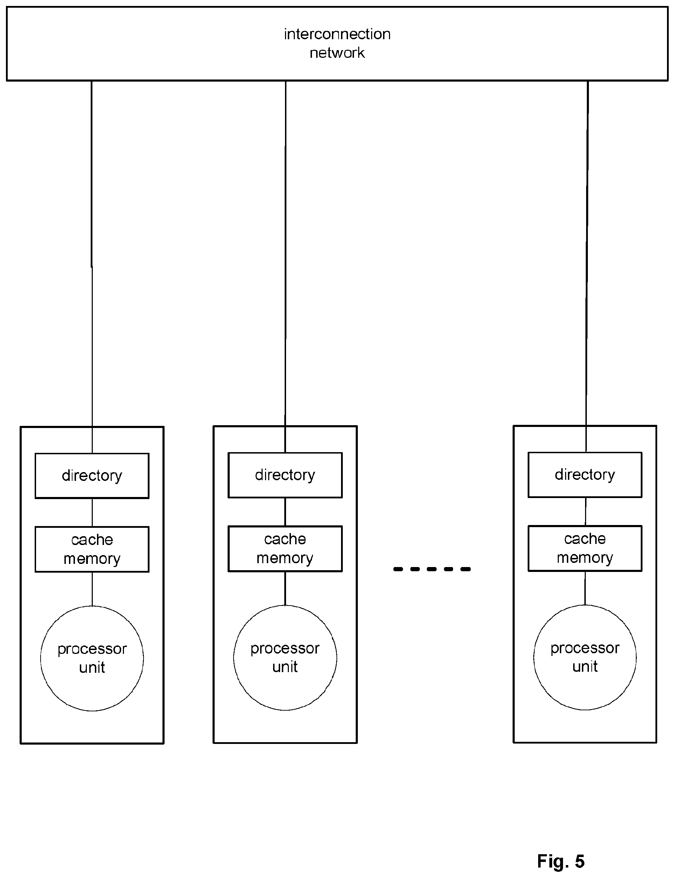

As figure 1 shows, parallel computing machines have been developed with different distinct architecture, each giving raise to different formation of latency times in their computation infrastructures. One of the most common multi-processor systems is the shared memory multiprocessors systems. Essentially, there are three basic architectures known for shared memory multiprocessors systems: (i) Uniform Memory Access (UMA), (ii) Non-uniform Memory Access (NUMA), and (iii) Cache Only Memory Architecture (COMA). In the UMA-architecture (see figure 3), all the processors share the physical memory uniformly. All the processors have equal access time to all the memory words. Each processor may have a private cache memory. Same rule is followed for peripheral devices. When all the processors have equal access to all the peripheral devices, the system is called a symmetric multiprocessor. When only one or a few processors can access the peripheral devices, the system is called an asymmetric multiprocessor. In the NUMA multiprocessor architecture (see figure 4), the access time varies with the location of the memory word. The shared memory is physically distributed among all the processors, called local memories. The collection of all local memories forms a global address space which can be accessed by all the processors. Finally, the COMA multiprocessor architecture (see figure 5) is a special case of the NUMA multiprocessor architecture. In the COMA multiprocessor architecture, all the distributed main memories are converted to cache memories. The COMA architecture can also be applied to distributed memory multi-computers. A distributed memory multicomputer system consists of multiple computers, typically denoted as nodes, interconnected by message passing network. Each node acts as an autonomous computer having a processor, a local memory, and sometimes I/O devices. In this case, all local memories are private and are accessible only to the local processors, thus such machines are also called no-remote-memory-access (NORMA) machines. Other known multi-processor architectures are e.g. multivector computers and Single Instruction, Multiple Data (SIMD) parallel computers, Parallel Random-Access Machines (PRAM) and parallel computers based on Very Large-Scale Integration (VLSI) chip etc., all having a different multiprocessor architecture and infrastructure characteristic. In summary, since different multiprocessor architectures give raise to different formation of latency times in their computation infrastructures, the development of programming models only cannot increase the efficiency of the computer, nor can the development of hardware alone do it.

As mentioned above, code parallelization can also be performed automatically by a compiler system, if a computer with a multi-core processor or a parallel computer is available as target platform. Such automatic parallelization, also called auto parallelization, denotes the converting of sequential code into multithreaded and/or vectorized code in order to use multiple processors simultaneously e.g. in a shared-memory multiprocessor (SMP) machine. With prior art systems, fully automatic parallelization of sequential programs is technically challenging because it requires complex program analysis and because the best approach can depend upon parameter values that are not known at compilation time. The programming control structures on which auto parallelization by compiler systems places the most focus are loops, because, typically, most of the execution time of a program takes place inside some form of loop. There are two main approaches to parallelization of loops: pipelined multi-threading and cyclic multi-threading. The compiler structure for automatic parallelization normally comprises a parser, an analyzer, a scheduler, and a code generator. The parser of a compiler system covers the first processing stage where e.g. a scanner reads the input source files to identify all static and extern usages. Each line in the file will be checked against pre-defined patterns to segregate into tokens. These tokens will be stored in a file which will be used later by the grammar engine. The grammar engine will check patterns of tokens that match with pre-defined rules to identify variables, loops, control statements, functions etc. in the code. In a second stage, the analyzer identifies sections of code that can be executed concurrently. The analyzer uses the static data information provided by the scanner-parser. The analyzer first detects all the totally independent functions and mark them as individual tasks. The analyzer then finds which tasks have dependencies. In the third stage, the scheduler will list all the tasks and their dependencies on each other in terms of execution and start times. The scheduler will produce the optimal schedule in terms of number of processors to be used or the total execution time for the application. In the fourth and final stage, the scheduler generates a list of all the tasks and the details of the cores on which they will execute along with the time that they will execute for. The code generator then inserts special constructs in the code that will be read during execution by the scheduler. These constructs will instruct the scheduler on which core a particular task will execute along with the start and end times.

If a cyclic multi-threading parallelizing compiler is used, the compiler tries to split up each loop so that each iteration of the loop can be executed on a separate processor concurrently. During auto parallelization, the compiler typically conducts two passes of automated assessment before actual parallelization in order to determine the following two fundamental preconditions for parallelization: (i) In a first pass, based on dependence analysis and alias analysis, is it safe to parallelize the loop?, and (ii) in a second pass, based on estimation (modeling) of the program workload and the capacity of the parallel system, is it worthwhile to parallelize it? The first pass of the compiler performs a data dependence analysis of the loop to determine whether each iteration of the loop can be executed independently of the others. Data dependence can sometimes be dealt with, but it may incur additional overhead in the form of message passing, synchronization of shared memory, or some other method of processor communication. The second pass attempts to justify the parallelization effort by comparing the theoretical execution time of the code after parallelization to the code's sequential execution time. It is important to understand, that code does not always benefit from parallel execution. The extra overhead that can be associated with using multiple processors can eat into the potential speedup of parallelized code.

If a pipelined multi-threading parallelizing compiler is used for auto parallelization, the compiler tries to break up the sequence of operations inside a loop into a series of code blocks, such that each code block can be executed on separate processors concurrently.

There are many parallel problems that have such relatively independent code blocks, in particular systems using pipes and filters. For example, when producing live broadcasting, many different tasks must be performed many times a second.

A pipelined multi-threading parallelizing compiler tries to assign each of these operations to a different processor, normally arranged in a systolic array, inserting the appropriate code to forward the output of one processor to the next processor. For example, in modern computer systems, one of the focuses lies on using the power of GPU's and multicore systems to compute such independent code blocks (or independent iterations of a loop) at runtime. The memory accessed (whether direct or indirect) can be then marked for different iterations of a loop and can be compared for dependency detection. Using this information, the iterations are grouped into levels such that iterations belonging to the same level are independent of each other, and can be executed in parallel.

In the prior art, many compiler for automatic parallelization exist. However, most modern prior art compilers for automatic parallelization depend on the use of Fortran as high level language, i.e. are applicable to Fortran programs only, because Fortran makes stronger guarantees about aliasing than languages such as C. Typical examples of such prior art compilers are (i) Paradigm compiler, (ii) Polaris compiler, (iii) Rice Fortran D compiler, (iv) SUIF compiler, And (v) Vienna Fortran compiler. Further disadvantages of the automatic parallelization by the prior art compilers lies in the fact, that a high optimization of the code is often difficult to achieve due to the fact, that (a) dependence analysis is hard for code that uses indirect addressing, pointers, recursion, or indirect function calls because it is difficult to detect such dependencies at compile time; (b) loops have often an unknown number of iterations; (c) accesses to global resources are difficult to coordinate in terms of memory allocation, I/O, and shared variables; and (d) irregular algorithms that use input-dependent indirection interfere with compile-time analysis and optimization.

One important task of a compiler is to try to handle the latency times efficiently. Compiling is the transcription from human readable and so-called higher languages (such as C, python, java, etc.) to assembler / processor code, which then only consists of the available instructions on a given processor. As already discussed, modern applications with a large demand for data or computation have to be targeted for appropriate infrastructure and a lot of different latency times are introduced - and currently only parts of it can be solved by prior art compiler optimization techniques.

For every level of complexity (hardware components), the solutions have historically been developed and evolved, from compiler optimization techniques to multithread libraries for concurrent data structures to prevent race-conditions to vectorization of code, to GPU systems with corresponding programming languages (e.g. OpenCL (Open Computing Language) to frameworks such as "TensorFlow" to distribute computations by programmers, to big data algorithm such as the "MapReduce", where MapReduce is a programming technique and an associated implementation for processing and generating big data sets with a parallel, distributed algorithm on a cluster. In the field of high-performance computing, theoretical, mathematics-based techniques to split large matrices to special gridding techniques for finite difference or element methods were developed and defined. This includes protocols, e.g. in cluster infrastructures Message Passing Interface (MPI) supports the transfer of data to different processes over an infrastructure.

As discussed above, the list of prior art optimization techniques is long. But from a system theory perspective, the question is more or less always the same: How can the code (any code) interact most efficiently with the latency times in a complex hardware infrastructure? Compilers work well when using a single CPU. As soon as the hardware complexity increase a compiler cannot really render the code parallel. The parallelization becomes merely CPU approximated, e.g. by introducing microprocesses. Hardware industry for CPUs, GPUs and clusters thereof mainly focuses on their specific domains, developer and research focus on implementation techniques and framework development and have so far not moved into the field of a more generic (cross- industry) approach. Further, the authors Ruggiero, Martino; Guerri, Alessio; Bertozzi, Davide; Milano, Michaela; Benini, Luca, revealed in their pamphlet: A Fast and Accurate Technique for Mapping Parallel Applications on Stream-Oriented MPSoC Platforms with Communication Awareness, International Journal of Parallel Programming, Vol. 36, No. 1, Feb 08, the partitioning of algorithms that process data streams onto different processor cores. The authors model is a simple communication network with a simple, additive communication model between processor cores. This does not allow realistic conclusions about the actual communication load caused by partitioning on multiple cores.

Generally, known processor manufacturer are focused on their processors and related hardware components, whereas other developers, for example, the research group for High Performance Computing (HPC) are focused on the numerical methods and the use of libraries. Currently, there is no attempt to solve the question regarding an optimization of a compiler system from a system theoretical perspective by accessing the latency dynamics resulting from a given source code. The source code in the prior art merely consists of a series of statements which result in read and write direct for a given target infrastructure.

The prior art document M. Kandemir et al. "Slicing Based Code Parallelization for Minimizing Inter-processor Communication", 2009 International conference on compilers, architecture, and synthesis for embedded systems (cases '09), Grenoble, France October 11-16, 2009, p. 87-96, discloses a system for auto-parallelization that aims in minimizing inter-processor communication in distributed memory multicore architectures by applying the concept of iteration space slicing, i.e. this prior art system is based on an iterative approach. The disclosed system does this by the portioning of output array by iteratively determining the partition of other arrays in the application code, i.e. by iterative determination of array parts, wherein the information is taken iteratively from the previous sliced array parts. In code parallelization, slicing denotes the process of extracting statements form a program that potentially have an influence on a specific statement of interest, which is the slicing criterion (see e.g. J. Krinke, "Advanced slicing of sequential and concurrent programs,"20th IEEE International Conference on Software Maintenance, 2004. Proceedings., 2004, pp. 464-468). These slicing techniques showing similar effects as the prior art systems relying on points data/control dependences (see e.g. J.L. Hennessy, D.A. Patterson "Computer Architecture", Fifth Edition: A Quantitative Approach, The Morgan Kaufmann Series in Computer Architecture and Design, fifth edition, p. 150ff) and data flow analysis (see e.g. Gary A. Kildall "A unified approach to global program optimization", proceedings of the 1st annual ACM SIGACT-SIGPLAN symposium on Principles of programming languages (POPL '73). Association for Computing Machinery, New York, 1973, USA, 194-206). Using iteration space slicing, these systems are able to assess which iterations of which statements is affecting the values of a given set of elements from a specific array A. Thus, iteratively, the system returns the set of loop operations to be assigned to a processor p e.g. from a loop nest s by relying on a specific set of data elements accessed by processor p from array A. Further, the prior art document Fonseca A. et al, "Automatic Parallelization: Execution Sequential Programs on a Task-Based Parallel Runtime", International Journal of Parallel Programming, April 2016 discloses another system for automatically parallelizing of sequential code for use in multicore architectures. The system discloses to use data-groups and memory layouts and then check the dependencies relying on task parallelism. Thus, in order to automatically parallelize the program, it is necessary for the system to analyze the memory accessed to assess possible dependencies between parts of the program. For instance, in an example of auto-parallelization of a code for Fibonacci sequencing, the disclosed system assesses the cost of creating a new task as higher than the cost of executing the method for a low input number. This assessment will then be used as main requirements for the position of the task during the auto-generation of the parallelized code, where the assessment is conducted by a specific function relying on a set of seven requirements to find the best position. Finally, this function outputs so called hard dependencies, which are the instructions after which a task can be introduced, and so called soft dependencies giving a set of already defined tasks which the current task will have to wait to execute. The parallelization is completed when all tasks are instantiated having a specified position, wherein a task is marked for execution by awaiting the execution of the current tasks and reading their results. Finally, US 2008/0263530 A1 discloses a system for converting application code into optimized application code or into execution code suitable for execution on a computation architecture comprising at least a first and a second level of data memory units. When scheduling instructions, a principle of locality, also called locality of reference, is used. This relates to the phenomenon that a same value or related storage location is frequently accessed. Different types of locality of reference are to be distinguished. In temporal locality, a resource that is referenced at one point in time is referenced again soon after-wards. In spatial locality, the likelihood of referencing a storage location is greater if a storage location near it has been recently referenced. Programs and systems which exhibit locality exhibit predictable behavior, and thus provide opportunities for code designers to improve performance through prefetching, precomputing and caching of code and data for future use. For this kind of data assessment optimization, the disclosed system accesses locality before layout locality, whereby for data, which is accessed again and again, accesses are brought together in time where possible when data transfer operations happen, and data which is accessed one after the other is brought together in space where possible. Therefore, in a first process (access locality) a partial fix is done, giving a range of options. In a second process (layout locality) one option is picked from the pre-defined range. This picking of one option may be done based on a cost function. As an embodiment variant, the system also addresses the problem of parallel data transfer and storage exploration by focusing on those parts of the application code with data parallel loops. A conversion structure allows to address both data-level aspects of different levels of memory units, such as back-ground memories, fore-ground memories, registers, and on functional units.

In summary, although parallelizing compilers exist, they typically focus on independent levels of parallelism such as instruction-level parallelism (ILP) targeting VLIW (Very Long Instruction Word) and EPIC (Explicitly Parallel Instruction Computing) architectures, data, and vector parallelism such as high-performance Fortran and MMX/SSE-capable compilers, or thread-level parallelism (TLP) as in the case of compilers supporting the OpenMP API or the PGI Accelerator Compilers for GPUs. Even more sophisticated, architecture-centric approaches such as IBM's Octopiler, still the need for manual performance tuning exists; therefore, all software-development processes have to be manually adapted to the new prerequisites. All kinds of multilevel parallelism, finer granularities, and nested hierarchical memory systems combined with software-managed or user-managed data transfers need to be utilized and expressed by the algorithms. In addition, applications need to be designed with respect to scalability across several processor generations and concepts. For all steps of application mapping (e.g., in numerical simulation), comprehensive hardware knowledge is required to achieve optimal throughput. An intricate trade-off exists between performance, productivity, portability, and flexibility of an implementation. In the present inventive system and method, hardware-aware computing is approached by providing the best combination of schemes, parallel algorithms, and platform-specific implementations for a given source code of an application.

Further, current, prior art auto-parallelization systems and programming approaches towards multicore systems - and especially heterogeneous parallel systems - unfortunately do not suit the specific needs of such systems: high-level parallel programming models deliver an abstract view as required by today's complex applications but do not feature fine-grained control over hardware mapping, resulting in poor hardware resource usage. Strict hardware-aware approaches, in term, enable such fine-grained control but will put the focus to hardware mapping. The inventive system and method being based on a hybrid approach provides a new technical combination of both aspects.

As further discussed below, conventional, prior art, parallel programming approaches can be divide into the following three fields that are shared-memory, message-passing, and data-parallel approaches with according standardized programming environments such as (in order of fields mentioned) OpenMP (Open Multi-Processing) for targeting compiler-exploitable TPL (Task Parallel Library), MPI (Message Passing Interface) for addressing manually exploited thread-level and pipeline parallelism, and high-performance Fortran for compiler-supported exploitation of Data Parallelity (DP). These programming models support only marginal flexibility and typically do not enable fine-grained architecture mapping. Of these three, message passing provides the highest level of controlling the architecture mapping of an application. On the downside, it forces the programmer to detailed partitioning and orchestration. One of the larges disadvantages is further, that hardware heterogeneity is typically not expressed by any of these models as this is outside their focus. Certain flexibility is supported by OpenMP allowing dynamic change of the number of threads to be created. Partitioned Global Address Space (PGAS) is a programming interface that defines a global address space on a possibly distributed system focusing on reference-locality exploitation: with PGAS, portions of the shared-memory space may have an affinity for a particular thread. Examples of this model are Unified Parallel C and Co-array Fortran but also recent and industry-driven approaches such as Chapel (Cray) and X10 (IBM).

Especially heterogeneous platforms require fine-grained ways of matching application code to the given platform on the lowest hardware level: one prior art example is the Cell BE forcing the programmer to explicitly partition the program into individual chunks to be executed on the single vector processing units, the SPEs. Communication must be explicitly formulated using so-called direct memory access streams, enabling the individual SPEs to fetch required data and write back result data. This careful matching of computation and communication may lead to speedups of orders of magnitude compared with a naïve implementation. It is however a quite tedious, error-prone, and time-consuming task. Hardware-aware programming techniques are also required on conventional homogeneous multicore platforms to minimize communication overhead, for example, by data-locality optimizing and appropriate prefetching. With current and upcoming multicore architectures, this becomes even more prevalent as such architectures feature distinct schemes of cache sharing and interconnection technologies.

Another problem of all discussed prior art approaches is the necessity of additional run-time layers and often language-centric extensions. They furthermore do not regard an application's required such as real-time requirements or computation accuracy. A different prior art approach is based on carefully extending existing system layers. However, it is inherently language agnostic and operating system agnostic and not compatible to existing parallel programming models. Further, overhead does solely appear for triggered options like performance measurements and function profiling for guided execution and the profiling overhead still is about an order of magnitude lower than often required.

To achieve real, hardware-optimized parallelization, all parts of the application code need to be compliant with multilevel parallel units, a hierarchical and potentially nested memory subsystem, and heterogeneous components of the computing units. All aspects need to be expressed explicitly in the implementations: in the prior art, there is only little software support and few mechanisms available that may assist automatic and optimized utilization of resources, as well as hide away hardware details without affecting performance. Although heterogeneity in hardware is growing, it still lacks expression within the used algorithms and applications. Current programming techniques mainly rely on minimally invasive approaches where local parts of the application are identified for acceleration and offloaded to particular computing engines. For the overall benefit, additional communication via narrow bottlenecks has to be taken into account. However, prior art solutions are often isolated and not portable. Hardware-specific optimization techniques include arrangement of computations (such as vectorization, loop unrolling, re-ordering, branch elimination), optimizing of data structures (array-access patterns, memory alignment, data coalescing), and optimization of data transfers (blocking for spatial and temporal locality, caching and cache-bypassing, in-place algorithms). This should include the parameter space since the parameter space becomes increasingly difficult to manage. With the known prior art systems, there is no way around auto-tuners searching for (Pareto-)optimal settings of implementation parameters. For selected kernels, autotuning may provide results, however, typically on the price of lack of portability across platforms.

The prior art document US 2008/0263530 A1 shows a system for automated code conversion. In particular, the system relates to compilers and pre-compil-ers for automated code conversion targeting a computation engine with a predefined architecture. The system converts the application code into optimized application code or into execution code suitable for execution on a computation engine, i.e. a digital processor, with an architecture comprising at least a first and a second level of data memory units are disclosed. The system obtains the application code with the data transfer operations between the levels of the memory units. The system, then, converts the application code, the converting of application code comprising scheduling of data transfer operations from a first level of memory units to a second level of memory units such that accesses of data accessed multiple times are brought closer together in time than in the original code. The converting of application code further comprises, after the scheduling of the data transfer operations, deciding on layout of the data in the second level of memory units to improve the data layout locality such that data which is accessed closer together in time is also brought closer together in the layout than in the original code.

It is known that a common goal when designing a digital circuit is maximizing its performance. However, in the prior art, the focus is often on the circuit itself, not combining, or at least not consequently combining code optimization and parallelization with the chip design optimization. As a result, though a circuit is analyzed repeatedly during design, inter alia, to determine its operating frequency for maximizing the performance, the focus is on timing modeling of the circuit design, which is used to check whether a digital circuit will operate correctly, given a set of timing constraints. However, this sole focus on the optimization of the circuit design has some fundamental technical disadvantages and is a time consuming process. For example, such a timing constraint is the clock period, which requires signals to be stable before the active clock edge to avoid latching stale data or inducing meta-stability in data storage elements. A common approach to determine a digital circuit's speed is Static Timing Analysis (STA). STA operates on a timing graph, an abstract representation of a digital circuit where nodes represent the pins of circuit elements and uni-directional edges represent the timing dependencies between them. Two classes of STA algorithms are known: path-based and block-based. Path-based algorithms perform a detailed analysis of every path in a circuit - offering high accuracy, but with worst-case exponential run-time. As a result block-based algorithms, whose computation time grows linearly with the size of the circuit, are usually used despite their more pessimistic analysis. While STA is significantly faster than other approaches such as timing simulation, it is still time-consuming. Consequently designers and optimization tools often opt to sacrifice accuracy, by performing STA only 'occasionally' during the design process, to minimize design iteration times. Despite this a placement tool like VPR will call STA hundreds of times during optimization. However this still means design decisions are made using stale (old and possibly now incorrect) timing information. This leads designers and optimization algorithms (whose decisions can benefit from accurate timing information) to assume unnecessarily pessimistic design conditions - resulting in costly over-design. Furthermore, design sizes continue to increase rapidly, while improvements in single-threaded CPU performance have slowed. Additionally, the number of timing analyses required to fully characterize a design is also increasing due to the proliferation of timing corners, and the growing number of clock domains. As a result, in commercial FPGA place and route tools STA typically takes 25% of total run-time, but may dominate the optimization algorithms when designs have multiple clocks and timing constraints. Moreover, modern FPGAs have performance-driven architectural features such as pulsed latches and interconnect registers, which exacerbate hold-time issues. This requires additional minimum-delay timing analyses to evaluate, and design tools to explicitly optimize for hold-time; requiring numerous rapid calls to STA. Finally, a variety of performant parallel algorithms have been proposed for FPGA placement, and routing. As these parallel approaches speed-up the core optimization algorithms, timing analysis becomes an increasingly dominant portion of run-time - limiting the achievable speed-up. These factors all make the development of fast and scalable timing modelling, which can exploit the parallelism available from modern computing systems, key to reducing FPGA design times and put a huge technical burden solely on the IC design and optimization. The focus to overcome this technical problems, again, relied on the optimization of IC and the corresponding optimization tools. For example, a development has been Statistical STA (SSTA). Rather than determining scalar delays, SSTA models delay probability distributions to capture the delay impact of manufacturing process variation. SSTA can be applied with either path-based or block-based algorithms, and calculated either analytically, or by Monte Carlo methods. In the prior art, due to their lower computational complexity, many industrial design flows, and most optimization tools, use block-based algorithms.

In contrast to the prior art technical optimization approaches and their technical problems, the present invention starts from the code to be processed by the IC. In a first step, the present invention provides the most parallelized code form an initial software code by auto-parallelization, and in a second step the parallelization of the code is combined with the IC optimization using it as a basis to extract the most condensed form of a parallel IC layout with multiple parallel CPU pipelines to process the parallelized code using the condensed structure of the parallelized code as an blue-print and starting point to build the most optimized chip layout, thereby accounting for data transfer latency when evaluating CPUs, GPUs, and processing pipelines, and even allowing to consider simultaneous multi-corner and multi-clock modelling. The optimized IC can be easily evaluated in one of the known optimization tool on a variety of large benchmark circuits, proving his effectiveness and groundbreaking approach moving IC design optimization on the edge of its possibilities.

In the prior art, the document US 2008/0263530 A1 discloses a system for converting application code into optimized application code or into execution code for execution on a computation engine with an architecture comprising a first and a second level of data memory units. The system obtains application code, the application code comprising data transfer operations between the levels of memory units. The system further converts a part of the application code. The converting of application code comprises scheduling of data transfer operations from a first level of memory units to a second level of memory units such that accesses of data accessed multiple times are brought closer together in time than in the original code. The converting of application code further comprises, after the scheduling of the data transfer operations, deciding on layout of the data in the second level of memory units to improve the data layout locality such that data which is accessed closer together in time is also brought closer together in the layout than in the original code.

### Summary of the Invention

It is one object of the present invention to provide a new auto-parallelization system and method, providing both parallelized code and parallel IC design, architecture and implementation based on field programmable gate array (FPGA) and/or Application-Specific Integrated Circuit (ASIC). The object of the present invention is, in particular, to provide the highest possible parallelization and parallel processing in respect to latency time mirrored by the highest possible optimized chip architecture and design. In order to validate the proposed system and method, for example, parallel genetic algorithm (GA) and parallel particle swarm optimization (PSO) algorithm can be used. Furthermore, the performance and advantage of the proposed FPGA-based parallel intelligent auto-optimization system and method can be tested by comparing it with popular known open multi-processing (OpenMP)-based parallel programming and compute unified device architecture (CUDA)-based parallel programming, where the final results show that the proposed system and method has the with highest real-time performance in parallel implementation, for code auto-parallelization and optimized parallel chip design layout. More particularly, the proposed system and method uses a novel compiler system for multi-processor systems and multi-computer systems compiling program codes to machine codes with optimized latency of the processing units of the multi-processor systems, thereby efficiently managing multiple processors and data dependency for higher throughput, and not having the disadvantages of the prior art systems, as discussed above. Thus, it is a further object of the present invention to provide a system and technique that can be used to achieve the highest performance in multi-processor machines through auto parallelization, thereby optimizing the exploitation of low-level parallelism (temporal and spatial) at the level of the processing of machine instructions and mirror this on the side of the chip design layout. It is a further object of the invention to overcome disadvantages of prior art techniques overcoming their limitations of dealing with parallelization sections which are typically restricted to specific systems in mind like loop or particular section of code. The auto-parallelization system should be able to optimize identifying opportunities for parallelization as a critical step while generating multithreaded application and ICs. Using, for example, FPGA-based parallel simulate annealing (SA) to address job shop scheduling problem (JSSP), it is possible to illustrate that the proposed auto-parallelization system and method has high potential in industrial applications.

According to the present invention, these objects are achieved, particularly, with the features of the independent claims. In addition, further advantageous embodiments can be derived from the dependent claims and the related descriptions.

According to the present invention, the above-mentioned objects for a symmetric auto-compiler system for hardware-optimized auto-parallelization of a program code for execution by a multi-core or multi-processor parallel processing system having a plurality of processing units simultaneously processing instructions on data in the parallel processing system by executing the program code, and corresponding method are achieved, particularly, in that the auto-compiler system comprising means for transforming a serial source code of the program code written in a programming language into a parallel processing machine code comprising a number of instructions executable by the plurality of processing units of the parallel processing system or controlling the operation of the plurality of processing units, wherein the parallel processing system comprise memory units comprising at least main execution memory units comprising a plurality of memory banks for holding data of at least parts of the processing code, and transition buffer units comprising high speed memory for storing starting locations of the processing code and data segments at least comprising branch or jump instructions and/or used memory references and data values, wherein the main execution memory units provide a slower access time than the transition buffer units, wherein the execution of the processing code by the parallel processing system comprises the occurrence of latency times, the latency times being given by idle time of a processing unit between transmitting data back after having processed a specific block of instructions of the processing code on the data by the processing unit and receiving data necessary for execution of a consecutive block of instructions of the processing code by said processing units, in that the compiler system comprises a parser module for translating the serial source code into a code with a flow of elementary instructions executable by the processing units, the elementary instructions selectable out of a limited, processing-unit-specific set of elementary instructions and the elementary instructions comprising exclusively elementary arithmetic and logic operations and/or elementary control and memory operations for the number of processing units, in that the parser module comprises means for partitioning the code of said elementary instructions into computation block nodes, each computation block node consisting of a smallest possible segmentation of a non-further decomposable sequence of elementary instructions of the code processable by a single processing unit, the smallest possible segmentation of the elementary instructions being characterized by a sequence of elementary instructions framed by consecutive read and write instructions, said sequence being not further decomposable by smaller sequences of elementary instructions between consecutive read and write instructions, and the read and write instructions needed to receive data required for processing said sequence of elementary instructions by the processing unit and transmit back data after processing by the sequence, in that the compiler system comprises a matrix builder for generating matrices out of computation chains portioned from the code, the matrices comprising computation matrices and transfer matrices and task matrices, wherein each column within a computation matrix comprises computation block nodes being simultaneously processable based on executability of read and write instructions transferring data required for processing of the computation block nodes, wherein the transfer matrix contains to each computation block nodes transfer and process properties at least characterizing data transfer properties from one to a consecutive computation block node at least comprising data size of transmitted data and identification of a source computation block node and target computation block node of the data transfer and/or process characteristics on one of the plurality of processing units, in that tasks are formed by the matrix builder wherein in case of computation block nodes each having a different read associated, the tasks of a task matrix are formed by splitting the computation block nodes of a column of the computation matrix evenly to the number of the plurality of symmetric processing units forming for each of the plurality of processing unit per column of the computation matrix one task, and splitting remaining computation block nodes based on a predefined scheme to at least a part of said tasks, and wherein in case of computation block nodes at least partially having a read with identical data transferred, the tasks are formed by minimizing the number of reads uniformly or essentially uniformly over the number of processing units and/or if a predefined offset value is exceeded by minimizing an integrated processing time uniformly over each of the processing units, and in that the compiler system comprises a code generator for generating the parallel processing machine code for the plurality of processing units with an optimized aggregated latency time based on the computation chains given by the optimized task matrix. Additionally the compiler system can e.g. comprise an optimizer module using a matrix optimization technique minimizing an aggregated occurring latency time integrating all occurring latency times by providing an optimized structure of the tasks within the task matrix, wherein each column of the task matrix forms a computation chain by one or more tasks creating an ordered flow of computation block nodes to be executed by one of the plurality of processing units. If matrices or tensors are used, the optimization by means of the optimizer module can e.g. be based on numerical matrix optimization technique (or more general numerical tensor optimization technique, respectively). Technically, the present optimization problem can be formulated by using tensors and/or matrices and obtain in this way matrix/tensor field optimization problems. For linear optimization, matrices and linear programming can e.g. be used by the optimizer module. For certain applications of the present invention, the concept of tensor can e.g. be technically instrumental. In optimization tensor technics are able to solve systems of nonlinear relations and equations and for unconstrained optimization using second derivatives. Tensor methods can be used as general purpose-methods intended especially for problems where the Jacobian matrix at the solution is singular or ill-conditioned. The tensor methods can also be used for linear optimization problems. An important feature of tensors is that their values do not change when they cause regular nonlinear coordinate transformations, and thus, this notion can technically be useful for the characterization of structural properties not depending on regular nonlinear coordinate transformations. Thus, the tensor optimization can also be applied within the framework of nonlinear optimization. However, it has to be noted, that one of the technical advantages of the present invention is, that all matrices, know up-to-now, are, in contrast to the prior art optimization techniques in the field of auto-parallelization of source code, linear optimization approaches, while the prior art systems mainly must rely on non-linear optimization. Optimization, herein, denotes the problem of finding a set of inputs to an objective function that results in a maximum or minimum function evaluation. For this technically challenging problem, for example, also various machine learning algorithms can be used with the optimizer module from fitting logistic regression models to training artificial neural networks. If the optimizer module is realized by realized machine learning structures, it can be formulated it usually can be provided by using continuous function optimization, where the input arguments to the function are real-valued numeric values, e.g. floating point values. The output from the function is also a real-valued evaluation of the input values. However, as an embodiment variant, also optimization functions can be used taking discrete variables, i.e. providing a combinatorial optimization problem. To technically select the best optimization structure, for example, one approach can be to group the selectable optimization structures based on the amount of information available about the target function that is being optimized that, in turn, can be used and harnessed by the optimization algorithm. It is clear, that the more information is available about the target function, the easier the function is to optimize by machine learning, for sure, dependent from the fact whether the available information can effectively be used in the optimization. Thus, one selection criterion can e.g. be related to the differentiable target function by the question, if the first derivative (gradient or slope) of the function can be calculated for a given candidate solution or not. This criterion partitions the available machine learning structures into those that can make use of the calculated gradient information and those that do not, i.e. machine learning structures that use derivative information, and machine learning structures that do not use derivative information. For the application, where differential object functions can be used, it has to be noted, that herein, differentiable function denotes a function where the derivative can be generated for any given point in the input space. The derivative of a function for a value is the rate or amount of change in the function at that point, which is also referred as the slope. The first-order derivative is defined as the slope or rate of change of an objective function at a given point, where the derivative of the function with more than one input variable (e.g. multivariate inputs) is referred to as the gradient. Thus, the gradient can be defined as derivative of a multivariate continuous objective function. A derivative for a multivariate objective function is a vector, and each element in the vector can be called a partial derivative, or the rate of change for a given variable at the point assuming all other variables are held constant. Further, the partial derivative can be defined as element of a derivative of a multivariate objective function. Then, the derivative of the derivative of the objective function can be generated, that is the rate of change of the rate of change in the objective function. This is referred to as the second derivative. Thus, the second-order derivative can be defined as rate at which the derivative of the objective function changes. For the present case of a function that takes multiple input variables, this is a matrix and is referred to as the Hessian matrix, where the Hessian matrix is defined as second derivative of a function with two or more input variables. Simple differentiable functions can be optimized analytically using known calculus. However, the objective functions may not be solvable analytically. The used optimization can be significantly easier if the gradient of the objective function can be generated. Some machine learning structures that are able to use gradient information and may be used for the present application include: Bracketing algorithms, local descent algorithms first-order algorithms, and second-order algorithms.

The invention has, inter alia the advantage to provide and achieve a massive optimization based in the lowest possible code structure, reducing high programing language code to a few elementary instructions, which are, in respect to their data input and output points, not further reducible due to the limited set of machine instructions running on a CPU/microprocessor. The elementary instructions comprise, for example, e.g. (i) arithmetic operations: +, -, *, / -> in applied numerical applications, i.e. mathematical operations, such as integrating or differential analysis are reduced to these elementary instructions, (ii) logical operations: AND, OR, etc., (iii) variable and array declarations, (iv) compare operations: same, larger, smaller, etc., (v) code flow: jump, call, etc., (vi) if (condition) {codeA} else {codeB}, and (vii) loop (condition). The interactions between today's modern higher languages (e.g. python, C, java, etc.) and the limited resources of processor instructions can be analyzed and made accessible by creating a 'mapping' of read and write of 'data points' by their operations. In other words, by mapping the interactions of the read and write of the single instructions using an appropriate representation, which can, in addition, also be represented graphical, they can be made available for numerical optimization techniques, which leads to the ability to parallelize source code automatically resulting always with a runnable concurrent code. There are several approaches to access these interactions, but none that consequently maps the read and write pattern of a source code to the data introduced by the programmer's choice of variable definition and then goes on to extract the required sequential chains and introducing potential communication patterns, which makes "mapping" the code to a wide range of hardware infrastructure. This method discloses a new approach of "fitting" source code to a given hardware infrastructure over all levels (FPGA, CPU, GPU, clusters, etc.).

The invention has further the advantage the disclosed method and system can solve known technical problems, such as resolving nested loops with arrays solving PDEs (Partial Differential Equations) with a new perspective or well-known problems occurring in optimizing steps of SOTA compilers. The method gives a new perspective on codes and this new scope is based on physical effects occurring in all classical computation infrastructures, resulting in a generic way to map computations to a given hardware structure and derive a concurrent representation of a code on a given hardware or an ideal hardware for a given code. This is based on the consequence keeping all dependencies of "reading" and "writing" of the introduced data nodes and building chains of instruction depending on these dependencies. By extracting these chains of instructions, a minimal bit-size to compute the instruction chains for a target platform are extracted. As every chain of instructions can be expressed as combinational circuit (output depends only on the present inputs), these series of instructions represent combinational circuit blocks. Chain of instructions in the same column can be processed parallel only limited by the delays given by the physical properties, respectively limits of binary computing (delay between applying voltage to stable result).

The resulting computation block nodes and their flow graph gives back a well-formed base in matrices, which result in a generic way of getting back code applicable to different computational units (e.g. CPUs, GPUs, FPGAs, micro-controller, etc.). The method has a new perspective on ICT software and hardware interaction following the principles of system theory. This results in a method, which can bring novelty solutions in a wide range of fields, as:
(i) Adaptive hardware - FPGAs (Field Programmable Gate Array)/ ACIDs (Atomicity, Consistency, Isolation, Durability): The invention decomposes code into chains with instructions, which obviously represent logic elements in Integral Circuits. As the method gives a generic form to optimize combination of computing and communicating, it can be used to optimize the group of instructions based on the same «bit-pattern» / «signal» and lead to new approaches e.g. to optimize the transfer, respectively automatically of software to FPGAs or close the gap from code to chip floor-planning.
(ii) ML (Machine Learning)/AI (Artificial Intelligence): Machine Learning and Artificial Intelligence codes need a lot of resources, especially in training phases. The method can be used for example to (i) optimize already known codes, (ii) support code development, which adapt their complexity during runtime and therefore are hard to parallelize in advance (as the method always result in an optimized code), (iii) support upcoming, not on Neuronal Network based approaches (e.g. Genetic Algorithms, see e.g. Inside HPC Special *Report, AI-HPC is* Happening Now by R. Farber)
(iii) HPC (High Performance Computing) applications: As the method can translate code from e.g. python to a C code with MPI support libraries it can close gaps existing e.g. in different research fields (HPC to Al development). Another application could be adaptive mesh refinement implementations, used in numerical model software packages for engineering applications, weather prediction models, etc.. Or it can be used to combine models with different spatial and temporal resolutions (e.g. Computational Fluid Dynamic models and Agent Based models, etc.) and improve existing software packages in different fields, such as modelling and analytic software packages.
(iv) Automated business processes: The invention can also be used in process management, the decision if a unit should work on a task or transmit it to another unit is a well-known problem. For this problem the method shows an approach.
(v) Cloud, desktop operation system, virtual machines, deployment in general: Having a generic approach available, which «reduces» a code on the elementary needed operation and possible concurrent options, supports a wide range of solutions in the interface between software and hardware. This interface occurs obviously especially for any form of operating systems, virtualization and / or deployment of software or more concrete e.g. for virtualization solutions for cloud infrastructures, operating systems (with multicore systems), virtual machines to support mixing of different operating systems, or similar examples.
(vi) Heterogeneous platforms, (i) loT and edge computing: Heterogeneous platforms dominating the given situation in different fields, such as loT projects, autonomous driving, combined mobile and cloud applications and other forms of application running with and / or on a mixed hardware infrastructure. The method can adapt a code to decide how to optimal distribute data, computations and / or data communication on a platform. Furthermore, she can incorporate in the process of deploying / developing software for different properties of the hardware components of a given network of computing units and optimize a code to fulfil target properties, such as e.g. reducing latency for some parts of a software system.
(vii) Embedded systems: Embedded systems have high requirements for e.g. power consumption or other specific adaption for a given code, such as only reduced instruction sets on some micro-processors or similar challenges. The method can support this mapping directly, as she can optimize for given physical properties and results therefore in a most efficient code representation for any given code.
(viii) Self-optimizing algorithms: The invention allows a complete autonomous circle, meaning an algorithm can optimize itself on a given platform without any by-hand interaction. This enables new applications and fields, not known up till now.

### Brief Description of the Drawing

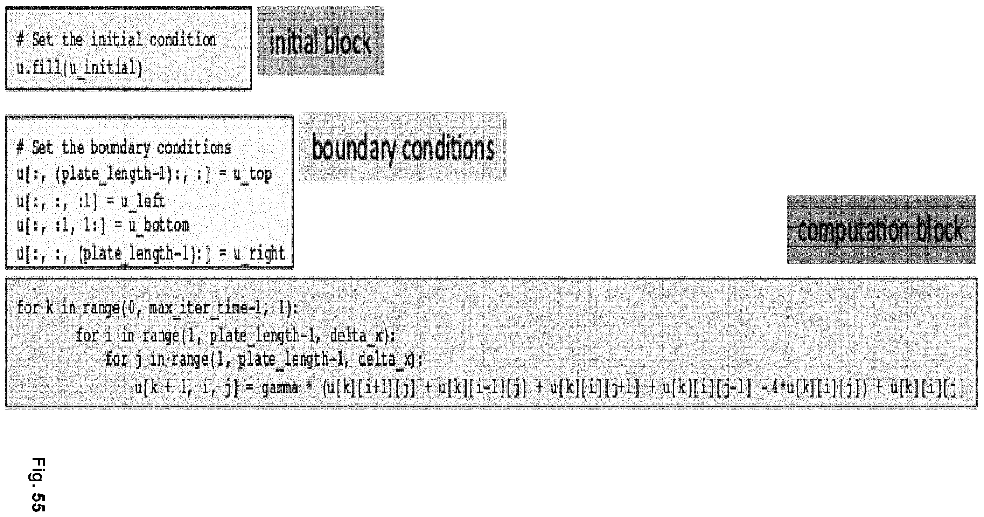

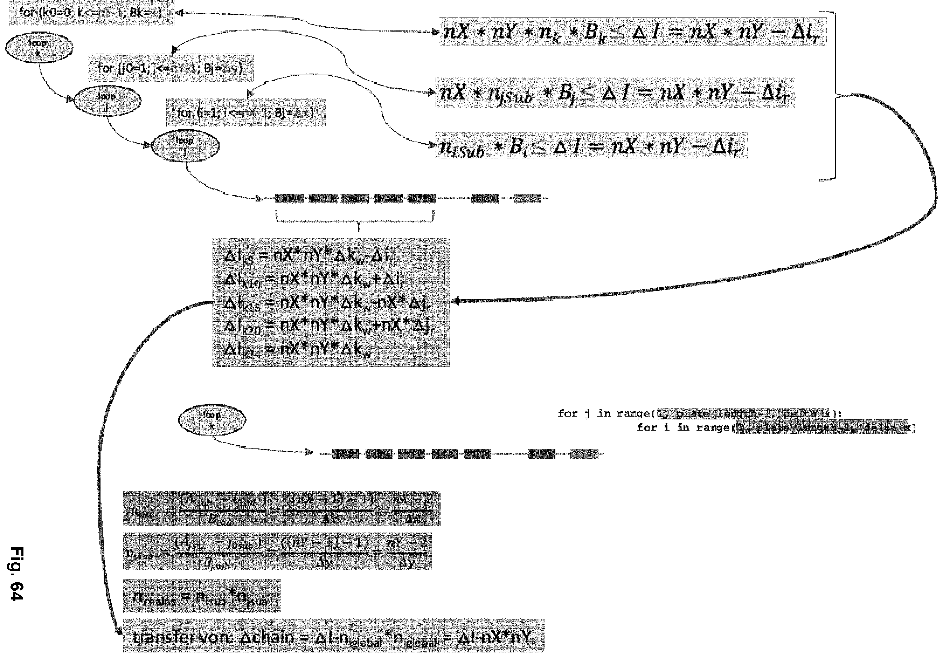

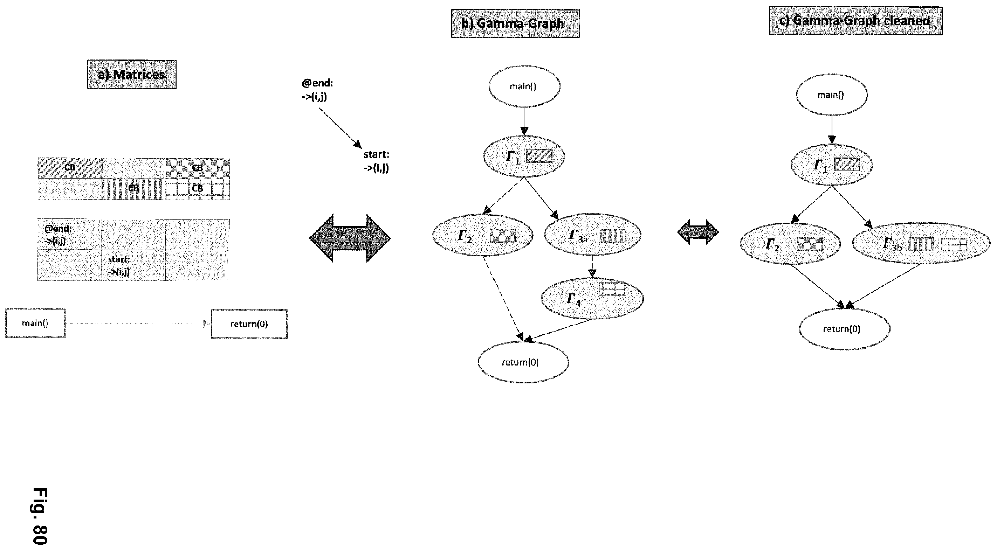

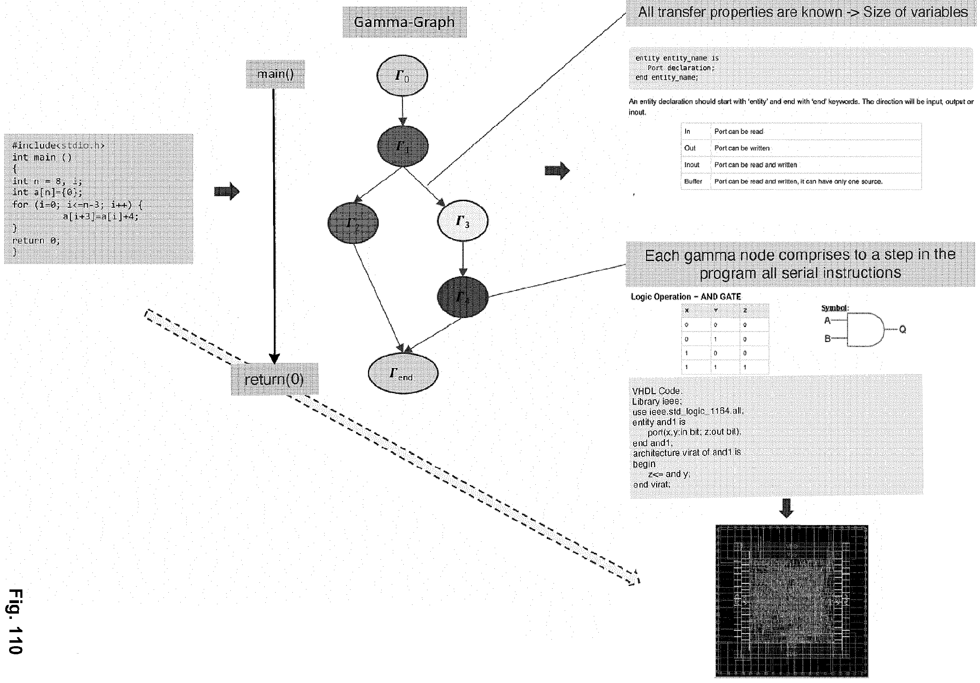

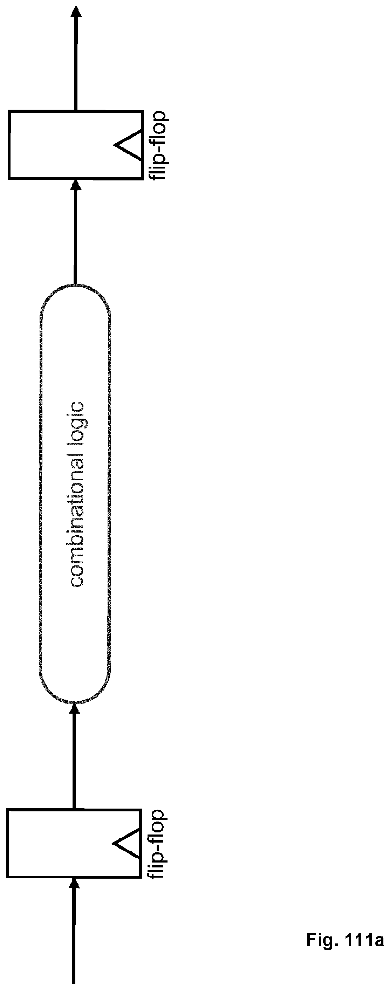

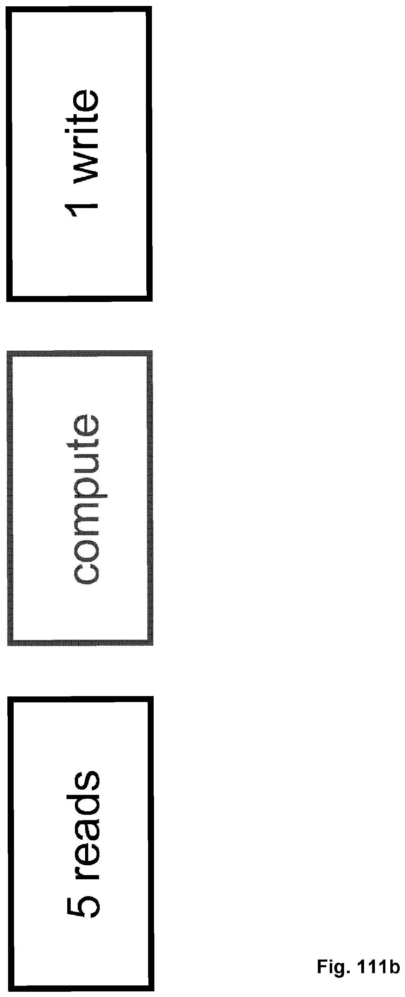

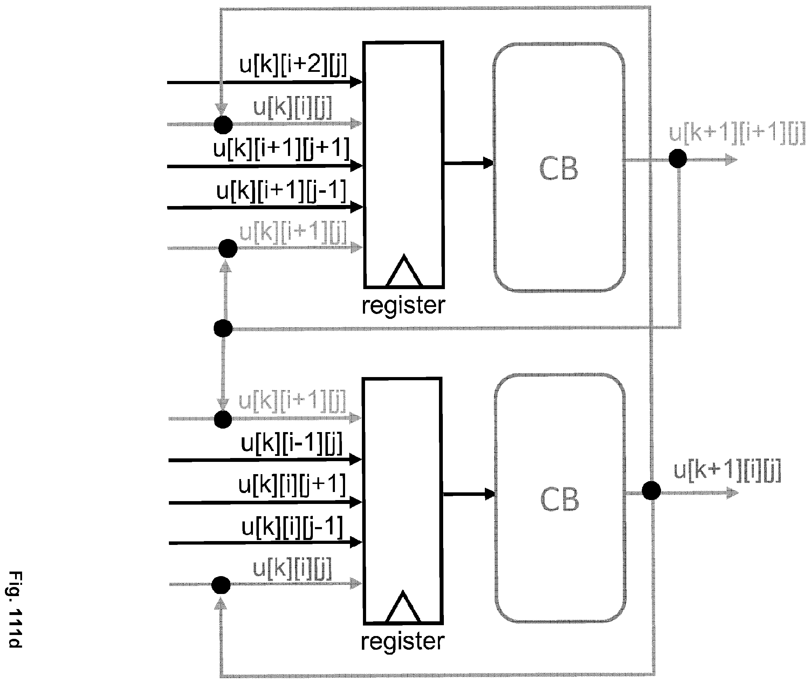

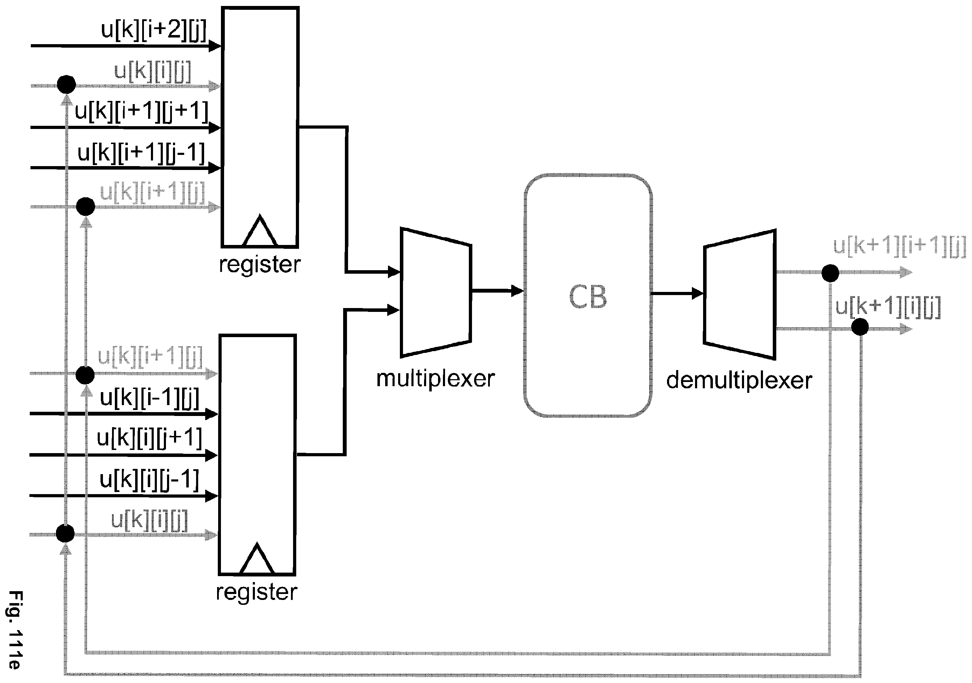

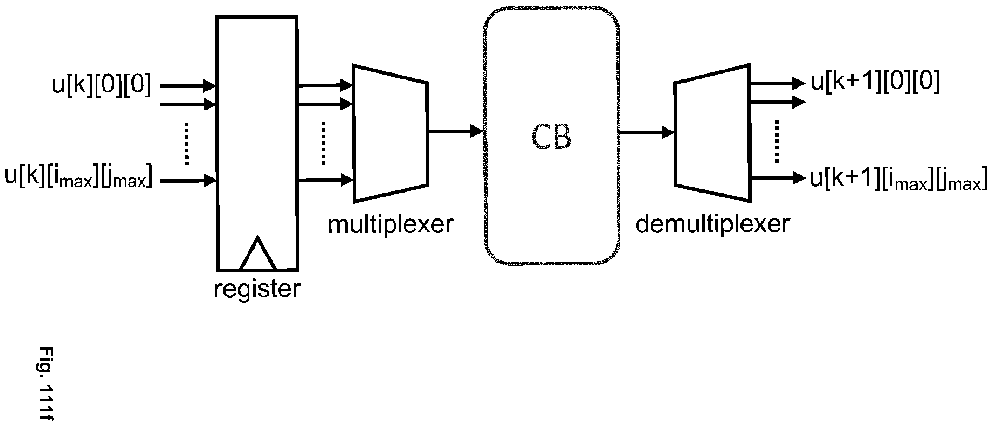

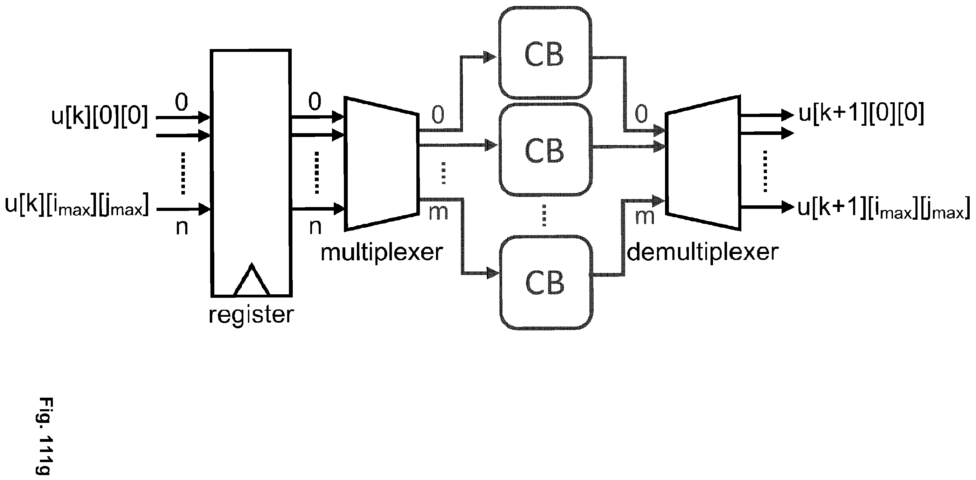

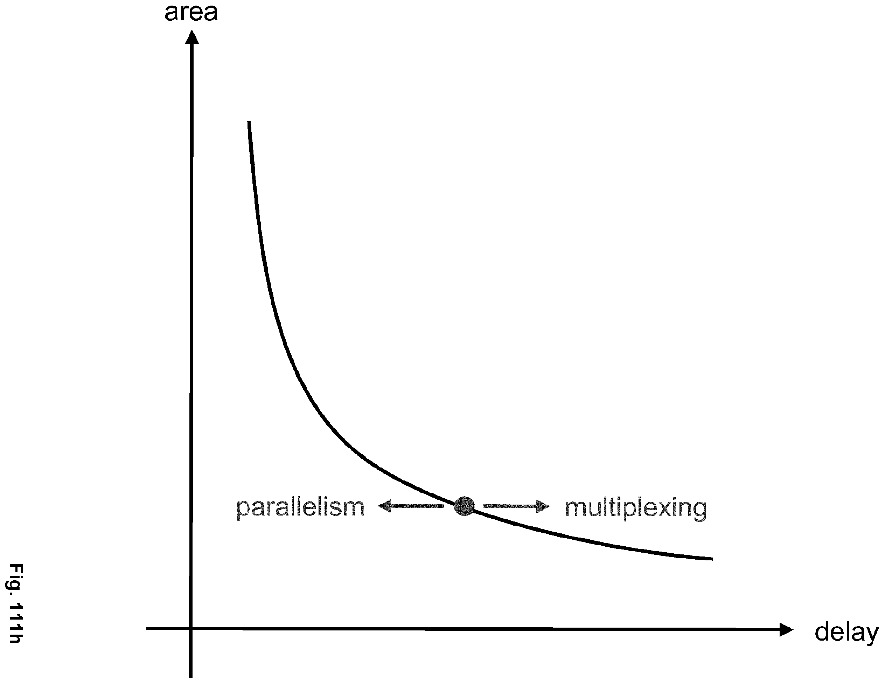

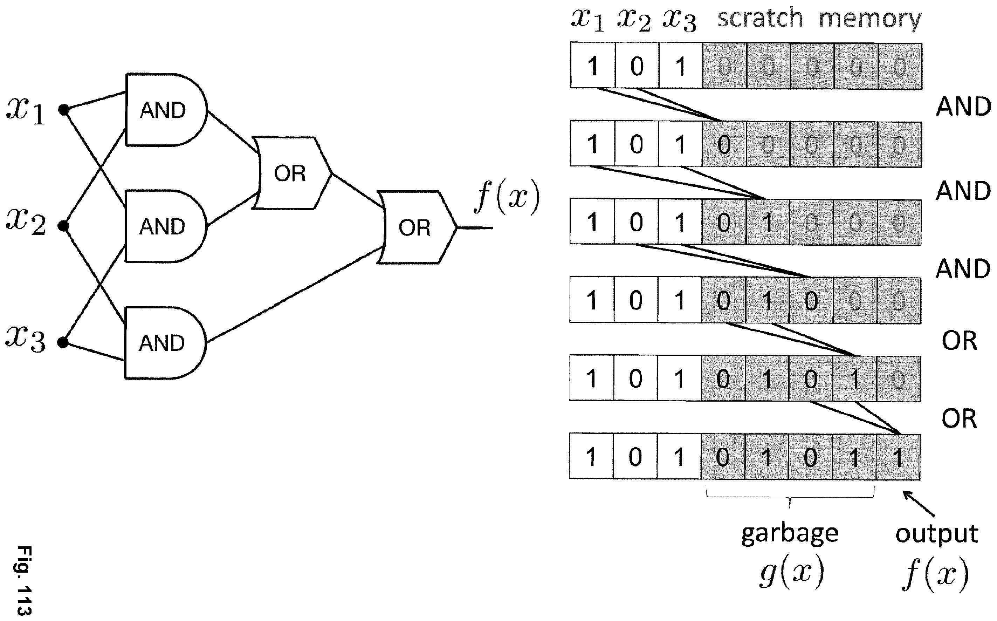

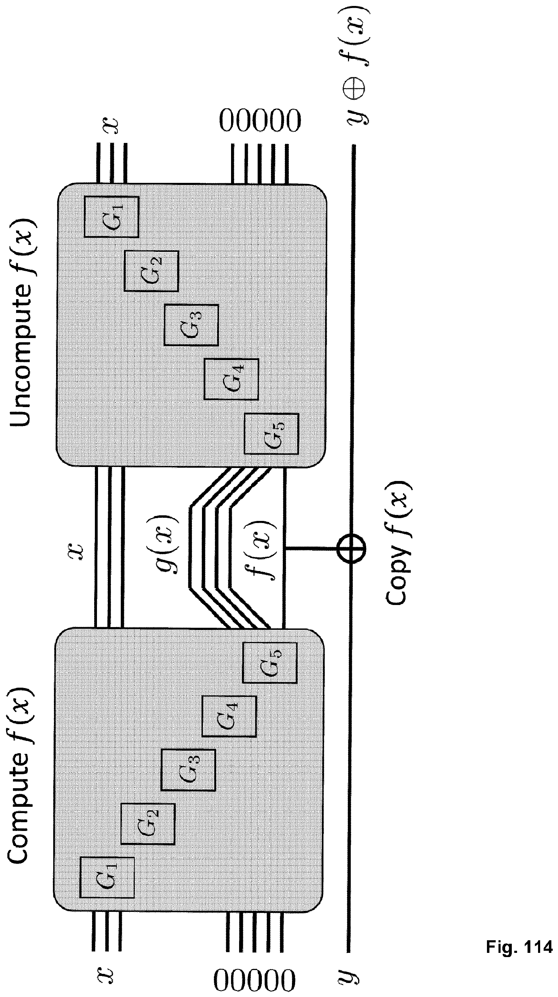

The present invention will be explained in more detail, by way of example, with reference to the drawings in which:
Figure 1 shows a diagram schematically illustrating the formation of latency times under different modern computation infrastructures. (Micro-) processors are based on integrated circuits allowing to perform arithmetic and logical operations based on two binary values. For this, the binary values must be available for the processor's calculating unit. A processor unit needs to get the two binary values to calculate the result of an expression a = b operand c. The time it takes to retrieve the data for these operations is known as the latency time. There is a wide hierarchical range for these latency times from the register, L1-cache, memory access, I/O Operation, or a network transfer, as well as processor configuration (e.g. CPU vs. GPU). As every single component has a latency time, the overall latency time for the calculation is a combination mainly of hardware components needed to get the data from one location to the other in a modern computation infrastructure.
Figure 2 shows a block diagram schematically illustrating shared memory multiprocessors as one class of parallel machines giving basis to the shared address programming model as top layer parallel programming. In the shared memory multiprocessors architecture, the assumption is taken that in this computer system a processor and a set of I/O controller are allowed to access a collection of memory modules by some hardware interconnection. The memory capacity is increased by adding memory modules and I/O capacity is increased by adding devices to I/O controller or by adding additional I/O controller. Processing capacity can be increased by waiting for a faster processor to be available or by adding more processors. All the resources are organized around a central memory bus. Through the bus access mechanism, any processor can access any physical address in the system. As all the processors are assumed to be or in fact equidistant from all the memory locations, the access time or latency of all the processors is same on a memory location. This is called a symmetric multiprocessor.
Figure 3 shows a block diagram schematically illustrating an UMA-architecture, In the UMA-architecture, all the processors share the physical memory uniformly. All the processors have equal access time to all the memory words. Each processor may have a private cache memory. Same rule is followed for peripheral devices. When all the processors have equal access to all the peripheral devices, the system is called a symmetric multiprocessor. When only one or a few processors can access the peripheral devices, the system is called an asymmetric multiprocessor.
Figure 4 shows a block diagram schematically illustrating a NUMA multiprocessor architecture. In the NUMA multiprocessor architecture, the access time varies with the location of the memory word. The shared memory is physically distributed among all the processors, called local memories. The collection of all local memories forms a global address space which can be accessed by all the processors.
Figure 5 shows a block diagram schematically illustrating a COMA multiprocessor architecture. The COMA multiprocessor architecture is a special case of the NUMA multiprocessor architecture, where all the distributed main memories are converted to cache memories.

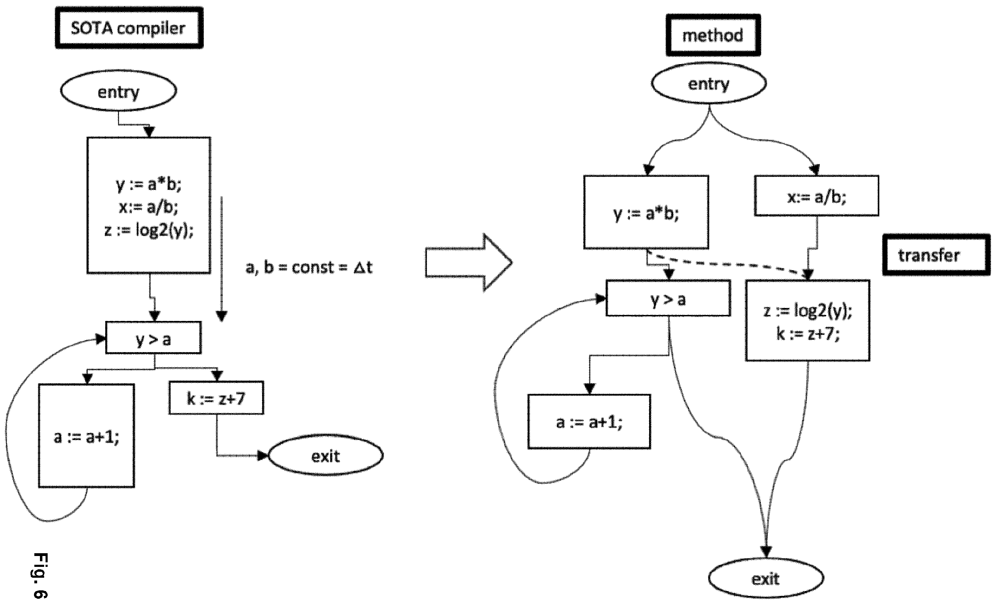

Figure 6 shows a block diagram schematically illustrating the different scopes of the units "basic blocks" (or "block units" respectively) and "computation block nodes" as schematic examples. "Computation block nodes" as used in the present application differ essentially from those block units, used in SOTA (State-Of-The-Art) compilers.

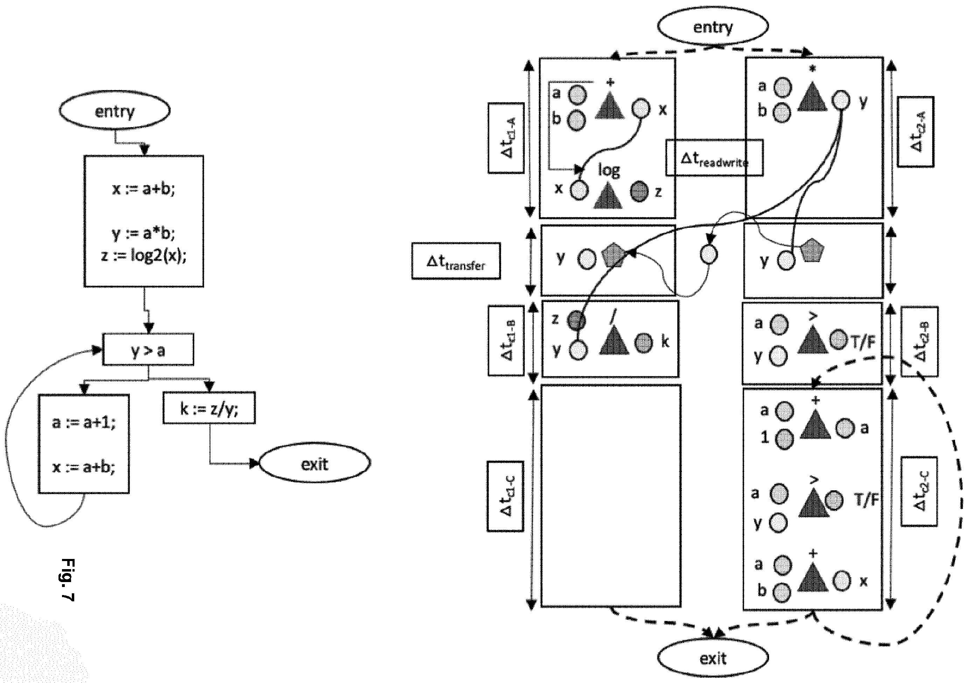

Figure 7 shows a block diagram schematically illustrating a simplified, but more realistic example, where the inventive method exploits the fact, that a logarithmic instruction (as an example on a modern CPU: FYL2X) needs much longer than a floating point addition and/or multiplication instruction (e.g. FADD, FMUL). The inventive method adds the statement 'x:=a+b' und 'y:=a*b' to two different computation block nodes (cbn), as both are based on the same information 'a', and 'b'. The 'log2(x)' statement is appended to the 'x = a+b' as it uses the information 'x'. The information 'y' is getting transferred, so the information is available to both, independent computation-chains.

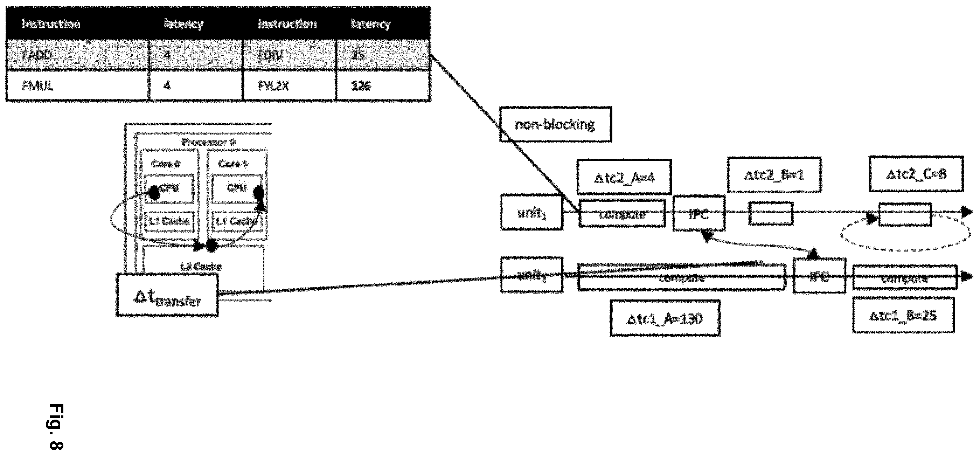

Figure 8 shows an example how the code from Fig. 7 is split to machine code executable on two computation units synchronized by any form of IPC (it has to be annotated, that IPC is meant more to be a communication between two computing units than "InterProcessCommunication"). The matrix indicates the needed clock cycles needed to compute the different machine instructions as an example how to get a value for the time to compute the instructions. In this form, it is visible in figure 8, that unit 2 can compute the long running instruction of the statement 'log2(x)' and unit 1 processes the loop with incrementing a ('a = a+1'), see figure 7.

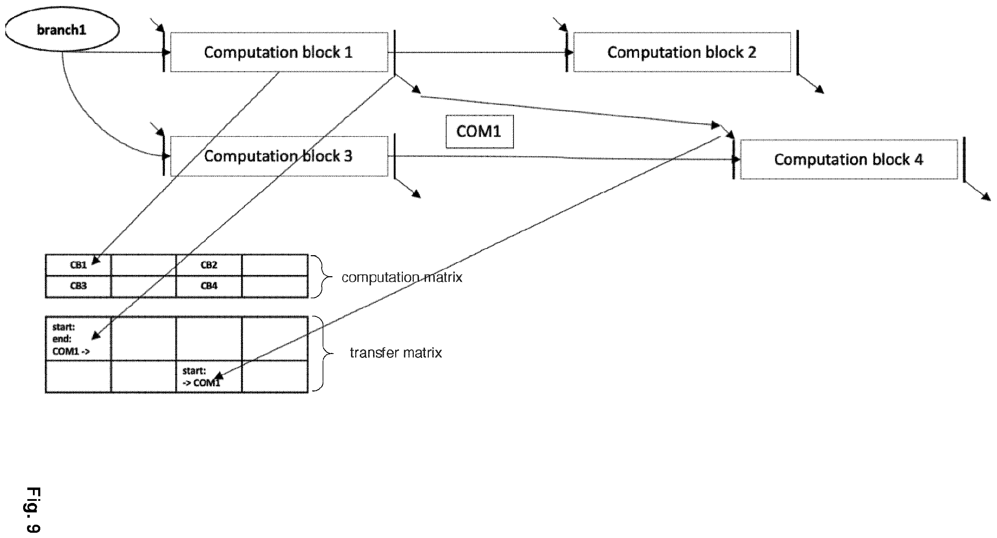

Figure 9 shows a block diagram schematically illustrating the inventive method forming out of a flow-graph of computation block nodes two matrices, the herein called "numerical matrices" (it is to be noted, that as a variant "numerical" as may also refers to text data for particular cases, since all data on an IT infrastructure can be understood as numerical on a low level, e.g. binary). One contains the instruction chains and in the other the possible transfer properties (from and to other computation block nodes). Therefore, the code extracted from the matrices always forms a pattern "compute -> communicate", as can be seen in detail in the following passages. Obviously, if code is mapped to one unit, the communicate part would vanish (and the computations (=chains of instructions) would sum up) and the inventive method would be reduced to the approach with "basic blocks", respectively can be handled with a SOTA compiler Furthermore, the matrices which represent a much more scalable form of accessing information than graphs, respective show the well-formed nature of the control flow graph. The definition of the computation block nodes (cbns) also indicates the generic nature of the inventive matrices: In one matrix, each row has an independent flow of instructions (= computations) and in the other, the needed transfers (= communications) to other cbns. In consequence, this ensures that a) no further information is needed to compute all instructions in a computation block node, b) the used information is nowhere else changed during the same computation step in the whole code and c) that only information is transferred not affected of computations during this time-step are possible.

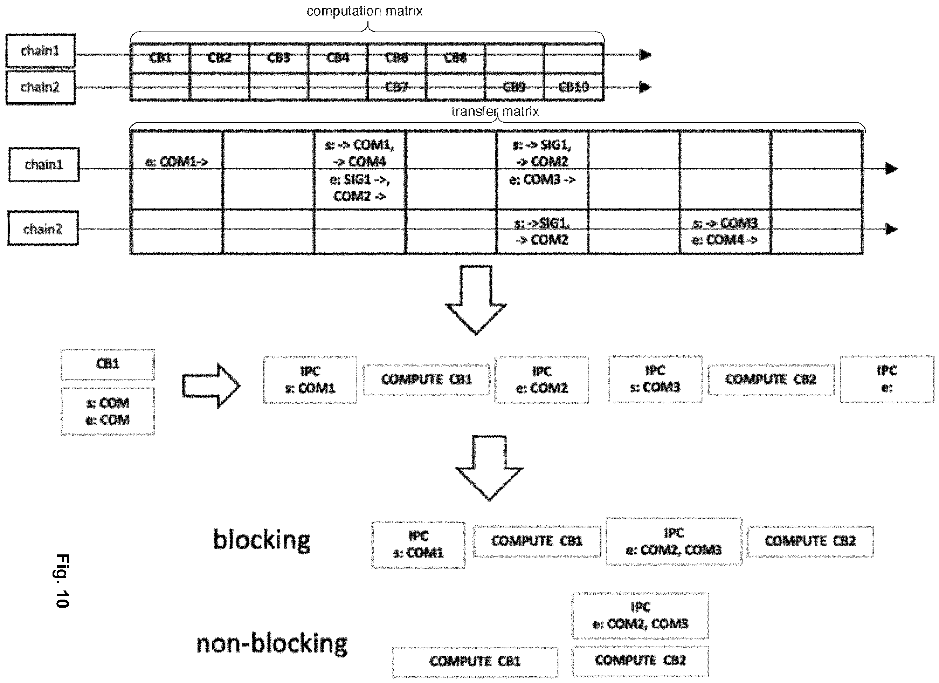

Figure 10 shows a block diagram schematically illustrating how each row of the computational and transfer matrix together, represents a combination of a chain of instructions and communication entries for one unit. Units are depending on the level of implementation (e.g. bare assembly, threads, processes, compute-nodes, etc.). Obviously empty computation cells or not used communication entries (empty cells in the computation and / or transfer matrices) vanish, as well as start- and end-communication link together as can be seen in figure 10.

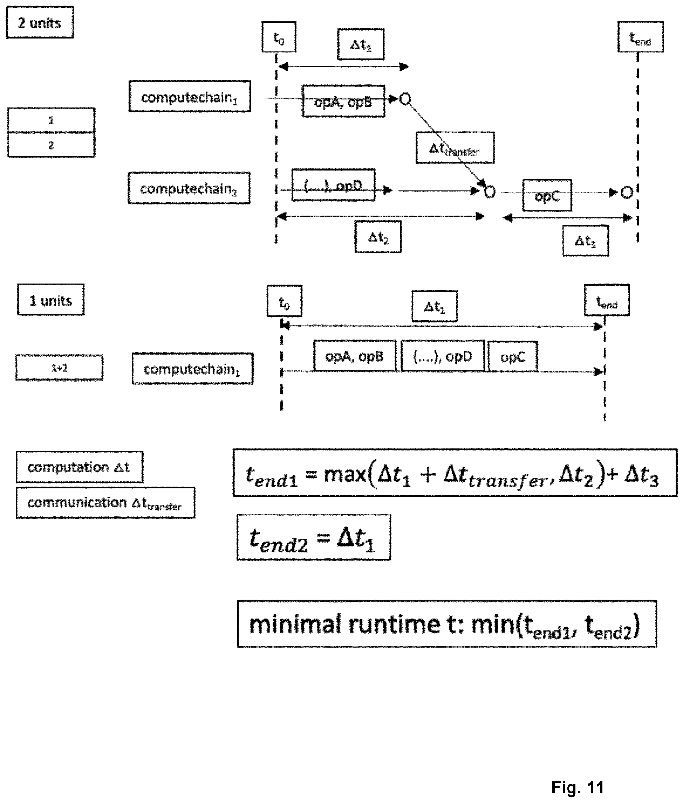

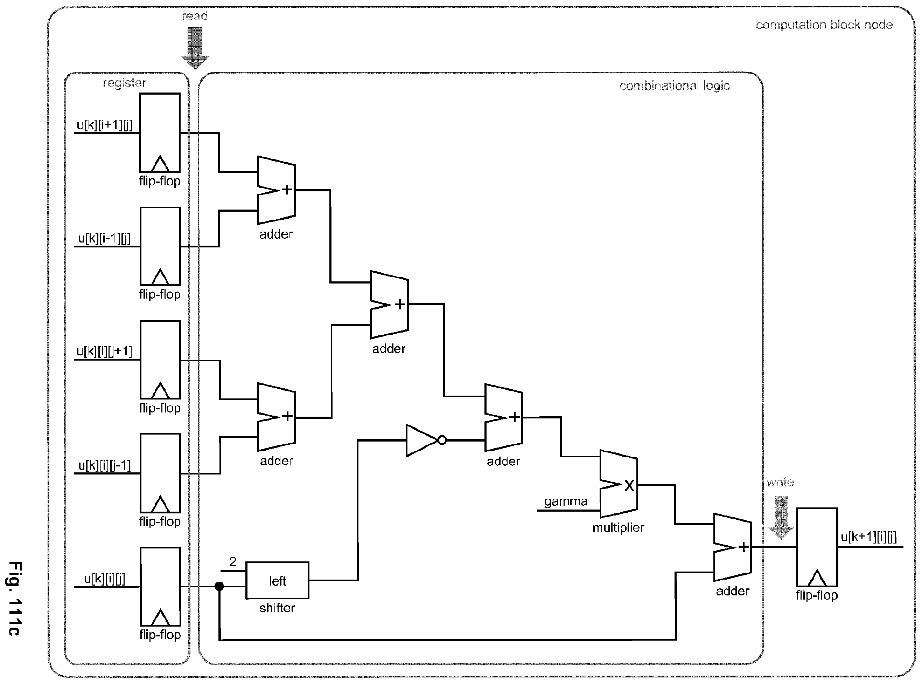

Figure 11 shows a block diagram schematically illustrating one possible optimization by the inventive system providing an optimized and ideal hardware to a technical computing and processing problem. The most obvious way for such an optimization is by building different combination of rows from the computation and the transfer matrices and each combination is one possible new, parallel/concurrent code (as the transfer on same units vanish and the computations sum up) and then assess its properties on the target infrastructure, as shown by figure 11 for a simple example.

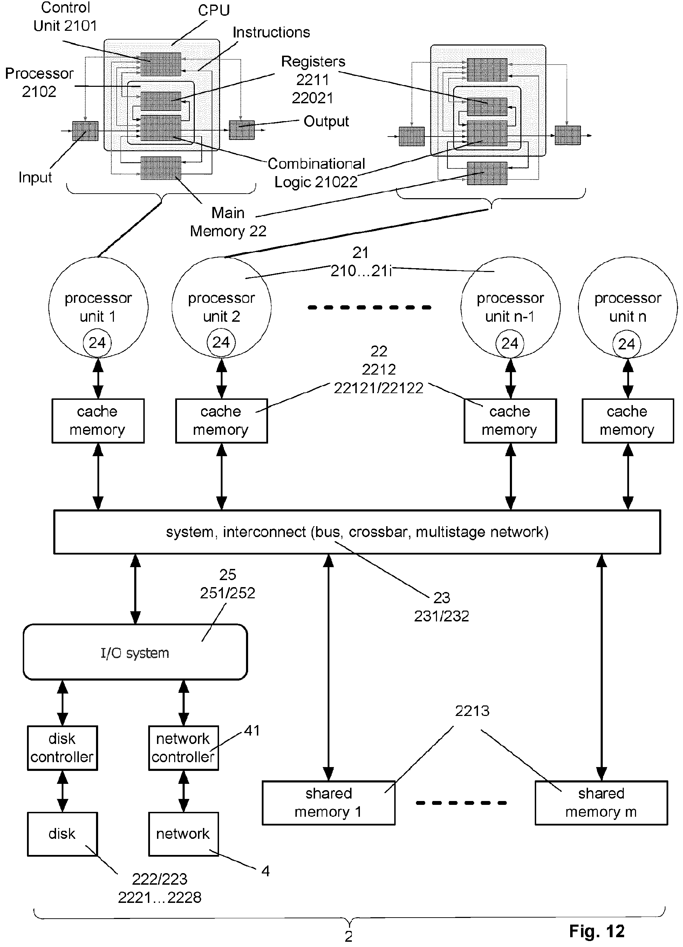

Figure 12 shows a block diagram schematically illustrating an exemplary multiprocessor system 2 having two or more processing units 21 (multiple processors) each sharing main memory 22/221/222/223 and peripherals 25, in order to simultaneously process program codes 3.

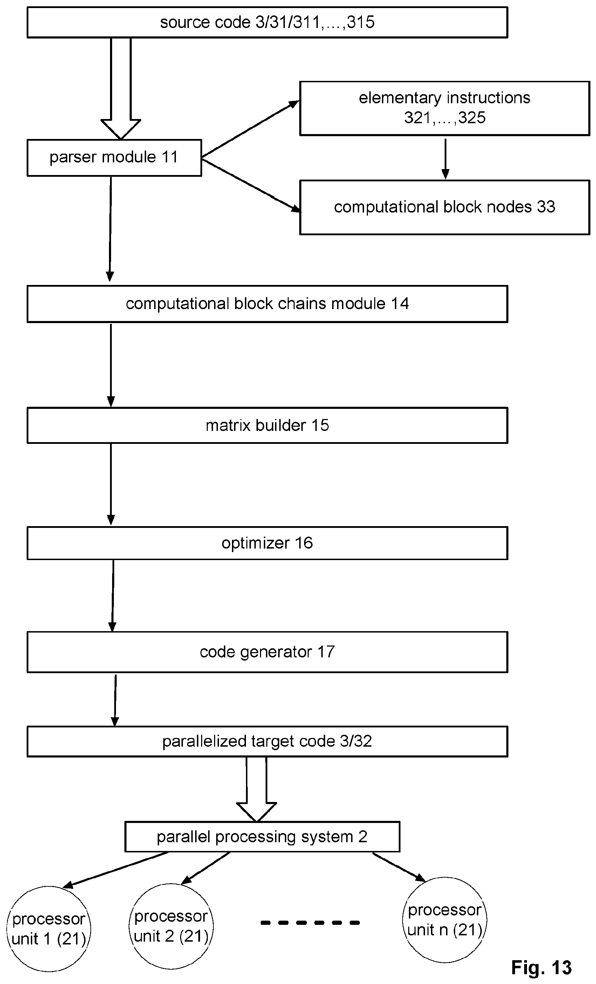

Figure 13 shows a block diagram schematically illustrating an exemplary embodiment variant according to the present invention with the source code 31 as input code to the auto-parallelizing compiler system 1 comprising the parser 11, the computational block chains module 14, the matrix builder 15, the optimizer 16, the code generator 17, the auto-parallelizing compiler system 1 generating the parallelized and optimized target code 32 as machine or assembler code for execution by the parallel processing system 2 having a plurality of processing units 21 according.

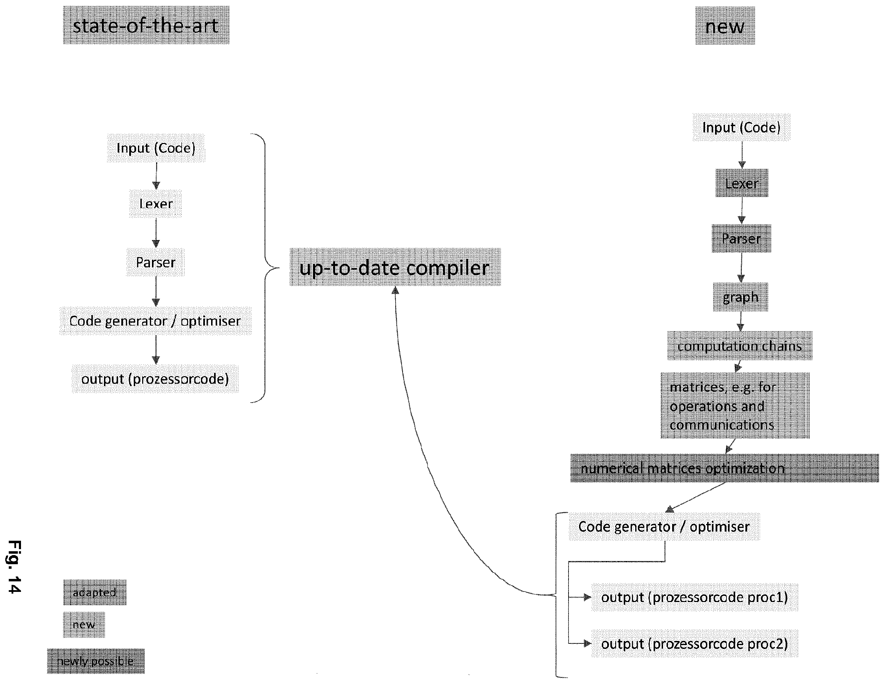

Figure 14 shows a block diagram schematically illustrating an exemplary compiler system as known by the prior art systems, in comparison to the inventive auto-parallelizing compiler system 1.

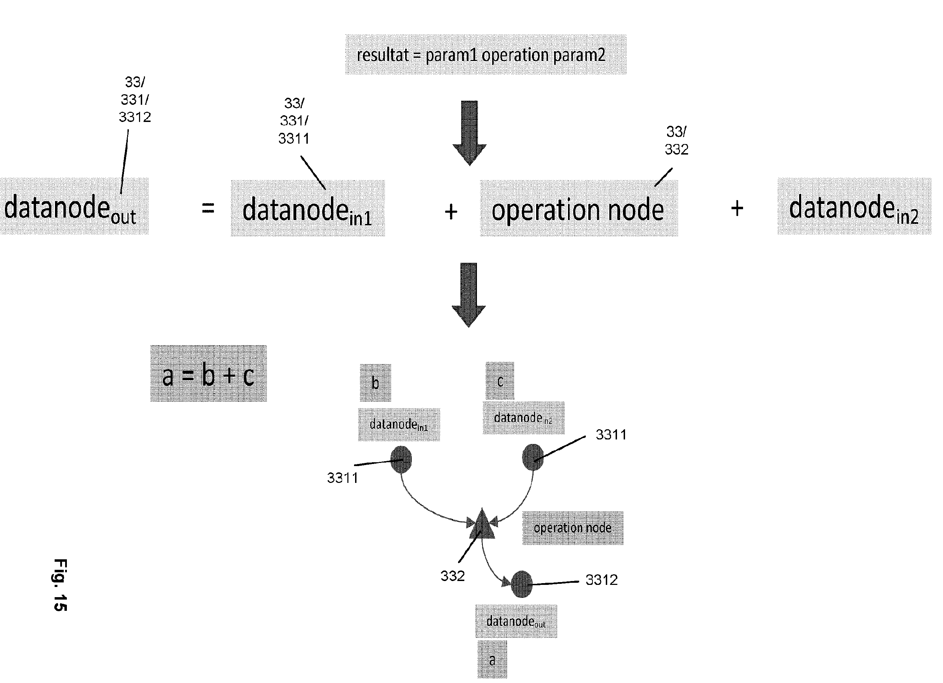

Figure 15 shows a block diagram schematically illustrating exemplary basic elements for a tree structure and/or computation graph, respectively. The computations are reduced to one type of a statement: result = param1 operation param2. The numerical operands are +, -, *, / -> from a numerical point of view these are the only ones. Within source code 31 as high level language, values are assigned to variable in the form of variablename = value. This is a link to a "virtual" place (at variablename) to save a value. The source code 31 is normally sequential - this is how a programmer thinks. According to the invention, the code is differently approach seeing the code as savelocation₁ = savelocation₂ operation savelocation₃. Based on this, basic graph or tree structure elements are here introduced with e.g. two input data nodes 33/331/3311 (datanodeᵢₙ₁ and datanodeᵢₙ₂), an operation node 332 and an output data node 33/332/3312 (datanodeₒᵤₜ). They are connected with directed edges as seen in figure 15. A node 33, as used herein, is a basic unit of a data structure, such as a sequence of linked processor instructions (computation block node 333/operation node 332) or tree data structure, as a data entry or data output structure (datanodeᵢₙ/datanodeₒᵤₜ). Nodes 33 contain data and also may link to other nodes 33. Links between the nodes 33 are often given in the graph of figure 15 by pointers (arrows).

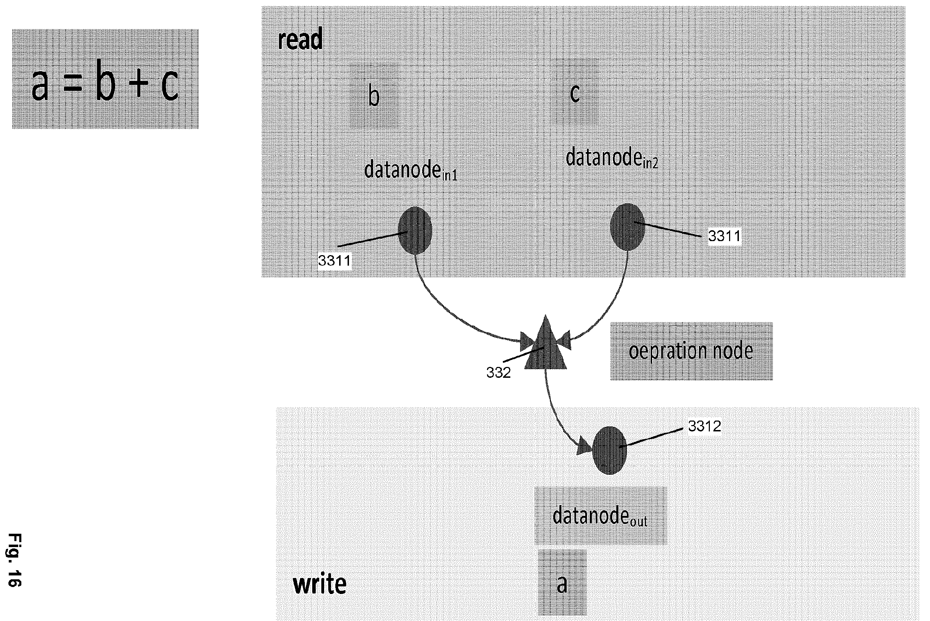

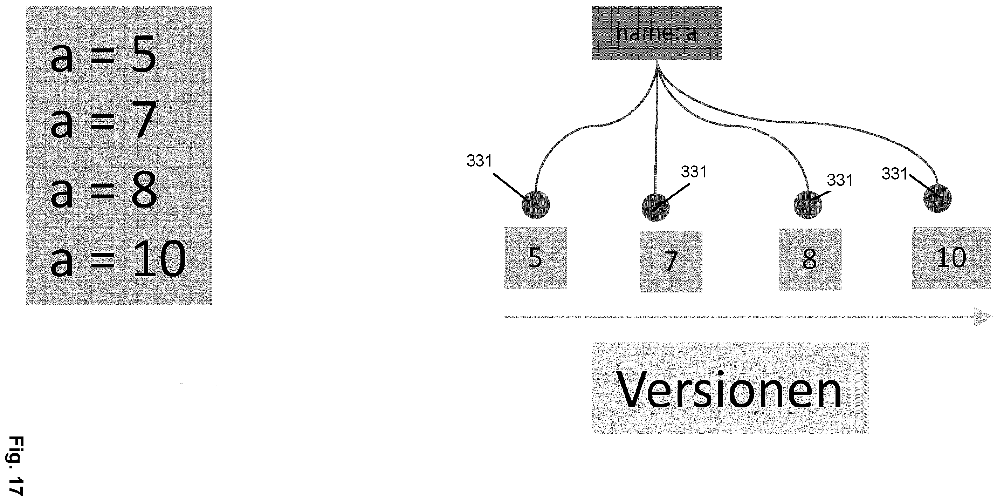

Figure 16 shows a block diagram schematically illustrating exemplary the basic elements of the source code. In the lexer and parser 11, operations from the higher language are reduced to the basic graph or tree structure elements. So it becomes possible to use: (i) arithmetic operations: +, -, *, /, (ii) logical expression like a condition: a == b or a >= b or similar leading to a true or false output, (iii) variable assignment name = value, (iv) flow control operations as (1) branch expression such as if (condition) {block1}, and (2) loop expression like loop (condition: incremental variable: maxᵥₐₗᵤₑ for incremental variable) {block1}. Here a similarity exists to the basic operation in assembler code, the instruction sets in a processor 21, which have normally 3 parameters. A statement and a basic graph element describe two read (datanodeᵢₙ₁ 3311 and datanodeᵢₙ₂ 3312) and one write access (datanodeₒᵤₜ 3312) after an operation (operation node 332). Multiple assignments to a variable name create versions of this variable and create different data nodes 331. As figure 17 shows, each version builds a new data node 331.

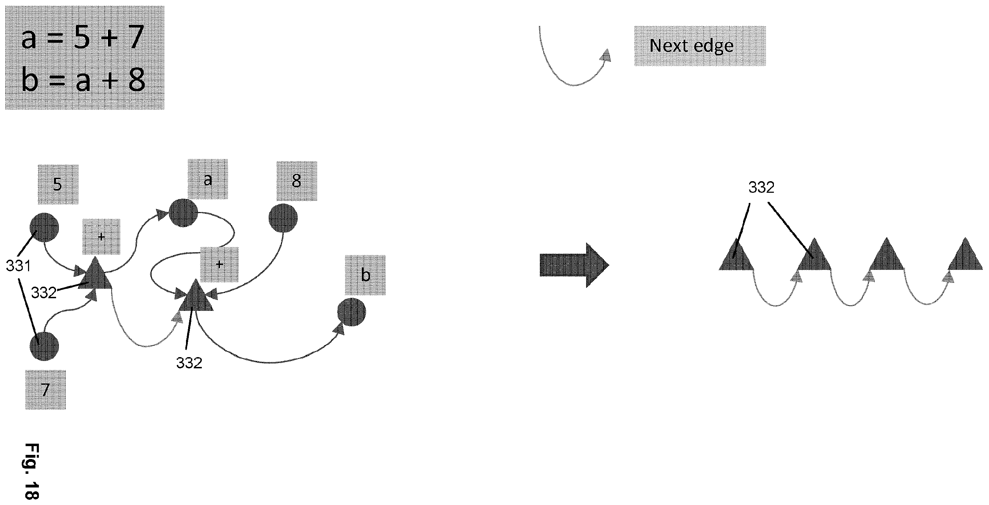

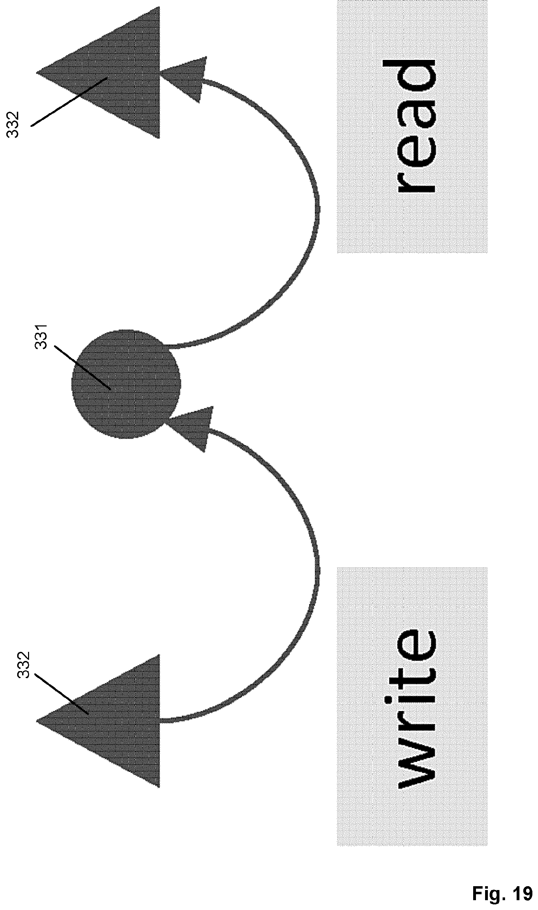

Figure 18 shows a block diagram schematically illustrating exemplary simple sequence of operations 332 in a tree structure or graph. Statement-by-statement, the sequence of the program code 31 can be added to the tree structure or graph. Complex expressions are reduced (by the need to reduce computation on a binary computing system to such a form) to a series of expression of type result = param1 operand param2. If an operation node 332 accesses a data node 331 to which another operation node 332 is writing, then the building a sequence is started by connecting these operation nodes 332 by a directed edge (next-edge). Write and reads are mapped by this method in the tree structure or graph for all data nodes 331 (see figure 19). As a rule to simplify the following steps, only 1 write is allowed to a data node 331 (this helps to simplify later operation to the graph). Otherwise a new operation 332 is introduced to model several writes to a data node 331.

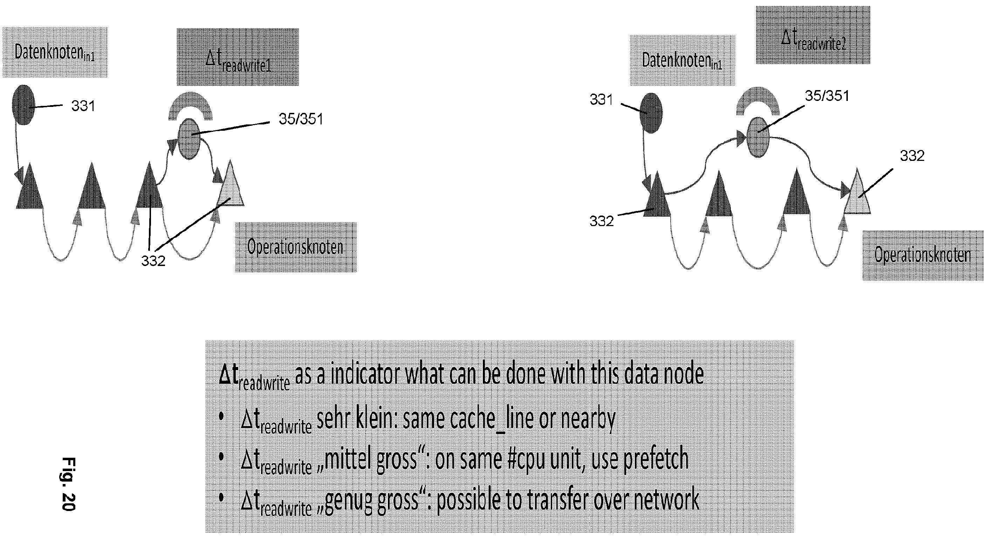

Figure 20 shows a block diagram schematically illustrating exemplary how △t_{readwrite} 35/351 describes the time, which lies between a write access and a read access to a data node 331. With this interpretation, the latency time △t_{readwrite} 351 can be viewed as a number which expresses the time the data node 331 has to be transferred to another process in the multi-processing system 2. The interpretation of △t_{readwrite} 351 depends on the level of the hardware setup. It is the technical and physical based time between a write access 3311 (I/0 process, network card or similar) and the read access. △t_{readwrite} 351 is a unit given by the hardware infrastructure. △t_{readwrite} 351 can be composed of different △t's: △tₜₒₜₐₗ = △t₁+ △t₂+ △t₃+ △tₙ (e.g. L1-cache access - memory access). For a 1-dependency (operation node read from 1 dependent datanodeᵢₙ) △t_{readwrite} 351 is given, respectively must be very short. It is to be noted, that other problems come up, if there are 2-dependencies, which is discussed below.

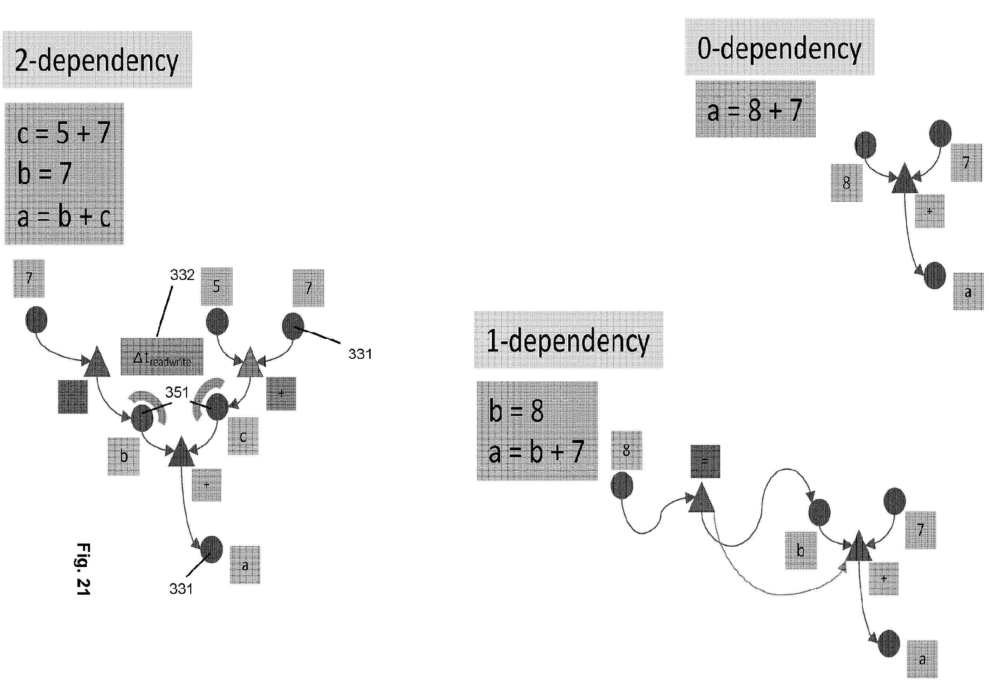

Figure 21 shows a block diagram schematically illustrating exemplary the dependencies for basic tree structure elements and graph elements, respectively. As a variant, it makes it easier if the rule is set, that only one operation node 332 writes to one data node 331. Then there exist different, but finite situations to add a new operation node 332 in a sequence: (i) 0-dependency: placement: independent, (ii) 1-dependency: placement: after the dependent operation node 332; (iii) 2-dependency: - unclear -> △t_{readwrite} 351 for both data node 331 (in1 3311 and in2 3312) are dependent of the history of their previous operation nodes 332; - At this point, to find △t_{readwrite} 351, the history of all preceding △t_{readwrite} 351 of datanodeᵢₙ₁ 3311 and datanodeᵢₙ₂ 3311 must be known. This history of △t_{readwrite} 351 has to be placed in contrast to a △t_{latency} 352, which is the time which is needed to distribute an information or data point to another location through the system 2.

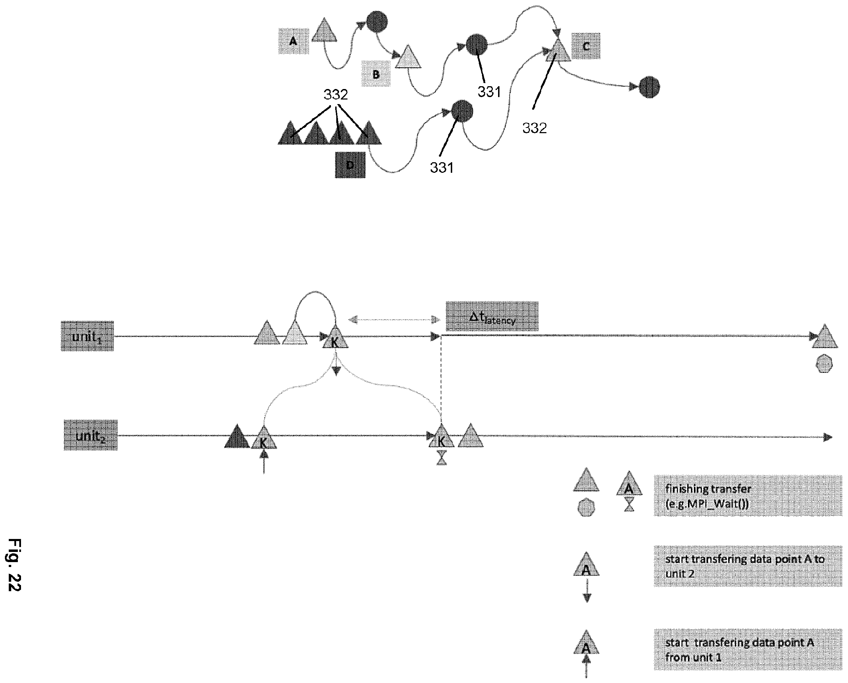

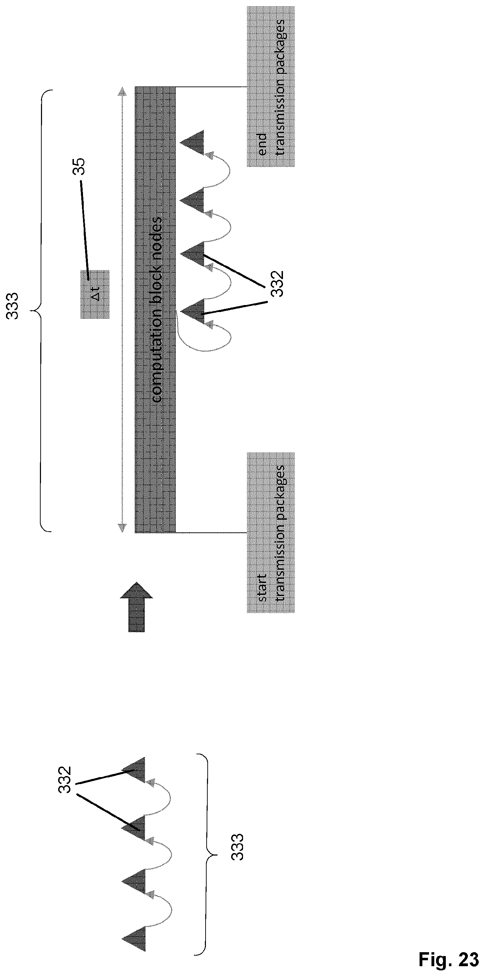

Figure 22 shows a block diagram schematically illustrating exemplary how data/information can be considered, e.g. it is possible to transfer data from one process to another, or in case of threading, e.g. it is possible to prevent same time writing. Moving data can be seen, for example, as elementary operations (operations K) and a transfer would be △t_{latency} 35 long. It is important to note that the interpretation of △t_{latency} 35 is strongly dependent on the hardware system and can be seen as the time to transfer data/information through the system. Further, during this time operation nodes not affected by the transfer can be computed, if the system allows this, e.g. in the case of a Direct Memory Access (DMA) network transfer. Or in case of a multithreaded system 2 (where two or more processes have access to the same data, but race conditions are critical) this △t_{latency} 35 can be seen as a block time, where one process reads/writes the corresponding data and no other is allowed. A transmission (see figure 23) can be seen to transfer information or data through the system 2 from a source to a target location. A transmission is not yet a clearly defined pattern (e.g. send and receive) and not given if it is needed in the final code, respectively is not vanished. This only can be done after optimization to the corresponding platform/hardware infrastructure.
Figure 23 shows a block diagram schematically illustrating exemplary computation block nodes 332/ CB1, CB2,...,CBx. Computation block nodes 333 can be introduced as follows: (i) computation block nodes 333 consist of connected operation nodes 332, (ii) operation nodes 332 are composed in one chain 34, (iii) computation block nodes 333 can be connected to next computation block nodes 333 or to control flow nodes 334, e.g. branch nodes 3341, (iv) △t_{computation} 352 is the time to compute all operation nodes 332 (representing instructions) in a computation block node 333, (v) it has a minimum length: △t_{latency} 35. During this time, it is possible to transfer data in the computation infrastructure, and (vii) for describing a communication, the transmission is introduced consisting of: (a) source: location in computation block node 333 (start, end), computation block node 333 id, operation node id, datanode_{in1/}datanodeᵢₙ₂ 3311 or output data node 3312, (b) *target:* location in computation block node 333 (start, end), computation block node 333 id, operation node 332 id, datanode_{in1/}datanodeᵢₙ₂ 3311 or output data node 3312. Transmission must not be explicitly sending and receiving information -> computation block nodes 333 can start sending and/or receiving data information at the beginning and end of the block 333 (before and after all operation nodes 332 are computed) -> this models would typically be applied in explicit non-blocking sending and receiving communication methods (e.g. Message Passing Interface (MPI)), where it can be possible to send and receive independently of computations (e.g. by Direct Memory Access (DMA) network cards). But block sending and receive work in the same way by explicitly introducing operation nodes with a send and receive operation (and then have own △t_{readwrite} 351). If no communication is allowed, e.g. in a multithread approach (threads sharing same data, but time dependency only can be guaranteed by lock-mechanisms), the send and write can be interpreted as lock set and release and the △t_{latency} 351 has to be interpreted accordingly.

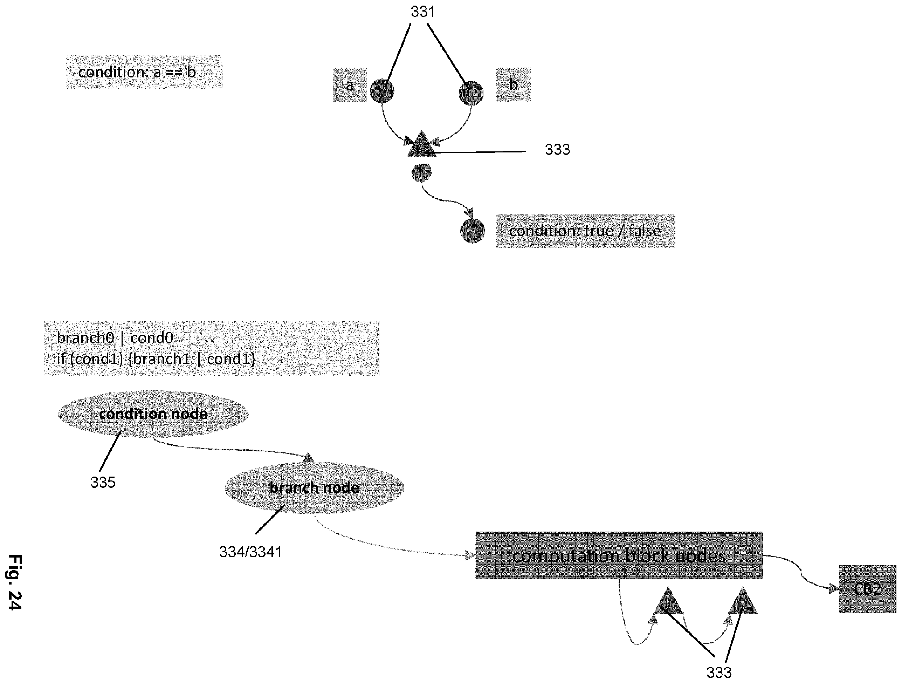

Figure 24 shows a block diagram schematically illustrating exemplary the handling of program flow control elements in a tree structure or graph. The condition nodes 335 are realized based on that (i) each condition in an if condition or loop condition creates a new "level", e.g. cond:0 -> cond:1, (ii) each condition knows how many levels between the own level and the base level of a program (condition 0) are given (e.g. by cond:0 -> cond:1 -> cond:2 which means 2 condition were computed to come to this location in code), and (iii) conditions nodes 335 are connected to branch nodes 334/3341 with same condition by a directed edge. Further the branch nodes 3341 are introduced: (i) each condition has at least one branch node 3341, (ii) each branch node 3341 is connected to computation block nodes 333 belonging to this branch (code in section of if clause). The condition results from an operation node 332 with a (logical)expression with "conditional" result such as true or false. The introduction of conditions is one way to make it possible to decide to which computation block node a new operation can be assigned in the "earliest" way (the computation block node must be in the group of the same condition level but can be in another branch node). It has to remark here, that branch nodes do not correspond with a block in a branch in the definition of "basic blocks".

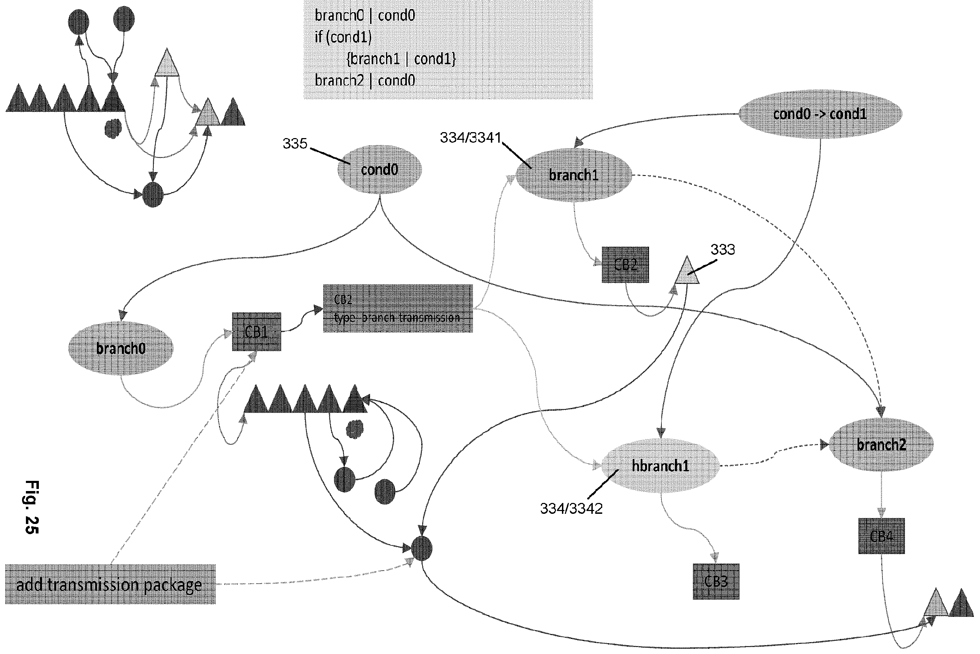

Figure 25 shows a block diagram schematically illustrating exemplary the handling of *"if statements".* If-statement leads to branching of the code under one condition (if (condition) {codeA}). As the result of the logical condition expression needed to be transferred in the system -> add a following, empty computation block node 333 after the computation block node 333 of the operation node 332 with the logical command in it -> this is the time needed to transfer the result of the comparison (meaning the condition) to other processes -> it can be used to compute other things - this computation block node 333 can be marked as a branch-transmission type (CB2). After this, CB2 333 two directed edges are added to a new branch node with new computation block nodes for code in the branch1 and a so called hidden branch node (see below) which will be used if condition is not fulfilled (but it is NOT the else clause, however, it can be the else clause). The result of the condition expression has to be transferred to the following branches -> a transmission package is added to the end of CB1. Edges from branch node and hidden branch node 3342 can be set only after parsing all the statements in the branch code section, so after the closing-statement for the if condition (see below).

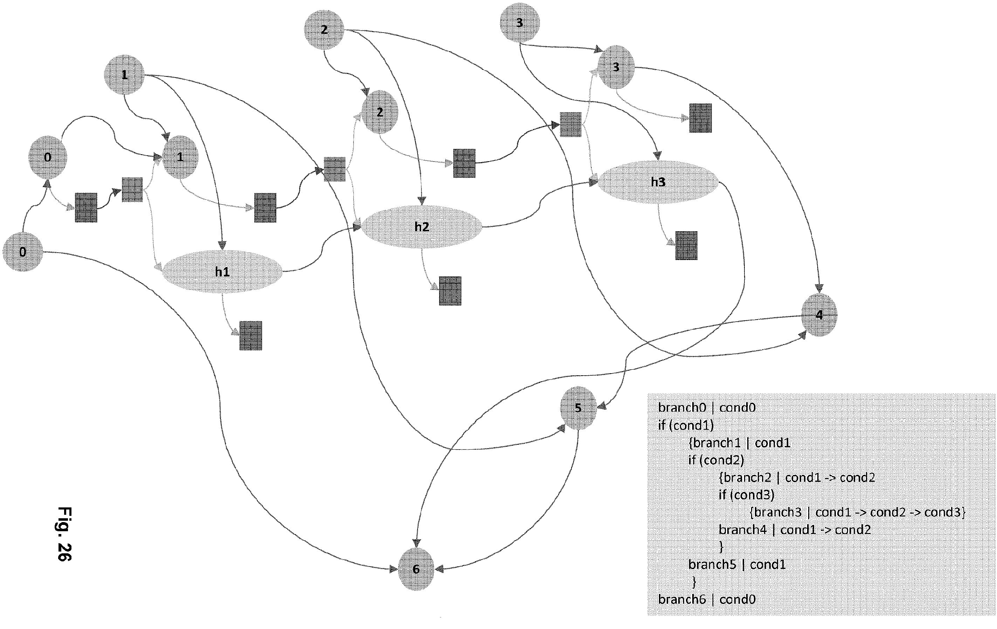

Figure 26 shows a block diagram schematically illustrating exemplary the handling of nested *"if statements".* As each statement in the code is added to the graph in the sequence it is read in, the control edge connection between branch nodes 3341 and following branch nodes 3341 can only be done after reaching the closing marks for an if statement -> nested if statements. The correct condition node 335 with the correct branch node 3342 can be found by calculating the last condition level (this is decreased with a closing if statement) and by traversing the graph to the correct nodes 33.

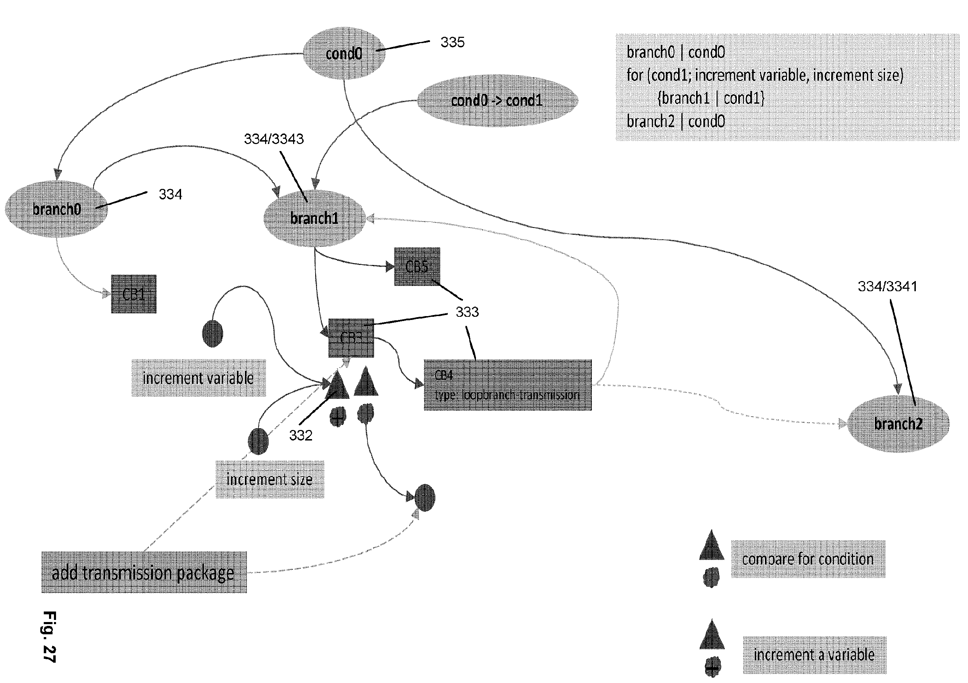

Figure 27 shows a block diagram schematically illustrating exemplary the handling of "loop statements". It is to be noted, that according to the branching illustrated above for if statements, loop statements can be handled with some adaptions. Loop-statement leads to branching of the code as long as one condition is fulfilled, in this example by incrementing a variable till a certain value is reached (loop (condition, i, 2) {codeA}). This is the same as for if-statement -> add CB4 333 for transmission with type loopbranch-transmission. An increment operation node 332 is added to the variable defined in the expression. The result of the condition expression has to be transferred to the following branches -> a transmission package is added to the end of CB3 333. Edges from computation block node 333 with type transmission and the branch node 3341 (branch2) after the loop branch node 3343 (branch 1) can be set only after the closing-statement for the loop statement (see below) was reached.

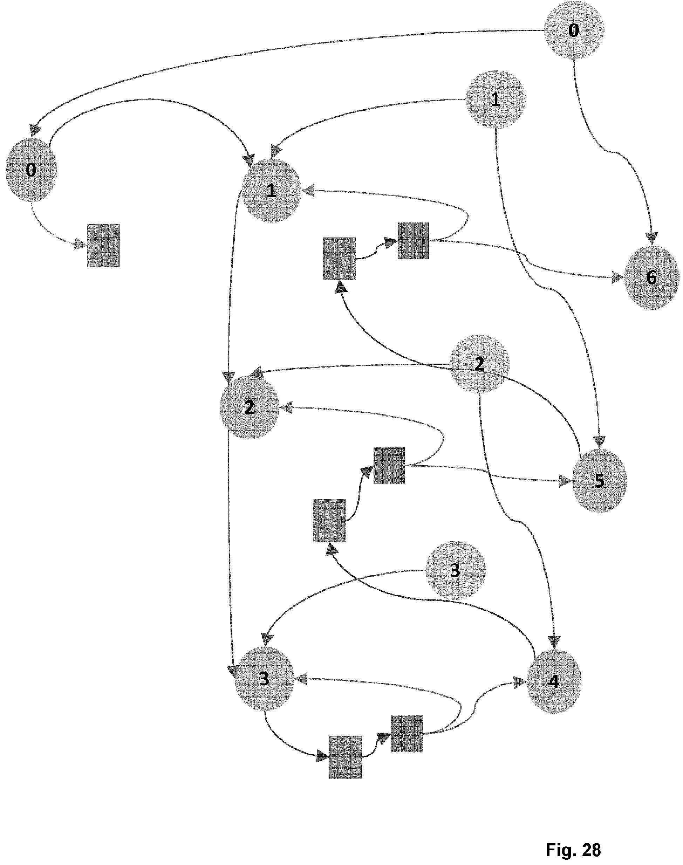

Figure 28 shows a block diagram schematically illustrating exemplary the handling of nested loop statements. As each statement in the code is added to the graph in the sequence it is read in, the control edge connection between computation block node 333 with type loopbranch-transmission and following branch node 3341 can only be done, after reaching the closing marks for a loop statement -> nested loop statements. This can be done by finding lower condition levels based on the last added statement and finding the correct loopbranch transmission node 33. The computation block node 333 with the compare and increment operation nodes 332, as well as the computation block node 333 of type loopbranch-transmission has to be reconnected to the branch node 3341 of the earlier loop. As well as the branch nodes connection after the loop have to be updated 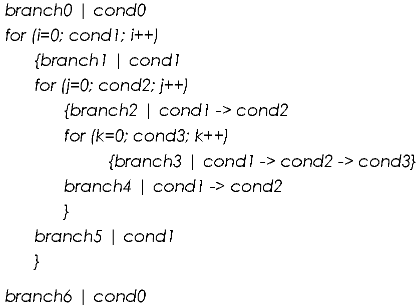
In regard to variable assignment, assignments are also operation nodes, but for a=0 and a=b with only one data node (in1) instead of two (in1 and in2): (i) a = 0 ( --> variablename = number): - 0-dependency and 1-dependency can happen, (ii) a = b: - a copy operation node has to be added, as you explicitly copy the data from data node to another data node with correct version number, - has to be a 1-dependency, (iii) a redefinition of a variablename leads to a new version of the variable and a new data node 331. Further, array and pointer variables can be handled in a similar way.

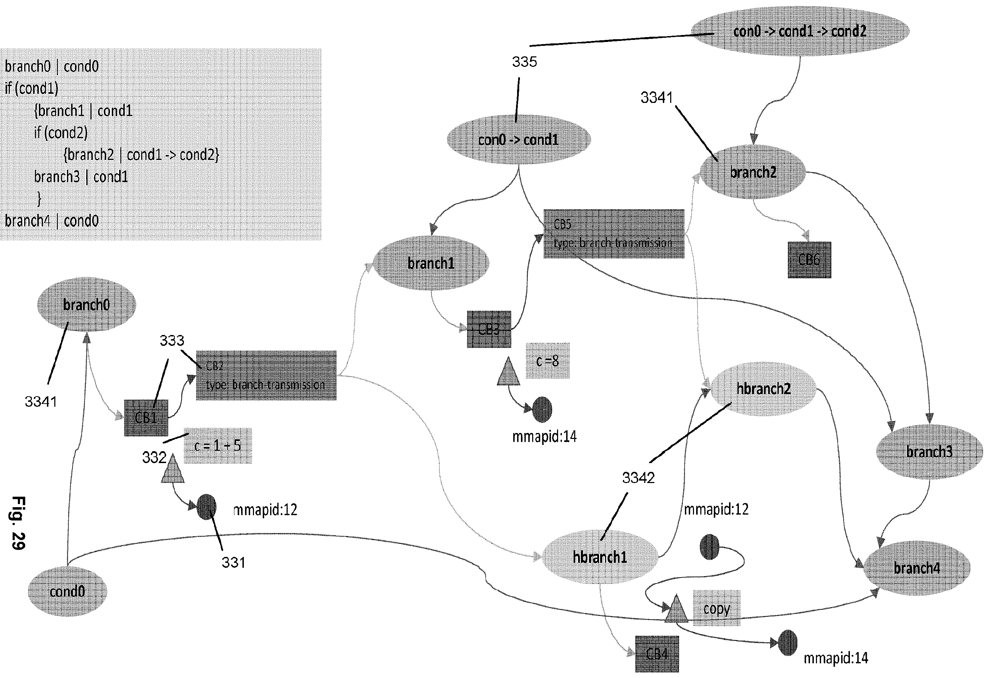

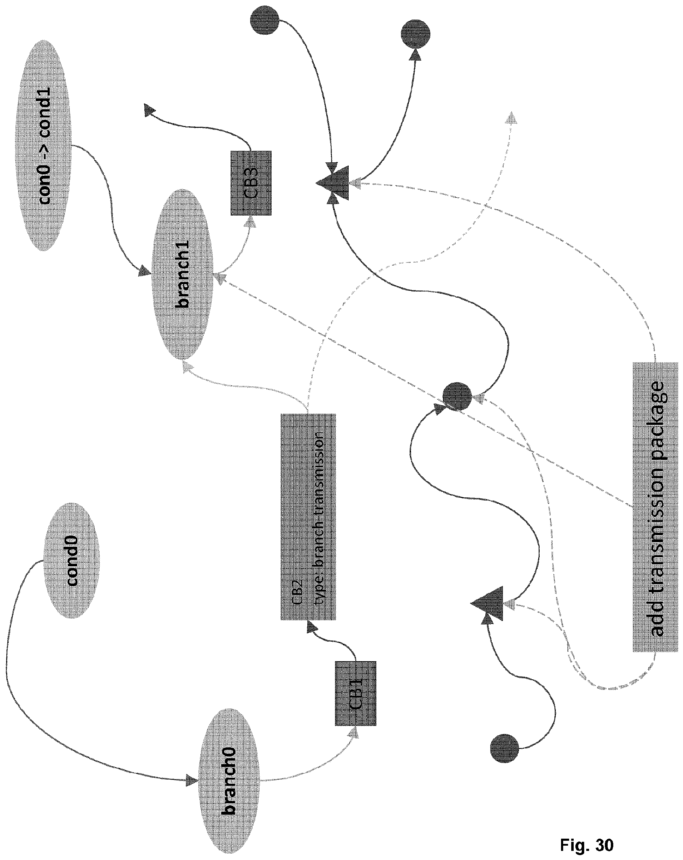

Figure 29 shows a block diagram schematically illustrating exemplary the handling of branching and variable versions. As the compiler sees code with a clear data centric perspective, also not explicit change to data under condition has to be incorporated. In figure 30, c is computed in branch0 under condition cond0. c is redefined in branch1 under condition cond0 -> cond1. If compare function in CB1 is false -> the program flow goes to hidden branch node 3342 hbranch1 -> copy the value from data node @ position mmapid: 12 (data node for c = 1 + 5) to new location as if in CB3 would be true. This is important and the reason there is a hidden branch node, which is not (only) the else statement. The above must be done, as the programmer programs the data flow for the true condition, but not the false condition (is expected nothing happens), but in the data dependency graph this is not true, because during parsing the code this c=8 in the branch1 has done a new version to the variable. Further, it has to be done for every variable assignment under a condition.
Figure 30 shows a block diagram schematically illustrating exemplary the handling of branching and transmissions. In the situation, when a e.g. 1-dependency or a 2-dependency occurs under different conditions -> different branch nodes -> means as branch nodes indicating that an information transmission must have happened before this. The same is also in 2-dependency cases when the same condition, but different branch nodes. However, there are also other possibilities to solve this problem. It means it needs a data transfer to this new computation block node in the corresponding branch node. Thus, branch nodes could also be handled otherwise.

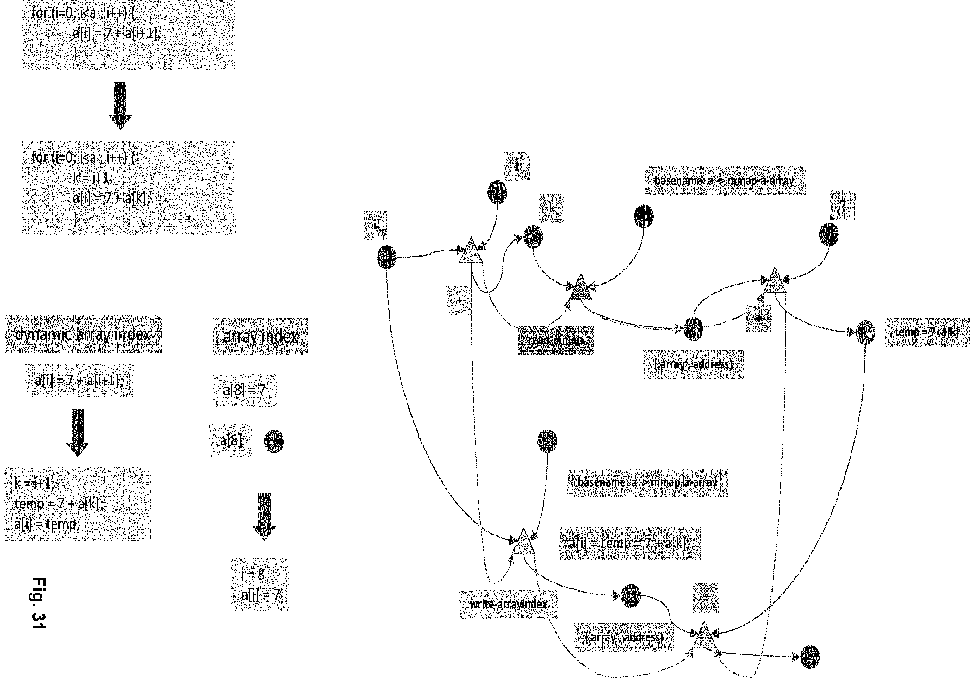

Figure 31 shows a block diagram schematically illustrating exemplary the handling of arrays and dynamic arrays. Arrays can be viewed as base variable name and an offset in a sequence of data with the same length (e.g. in C pointer variable and an offset). So it can be handled with a two-step operation: find address / location of base variable and get the offset and then go to offset found by the variable definition (type / length, e.g. u_int8 <-> u_int32). It is worth noting, that in this special case, the operation is, de facto, no really direct CPU-based elementary instruction since those are performed by the processor, itself, by first looking up in the L1-Ln caches, etc.

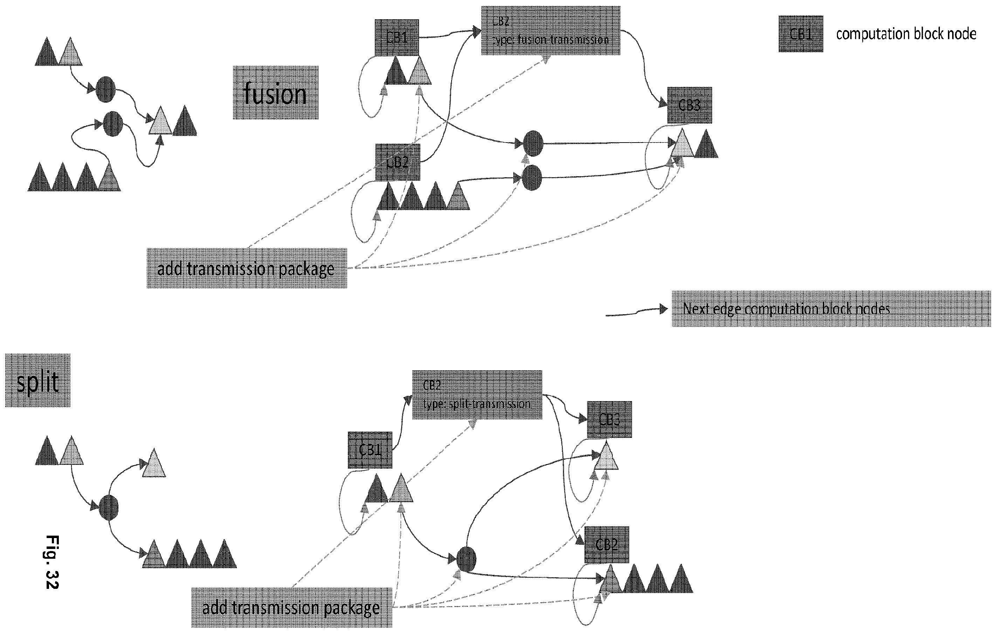

Figure 32 shows a block diagram schematically illustrating exemplary split and fusion situations for computation block nodes 333. In case of a 2-dependecy, there must be a fusion situation of two computation blocks 333. In case, when two operation nodes read from the same data node -> this creates a split situation of two computation block nodes 333. For both cases by introducing a new computation block node 333 (e.g. fusion-transmission or split-transmission), to split or to (re)join two calculation chains 34 (chain of computation block nodes) is allowed by sending transferring data/information through the system. Transmission information are added to the -transmission typed computation block nodes newly created.

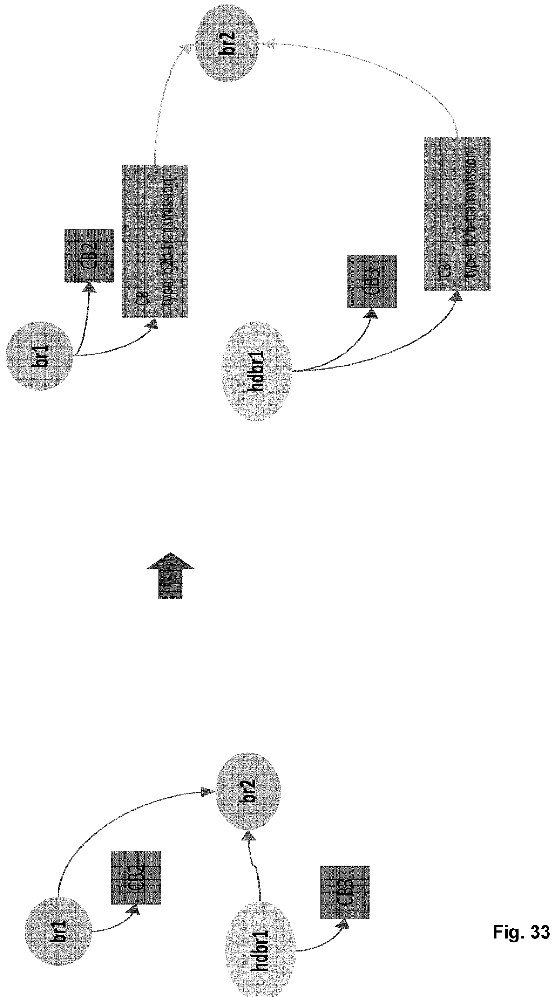

Figure 33 shows a block diagram schematically illustrating exemplary how to close transmission gap in graph flow. This step can happen only after all statements from the source code were added to the graph. Then to the branch nodes is added, which are not connected by computation block nodes 333 of type -transmission an additional computation block nodes 333 of type b2b-transmission. This is needed to propagate the branch change through the system. At a later step these transmission blocks must be set to the latest block number (computation step), so the information of the branch change can be propagated through the system 2.

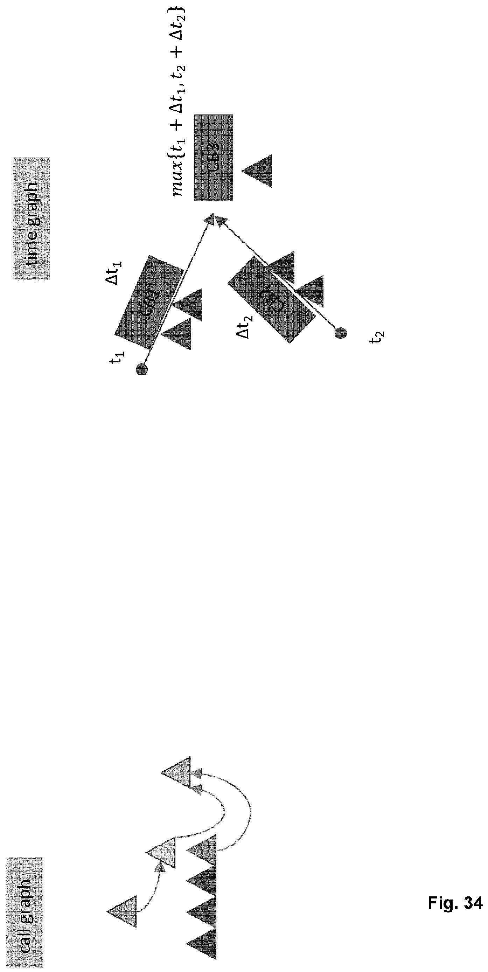

Figure 34 shows a block diagram schematically illustrating exemplary the introduction of a time perspective to the tree structure or graph. From the connected operation nodes 332 and the flow controlled computation block nodes 333, the tree structure or graph can be seen as chains 34 of computation blocks 333 with △t_{computation} 352. In every computation block node, the operation nodes are grouped, so △t_{readwrite} 351 is "optimal" (in the sense of locality, so copy data is slower than computing data). These sequential chains in the computation block nodes should not be disrupted, because they represent the sequential part of the code. To parallel the code, the computation block nodes need to be balanced by the time to make both incoming chains of computation block nodes (and therefor chains of operations) balanced to each other -> so in a fusion situation both incoming chains have to have the same runtime. Otherwise the overall computation stalls the time the other chain has to be computed. If in all fusion situations of a computation block nodes 333, the incoming chains (CB1 and CB2) have the same runtime and start timepoint, a most concurrent/optimized parallel code is achieved. In a split situation it is possible to start different chains at the same time and create therefore parallel computations. It has to be noted that a series of "+" and under some conditions "*" could happen in a computation block node and they could be again split to parallel computations. However, this is easy to detect during an optimization phase. Each computation block node needs △t_{compute} to calculate all operation nodes 332 in it. Now it is possible to try to balance out the △t_{compute} with the systems available △t_{latency} 35, because each computation block node 333 can be viewed as minimum △t_{latency} 35 long, as this was so introduced in the preceding steps. By assuming that every computation block node 333 has to be at least △t_{latency} 35 long, it is possible to transfer data in the system 2. Finite block numbers can be introduced for each computation block node. They represent the required sequence of the computation blocks 333 of the sequential chains 34 of operation nodes 332. This generates a distinguished and well-defined grouped graph, where every group of operations has a unique number and is according to these numbers transformable to bring them in matrices. These matrices then can be used to optimize/map using e.g. real world times to a given or ideal infrastructure.
   Regarding to assign the block graph or tree structure to runtime numbers the numbering can be implemented, for example, as a recursive function parsing the graph of computation block nodes and their edges, branch node by branch node. In each branch node 3341, the computation block nodes 333 are started to be numbered. Then, it is stepped recursively through the computation block node chains 341 of the branch nodes 3341. After a branch node, the maximal block number is known given a computation block node in a branch node. This is used for the next branch node. The rules are computation block node 333 are stepped to computation block node 333. Is there only one or no previous computation block -> set the block number to actual block number and increase the block number (for the next computation block node). Are there 2 preceding computation block nodes -> this is a fusion situation -> if this is the first visit to this node -> append to a local list of block numbers. Otherwise if this is the second visit -> use the highest block number (actual from the function call or the saved in the list of the node). Is there 1 following computation block node -> call the function for the computation block node (recursive approach). Are there 2 following computation block nodes -> split situation -> call for both the computation block node numbering function in a recursive way. If there are none (so no next computation block nodes) -> give back next branch nodes if there are and finish the actual recursive call. By appropriately adjusting the block numbers in the branch nodes transmission, the call graph is numbered based on the computation block nodes connection to a form of a discrete time graph, where each computation block node has a finite number, which has to be calculated during the same time period.

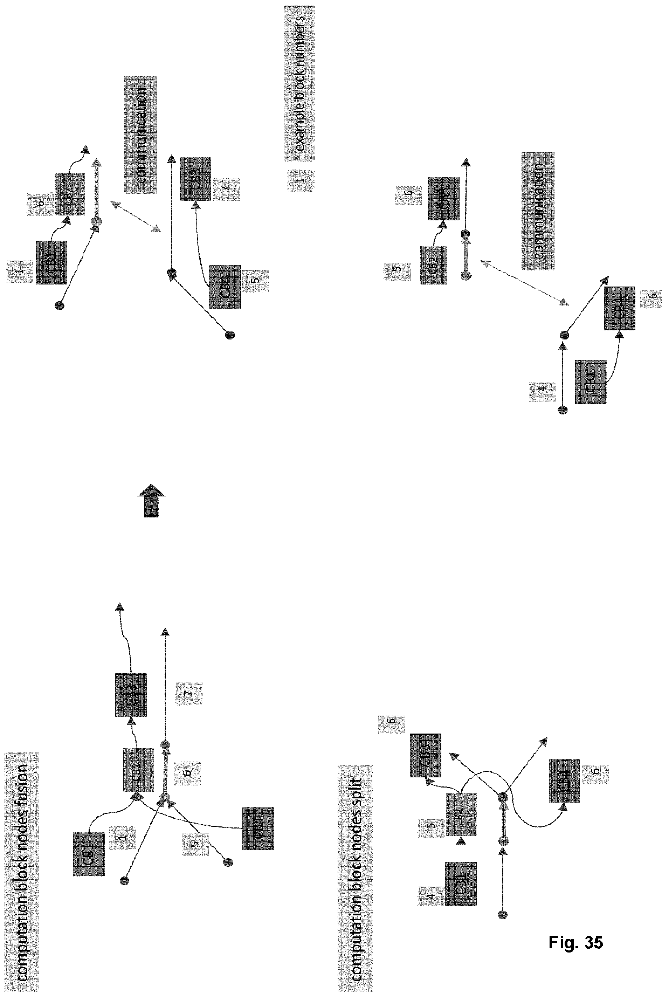

Figure 35 shows a block diagram schematically illustrating exemplary splitting the graph to single/"transmission coupled" call chains. At this point, it is possible to split the call graph or tree structure into single chains 34 of computation block nodes 333 , which leads to a single series of operation nodes with corresponding transmission information for each computation block node 333. Each computation block node has a unique number. The needed transmission/communications are saved in the computation block nodes.

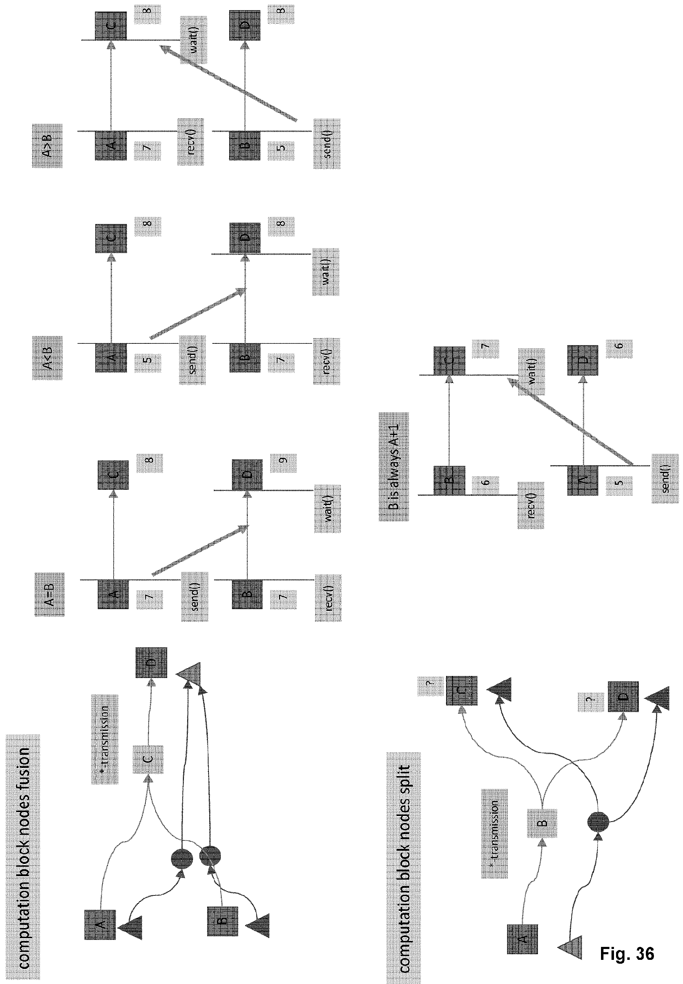

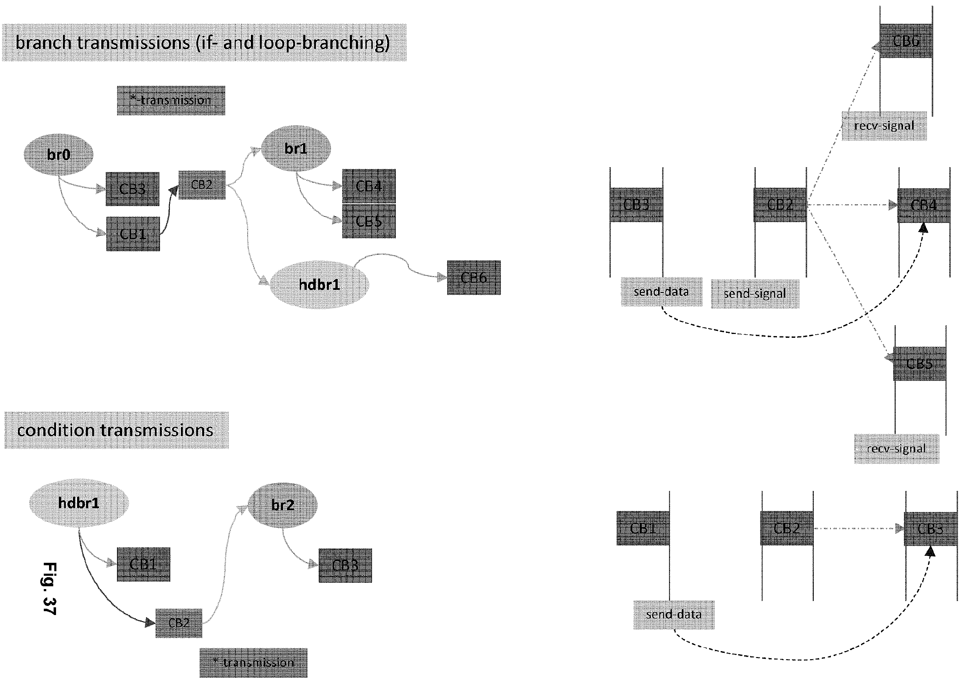

Figure 36 and 37 show block diagram schematically illustrating exemplary a possible process from transmission to directed communication. The direction of the communication can be dependent on the computation block node 333 numbers, as the examples of figure 36 and 37 show. It has to be made sure that all -transmission computation block nodes are at the highest+1 block number (to ensure to have enough time to propagate information of program flow to all computation units / processes) in one branch node. Transfer the transmission packages with source and target information explicitly to send commands in the correct computation block nodes. The receive part can only be done after the optimization step. Signals transmission, such as a branch- or loop-transmission has to be implemented to all connected next computation block nodes 333 in the corresponding branch.

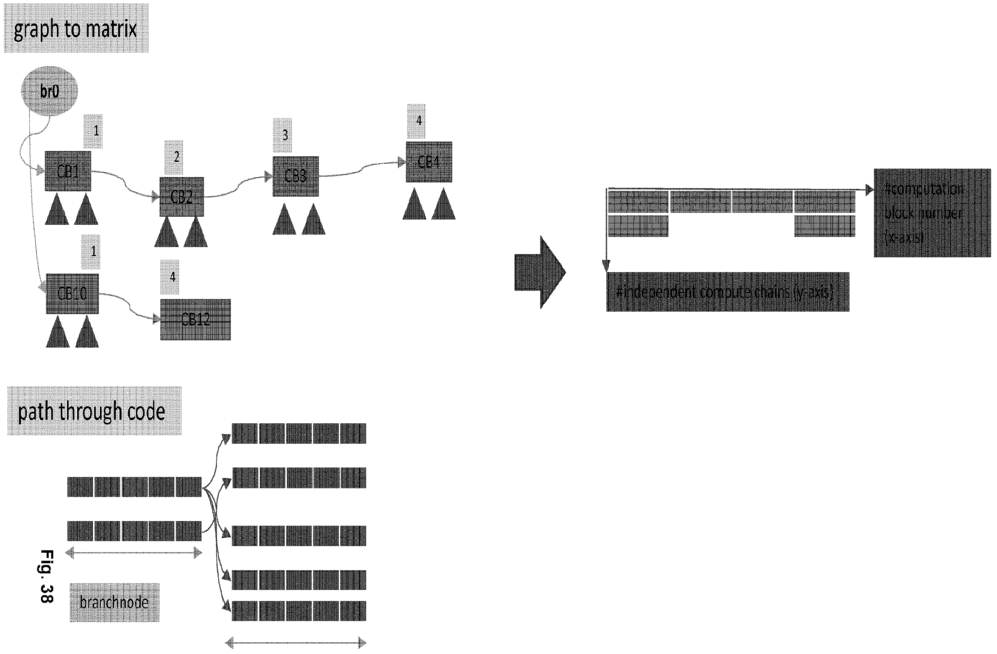

Figure 38 shows a block diagram schematically illustrating exemplary the process from graph to matrices. At this point, the graph consists of branch nodes with single chains 34 of computation block nodes 333. Each computation block node 333 knows to which other computation block node 333 what information (data and or signal) has to be transferred. Each computation block node 333 has a discrete number, which represents the order each block has to be computed over the time of the program. So the graph can be interpreted as matrices where each cell is a computation block node, each row a single unit and each column the discrete block number (order number) and each cell (computation block node) knows what for information has to be send to other computation block nodes 333 (cell entries). Each cell knows which operations (chain of operation nodes) has to be calculated during their block number and in which order - they are independent and have to be in the correct order -> which have a clear nearest write and read connection. Each operation node knows the correct global data which is needed to read (in1 and in2) and write (out). The matrices now can be optimized, e.g. numerically, to the target hardware infrastructure (CPU, CPU with explicit network transfer e.g. by MPI, GPU (memory transfer then vectorized operations), etc.)

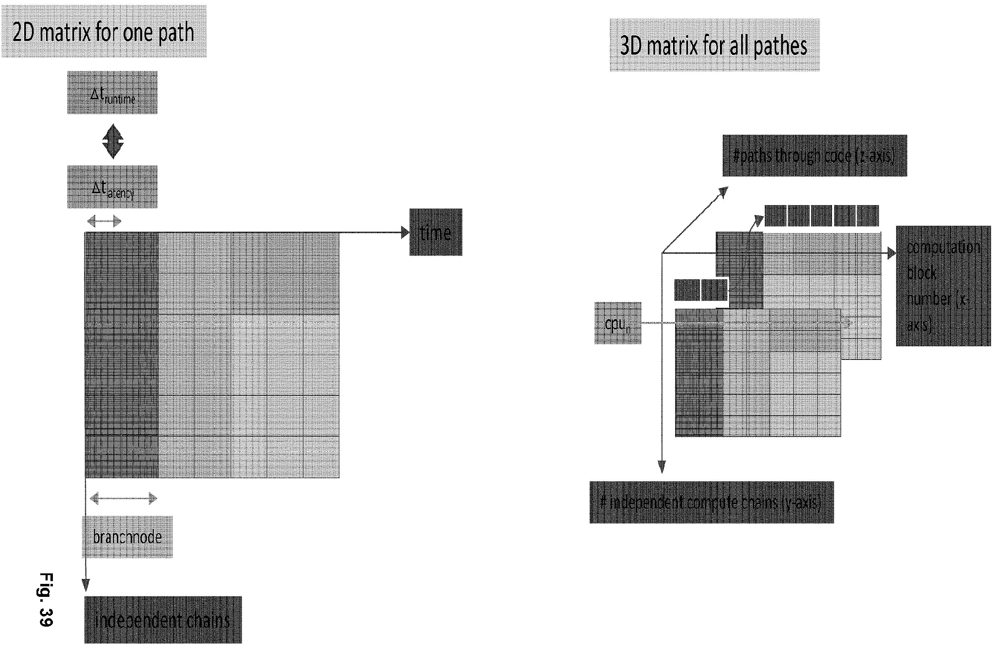

Figure 39 shows a block diagram schematically illustrating exemplary program paths and matrices. z-axis dimension is a code perspective for each path through the code (each condition change introduces a different path through the code). The 3rd dimension (or z-dimension) is a condition switch meaning each set of a transfer and a computation matrix is one way through the code under 1 condition. In this perspective, each path through the code could be represented by two matrices with row for the independent chains and columns (x- and y-axis) for the block numbers. Branching evolves by switching to the corresponding z-dimension set of matrices (path through code) and each process node needs to know all possible chains 34 for itself. In this description each condition change is captured by one set of a computation and a transfer matrix, but matrices can also be seen a tensor and then e.g. a computation and a transfer tensor can embrace in their rows the independent operations, respectively corresponding transfers and in each column a discrete computing step and in their 3rd dimension different conditions. Or all could be packed in one tensor combining computations and transfers for each block number and unit and condition, etc..
   Regarding optimization, the now applicable automatic optimization techniques are numerous: combine rows to reduce parallelism, move single operation chains to the earliest point (send commands in the cells are like barriers), reduce communication by best combination of rows, etc. The compiler system 1 can be used to get an estimation for runtime of a cell entry, or ways like by Agne Fog of the technical university of Denmark can be used to extract CPU and cache interactions, or use tables from the manufacturer of the CPUs, or compile it with openCL, etc. There is a wide range of optimization techniques to map the matrices to a target infrastructure in the technical fielders. For example in the perspective with one tensor for the computations and one for the transfers, different parallel code versions can be retrieved by combining the same rows in each tensor and therefore generate new combinations of "computations and transfers" per block number. This would lead to reduce the number of parallel / concurrent units. By combining rows it is possible to reducing or group transfers (in a final code communications) and the computations sum up. Operation nodes in a block can be move to a previous block in case there is no send() or read() at the beginning of the block. Each cell knows the amount of data (memory or similar) it needs. The different given Δt_{latency} 35 on the target platform can be used to make a decision on which sequential part (cell entry in computation matrix) has to be computed at which hardware unit. The communication type in the infrastructure can be implemented as needed, from asynchrony or non-blocking to blocking explicitly send and receive commands in a MPI framework, to prevent race conditions by ensuring correct barriers are set and released, to bulk copy transfer in GPU infrastructure, etc. The choice of the optimization technique can, thus, easily be done by choosing an appropriate prior art optimization technique, e.g. by use of a SOTA compiler for each code (computations and transfers) per unit. The used optimization techniques will introduce a much wider perspective to get a more "perfectly parallel" code than others (perfect in the mean of a linear dependency of speedup vs. # processes with a slope of 1). So it is possible to numerically optimize the matrices to a new parallelized and optimized/concurrent code for the target hardware. This can be done automatically and therefor it is a big step compared with other methods. As this is done by software, software now can parallel its own code, which is new and leads to new possibilities, for e.g. adaptive models in Machine Learning (ML) or Artificial Intelligence (AI) applications, meshes in Computational Fluid Dynamics (CFD) calculations or particle sources in vortex methods, or combining different model methods with different spatial and time resolution (Finite Volume Methods (FVM) with agent-based models and statistical models), etc.

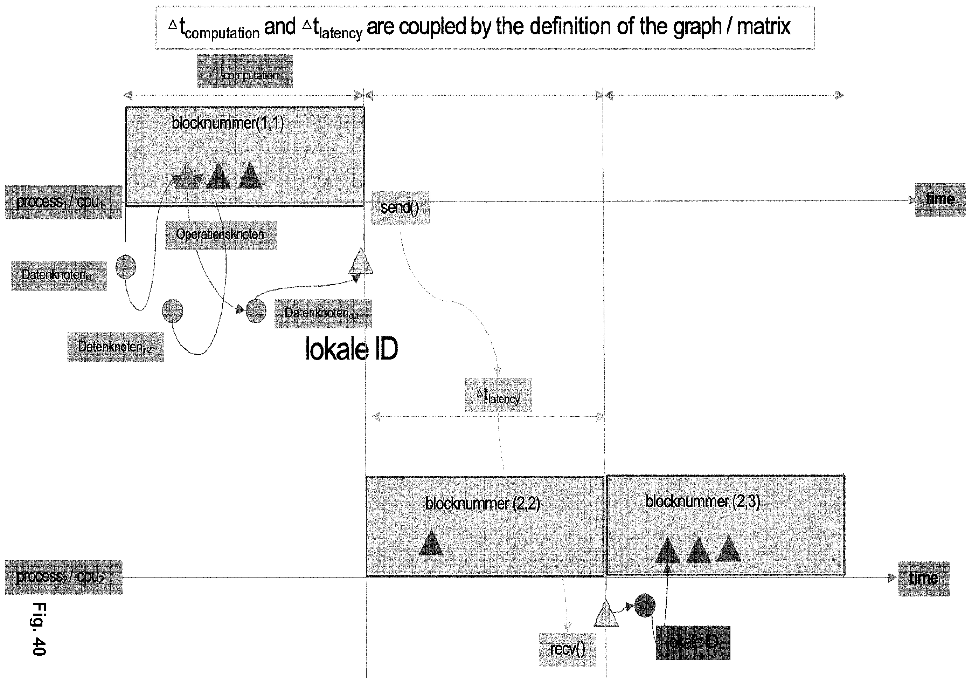

Figure 40 shows a block diagram schematically illustrating exemplary code extraction. Code can be extracted from the matrices by a wide range of implementations: directly extract assembler code, write code files and compile them by state-of-the-art compilers, implement send and receive methods explicitly, e.g. for Message Passing Interface (MPI). The computation matrix cells have the code = statements in form of the operations, and each column has to be computed during the "same" time-intervals and each row is a separate process. The transfer matrix cells know what information has to be shared with what other cells.
Figure 41 shows a block diagram schematically illustrating the computation block nodes (CB) with the operation and corresponding data nodes (similar to the token in table 1) for a double recursive call of a function.
Figure 42 shows a block diagram schematically illustrating the recursive call of the functions resulting in additional transfers. 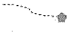 indicates a transfer to the location in the computation block nodes (start- or end-point of the computation block nodes).

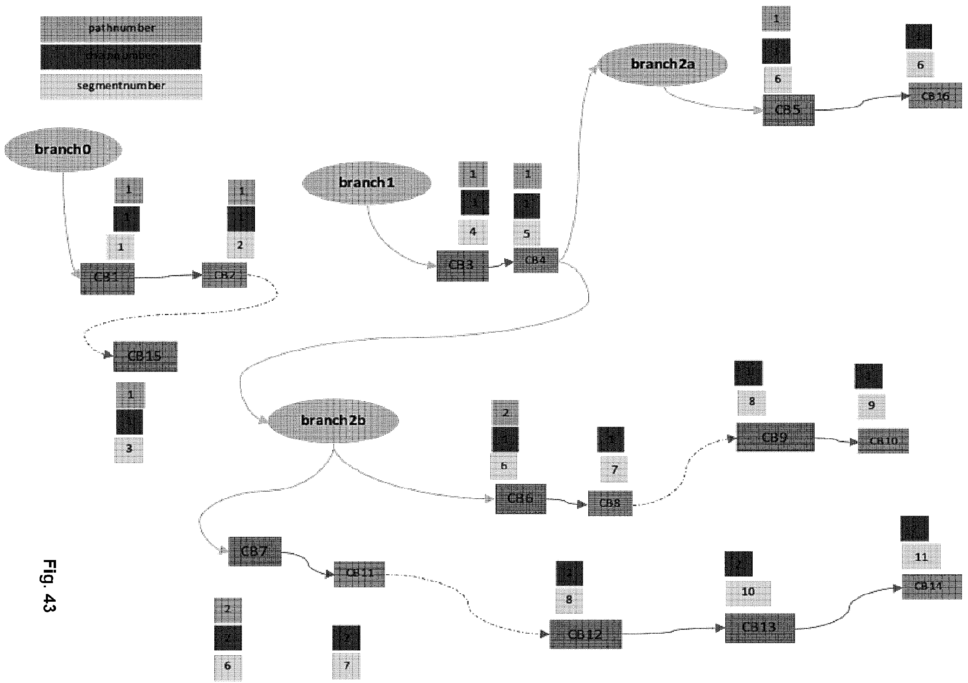

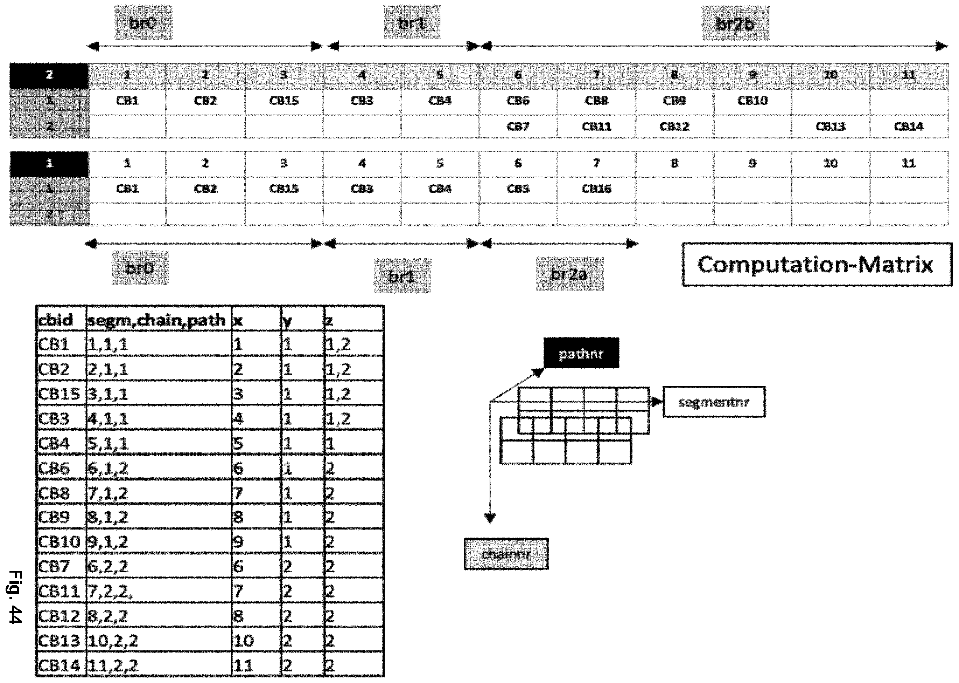

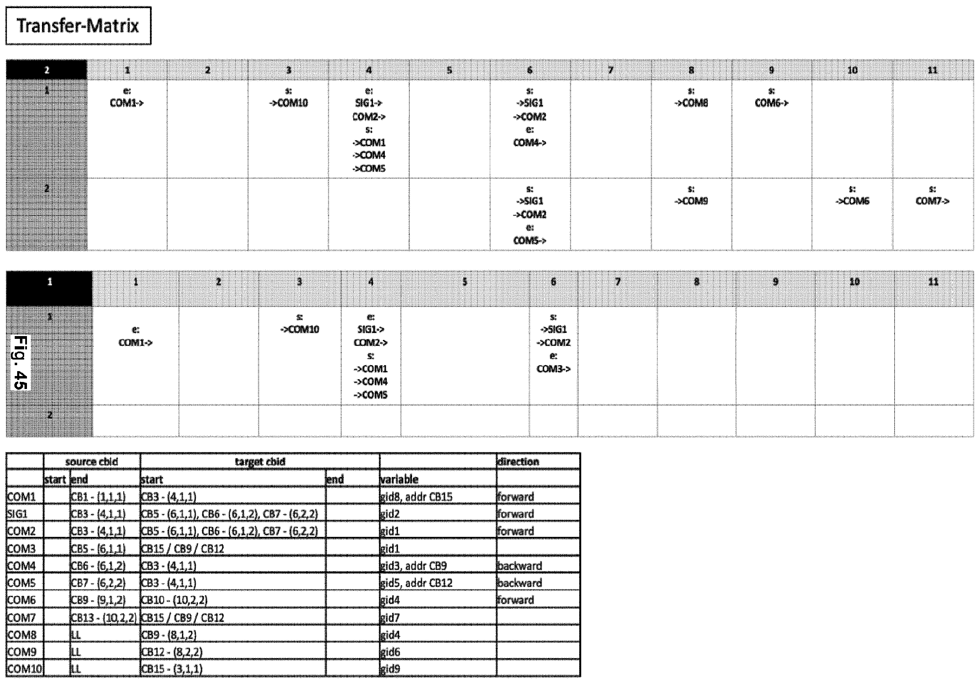

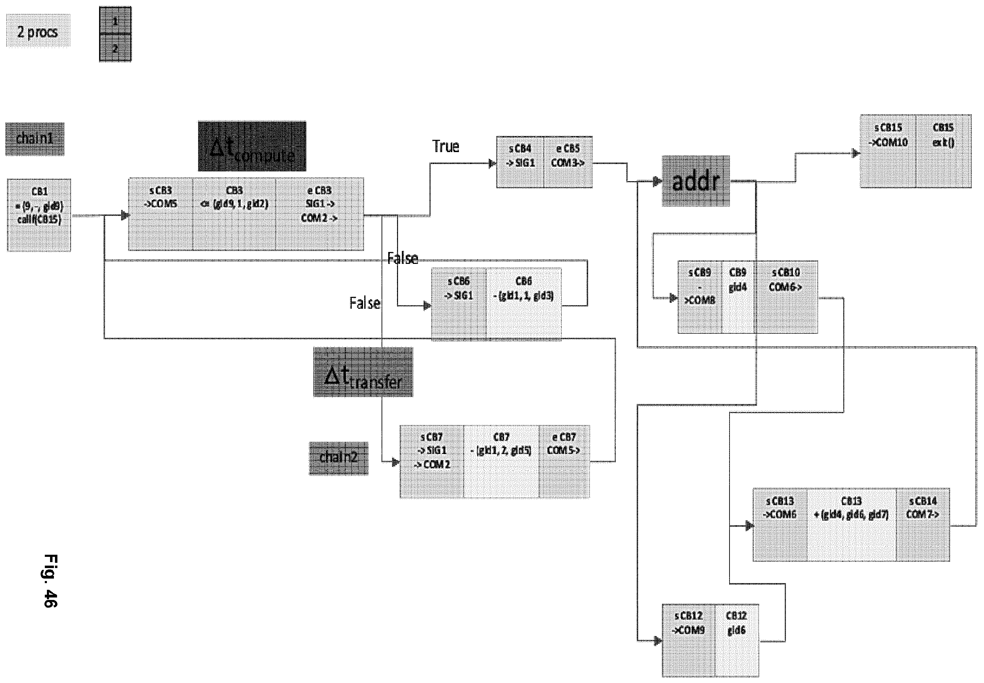

Figures 43, 44 and 45 show a block diagram schematically illustrating the step of numbering the computation block nodes depending on their call-position in the code, resulting in a pseudo graph like schematically represented in figure 43, which in return results in the computation and transfer matrix for each path number as shown in figures 44 and 45. In the perspective to see a matrix as a m x n object, then there will be created one set of a computation and a transfer matrix per path number, resulting in 2 computation and 2 transfer matrices. The switch of the paths (or conditions) can be seen in figure 46, where the 'True'/'False' signaling is indicated.
Figure 46 shows a block diagram schematically illustrating the result of combining start- and end-communication cells in the transfer matrix and eliminating empty cells in the computation matrix (for each path) and bring them back to different code segments. Based on this code segments a code can be generated directly (as a compiler) or transferred back to code and then using a SOTA compiler to generate machine code (as a transpiler), e.g. to use the unit specific optimization techniques implemented in SOTA compilers, which target mostly on one unit compilations.
Figure 47 shows a block diagram schematically illustrating how a function call in a parsed code can be handled with the presented method. After the parsing of the function definition the resulted computation block nodes (or matrix entries) can be "copied" / used at the position, where the function is called.

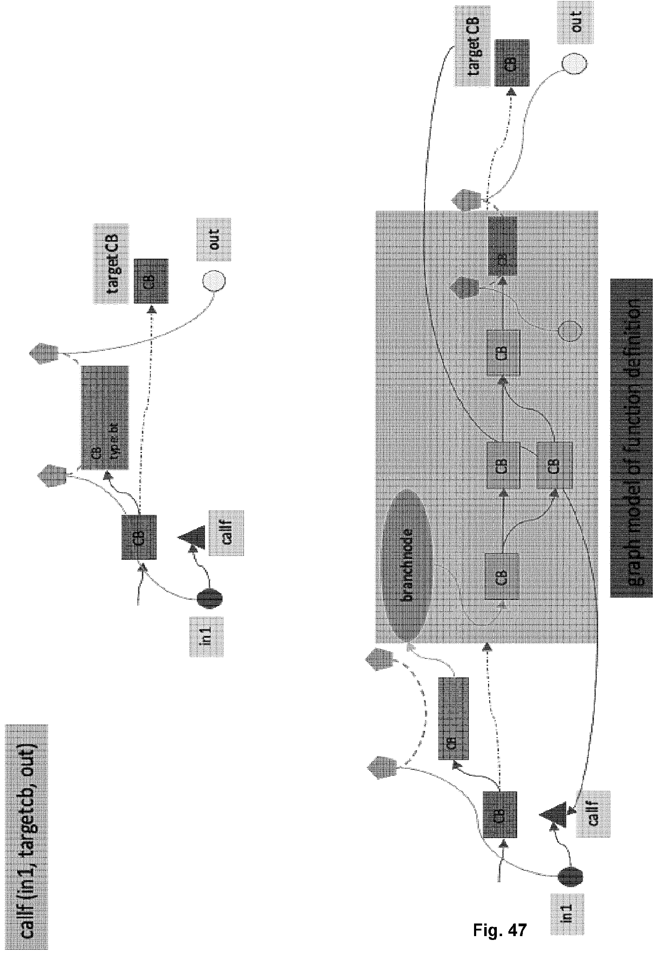

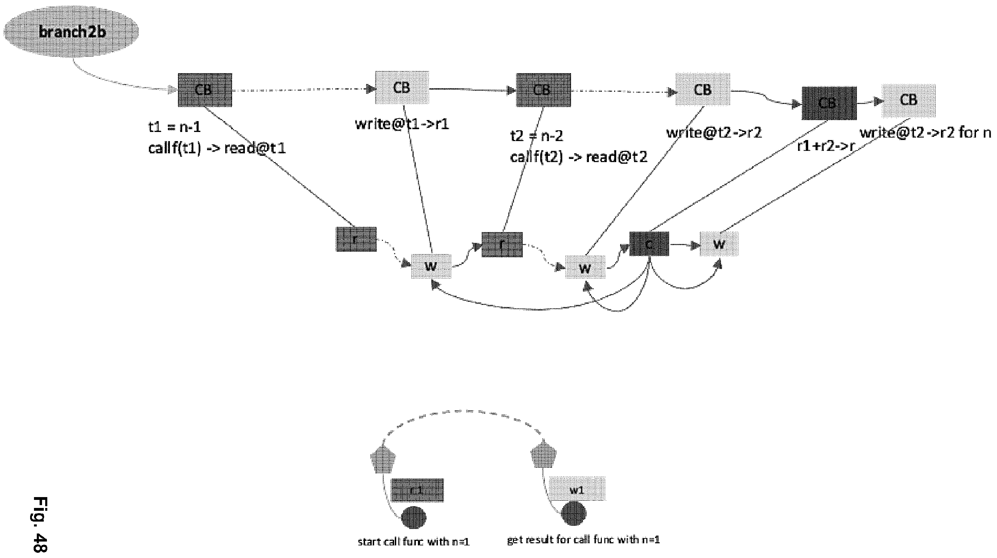

Figure 48 shows a block diagram schematically illustrating how the inventive method maps and/or optimize the code in a more concurrent solution than the input code. As indicated to optimize the code it is the combination between the rows, the graph is shown with the combination of the cbn in the branch node marked as branch2b (see figure 43) and combine them, see figure 48. Calling a function is in the method placing the computation block nodes to the correct location in the matrices, respectively to apply the corresponding transfers as indicated in figure 47. With this in mind, the recursive call of the function can be seen with the inventive method as a transfer and 'read' and 'write' of the function parameters and result variables in a return statement, figure 48.
Figure 49 shows a block diagram schematically illustrating, according to the example of a function call to calculate the Fibonacci number for input 4 (fib(4)), step-by-step how additional computational block nodes and the reducing of the transfers (as all is on one computation-chain) results in a more optimized source code.
Figure 50 shows a block diagram schematically illustrating step 4 showing the cbns for a call with 'n=4', where, as recursive calls can be very simply detected in the code, it is easy to not implement a recursive call in full dimension in a final application, as shown by figure 49-53 with some simplification, where the depth of this chain depends directly on the number n in fib(n).
Figure 51 shows a block diagram schematically illustrating step 5 showing the transfers, which will be occur (transport the information of the last "write" to a data node to the place where the "read" of a data node occurs and remember this information in the corresponding computation block nodes).
Figure 52 shows a block diagram schematically illustrating, as all computations are on one chain, the transfers will vanish, as can be seen in figure 52.
Figure 53 shows a block diagram schematically illustrating that, when resolving every step, this leads to a program of the form in figure 53.
Figure 54 shows a block diagram schematically illustrating that a function call and therefore a recursive call can also be interpreted like an array operation applying the inventive method, as it is transferring an information (function parameter param[i]) to the corresponding cbns in the branch node of the function declaration and then transfer back the return value(s) to a[i].
Figures 55 and 56 show a block diagram schematically illustrating an implementation in python to solve a 2D heat equation. Each entry in an array is a data node. Reading from an array index is in the inventive method an operation node with data node of the index and the base address of the array. Array operations can be seen as operation nodes with corresponding data nodes, see figure 56.
Figure 57 shows a block diagram schematically illustrating, for the example of a loop array with an array operation a [i+Δiw] = a[i], the corresponding computation block nodes.
Figure 58 shows a block diagram schematically illustrating the initial block (figure 55) being expressed in detail in the graph as shown in figure 58.
Figure 59 shows a block diagram schematically illustrating that by using a 1D array notation and applying the fundamental rules of the method, a model approach is derived.
Figure 60 shows a block diagram schematically illustrating that a statement such as the array operations in the j-loop (figure 55), result in 5 computation block nodes, representing "reading" operations of the array, then a computation block node which computes the arithmetic solution and then a computation block node with the write to the array at the position [k+1][i][j]. This form of representation is a schematic perspective to show more clearly how the method take such array operations into account, leading to a situation indicated in figure 60.
Figure 61 shows a block diagram schematically illustrating a scheme that can be derived from the fact that each loop creates therefore a new computation block node with a "reading" or "writing" operation node and the corresponding transfers. So each loop iteration introduces the computation block nodes and form for one unit (later unit which computes the operations) a chain of read, compute, write steps. Transfer will be introduced in case between these computation block nodes "write" and "read" dependencies occur, see figure 62.
Figure 62 shows a block diagram schematically illustrating that an offset in the index of the "reading", respectively "writing" operation can lead to a transfer between the computation block nodes containing the "reading", respectively "writing" operation nodes.
Figure 63 shows a block diagram schematically illustrating the conclusion as derived from the dependencies in "reading" and "writing" of the data nodes of ana array indicated by indices in a loop.
Figure 64 shows a block diagram schematically illustrating the dependencies between "read" and "write" operations in the "read" and "write" computation block nodes and the size of the loops (in this case the mesh size) resulting from the 2D heat equation with Central Difference Scheme with a 3 nested loops implementation as indicated in figure 55.
Figure 65 shows a block diagram schematically illustrating for one nested loop, for each loop-nest a rule can be derived to handle the gaps and the consequence to the "transfers" in the proposed model. The gaps results from looping not over the complete array / mesh / dimension, indicated with j0 and Bi in the loop definitions.

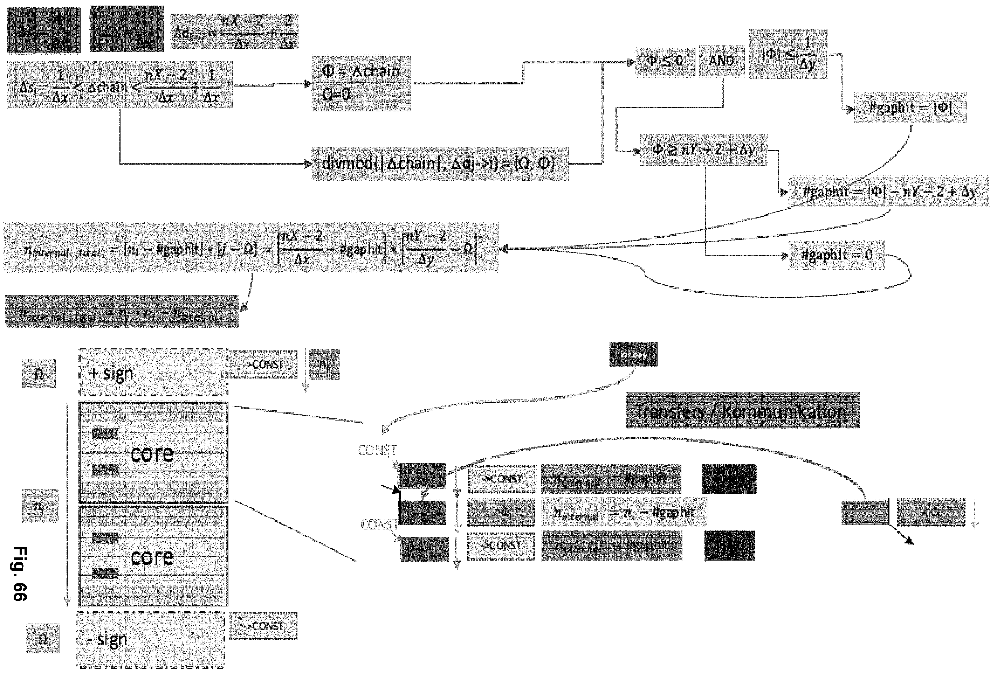

Figure 66 shows a block diagram schematically illustrating that incorporating the gaps occurring by the looping over a subset of the array, the transfer pattern of a discretized equation can be derived, and a model can be built for the transfers, depending on the gap-sizes, sizes of the loops (= in this case meshes) represented by the computation block nodes of the inventive method. The method can also be applied for each iteration for each loop and add the corresponding elements to the graph / tree structure, but this could bring some performance issues to apply the method to large problems (e.g. large meshes).
Figure 67 shows a block diagram schematically illustrating that with a very small example of nX=5 and nY=4, this leads to the set of a computation and a transfer matrix as in figure 67. In the transfer matrix the arrows '->' indicate getting information and '<-' indicating sending data to other computation block nodes.
Figure 68 shows a block diagram schematically illustrating the occurring transfers between the units, as each unit is represented by one row in the transfer matrix and the computations, represented in the computation matrix. In this illustration the entries of the computation and the transfer matrix are shown together. It is a combination of computation and transfer matrix.

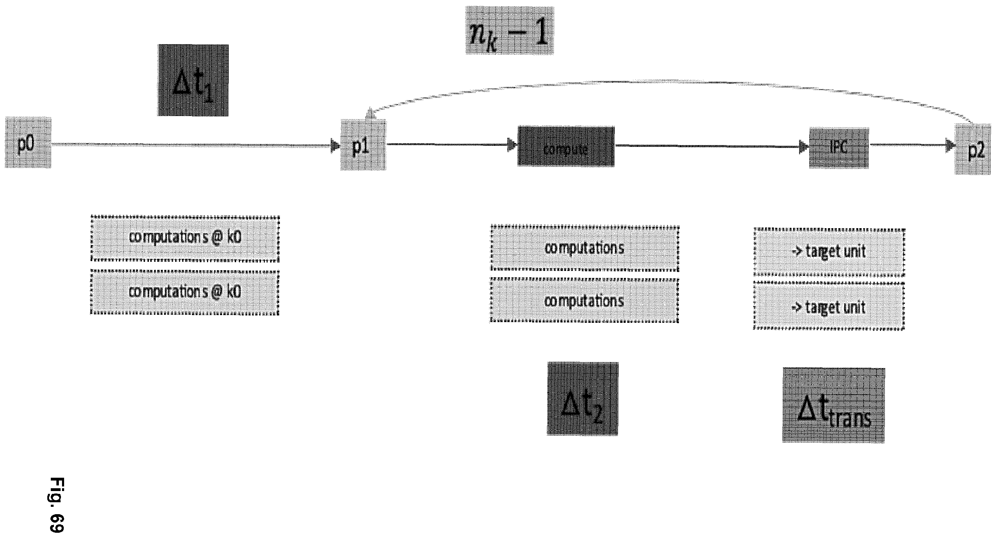

Figure 69 shows a block diagram schematically illustrating that it is important to note at this point, that this does not mean it has to be sent and received, it also can be e.g. shared by a shared memory segment and guarded by a barrier or lock or vanish as it is shared by cache and therefore handled by a CPU - it depends on the used transfer / communication mechanisms. This can be transferred to a model, respectively leads to a code of the form as shown in figure 69. As the method is based on keeping all dependencies of "writing" -> "reading" and a calculation of the form a[i1] = a[i2] is first "reading" an information with a[i2] and then "writing" an information with a[i1], the operations of the first "reading" (p0 - p1) are introduced.
Figure 70 shows a block diagram schematically illustrating how the transfers can be used to create a time model. Grey are the meta values (e.g. known from variable type definitions or similar), which also can be used to map/optimize the matrices to a given hardware infrastructure. These values are not used in this example.
Figure 71 shows a block diagram schematically illustrating a simple model fully resolved to illustrate possible optimizing steps.
Figure 72 shows a block diagram schematically illustrating the behavior, which can be derived for a grid of nX=2048 and nY=1024 for Δt = computations in combined cbn * cpuPower+number of transfers*networkLatency with two different set of cpuPower and networkLatency.
Figure 73 shows a block diagram schematically illustrating that the Fibonacci source can also be implemented using loops. According to the example with the 2D heat equation, this leads to the result in figure 73.
Figure 74 shows a block diagram schematically illustrating that applying the inventive method to the technical problem of pointer disambiguation, it can be shown, that the inventive methodology resolves the disambiguation occurring by passing function parameters as pointers, because it takes the pointer as an information and this disambiguation will be resolved in the step of the transfer vanishing, as illustrated by figure 74. It is to be noted that the labels "Intel P5 Infiniband" and "Intel Haswell L3-cache" can generally denote a configuration 1 and a configuration 2.
Figure 75 shows a block diagram schematically illustrating LLVM IR and corresponding grouping of instructions in computation blocks (CBs).
Figure 76 shows a block diagram schematically illustrating the forming of compute and transfer segments.
Figure 77 shows a block diagram schematically illustrating a time model structure for compute and transfer segments for nᵤₙᵢₜ=3.
Figure 78 shows a block diagram schematically illustrating an option for 2 units, marked as combination (c1) and combination (c2) for nᵤₙᵢₜ=2.
Figure 79 shows a block diagram schematically illustrating the runtime for one unit: nᵤₙᵢₜ=1.
Figure 80 shows a block diagram schematically illustrating a representation of decomposed code as matrices or graph.
Figure 81 shows a block diagram schematically illustrating the forming of a gamma-graph for fib(3).
Figure 82 shows a block diagram schematically illustrating a computation graph with serial and parallel time estimations.
Figure 83 shows a block diagram schematically illustrating three different computation graphs for TT = 1, 3, 10.
Figure 84 shows a block diagram schematically illustrating an embodiment variant using the system and method is in the middle end of an auto-parallelization compiler, i.e. the use of method in SOTA compiler.
Figure 85 shows a block diagram schematically illustrating a representation of decomposed code as matrices or graph.

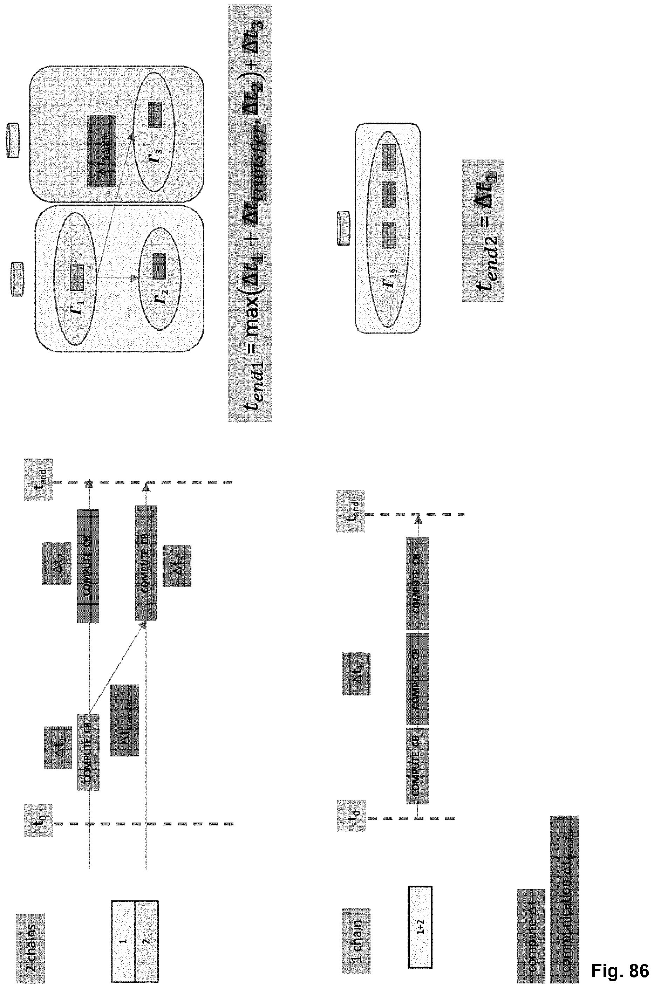

Figure 86 shows a block diagram schematically illustrating combining of CBs and resulting distributing to computing units.
Figure 87 shows a block diagram schematically illustrating distinguished computing and transfer/communication sections from a gamma-graph.
Figure 88 shows a block diagram schematically illustrating paths in a code in basic block (BB) and control flow graphs (CFD) representation and with the inventive computation block (CBs).
Figure 89 shows a block diagram schematically illustrating a graph with computation blocks with one if-condition leading to a branching.
Figure 90 shows a block diagram schematically illustrating computation and communication segments for 2 units and one if-branching.
Figure 91 shows a block diagram schematically illustrating a loop-body in Control Flow Graph as read, compute, and write computation blocks (CBs).
Figure 92 shows a block diagram schematically illustrating an unrolled representation of computation blocks and transfers for i=0-7.
Figure 93 shows a block diagram schematically illustrating loop-sections with parallel CBs and explicit loop iterations.
Figure 94 shows a block diagram schematically illustrating a loop-section data analytic 'A - resolved' or 'B - structure' (B-model). Getting gamma-nodes from data analysis in a loop is a NP-complete problem (A - resolved). With the introduced embodiment variante of the method it is possible to get the gamma-node from the loop-headers/latch and the statement(s) for accessing a random access data structure.
Figure 95 shows a block diagram schematically illustrating a generic structure with CBs for a n-nested loop with a statement to a random access data structure (e.g. an array).
Figure 96 shows a block diagram schematically illustrating case 1 with gamma-nodes for 1-read-write dependency in CB.
Figure 97 shows a block diagram schematically illustrating case 2 with K-reads and 1-write, with K=2.
Figure 98 shows a block diagram schematically illustrating case 2 with K-reads and indicated how to retrieve *n*_{∥} and K=3.
Figure 99 shows a block diagram schematically illustrating combining parallel CBs leads to reduced transfers and summed up computation on *n*ᵤₙᵢₜ=2.
Figure 100 shows a block diagram schematically illustrating building combinations of CB as a function of read-shifts leads to reduced transfers.
Figure 101 shows a block diagram schematically illustrating building combinations of CB as a function of read-shifts leads to a distinct function describing number of combination n_{comb} and size of transfers T.
Figure 102 shows a block diagram schematically illustrating the minimal transfer per CB and constant transfer *S*_{T,const} for *n*_{comb} > *n*_{comb,const}. Transfers between the CB i>3 and i<blocksize-5 vanish.
Figure 103 shows a block diagram schematically illustrating optimal distributing of gamma-nodes, when resources are limited. by adding transfers to distribute Gamma-nodes evenly over limited resources.
Figure 104 shows a block diagram schematically illustrating structured data and resulting gaps when not iterated over the whole array.

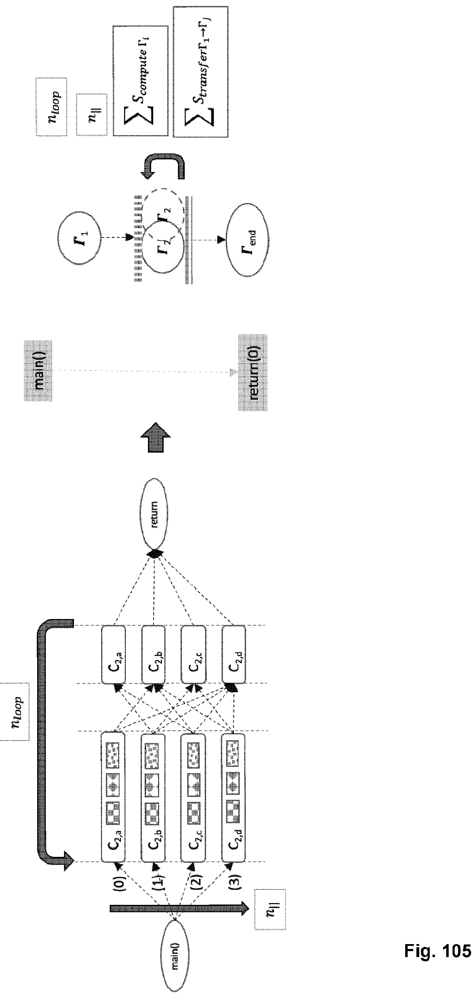

Figure 105 shows a block diagram schematically illustrating gamma-nodes with CBs and transfers after each nₗₒₒₚ iteration and their representation as gamma-nodes.

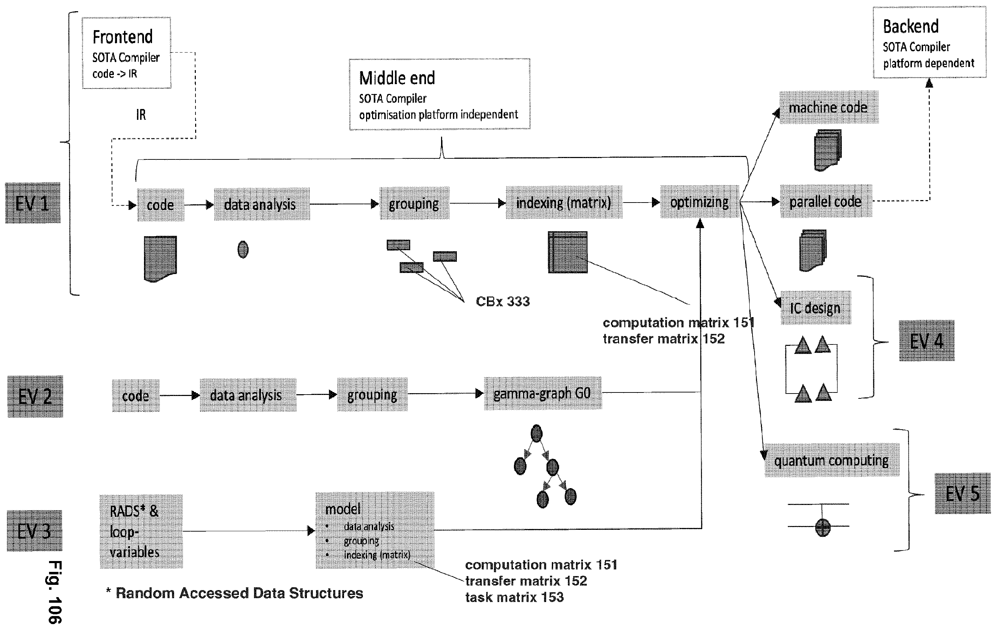

Figure 106 shows a block diagram schematically illustrating different possible embodiments EV1 to EV5. EV1 of figure 106 shows the most fundamental embodiment variant enclose the basis of all other embodiment variant of the inventive system and method providing auto-parallelization of code by optimizing the overall latency time to a minimum. The embodiment variant EV1 is based on some fundamental assumptions, which are, inter alia, that (i) the optimization of the auto-parallelization is not limited by the number of parallel processors (single-core 2103 and/or multi-core 2102) available, (ii) the latency time for memory access and data transfer to and from a processor 2102/2103 to the processing time needed to compute a computation block node 333 on a processor 2102/2013 is small, and (iii) the time difference to compute different computation block node 333 is neglectable. The latter can be assumed based on the inventive choice of the extremely basic structure of the computation block node 333. To optimize to limited resources (given maximal rod-dimensionality) a reduction of the row dimensionality can be obtained by building combinations. This form of optimization is bounded with the assumptions (i) any transfer introducing a significant latency time compared when a transfer in the transfer matrix vanishes Δ*t_{transfer}* » Δ*t_{transfer}* ≈ 0. (ii) variations between transfers are small Δ*t_{transfer,i}* ≅ Δ*t_{transfer,j}*, meaning all transfers have approximate equal latency times. Assuming (i) and (ii), the maximal row-dimension in the compute and transfer matrix define the combinatorial complexity of the system (several CB per BB). Following Wall, David W. "Limits of instruction-level parallelism." Proceedings of the fourth international conference on Architectural support for programming languages and operating systems, 1991 there are on average 3 to 4 ILP opportunities per Basic Block. (i) and (ii) are given for most of modern multicore-processors. Nevertheless, these assumptions can lead to miss some optimize opportunities and to potential limits for the combinatorial optimization step, especially for loop-sections and / or if (iii) the units have not similar computing performances and transfer latencies.
   EV2 in figure 106 shows an embodiment variant comprising the process of building the inventive tasks out of combination of computation block node 333 belonging (i) to the same column in the computational matrix, i.e. executable in parallel due to the available data and / or (ii) continuous computation block node 333 in the same row with empty cells in the transfer matrix for the same branch node 334 (=compute segments). This allows for a processor-architecture specific and/or system-architecture specific optimized auto-parallelization where the number of processors 2102/2103, the performance of the different processors/cores 2102/2103 and/or processor units 21, the differences in size and response time of the different memory units 22, in particular the different processor registers 2211 and/or processor caches 2212 and/or RAM units 2213. These hardware-specific structure parameters can be included in the optimization of the auto-parallelization and thus equalized by building tasks 36 of different length, e.g. in the number 36i of processed computation block nodes 333 of a task 36, where the computation block nodes 333 of a task 36 belong to the same column of a computation matrix 151 or are continuous computation block nodes 333 of the same branch node 334 without an entry in the corresponding transfer matrix 152. This differentiation is illustrated in figure 80 in gamma-graph a) and b).
   EV3 in figure 106 illustrates handling parallelization of random accessed data structures in loops by the inventive system 1 and method, without explicitly resolving data-dependencies in the loop sections instead by evaluating the read-write dynamics from the affected statement(s) to access the random accessed data structure and the influence of used loop-variables by analyzing the loop-header/leap-definition(s).
   EV4 of figure 106 (more detailed illustrated in figure 110) illustrates the applications of the inventive system 1 in its use for optimization of integrated circuit (IC) or chip design solving electronics engineering technical problem if IC design by encompassing logic and circuit design required to design integrated circuits, or ICs.
   EV5 in figure 106 illustrates an embodiment variant of the inventive system applied for getting quantum gates in quantum computing systems. In classical computing the basic memory element is a bit and can have 0 or 1. 0 and 1 is represented on the electronical level as two distinct voltages (see e.g. Basic quantum algorithms by R. Portugal). To get a result for a classical computation, the voltage at the output of the computation is measured as voltages. In quantum computing the units are qubits which are assumed to be at the end of a computation also 0 or 1. In contrast to bits, qubits can be simultaneous of 0 and 1, meaning coexisting during computation. The quantum coexistence (before a measurement) can be captured by a linear combination of orthonormal vectors (see e.g. Basic quantum algorithms by R. Portugal). With a measurement the quantum system gets inevitably affected and results in a stochastic result, resembling the classical bit. The definition of a unitary matrix is if its conjugate transpose UT is also its inverse UTU = UUT = UU-1=I, where I is the identity matrix. To manipulate the state of a qubit (see state as the "value" of the qubit before the measurement, quantum gates are needed where a single-qubit quantum gate can e.g. be expressed as a 2x2 unitary matrix. Any matrix describing quantum gates must be unitary, as quantum gates must be reversible and preserve the probability of the amplitudes. In the 1970s Charles Bennett showed how it is possible to transform any classical computation into a reversible form (see Logical reversibility of computation by C. Bennett). This can be done by keeping intermediate data with extra memory. Seeing f(x) as representing a classical computation, f(x) enables to manipulate n input bits to m output bits. Simplified, by keeping the garbage g(x) each classical gate can be transformed in a reversible version. Figure 113 (below) shows the classical computation for input xi to output by f(x). Such an approach enables to compose from a given classical computation circuit a reversible form. This reversible form makes it possible to retrieve quantum gates with the needed unitary properties. An illustrated form of this approach is given by 114 (below).
Following Figure 111 (below), it is possible with the inventive system to automatedly retrieve, e.g. from nested-loop and statements of accesses to an array (EV3) a representation as classical combinational integrated circuits (EV4). A perspective of the method is to see the decomposition in computation blocks as extracting a unique data bit-size for each computing step minimal needed to compute the input bits in parallel. This is illustrated and marked as "independent chains" in figure 39. Each row in the matrix represents a needed data size to compute this step in parallel in the program. This information can be used and could enable an approach to derive quantum gates also from (nested-) loops. The input bit-size per stencil can be derived by Σ(*tᵢ* + *gₖ*) · *dr*, where *tᵢ ∈* [*a, b, c, d,e*] describe the input bits (see figure 113), *k ∈* [0,6] are the garbage memory bits needed and dr the corresponding data-sizes (e.g. 32 or 64 bit for float values). The method enables the extraction of the parallel computing blocks, also for complex cases as an implementation of a 2d heat equation implementation as in Fig. 55 shown. EV3 enables the extraction of parallel computing blocks without resolving all data dependencies and retrieves the number of parallel computation blocks in the loop *n*_{∥} = *n_{isub}* · *n_{jsub}*, see figure 64. This data size information enables to retrieve the needed number of qubits as a function of runtime-time parameters (*n_{isub}* and *n_{jsub}* are a function of nX and nY = mesh, respectively problem size). The computational base for quantum computations is defined by 2*ⁿ*, where n is the number of qubits. As the method enables to extract from the parallel computation blocks parallel combinational circuits (figure 111g) the method is able to derive unitary matrices (quantum gates) to compute a set of input bits as in figure 114 shown with f(x).

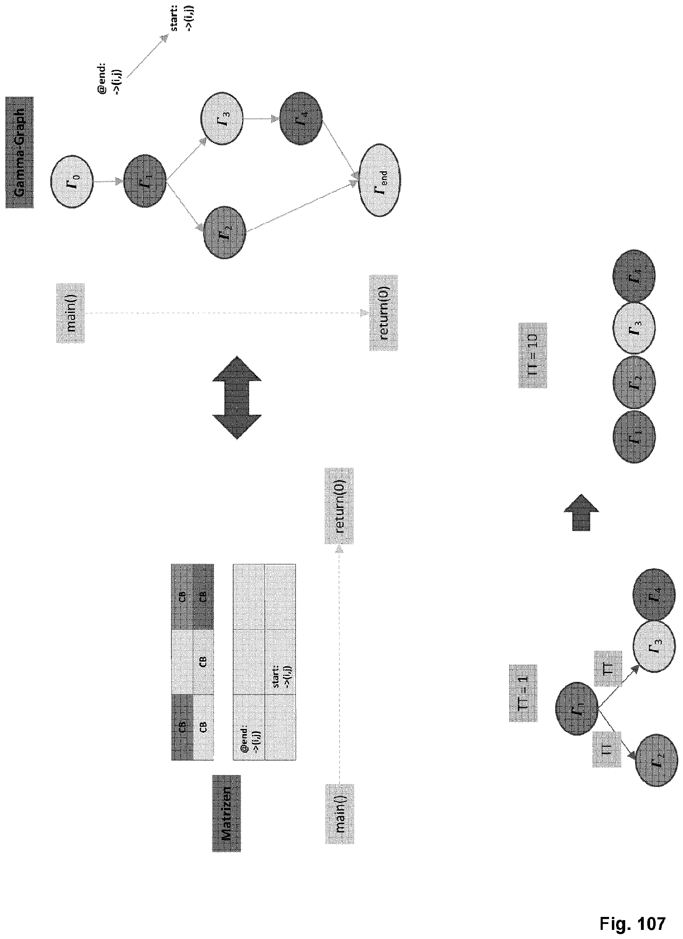

Figure 107 shows a block diagram schematically illustrating the embodiment variant EV2 of figure 106 more detailed. The embodiment variant EV2 comprises the process of building the gamma graph out of the computation block node 333 of EV 1, wherein the computation block node 333 and gamma-node in the initial granularity composed of the cell in the computational matrix. Gamma-nodes connected with one edge can be combined in a later step to one gamma-node, as they consist of one compute segment. A compute segment is a series of CBs of the same branch node 334 without any transfers in the transfer matrix. This allows e.g. for a processor-architecture specific and/or system-architecture specific optimized auto-parallelization in respect to the number of processors 2102/2103, the performance of the different processors/cores 2102/2103 and/or processor units 21, the differences in size and response time of the different memory units 22, in particular the different processor registers 2211 and/or processor caches 2212 and/or RAM units 2213. In the representation of the gamma-graph the edges represent transfers Δ*tₜᵣₐₙₛₑᵣ*. This enables new, bounded optimizing approaches, e.g. to reform a gamma-node by fixing all transfers Δ*tₜᵣₐₙₛₑᵣ* by a hardware defined Transfer Times (TT). Traversing the graph it is feasible to define for a parent node by combining child nodes (runnable in parallel) if it is beneficial to compute the child nodes in parallel and adding the transfer overhead TT or run all or some of the child node in serial (e.g. in a multithreading environment can TT be seen as the context switch time) without having the overhead of parallelizing.

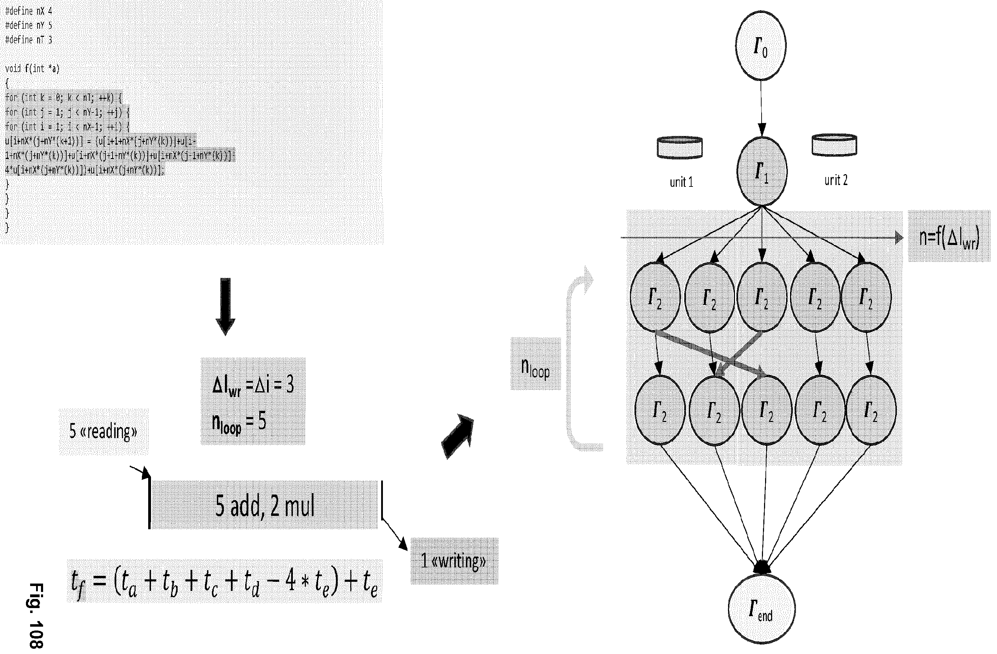

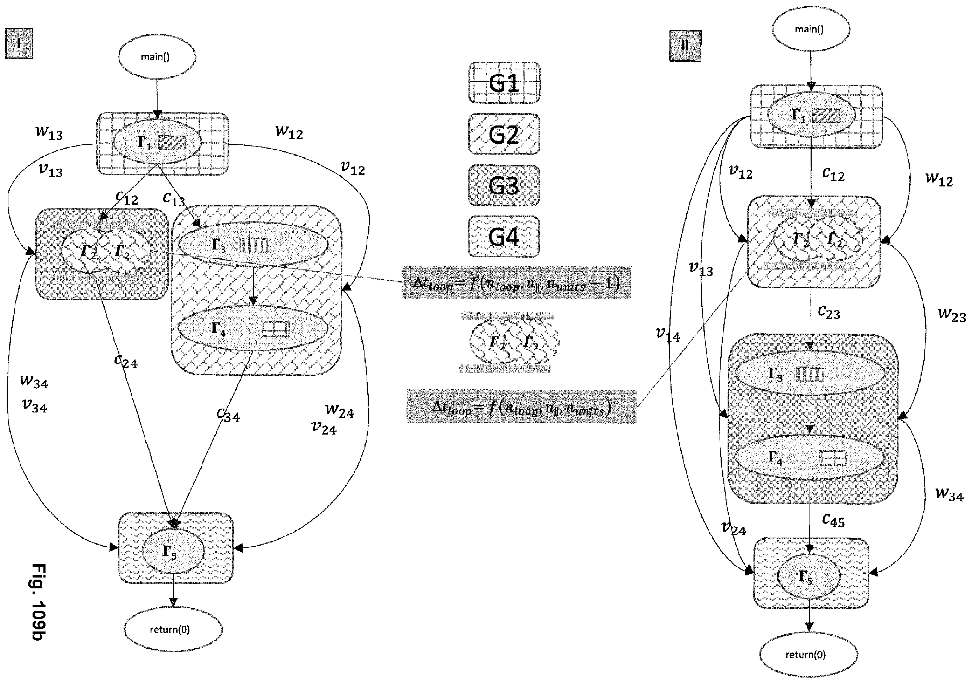

Figure 108 shows a block diagram schematically illustrating the embodiment variant EV3 of figure 106 more detailed by illustrating the applications of the inventive system 1 to loop parallelization. This can be illustrated along the 2d heat equation example, where a gamma-graph can be derived as a function of the read-write distance Δ*I_{rw}* obtained by the array read and write statements formed by accessing the array u[i+nX*(j*nY*k)] in the loop-body. The change of the loop-variable i, j and k and their dependency on the runtime-variables can be obtained from the loop-header/latch. It is to be noted that since parallelization, i.e. optimized generation of multi-core or multi-processor code (in particular the task scheduling) is considered of most of the codes as NP-complete problem, the predominant opinion in the prior art is that optimized parallelization can only by achieved applying heuristics. The method with EV3 allows for loop-sections with statements including random access data structures in conjunction with loop-variables, a non NP-complete solution. Normally, loop-sections are where in codes the highest computational effort emerge. The inventive system EV3 and method allow to get a simple, non NP-complete system for loop-sections. Studies performed on a running system of the present invention proved by starting from discretized 2D heat equation (PDE) source code to provide optimized executable Message Passing Interface (MPI) parallel code (send and receive principle, i.e. data dependence must be fully resolved), where MPI is a portable message-passing standard designed to function on parallel computing architectures. Additionally, EV3 and method allow to reduce the complexity in finding optimal solution with exact or heuristic methods in EV1 and 2, see Fig. 109b.

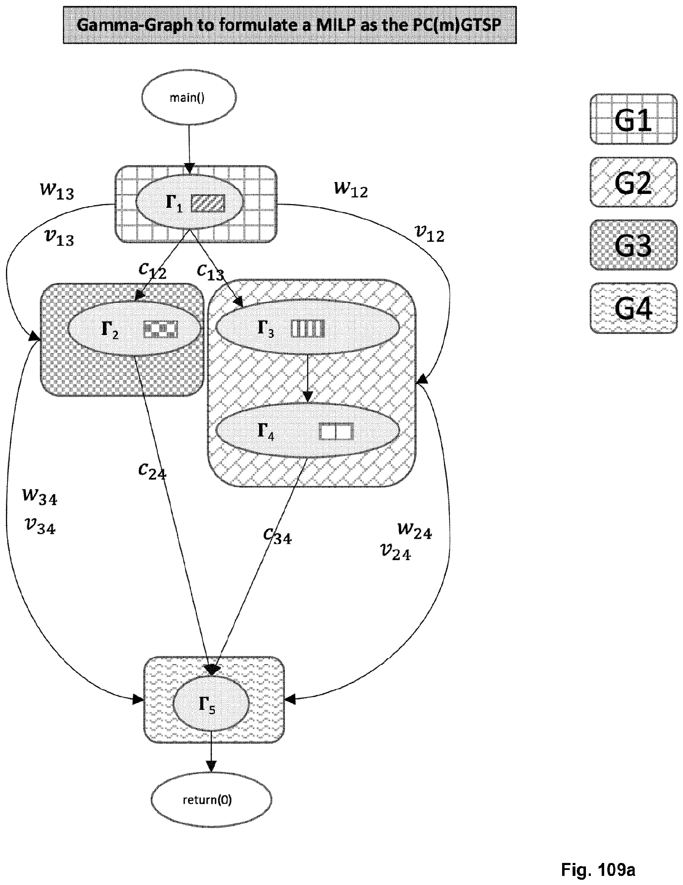

Figure 109a shows a block diagram schematically illustrating the embodiment variant EV2 of figure 106 more detailed by illustrating the applications of the inventive system 1 to generate a gamma-graph, which can describe a Mixed Linear Integer Programming problem (MLIP). A general integer linear programming (ILP) problem is defined as: ${z}_{ILP}^{∗} : = minimum z \left(x\right) : = {c}^{T} x$ $Ax \leq b und x ∈ {ℤ}_{+}^{n}$ where $z : = {ℤ}^{n} \to ℤ$ denotes the objective function with its set of feasible solutions by ${S}_{ILP} : = \left\{x∈{ℤ}_{+}^{n}:Ax\leq b\right\}$. As an example following the work described in R. Salman, "Algorithms for the Precedence Constrained Generalized Travelling Salesperson Problem", Chalmers University of Technology, University of Gothenburg, Sweden 2015, the problem of optimizing the gamma-graph can be formulated as a MILP problem such as the proposed Precedence Constrained Generalized Travelling Salesperson Problem (PCGTSP). With such a set of equation, the optimization on one unit can be optimized or at least approximated with heuristic methods. Extending the problem to a parallel machine with m units, the optimization method can be used, as e.g. disclosed by R. Salman, "Optimizing and Approximating Algorithms for the Single and Multiple Agent Precedence Constrained Generalized Traveling Salesman Problem", Chalmers University of Technology, University of Gothenburg, Sweden 2015 in paper III F. Ekstedt, et al., "A Hybridized Ant Colony System Approach to the Precedence Constrained Generalized Multiple Traveling Salesman Problem", 2017. In particular, the system of equations and objective function with reference on page 19 and 20 (5.3a) - (5.3m), disclosed in this document can e.g. be used to generate a gamma-graph solving the discussed optimization problem of the computational and transfer matrices. Finally, this leads directly to a definition of a Precedence Constrained Generalized Multiple Traveling Salesman Problem (PCGmTSP). As the optimization step can be done during compile-time, the computational effort to cover the generic situation of code and heterogeneous hardware granularity can be (very) high from an application perspective.
Figure 109b shows how EV2 can be combined in EV3. Each loop-section can be condensed and approximated to a Δ*tₗₒₒₚ* time as a function of the properties in EV3 *nₗₒₒₚ*, *n*_{∥} which can be expressed as a function of loop-variables: Δ*tₗₒₒₚ* = *f*(*nₗₒₒₚ*,*n*_{∥}, *nᵤₙᵢₜₛ*). This enables e.g. to generate MILP based on two different simplification:
   I. depending on the number of parallel groups in the gamma-node, the amount of *nᵤₙᵢₜₛ* assigned to a loop-section is defined and optimized.
   II. all units are used to compute loop-sections, which separates code between different loop-sections to be optimized separately, what reduces the overall complexity.
Figure 110 shows a block diagram schematically illustrating the embodiment variant EV4 of figure 106 more detailed by illustrating the applications of the inventive system 1 in its use for optimization of integrated circuit (IC) or chip design solving electronics engineering technical problem if IC design by encompassing logic and circuit design required to design integrated circuits, or ICs.

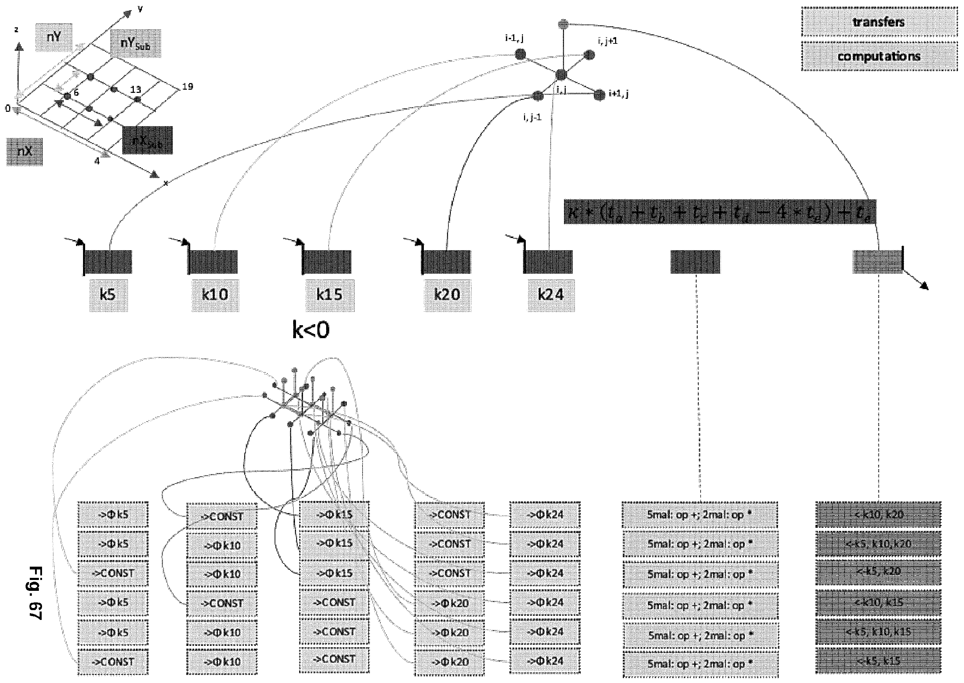

Figures 111a to 111h show block diagrams schematically illustrating the inventive system applied for its usage for IC (Integrated Circuit) design. The inventive system 1 can be applied (see figure 106/110) for both designing and optimizing VLSI designs. Circuit design is about arranging transistors to perform a particular logic function. From the design, the delay and power can be estimated. Every circuit can be represented as a schematic or in textual form as a netlist. Simply illustrated (see figure 111a), digital logic can be divided into combinational circuits (Boolean logic), whose outputs depend only on the present inputs (series of logic gates), and sequential circuits, whose building blocks are registers (flip-flops) and latches. The Inventive System 1 can be used to determine the computation block nodes. The computation block nodes in turn can be used to determine the digital logic, which will be illustrated by the example of the 2D heat equation. Fig. 67 shows that a computation block node for this algorithm consists of 5 reads, 1 compute and 1 write (figure 111b). The result of a simple circuit is shown in Fig. 111c. The reads become the sequential circuits consisting of 5 flip-flops (together they form the register, though, the effective register size is determined by the bit length of the individual data). It is assumed that a rising-edge of the clock (time k), wait for the required hold-time to be sure that the correct values (logical 0 or 1) for u[k] [i+1] [j], u[k] [i-1][j], u[k][i][j+1], u[k][i][j-1] and u[k] [i] [j] are present at the output of the flip-flops. This is basically our read. The data can now propagate through the combinational circuit (computational block), which results from the arithmetic consisting of the required adder, shifter (multiplication by 4), subtractor (inverter and adder combined) and multiplier. At the output of the computational block the value u[k+1] arises (equivalent to the write operation) after the setup time, which is the amount of time required for the input of a flip-flop to be stable before a next clock edge. The register on the right side is nothing else than the value at the next time k+1, which is needed for the next iteration on the left side. From this results that the values can be written directly into the same register. This thought experiment can now be carried out for each point on the computation matrix. Already for two points on the matrix (Fig. 111d) it becomes obvious that data are now written crosswise or that only one register per matrix point is needed. The computational block (CB) always consists of the same combinational circuit, although in the electronic implementation the propagation delays will never be the same. It is therefore important to keep an eye on the critical paths that limit the operating speed of the system and require attention to timing details. Real world settings are always limited in space with VLSI design. An infinite parallelizability is not possible, so certain (not all) computational blocks are combined and processed sequentially. To make this possible for a finite number of registers, a multiplexer is connected between the output of the registers and the input to the CB. A multiplexer chooses the output from among several inputs based on a select signal. At the same time, a demultiplexer is connected between the output of the CB and the register input (see Fig. 111e) to feed the data back correctly, whereby the design optimization process might show that the demultiplexer is not always need. What is processed per clock rate on the ideal, parallel circuit is now processed in several clock cycles in the more realistic circuit (Fig. 111f/g) - as much parallel as possible in as many cycles until a complete iteration is completed. Using the 4x5 matrix from Fig. 67 as an example, this would mean: With 6 parallel CBs: 1 cycle to calculate k+1, with 3 parallel CBS: 2 cycles (2x3 parallel) including a higher delay do to multiplexing. VLSI designers always must make trade-offs between area, throughput, latency, power consumption and energy of executing a task. The optimal circuit is always located somewhere on an inverse curve (see Fig. 111h). If there is a lot of area available, parallelization can be done well. If there is less area available, the system must multiplex, which leads to a higher delay. Somewhere in between lies the optimal point between area and number of parallel CBs. Since the inventive system 1 can give the optimal code for a given unit, it can also be used to find the optimal circuit for a given area, helping in the iterative design process refined as actual module sizes and critical paths become known.

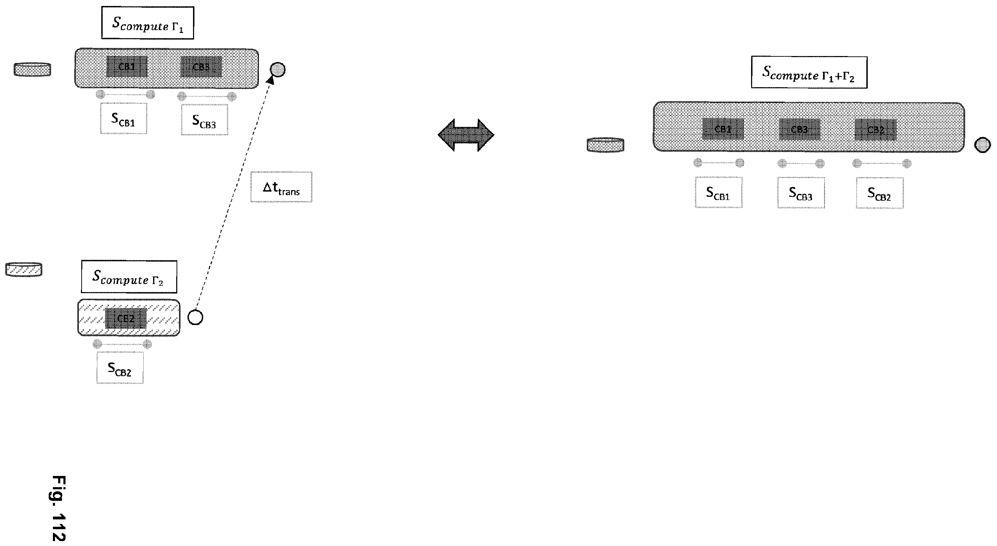

Figure 112 shows a block diagram schematically illustrating the effect of combination of CBs and the influence on *S_{compute}*, which is the (optimized = minimized) size needed to compute a series of instructions on a target platform (e.g. register). It has to be noted, that *S_{compute}* Γ₁+Γ₂ ≠ *S_{compute}* Γ₁ *+ S_{compute}* Γ₂· *S_{compute}* Γ₁+Γ₂ as *S_{compute}* Γ₁+Γ₂ depends on the instructions in CB1, CB2 and CB3, target architecture (available instruction sets and data space characteristics, e.g. registers in a CPU or flip-lop / input signal in an IC-circuit) and used method to ILP optimization and scheduling.
Figure 113 exemplarily shows the classical computation for input xi to output by f(x).
Figure 114 illustrates the application of f(x) to input bits and keeping the 'garbage' values during computing the result of f(x) enables to uncompute f(x) = reversible form.

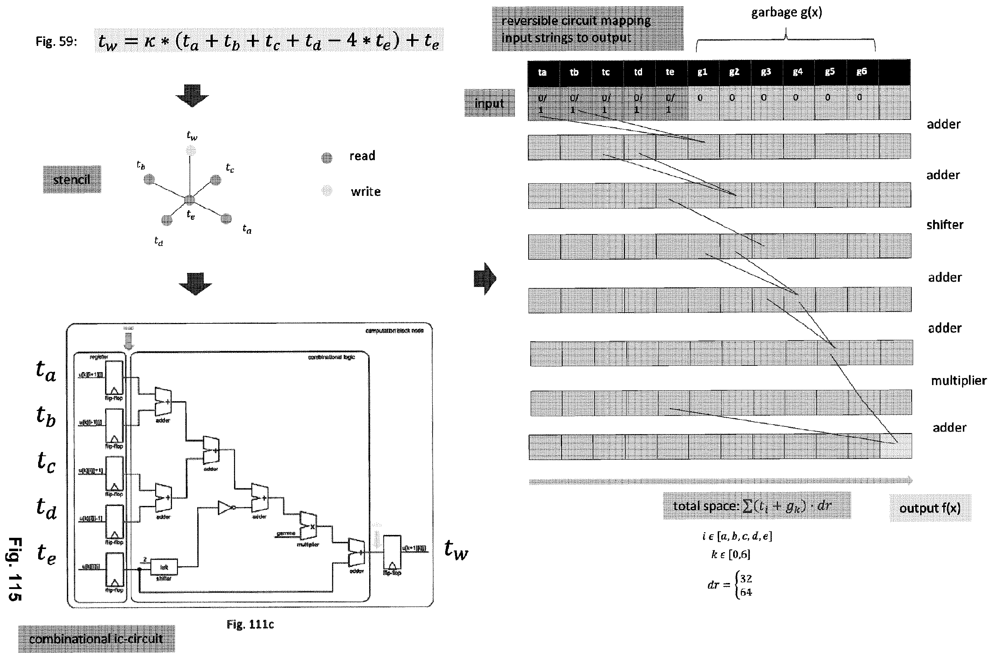

Figure 115 illustrates the application from statement in code to a combinational circuit and resulting reversible forms.
Figure 116 shows an exemplary block diagram illustrating a timing path between two flip-flops.
Figures 117 show exemplary block diagrams illustrating NAND gate and inverter formed from transistors, in particular 117a-d.
Figure 117a shows an exemplary block diagram illustrating a 2-Input NAND gate schematic and symbol.
Figure 117b shows an exemplary block diagram illustrating a 2-Input NAND gate schematic *Y* = *A̅•̅B̅*.
Figure 117c shows an exemplary block diagram illustrating an inverter schematic and symbol.
Figure 117d shows an exemplary block diagram illustrating a 2-Input NAND gate schematic *Y* = *A̅*.
Figure 117e shows an exemplary block diagram illustrating a 3-Input NAND gate schematic *Y =* *̅A̅•̅B̅*̅•̅*̅C̅*̅.
Figures 118 show exemplarily block diagrams illustrating the function principle of a pMOS switch, in particular, how a pMOS switch works as a function of the voltage attached to the gate *V*_{g}, wherein in fig. 118a, a negative gate voltage is applied between a p-type body and a polysilicon gate. The positive mobile positive charged holes are attracted to the insulator (by the negative voltage at the gate); wherein in fig. 118b, when a positive voltage is attached to the gate, the free positive holes are pushed away from the insulator; wherein in fig. 118c, when the positive voltage to the gate is higher than a critical voltage *Vt* the free positive holes are pushed farer away and some free electrons in the body are attracted to the insulator.
Figure 119 shows an exemplary block diagram illustrating a nMOS transistor working with positive voltage at gate *V_{g}* higher than the trigger value *Vₜ*. A nMOS transistor consists of a gate, a source, and a drain, with p-type body and n-type channels. The derive principle of an electronical switch from one of the figures 118 is used to build a nMOS transistor, see figure 119.
Figure 120a shows an exemplary block diagram illustrating IV characteristics of ideal 4/2 *λ* nMos transistors.
Figure 120b shows an exemplary block diagram illustrating IV characteristics of ideal 4/2 *λ* pMos transistors.
Figure 121 shows an exemplary block diagram illustrating static sequencing methods.
Figure 122 shows an exemplary diagram illustrating a typical structure of a FPGA.

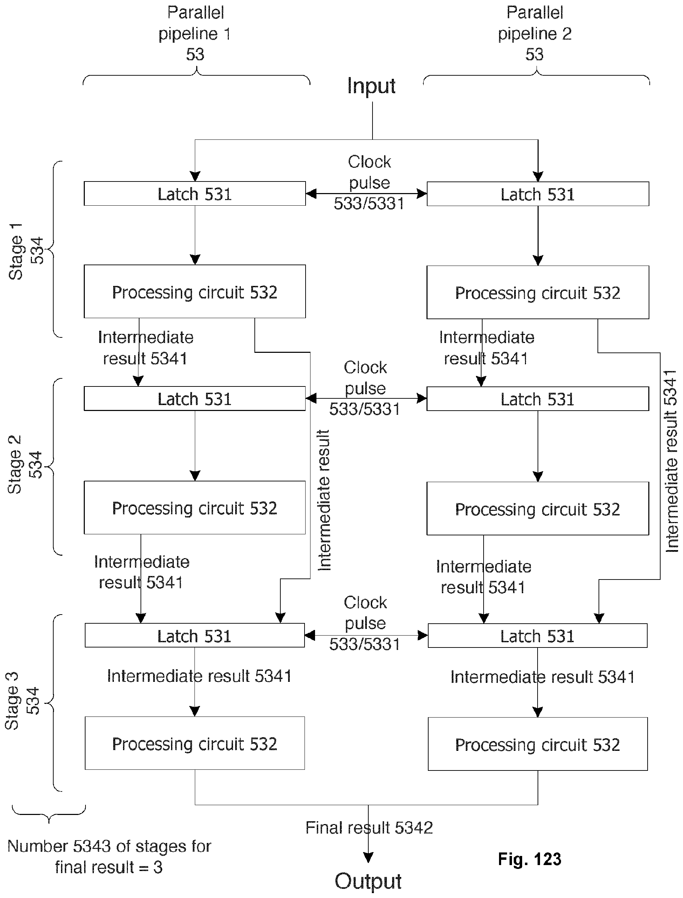

Figure 123 shows an exemplary block diagram illustrating three-stage dynamic parallel pipelines. A sequential process is decomposed into several sub processes, called stages or segments. A stage performs a particular function and produces an intermediate result. It consists of an input latch, also called a register or buffer, followed by a processing circuit. A processing circuit can be a combinational or sequential circuit.

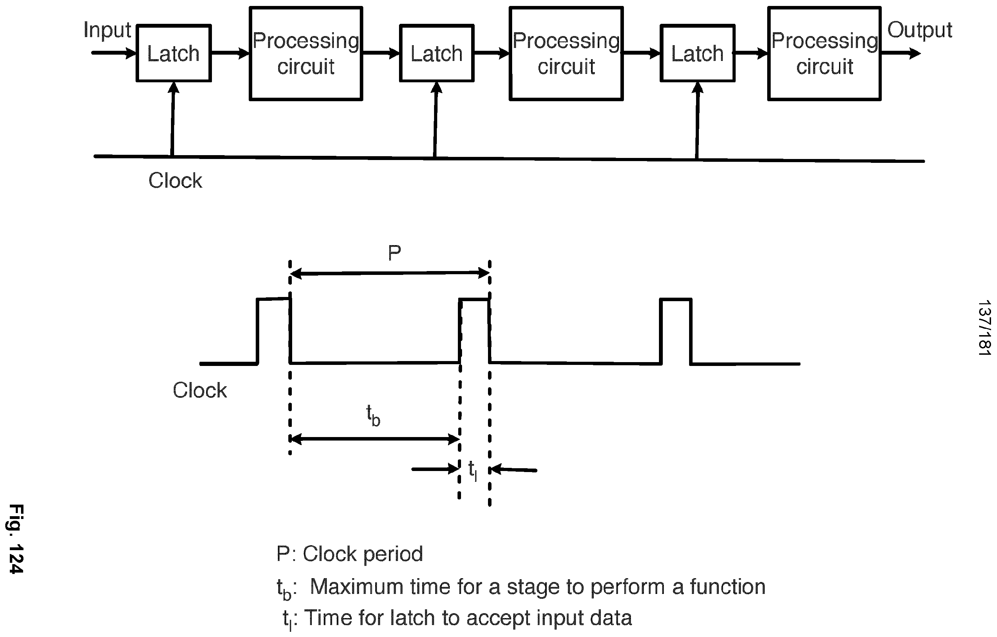

Figure 124 shows an exemplary block diagram illustrating the basic structure of a pipeline. The processing circuit of a given stage is connected to the input latch of the next stage. A clock signal is connected to each input latch. At each clock pulse, every stage transfers its intermediate result to the input latch of the next stage. In this way, the final result is produced after the input data have passed through the entire pipeline, completing one stage per clock pulse.

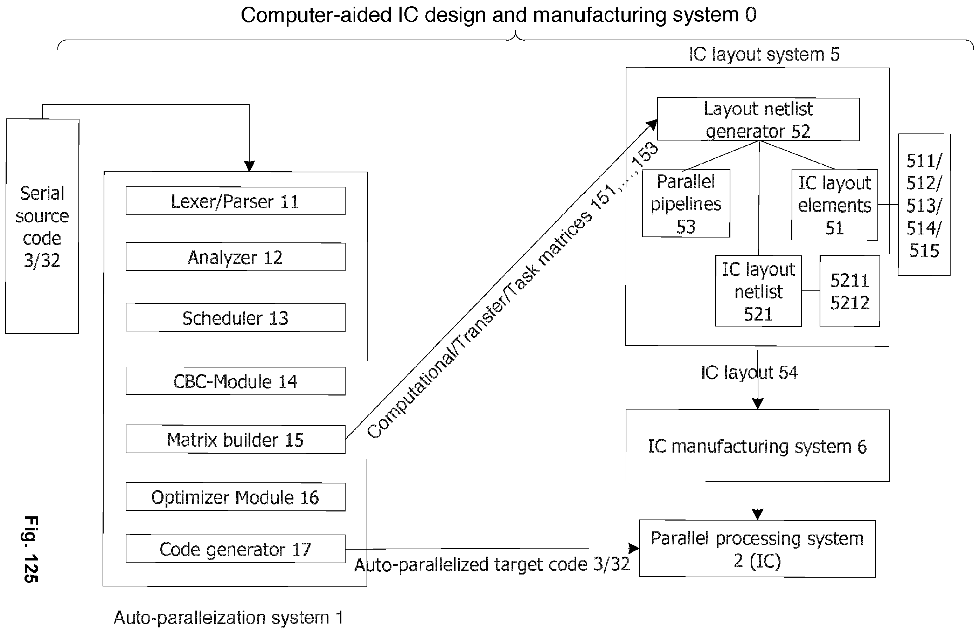

Figure 125 shows an exemplary block diagram illustrating an architecture for a possible implementation of an embodiment of the computer-aided IC design and manufacturing system 0 for optimized generation of a multi-core and/or multi-processor integrated circuit 2 architectures or layouts, integrated circuit 2 performance and integrated circuit 2 manufacturing yield.

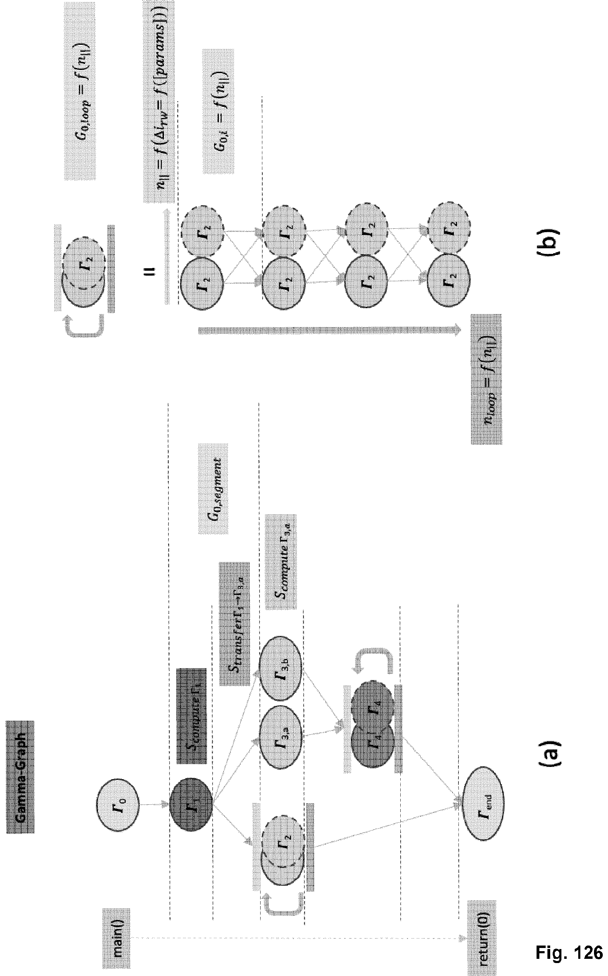

Figure 126 shows an exemplary block diagram illustrating (a) gamma graph (b) loop sections in a gamma-graph, represented by n_ll and n_loop derived from loop-body analysis as a function of runtime-parameters params.

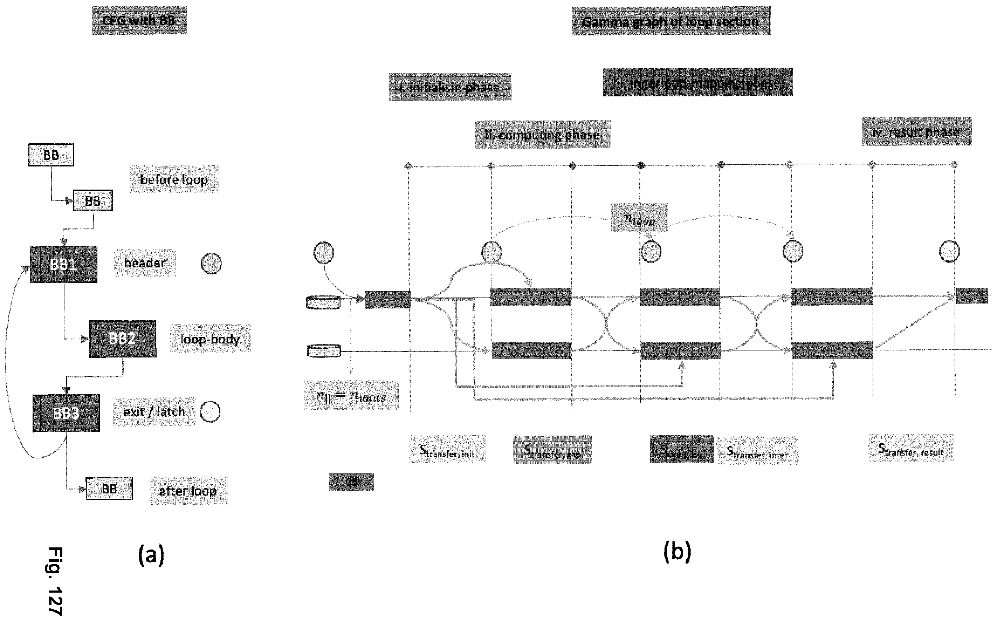

Figure 127 shows an exemplary block diagram illustrating how to come from loop-sections in (a) CFG with Basic Blocks to (b) a gamma-graph with different transfers for the different phases of a loop-section.

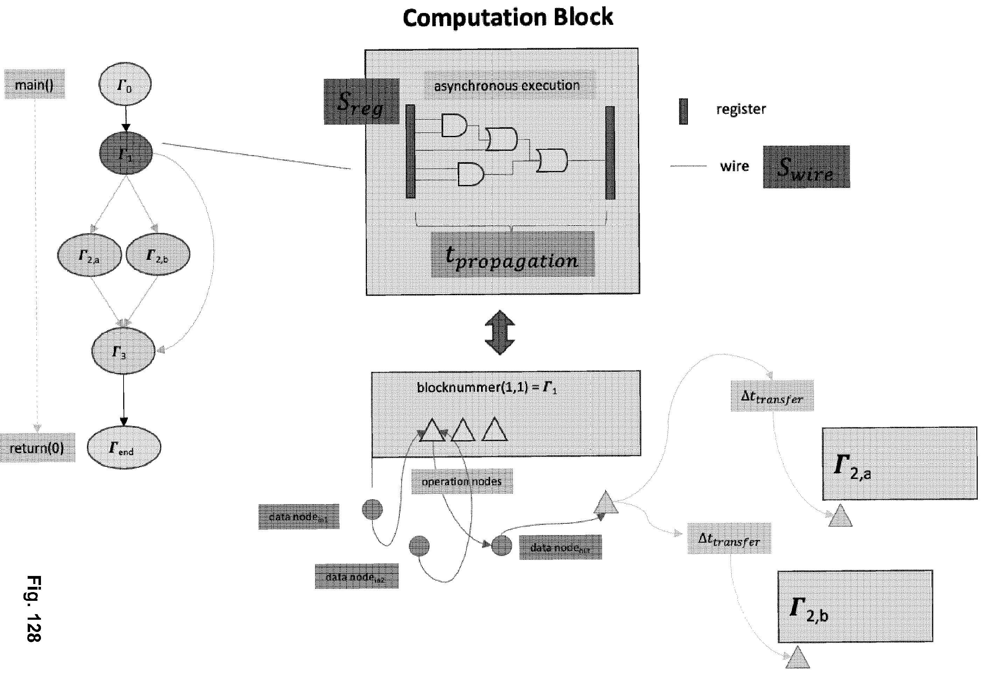

Figure 128 shows an exemplary block diagram illustrating a computation block (CB) forming a combinational logic with asynchronous computation.

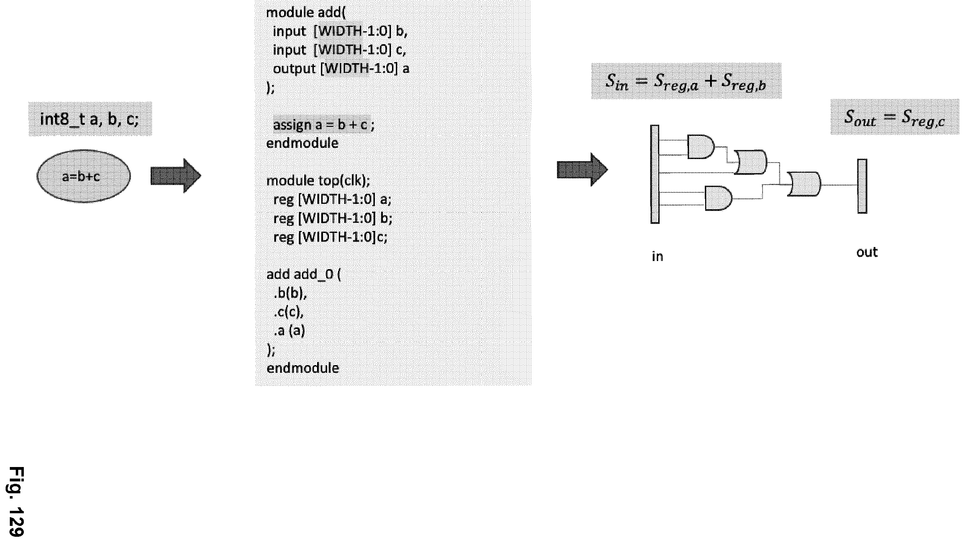

Figure 129 shows an exemplary block diagram illustrating how to get from Computation Block to Verilog code to synthesized logic gates.

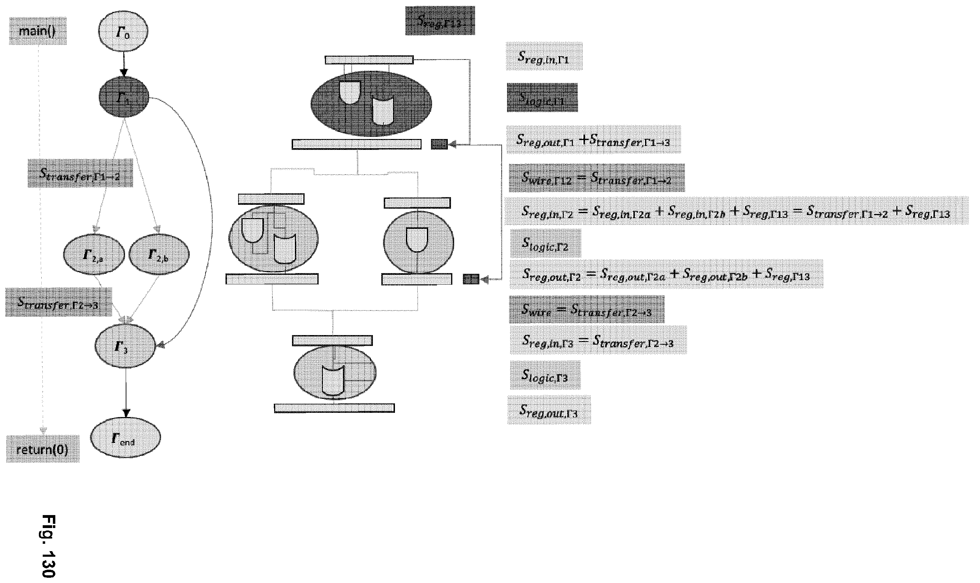

Figure 130 shows an exemplary block diagram illustrating how to get from gamma-graph to RTL-code by using registers to introduce a synchronous design and combinational computation for the parallel CBs.

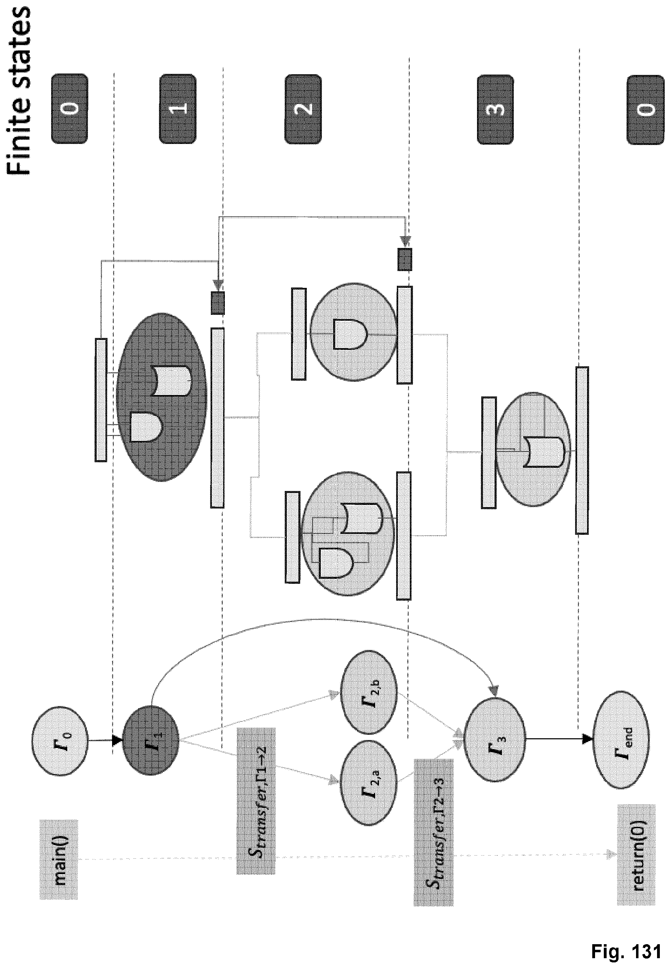

Figure 131 shows an exemplary block diagram illustrating a finite states in a gamma-graph.

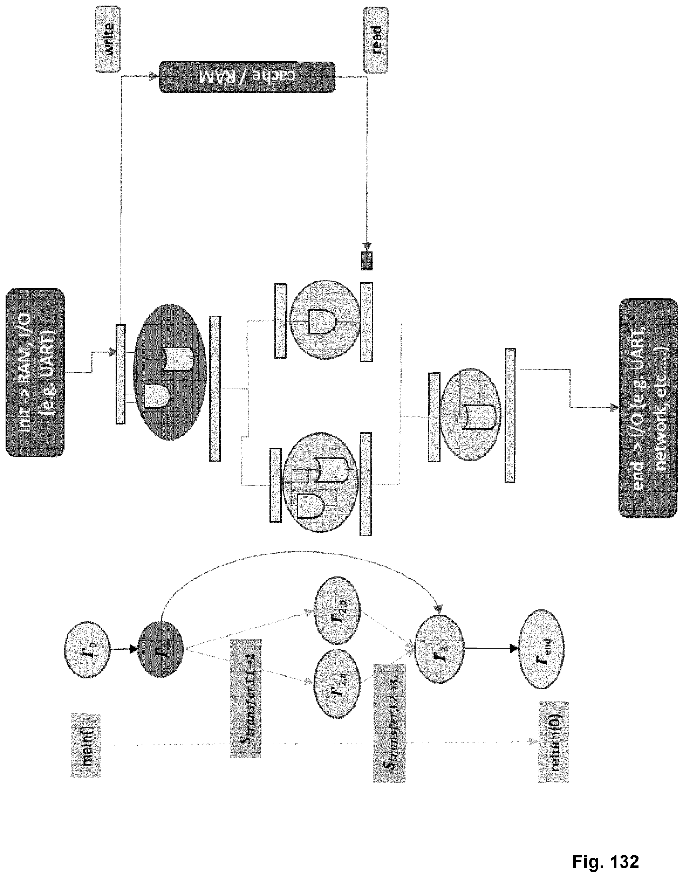

Figure 132 shows an exemplary block diagram illustrating the case of including I/O operations, respectively using on device or external RAM.

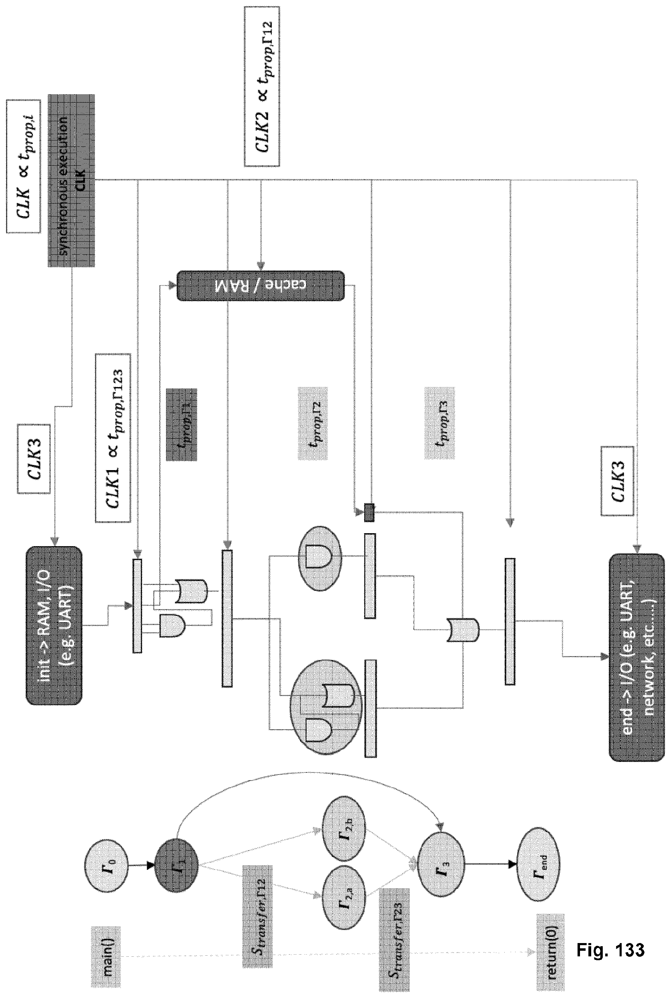

Figure 133 shows an exemplary block diagram illustrating defining clocking as a function of propagation times per level in the gamma-graph.

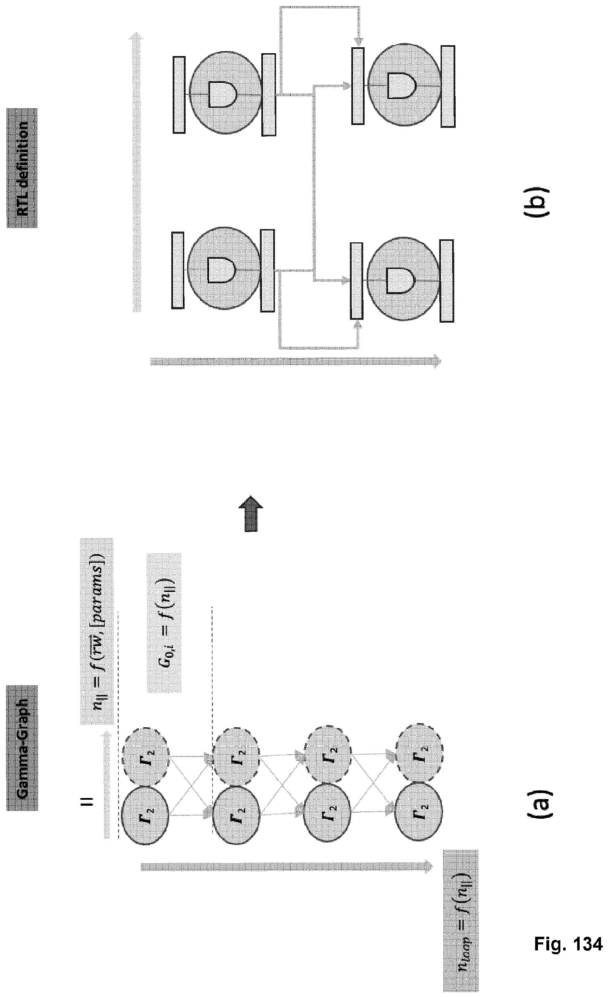

Figure 134 shows an exemplary block diagram illustrating getting from gamma-graph to an RTL-definition.

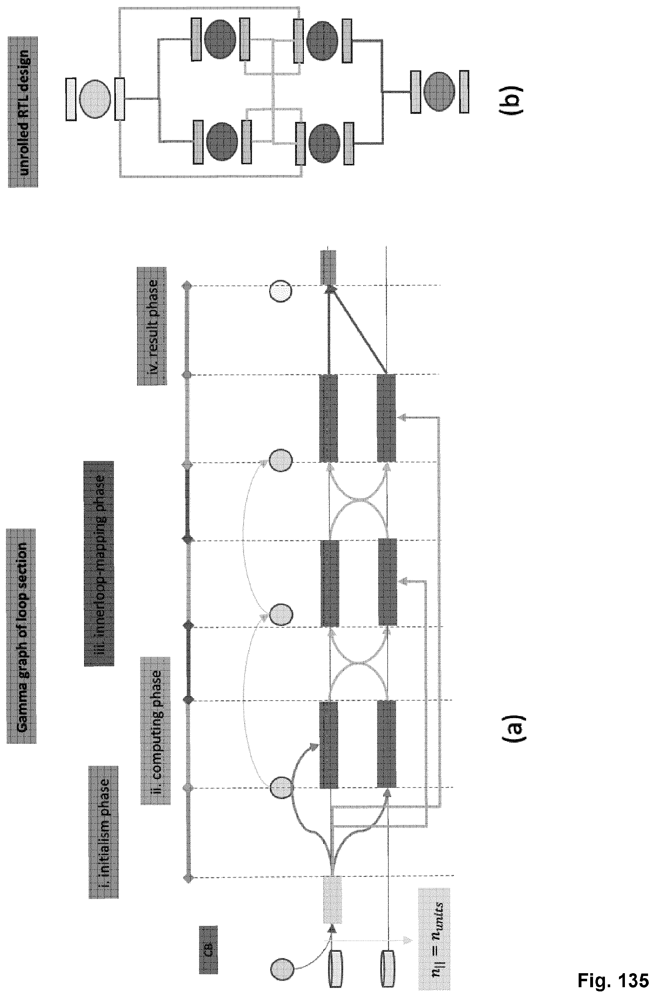

Figure 135 shows an exemplary block diagram illustrating phases in gamma-graphs of loop-sections and correlating unrolled RTL-design.

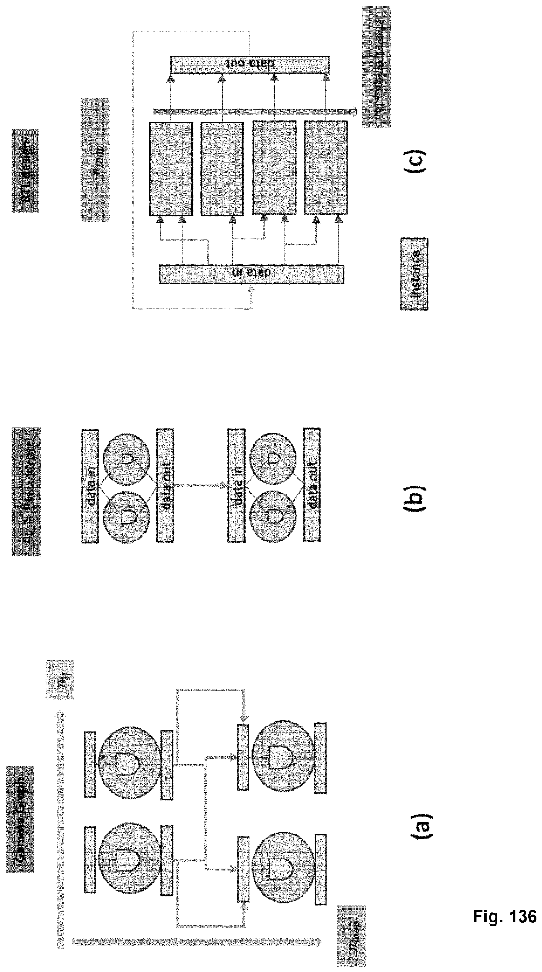

Figure 136 shows an exemplary block diagram illustrating getting from gamma-graph (a) with parallel CBs to an optimised IC-design with reduced data in and data out and maximal parallel instances to compute all parallel CBs per iteration (c).

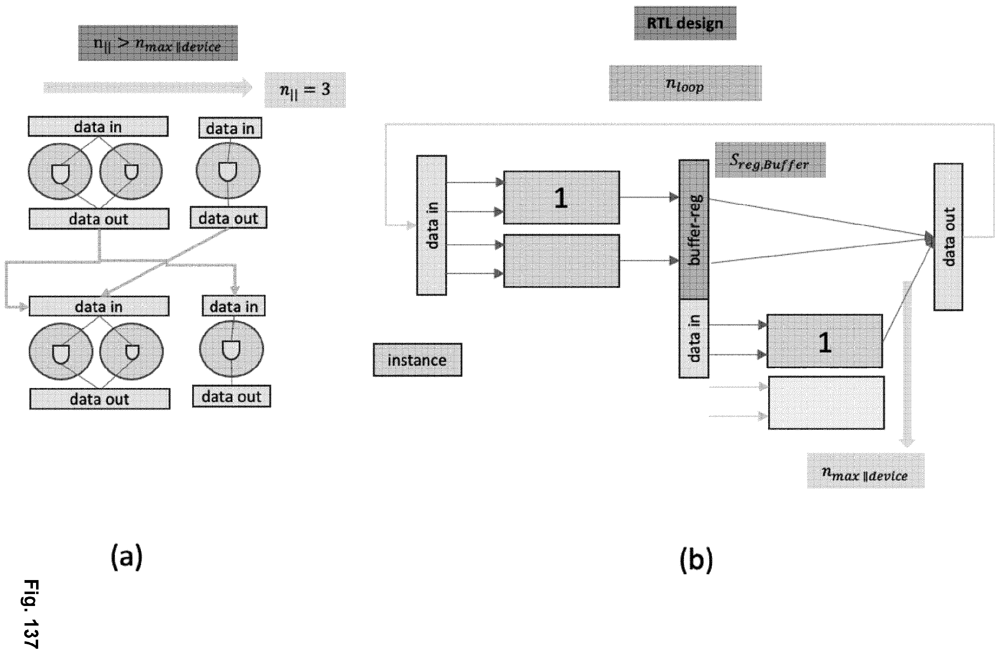

Figure 137 shows an exemplary block diagram illustrating using buffer-register to compute all parallel CBs with limited maximal parallel instances *n*_{*max*∥*device*}.

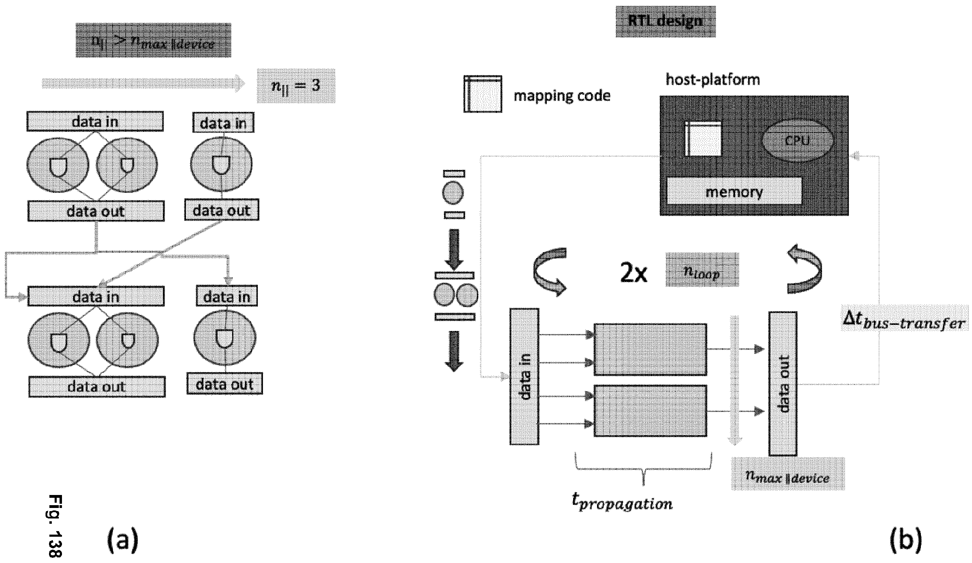

Figure 138 shows an exemplary block diagram illustrating using host platform to map and store interim results with additional latency to transfer data between device and host by an appropriate I/O-interface (bus).

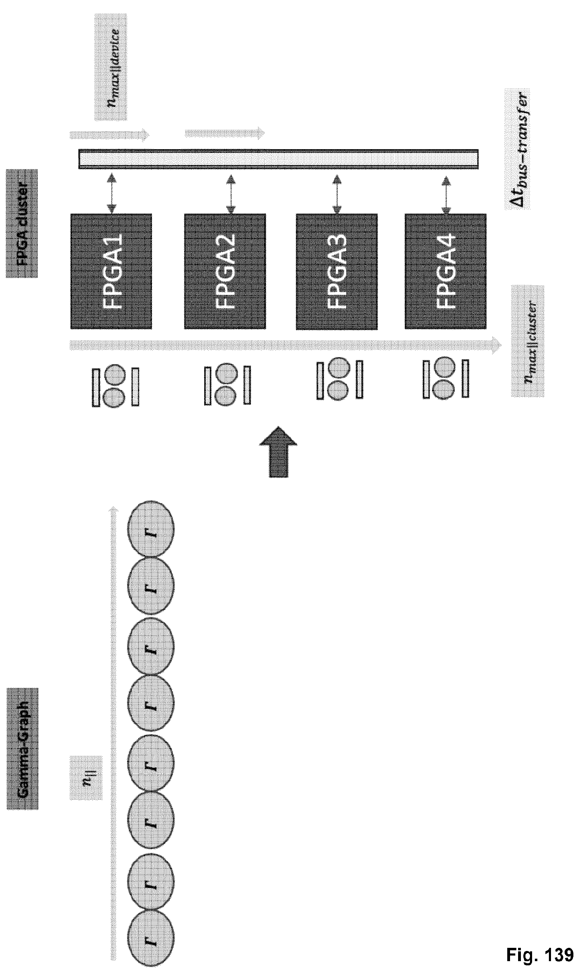

Figure 139 shows an exemplary block diagram illustrating an FPGA cluster as a larger area for parallel instances.

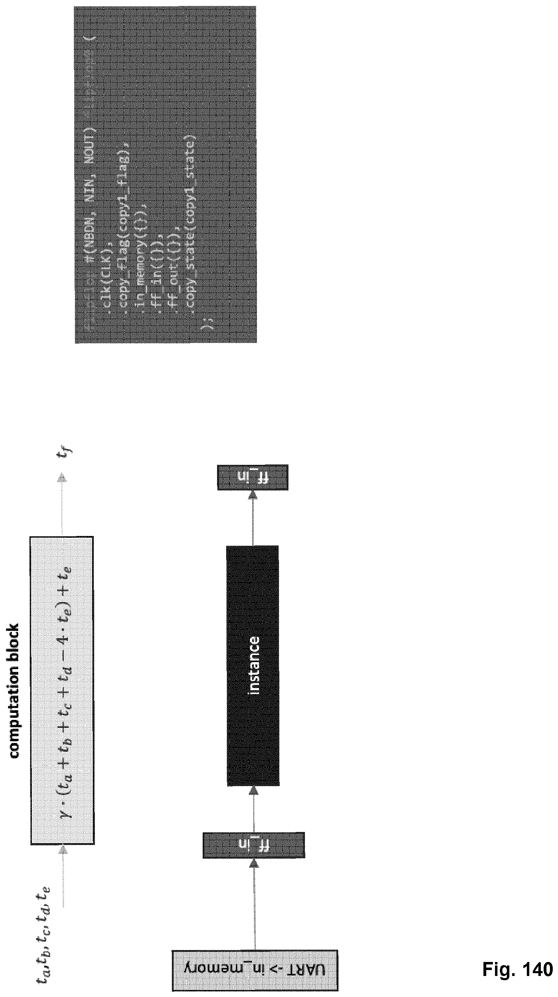

Figure 140 shows an exemplary block diagram illustrating a computation block and corresponding instance as one combinational block between two registers (flipflop).

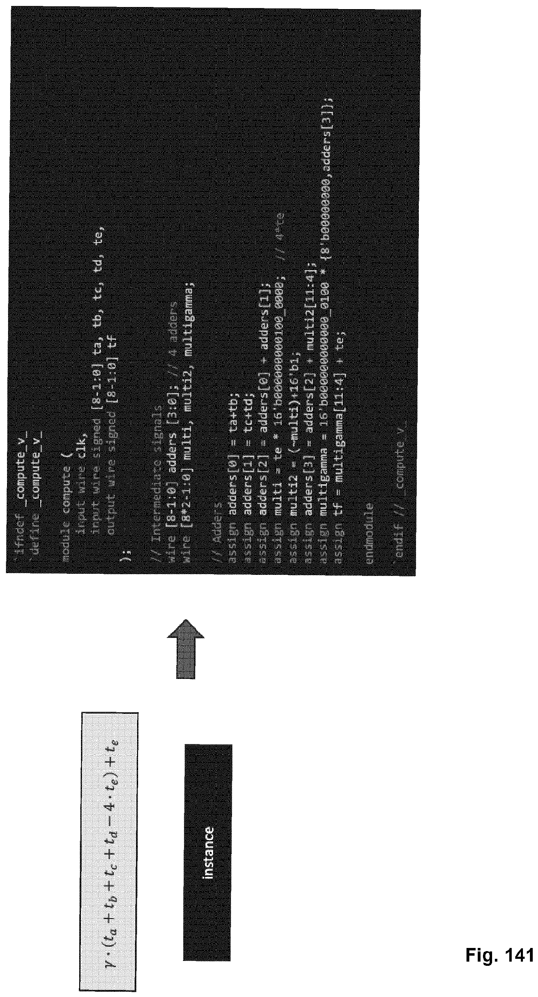

Figure 141 shows an exemplary block diagram illustrating getting from a Computation Block to a Verilog definition of the logic operations.

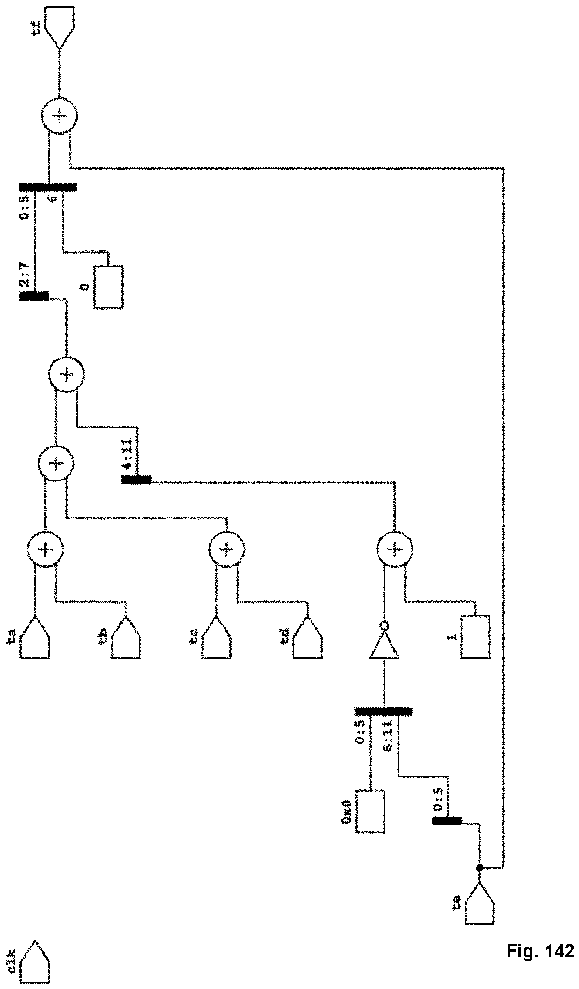

Figure 142 shows an exemplary schematic view of instance from Verilog code.

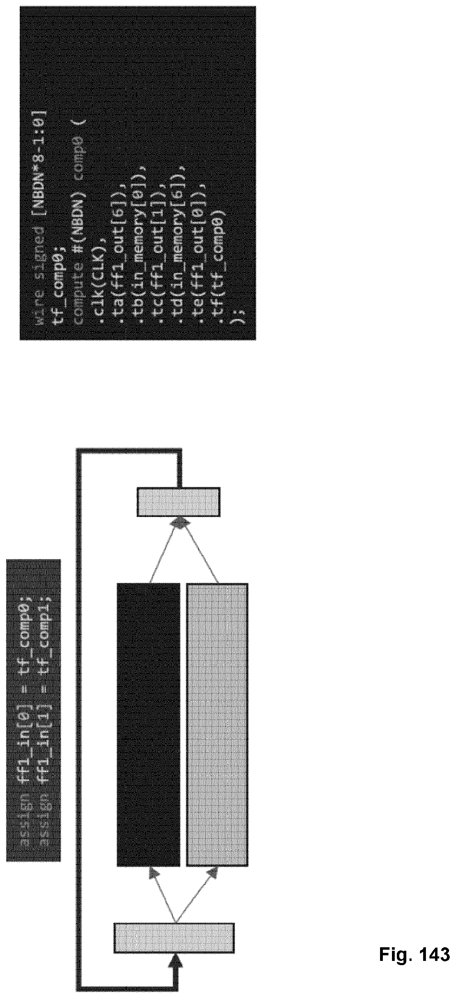

Figure 143 shows an exemplary block diagram illustrating composing parallel CBs and inner-transfers to an RTL-design.

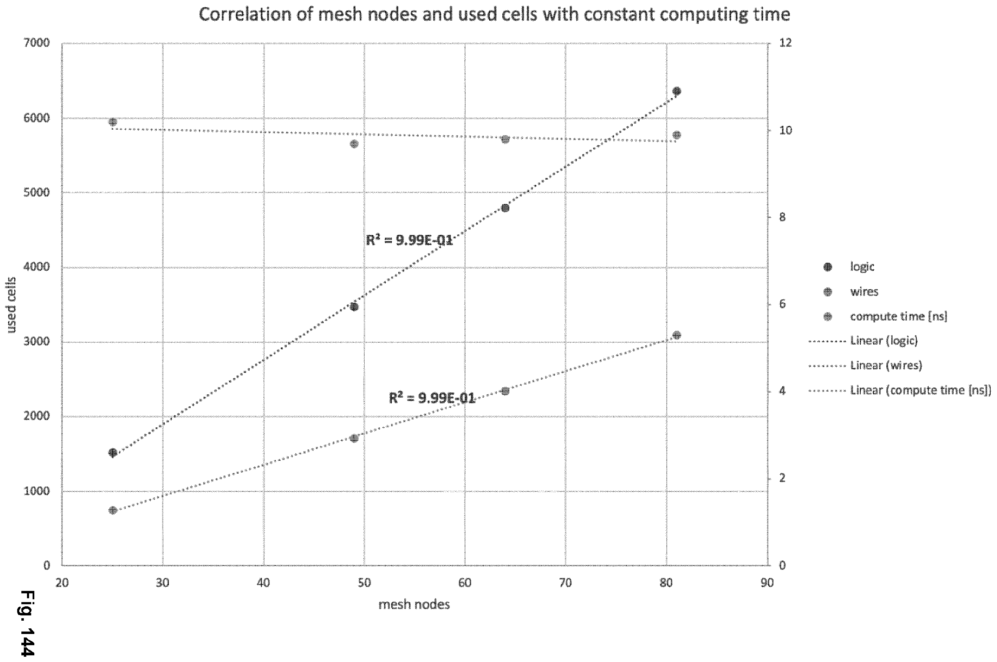

Figure 144 shows an exemplary block diagram illustrating used cells and logic computing time for 4 different meshes.

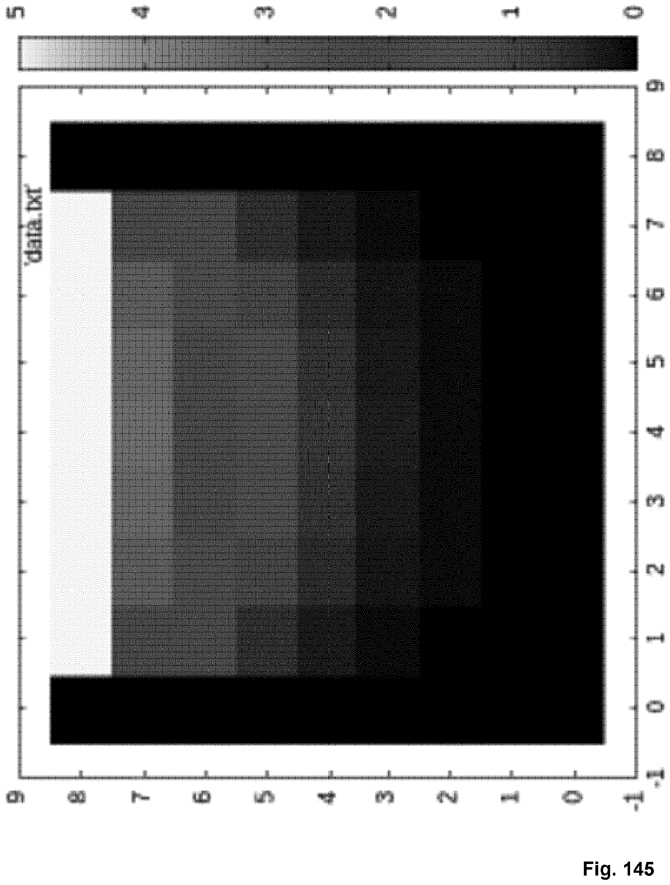

Figure 145 shows an exemplary block diagram illustrating a result after 10-iteration for a 9x9 mesh and the boundary condition of 5°C at the top boundary.

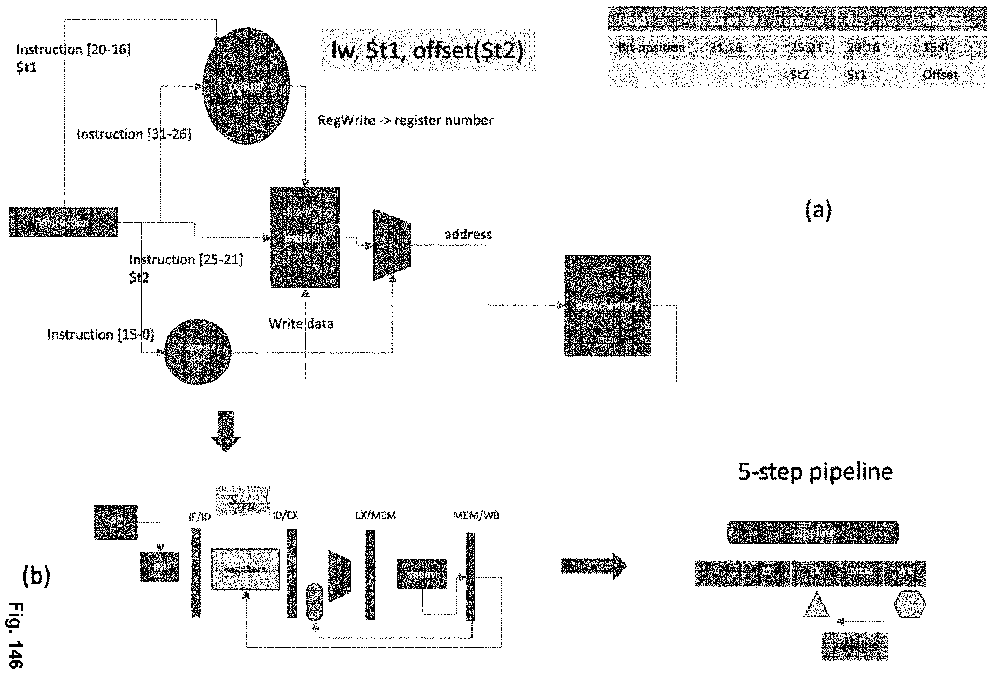

Figure 146 shows an exemplary block diagram illustrating storing (and load) as (a) IC-design (b) pipelines version.

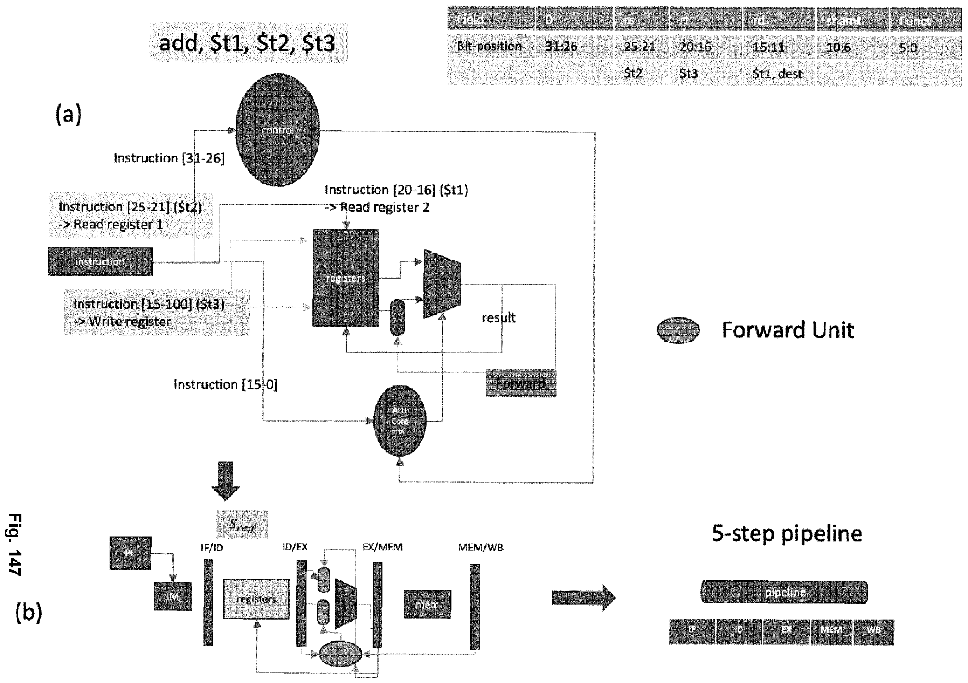

Figure 147 shows an exemplary block diagram illustrating an arithmetic (R) operation as (a) IC-design (b) pipelined version. Indicated Forwarding to use results from a previous instruction in the next cycle.

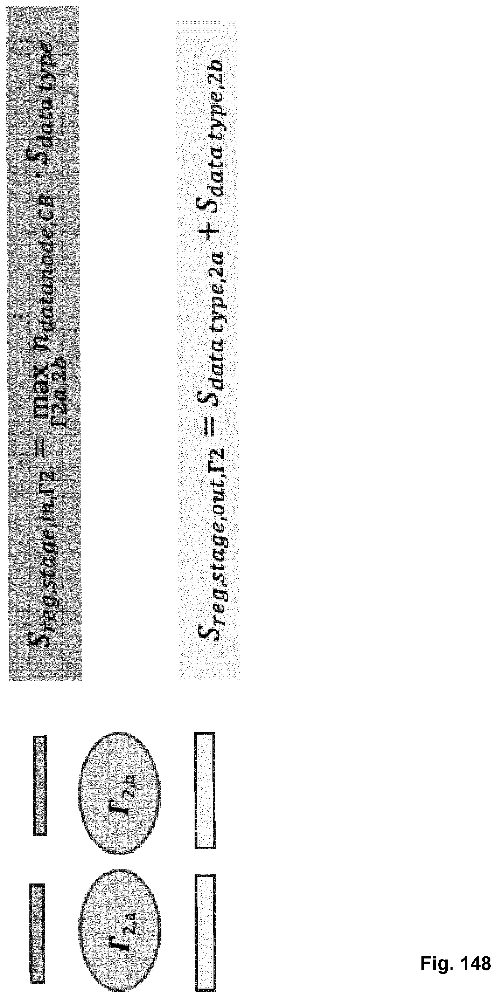

Figure 148 shows an exemplary block diagram illustrating a register-size per stage.

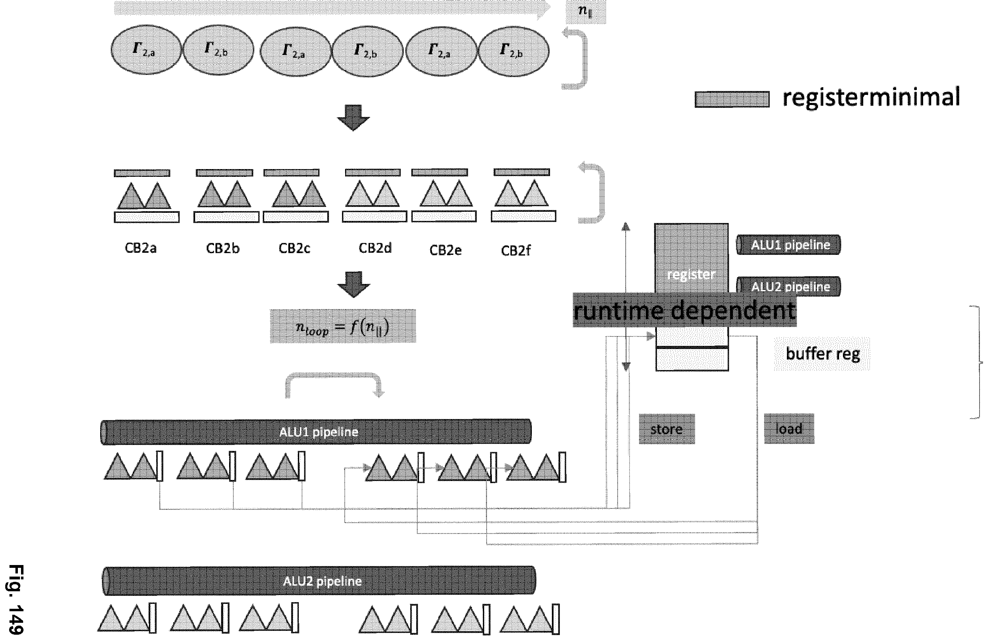

Figure 149 shows an exemplary block diagram scheduling parallel CBs to available pipelines.

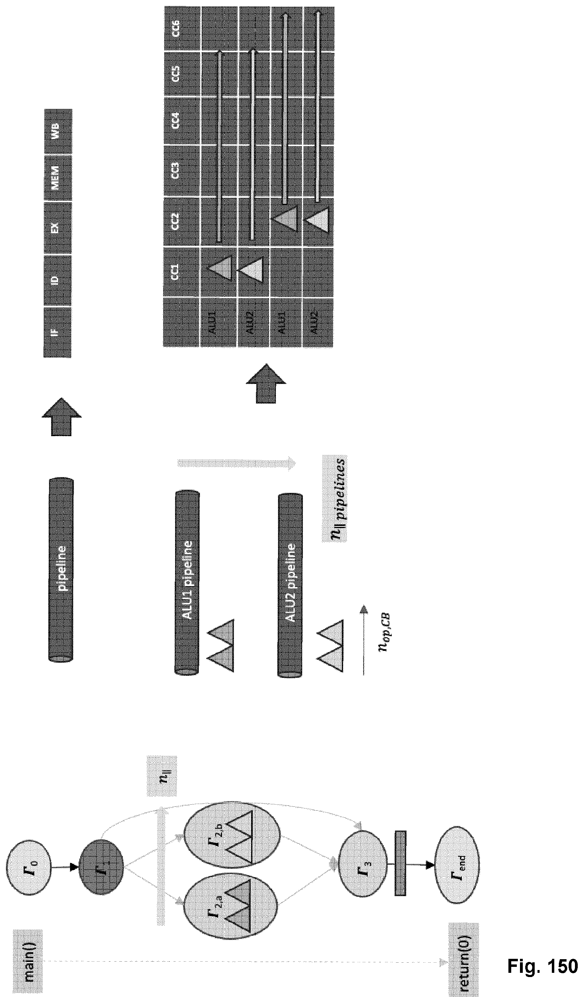

Figure 150 shows an exemplary block diagram scheduling Computation Blocks to parallel pipelines.

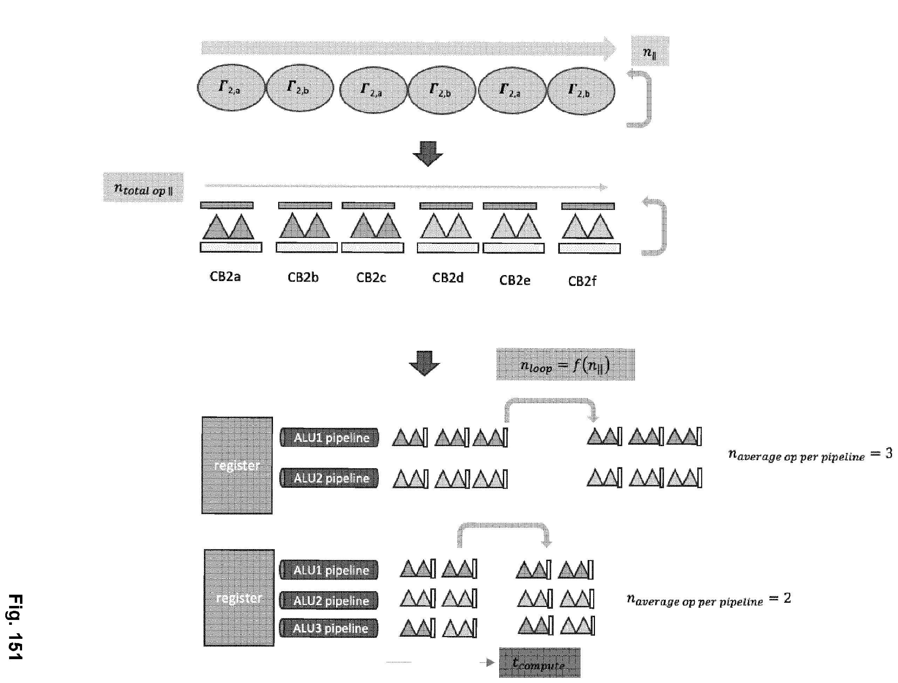

Figure 151 shows an exemplary block diagram a distribution of parallel CBs and link to needed registers and compute time.

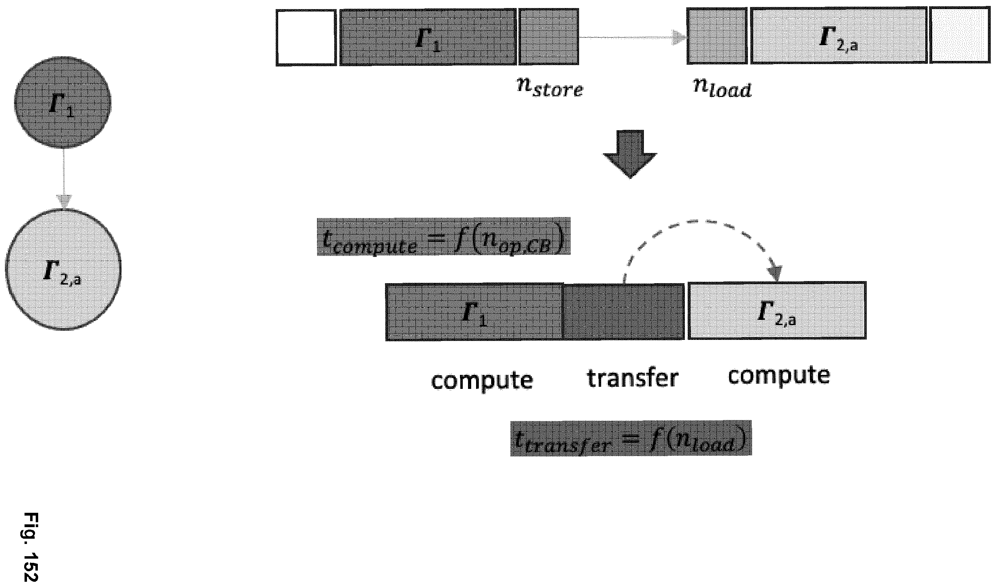

Figure 152 shows an exemplary block diagram load data for *Γ*_{*stage,k+*1} *= Γ*_{2*,a*} before *Γ_{stage,k} = Γ*₁.

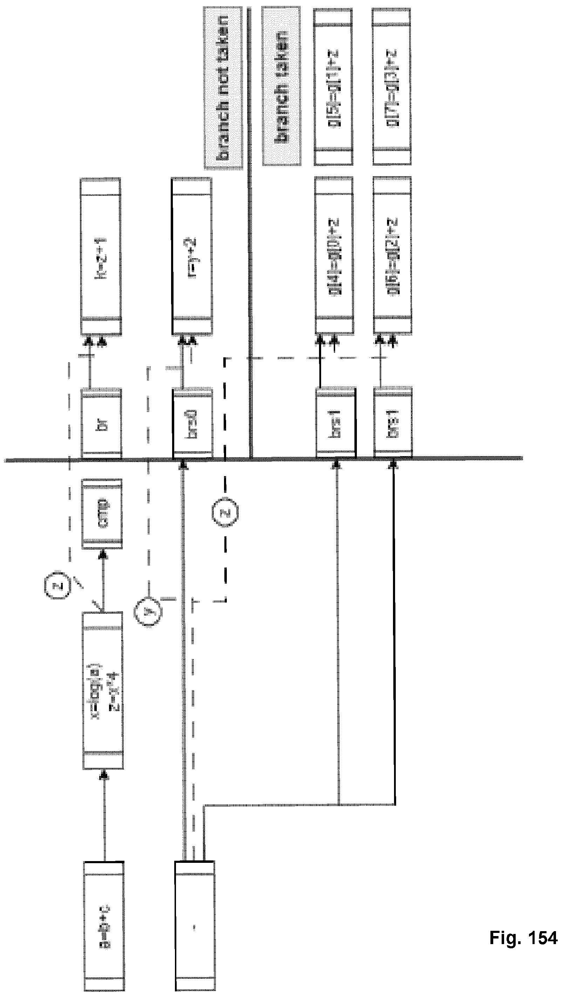

Figure 154 shows an exemplary block diagram illustrating a Computation Block for a demonstration code.

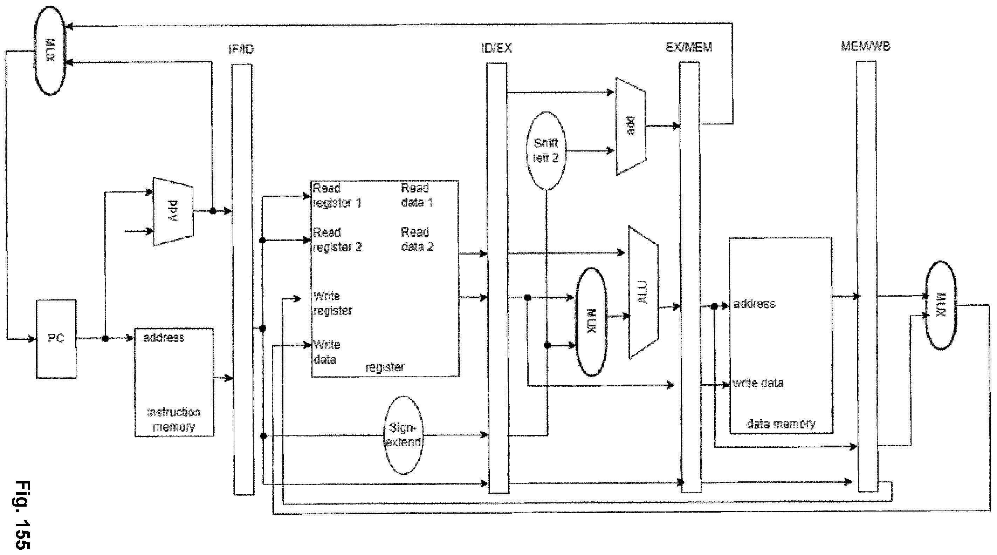

Figure 155 shows an exemplary block diagram illustrating a standard 5-stage pipeline.

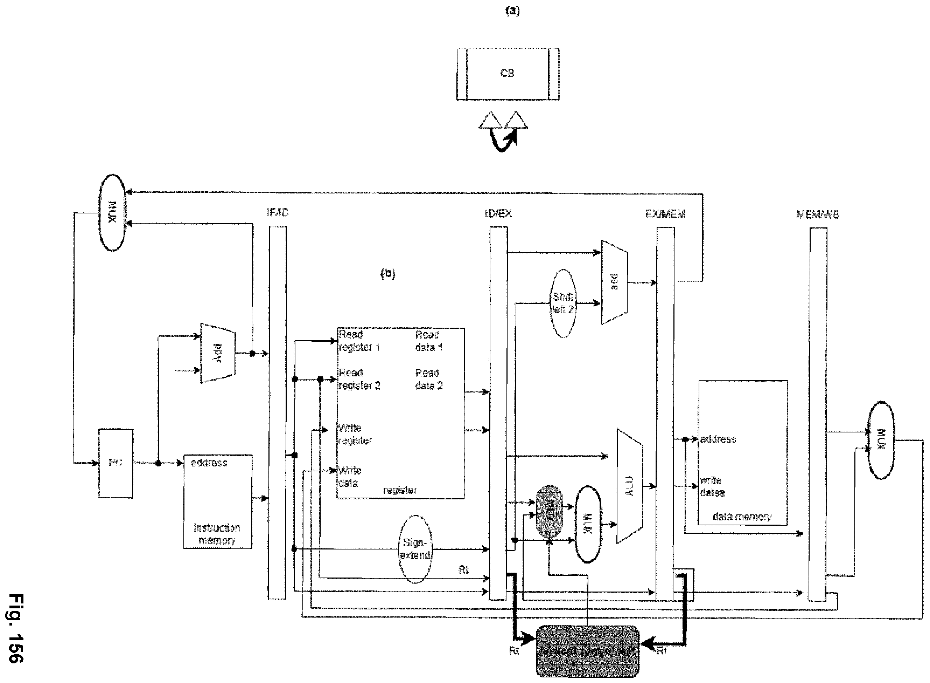

Figure 156 shows an exemplary block diagram illustrating (a) a Computation block with instructions with RAW-dependencies (b) 5-stage pipeline including forwarding.

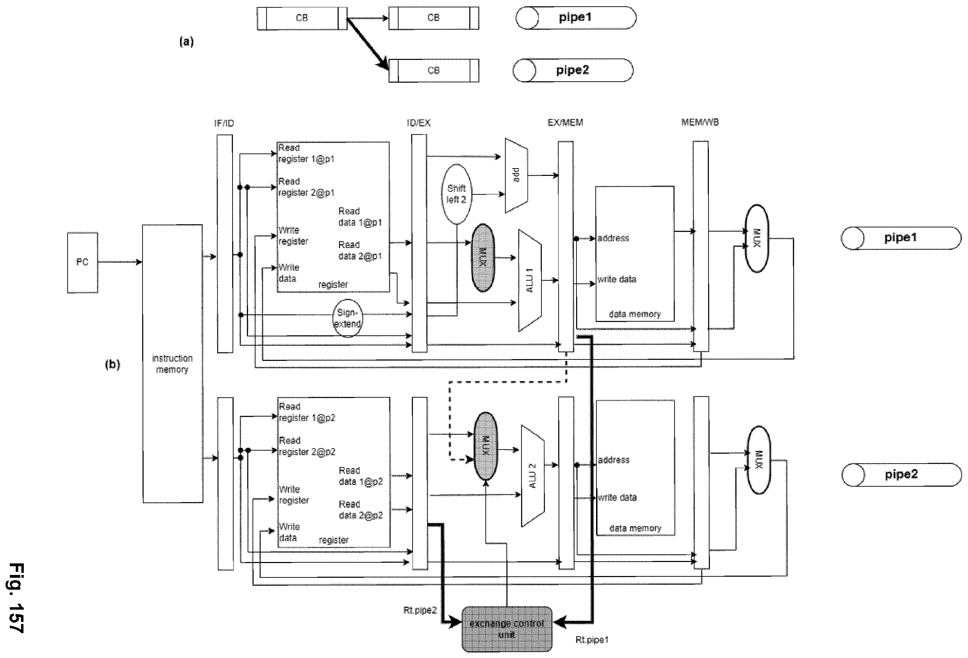

Figure 157 shows an exemplary block diagram illustrating Exchange between two parallel pipelines using the EX/MEM as input to the ALU of a parallel pipeline.

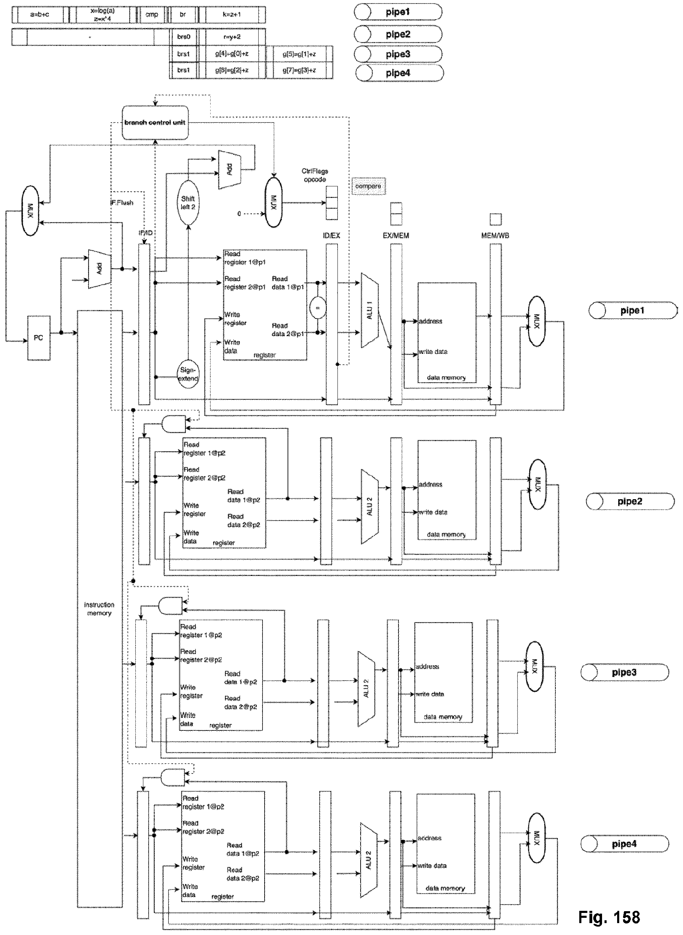

Figure 158 shows an exemplary block diagram illustrating parallel pipelines with control hazard support by enabling the hardware to flush more than one pipeline (which was not taken).

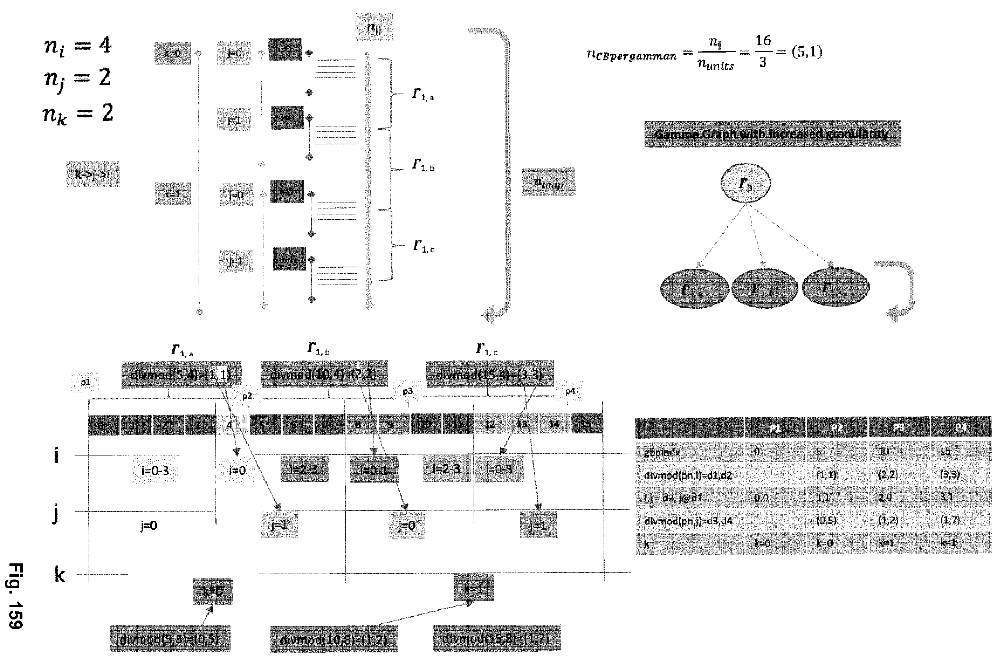

Figure 159 shows an exemplary block diagram illustrating a runtime data mapping.

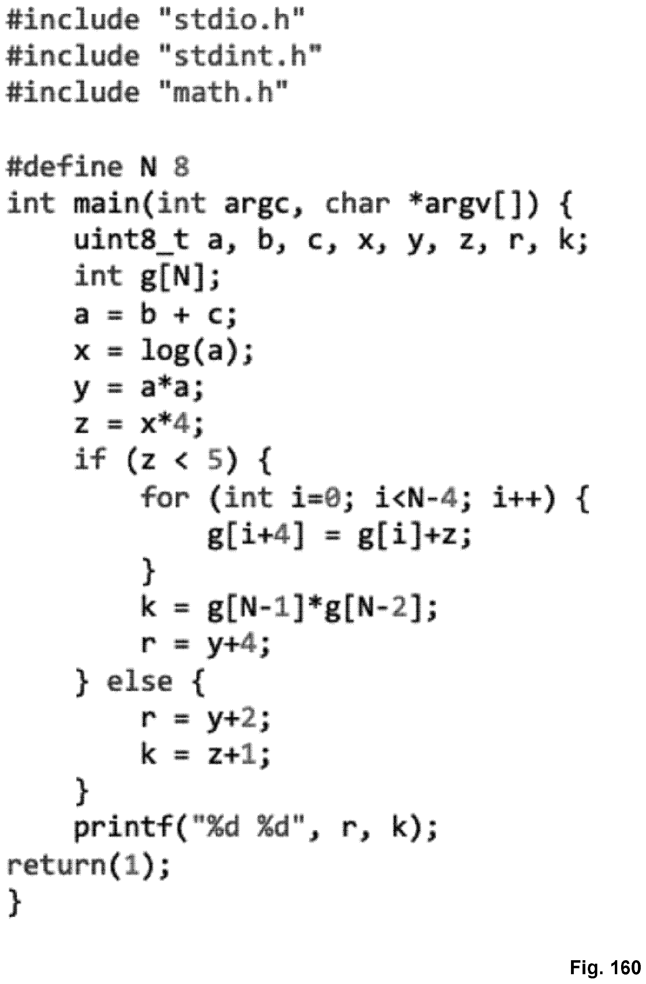

Figure 160 shows an exemplary block diagram illustrating demonstrating code from the technical note.

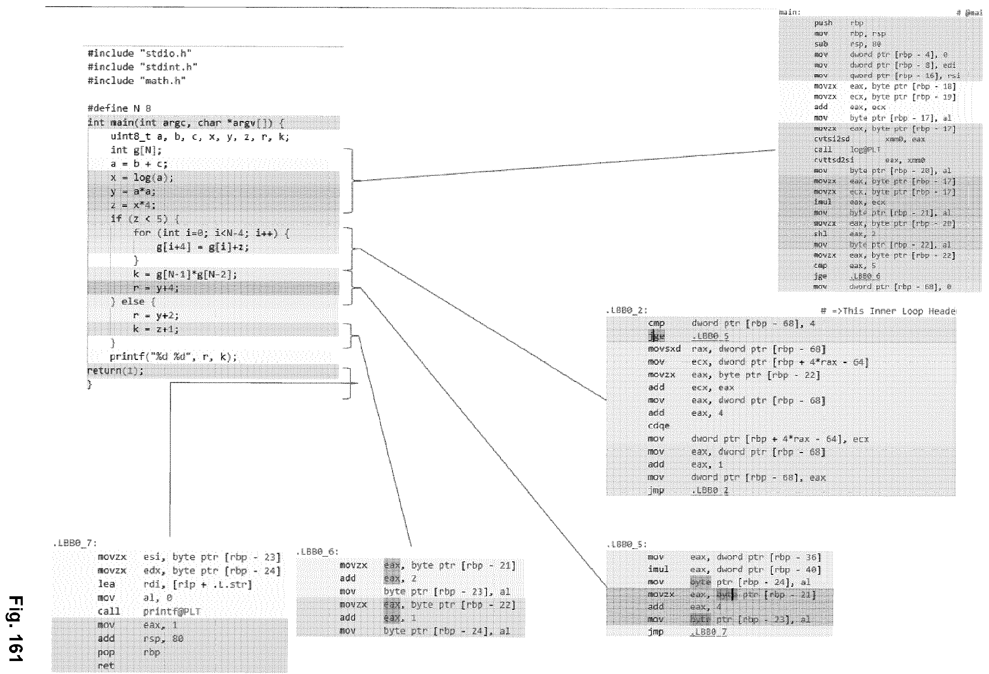

Figure 161 shows an exemplary block diagram illustrating Basic Blocks for compiled code from figure 160.

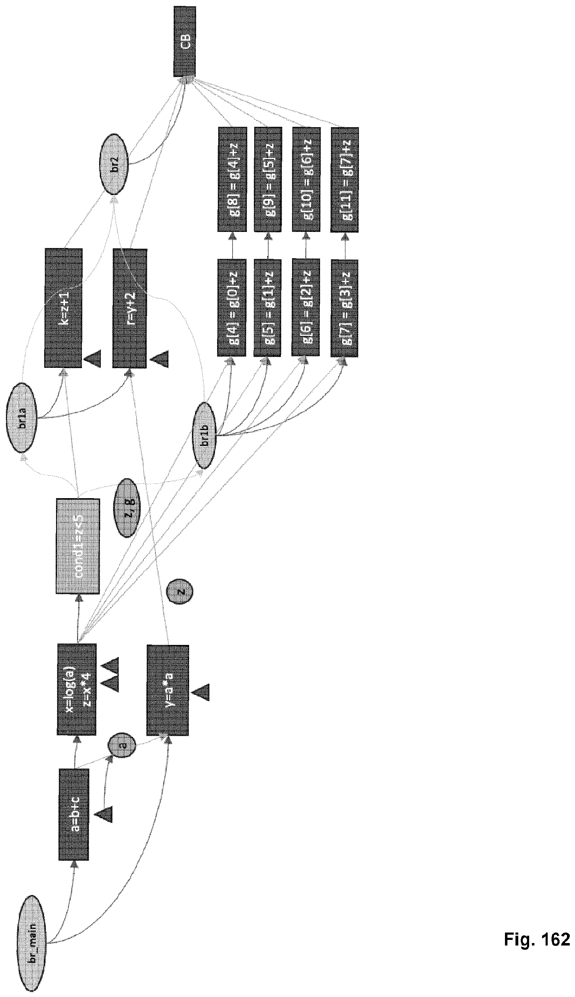

Figure 162 shows an exemplary block diagram illustrating demonstration code with 1 branch, some ILP in BB1 and more in BB3 in branch br1b.

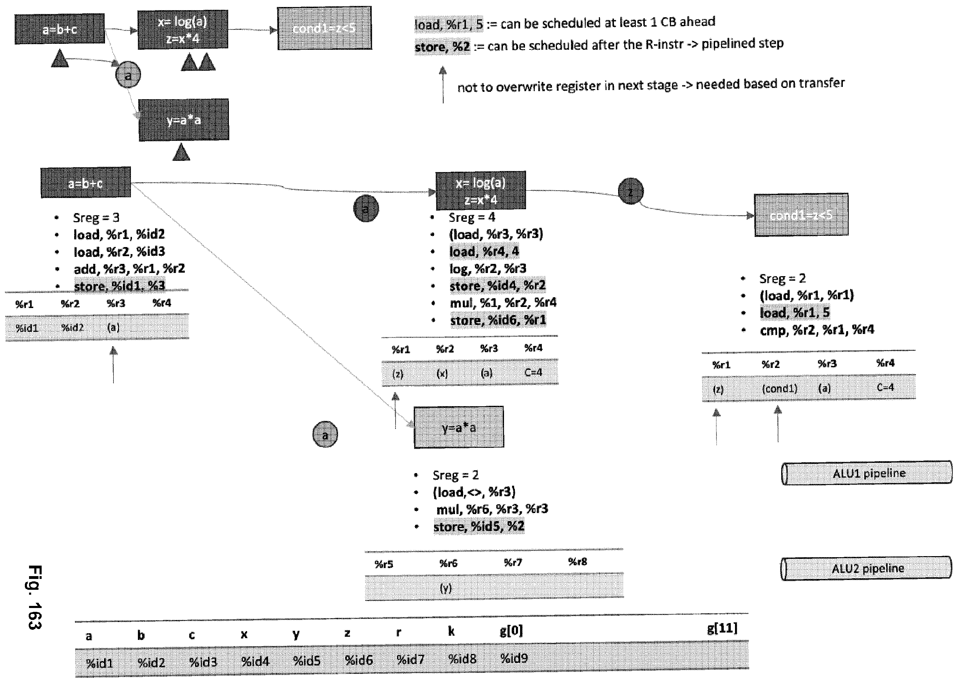

Figure 163 shows an exemplary block diagram illustrating a gamma-graph, register allocation and pseudo assembler code for branch br_main.

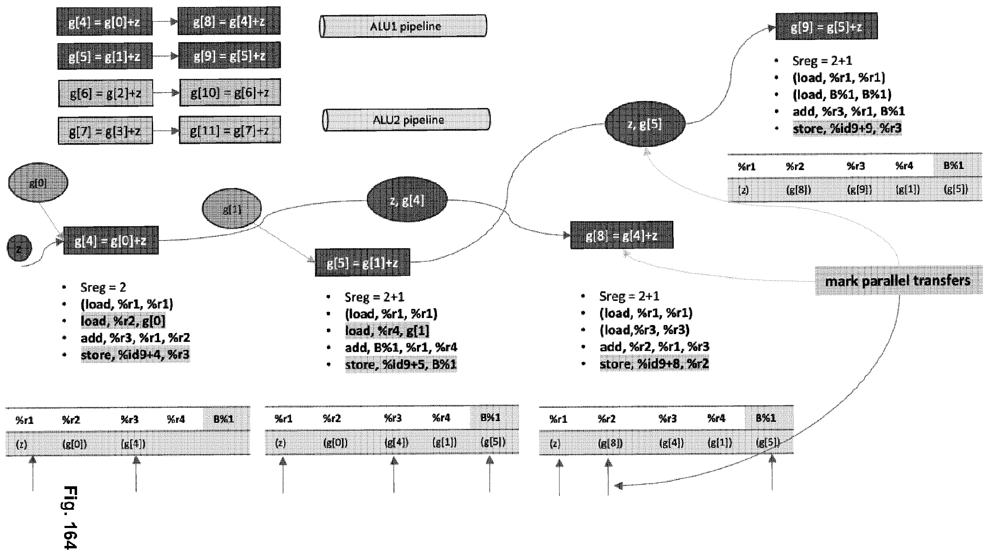

Figure 164 shows an exemplary block diagram illustrating a gamma-graph, register allocation and pseudo assembler code for branch br1b ALU1-pipeline.

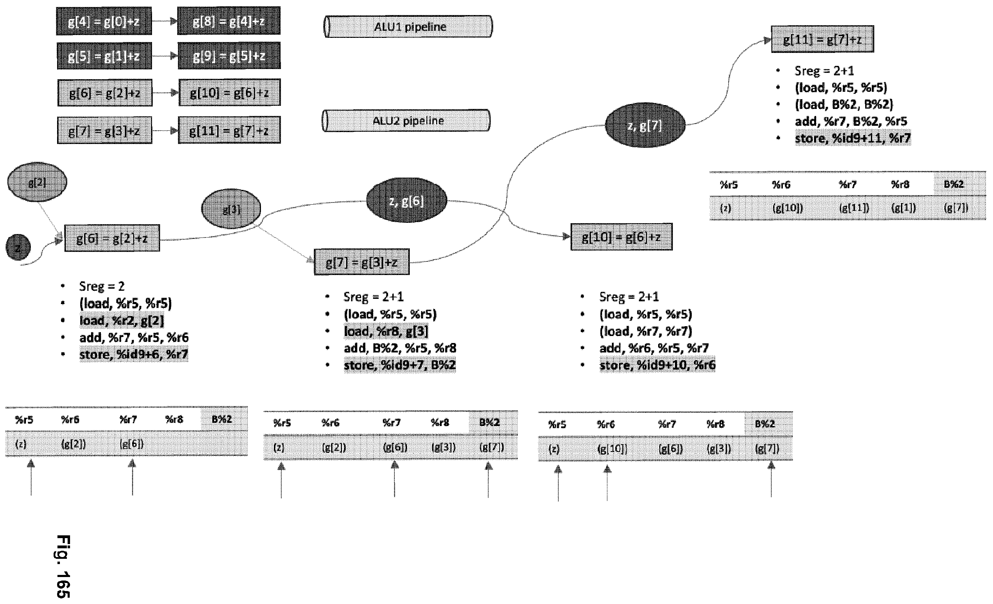

Figure 165 shows an exemplary block diagram illustrating a gamma-graph, register allocation and pseudo assembler code for branch br1b ALU2-pipeline.

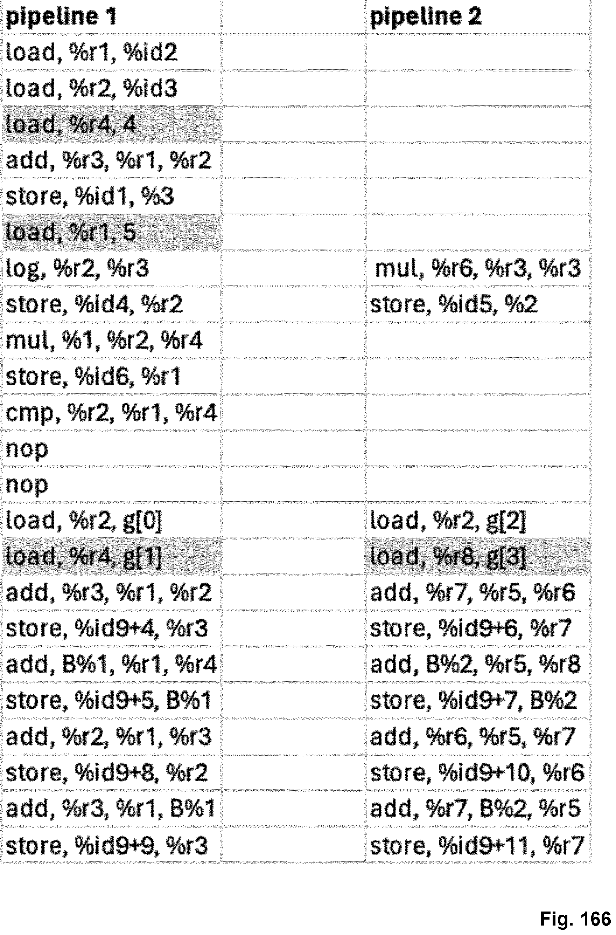

Figure 166 shows an exemplary diagram illustrating how the code compilation leads to pseudo machine code for the two-pipeline CPU with scheduled Computation blocks and optimised load and store instructions. Indicated are the moved load instructions to compensate longer latency to external memory than R-instructions on the ALUs.

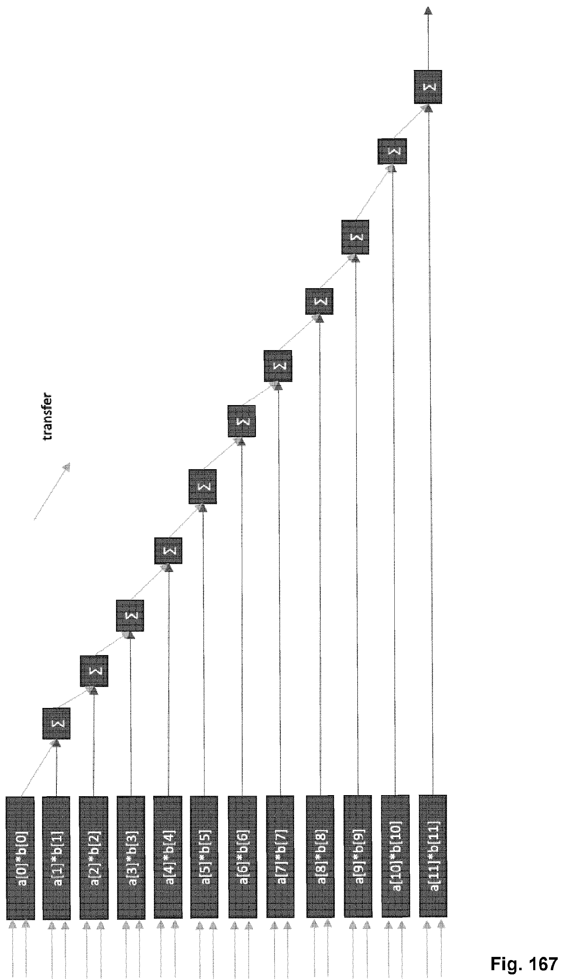

Figure 167 shows an exemplary block diagram illustrating a computation block for code to compute a dot-product between two vectors a and b.

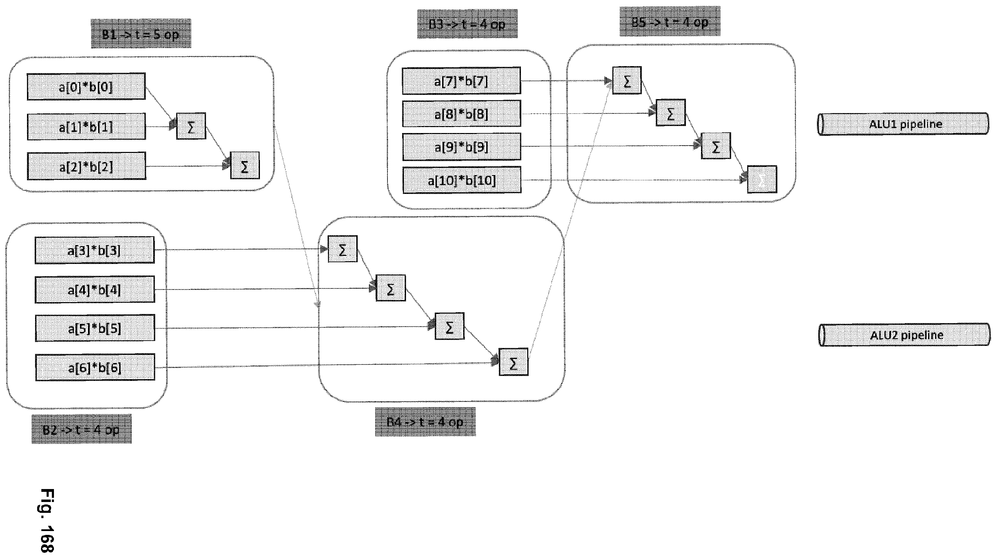

Figure 168 shows an exemplary block diagram illustrating a scheduling parallel CBs on two, parallel pipelines.

### Definitions

### (i) The "computation block nodes"

The definition of the term "computation block nodes", which group the instructions and entail the communication/transfer data to other computation block nodes, is crucial for the present application. The term "computation block node", as used herein, differ from similar terms, used in the state of the art, though there is no generally recognized meaning.

The well-known basic blocks (e.g. see Proceedings of a symposium on Compiler optimization; July 1970 Pages 1-19 https://doi.org/10.1145/800028.808479) are a central definition in classical Control Flow Graphs (CFG). Simplified, they group statements, which have no jump or jump targets inside. Therefore, with a given input they can perform operations without interruption to the end, respectively to the output. This is a basic concept in compilers today. The definition for basic blocks is also historically targeted for single computation units and very well established. There exist optimization methods for a wide range of problems and it has been shown how they solve different technical problems. But seeing a code with the goal to split the statements to different dependent units (connected e.g. by a shared cache, via bus or network, etc.), this definition lacks in granularity and the classical scope prevent a broader perspective. Scoping the blocks on the bases of any unique information given in a code (see information as a bit-pattern) and combine this scope with the relevant times to compute and transfer of an information in a system, creates a different, but well physical based perspective on a given code. The alternative scope enables new option as well as solves some well-known technical problems of today's SOTA compilers (see following example for a PDE, Fibonacci or pointer disambiguations).

The term "computation block nodes", used in the present application, bases on a different and not in this way applied important unit in SOTA compilers: the interrelation of transfer and compute time for a given set of statements. These new defined "computation block nodes" group instructions together which use the same information, which is not changed by any other instructions (statements) in any other computation block node during a particular time in the complete code. In this way, they group instruction which can be processed or computed independently of any other statements with the scope on the information (information as a distinct bit-pattern), what is called in the present application "not-further splitable instructions chains". These chains of instructions in every computation block node have each a physical based "time" associated how long it takes a unit to process or compute them on a given hardware. As the hardware properties have a fundamental influence (as well as software components, such as OS, drivers, etc.) on the time needed to process or compute the instructions, the "computation block nodes" correlate them also to the time needed to possible transfers of any other information during a particular time - if needed during a particular program step - to another "computation block node" in the complete code. Each "computation block node" knows which and when the information for the own instructions has to be exchanged (communicated / transferred, respectively "received " or "send") to other "computation block nodes". Therefore, a "computation block node", as used in this application, brings a new scope and a decision criterion, meaning one of the central aspects of parallelism of a code, in relation: compute an information (bit-pattern) on a unit or transfer this information to another unit and compute it parallel. This decision can only be done, when it is guaranteed, that the used information is not changed during a particular program step (or time) in any other part of the program. Furthermore, building block nodes with this scope do not only bring advantages to parallelize a given code, this scope also shows some advantages for problems not well handled with SOTA compiler optimization techniques. Such problems and different solutions are well documented, for example, in the publication Modern compiler design by D. Grune. To show the technical benefits, some advantages resulting from using the new scope to some of these known technical problems, is shown below, such as pointer disambiguation and different performances for Fibonacci series codes, but also how the method solves up till now not solvable problems, like PDE parallelization.

First, the different scope is illustrated with a schematic example in figure 6. The illustration makes some adaption to show easier, what the inventive system and method does, such as the statement 'y > a' would not occur twice in the same computation chain, the resulting "compute" -> "communicate" model would lead to a corresponding placing of a loop, jump or flow-control instruction. Nevertheless the example illustrates, what the different scope of the computation block nodes give compared to basic blocks: the fact that 'a' and 'b' do not change in block 1 and the information of the condition of 'y > a' is already known after the evaluation of the statement 'y := a*b', the alternative scope of the computation block nodes takes these properties into account. The proposed perspective of computation block nodes groups the statements in a new way together. This change in perspective results from the approach to group operations together, which rest on information, which is not changed at the same time-step in the code. In the example this is shown that two independent computation-chains evolve, which both are independent concerning the information of 'y'.

In the simplified, but more realistic example of figure 7, the inventive method exploits the fact, that a logarithmic instruction (as an example on a modern CPU: FYL2X) needs much longer than a floating point addition and/or multiplication instruction (e.g. FADD, FMUL). The inventive methods add the statement 'x:=a+b' und 'y:=a*b' to two different computation block nodes (cbn), as both are based on the same information 'a', and 'b'. The 'log2(x)' statement is appended to the 'x = a+b' as it uses the information 'x'. The information 'y' is getting transferred, so the information is available to both, independent computation-chains.

### (ii) The "computation matrices" and "transfer matrices"

The inventive method forms out of such a flow-graph of computation block nodes, as discussed above, two technically defined matrices called "*computation matrix*" and *"transfer matrix"* in this application. Both are numerical matrices. The "*computation matrix*" contains the instruction chains and the *"transfer matrix"* the possible transfer properties (from and to other computation block nodes). Therefore, the code extracted from the matrices always forms a pattern "compute -> communicate", as it is described in more detail in the following passages. If code is mapped to one unit, the communicate part would vanish and the inventive method would be reduced to the approach with basic blocks, respectively can be handled with a SOTA compiler. See the example from figure 7 in this form, it can be seen, that unit 2 can compute the long running instruction of the statement 'log2(y)' and unit 1 processes the loop with incrementing a ('a = a+1'), see figure 8. To see how this works, in the next passages the matrix builder is shown in detail.

The name "matrices" is used to name a structure of the from (m x n x p), where $m , n , p ∈ {ℕ}_{0}$ . As m, n and p depend on the code, this can include different forms of a mathematical object, especially concerning dimensions like as a point, vector, a matrix, a tensor, etc.. m is the number of the maximal number of computation blocks, respectively block numbers like in Figure 43 the segment-numbers, n is the number of independent, but with the same segment number computation block nodes, like in Figure 43 indicated as chain numbers. Depending on the maximal level of conditions in a code (or series of branch nodes like in Figure 26), p is defined, indicated in Figure 43 as path number. Therefore it could be said, that whenever the term 'matrix' / 'matrices' is used, it can be a vector, a matrix or a tensor or any other object of the form (m x n x p) or with representation in from of a graph or tree. Therefore, optimization can also be done e.g. with one tensor by combining the computation and transfer matrices into one structure, or that a transfer and computation matrix each can be a tensor, or they both can be a vector, in a code with only one block / segment number. The dimension of these "matrices" depend on the form of the code and the way of handling / representing the information in the way the method is applied. The term "numerical matrices", as used herein, can also include forms of text, like for a transfer '1->2'. Depending on the used optimizing / mapping techniques, the text in the matrices will be or can be reduced to a numerical value (depending on the used character encoding) so they can be e.g. searched or compared. Or the textual transfer'1->2' can be represented / encoded by a numerical value from the beginning and directly be compared with other transfers and therefore omitting character encoding.

As the "numerical matrices" can be used as another well-formatted form of representing a graph / tree alike structure, it is also possible to work without the "numerical matrices" and do all optimization / mapping in graph / tree form. Whatever form of mathematical or computational form of representing the groups of instructions (here named computation block nodes) and their transfer dynamic represented here with the e.g. in Figure 23 mentioned "transmission packages", based on the physical based dependency of transfer and computing latency occurring in all binary based electronic computing systems. It is based on grouping instructions (any form of instruction / operation, e.g. representing a form of electronic circuit) in a code (any form of code (high level, assembly, etc.)) on the rule to place an instruction "reading" an information A in the same group (here named with computation block node) where the instruction is located which "writes" the information A. This is significant different to group instructions with the well-known basic blocks. If the dependency is not clear (indicated in Figure 21 in the case of graph elements with 2 "reading" and one "writing" node per instruction) a "transfer" is introduced between the two computation block nodes (on holding the instruction, which "writes" to one holding the instruction which "reads"). In this form the code can be represented in form of computation blocks nodes connected by their needed transfers. This information can be enclosed in graph / tree or array or any structure suitable. To run these instructions on a given hardware the well-known methods in SOTA compilers can, but must not, be used to optimize the chain of the computation block nodes grouping instructions and for each unit then to run on the involved computing units (would in this case called transpiling).

### (iii) The "matrix builder" and the way back to code

After parsing the code and adding all instructions to computation block nodes (cbns), each computation block node can be enumerated depending on its position in the flow graph. This leads to a similar form of a Control Flow Graph, given by the edges between the cbns as well as the connection of the defined branch nodes. Using these positioning numbers, the unique positions in the flow of the code is used to place the information of what to compute and what to transfer in the two matrices "*computational matrix*" and *"transfer matrix",* the "*computational matrix*" for the computation and the *"transfer matrix"* for the transfers. It is obvious that meta data, such as size of the data needed for each cbn, the size of the transfer between the cbn, etc. can easily be derived.

Matrices represent a much more scalable form of accessing information than graphs, respective show the well-formed nature of the control flow graph. They are not absolutely essential for the method and this step could also be performed directly on the graph / tree structure. But the definition of the block nodes also indicates the generic nature of the inventive matrices: Each row has an independent flow (dependency by transfers) of instructions (= computations) and needed transfers (= communications) to other cbns. It is guaranteed that a) no further information is needed to compute all instructions in a computation block node (this is similar to a basic block, but the scope of the independencies is quite different), b) the used information is nowhere else changed during the same computation step in the whole code and c) that only information is transferred not affected of computations during this time-step are possible. With this fact, each cell in the computation matrix has all instructions, which can be independently computed concurrent with all instructions in the other cells in the same column. In the transfer matrix in each cell, the needed transfers at the beginning and at the end of each computation step (corresponding cell in the computation matrix) is now known. Getting back code to run on the different units results in a representation in the form "communicate -> compute -> communicate -> compute" and so on. Each row represents a chain of computation and communication properties forming a series of computations coupled by communication with the other rows = chains of computations. The needed information to communicate with the other rows = chains is in the transfer matrix. Each row in the computation matrices (and the same combination in the transfer matrix) can also be combined (compute all instructions of both, combined cells and make the necessary transfers of both cells based on the transfer matrix) with any other row in the matrices to create a new combination of computation <-> transfer behavior of a given code. In this step the computations sum up and transfers on the same unit (by combination) vanish. This will lead later to a simple form of optimization, as well as the fact, that the optimization / mapping step results definitely in a runnable code, as no iterative or similar solution methods are needed. This is also a technical well known-problem parallelizing code, as debugging of parallel code is very complex (for example, see "ParaVis: A Library for Visualizing and Debugging Parallel Applications", A. Danner et al.).

Each row of the computation matrices, as defined herein, represents a chain of instructions for one unit. Units are depending on the level of implementation (e.g. bare assembly, threads, processes, compute-nodes, etc.). Obviously empty blocks (empty cells in the computation matrix) or not used communication entries (empty cells or transfer on same units in the transfer matrices) vanish, as well as start- and end-communication link together as can be seen in figure 10. This results in case there is no transfer if the code is run on a single unit and all transfers will vanish by reassigning / renaming of variables, respectively applying well known optimizing methods in SOTA compilers to get an optimized code for a given unit.

Depending on the method to implement the communication, non-blocking or blocking mechanisms can be used, as it is guaranteed, that during a computation block node no information will be transferred used in the instructions at the same time, respectively another cbn with same number. Depending on the level the computation and communication part can be implemented, resulting to use the method as a compiler or transpiler. The transfer back to code of the form "computation -> communication" approach makes it also easy to use languages (e.g. C, C⁺⁺, python) suiting best for an application and depending on the target infrastructure, such as IPC (InterProcess Communication) methods (e.g. queue / pipe, shared memory, MPI (Message Passing Interface), etc.), libraries (e.g. eventlibs, multiprocessinglibs, etc.) and the use of available SOTA compilers, etc..

### (iv) "Optimizations"

The generic, well defined nature of the matrices is the unique base for a wide range of possibilities to map/optimize a code to a given hardware or evaluate an optimal hardware configuration for a given code (e.g. see the different embodiment variants E1-E5 in figure 106). The structure guarantees as a result a runnable code. Each hardware infrastructure has its own performance properties and in combination with the available software layer, a modern ICT (Information and Communications Technology) infrastructure is very complex. The inventive method allows to optimize the code to the hardware or allows to give out an ideal hardware. The most obvious is by building different combination of rows from the computation and the transfer matrix, whereby it is important that in both matrices the same combinations are built. Each combination (e.g. combine row 1 and 2 in computation AND transfer matrix) is then a new version of a parallel / concurrent code for the given input code and then its properties on the target infrastructure, see figure 11 for a simple example, can be assessed.

By different combinations of the rows in the matrices (e.g. combine row 1 and 2 in computation and transfer matrix or row 2 and 5) different combinations of computation <-> communication ratios are retrieved. Each of the combinations then can be examined including other known meta-data for a given hardware / software infrastructure. For example data types of the data nodes () can be used to evaluate for hardware properties, such as cache-lengths, available memory or other properties of a target platform. This form of combining and searching for an optimal compute / communication ratio for a given code and a given hardware results always in a runnable, concurrent code, because no iterative solution method or similar approach is needed to find a solution in the optimizing step, nor solution with e.g. race-condition, dead-lock, etc. can occur, respectively dead-locks can be detected.

The grouping of the instruction is based on the inherent physical constraint that transfer is normally a magnitude larger than to compute at the same "location", the method spawns a form of optimal solution space for the most splitable form of a code and results in a well-defined way and search space for a unique way to find an optimal map for a given hardware, or the ideal hardware for a given code. This makes this method quite generic and solves the technical problem to adapt a given code to a target platform automatically. In case the method is used as a transpiler, SOTA compiler could be used to optimize then the code to a target hardware / unit.

Other methods do not exploit the inherent time properties and dependencies given in a code and do not produce this form of unique solution space to optimize, in the form the method's definition of the computation block nodes (by grouping by the scope of no changing information) - this solves technical problems directly in many ways. The examples in the detailed description will show this in more detail.

### (v) "Computation block nodes" according to the invention and "basic blocks or slices" of the prior art

Computation block nodes are NOT the same as basic blocks or slices: They have a different scope. They do not follow the definition of basic blocks, e.g. by connecting independent program parts based on their jump / branching. Instruction chains in computation block nodes have an elementary data dependency, meaning that the information used in these chains is nowhere else in a given code changed nor transported at the same time/program step.

So the time, respectively the place of an instruction in a program is brought into dependency in the computation block nodes. The computation block nodes consist of a chain of instruction, which is based on the same information, whereby information is defined as every form of bit-pattern (e.g. data variable, a pointer-address, etc.). By introducing a transfer/communication, where an information is not only used by a time-step in a code and coupled with the instruction, a correlation of these both physical based times are reached in a computation block node. The method places the computation blocks in such a way, that to all timepoints is definite which information can be transferred and where to and which information can be computed in parallel. This gives a different perspective, especially for optimization techniques. A wide range of technical problems exists, which can be solved by this change in perspective. The computation block nodes connect the location of an information (bit-pattern) in a computation framework with the time this information is used in a program. This is backed by the elementary physical principles of computing in a classical infrastructure. The following example with nested loops and arrays shows this effect good: the branches in the loop definitions can be translated to a read and write of data points with according to arrays when distributed over parallel computation block nodes.

The inventive method splits a code into segments of computation and where the resulted information has to be transported. Therefore, by the definition of the computation block nodes the inventive method generates a matrix system where it is given, that instructions are grouped which base on the same information and the constraint that during any given timepoints nowhere else the same information is needed in the infrastructure. The grouped instructions are not further splitable, because as it is not possible to reach a faster computation for a particular group of instructions, because the transport in any form would be longer than to compute this given chain in the computation block nodes. As shown the generic nature of the computation and transfer matrices makes it possible to optimize the split code to a most concurrent as possible solution for a given hardware. The ratios of computations and transports are depending on the target hardware and the method provides different solutions to split to different ratios for a given code. By translating the graph of dependencies into matrices these can be used in a more effective way to map / optimize the split code to a target platform, including the specific properties of this infrastructure (e.g. GPU need another handling of transfer / computation distribution, than CPUs). But it is not essential to use the matrices and the optimization / mapping could be done directly on the graph / tree structure.

### (vi) "Idle time" - "latency time"

The latency times, as defined herein, is given by the idle time of a processing units 21 between transmitting data back to the parallel processing system 2 after having processed a specific block of instructions of the processing code 32 on data by a processing unit 21and receiving data (i.e. after retrieving and/or fetching the data) necessary for execution of a consecutive block of instructions of the processing code 32 by the same processing units 21. In contrast, idle time of a processing unit can be defined herein as the amount of time the processing unit is not busy between two computational block nodes, or, otherwise, the amount of time it executes a system's idle process. Thus, idle time allows to measure unused capacity of a processing unit of the parallel processing system. Maximum speed-up, efficiency and throughput are the ideal cases of parallel processing but these are not achieved in the practical cases, as the speedup is limited due to various factors contributing to the idle time of a processing unit. Idle time of a processing unit, as used herein, can find its origin in various causes, inter alia, comprising: (A) *Data dependency between successive computational block nodes*, (i.e. tasks which cannot further be split up framed by read/write operation): There may be dependencies between the instructions of two computational block nodes. For example, one instruction cannot be started until the previous instruction returns the results, as both are interdependent. Another instance of data dependency will be when that both instructions try to modify the same data object, also referred to as data hazards; (B) *Resource Constraints*: When resources are not available at the time of execution then delays are caused in pipelining. For example, if one common memory is used for both data and instructions and there is need to read/write and fetch the instruction at the same time then only one can be carried out and the other has to wait. Another example is of limited resource like execution unit, which may be busy at the required time; (C) *Branch instructions and interrupts in the program*: A program is not a straight flow of sequential instructions. There may be branch instructions that alter the normal flow of program, which can delay the execution and affect the performance. Similarly, there can be interrupts that postpones the execution of next instruction until the interrupt has been serviced. Branches and the interrupts can have damaging effects on the minimization of the idle times.

It is to be noted, that the task of minimizing idle times is also sometimes referred to as "load balancing", which denotes the goal of distributing the work among the processing units so that all processing units are kept busy in the ideal case all of the time.

### (vii) "Elementary instructions"

The term "elementary operations" or "elementary instruction", as used herein, refers to machine operations that contains no simpler operations. They are on machine language level. However, in specific embodiment variant, they can at least comprise microcode instructions or completely consist of microcode instructions. As microcode is the result of lower-level machine language interpretation, where microcode instructions directly manage hardware resources at the register or circuitry level. Machine language interprets and sends machine instructions to the lowest hardware layer level where they are translated into small micro programs called micro-codes. Thus, microcode is low-level code that defines how a microprocessor should function when it executes machine-language instructions. Typically, one machine-language instruction translates into several microcode instructions.

As discussed, the execution of an elementary instruction, as defined above, consists typically in the successive execution of some number of operations, including such operations as resetting a register, resetting memory storage, shifting a character in a register left or right by one place, and transferring data between registers as well as the comparing of data items and logical addition and multiplication. A set of elementary operations can provide a structure for executing a specific instruction. Elementary operations comprise basic logical functions of logic gates comprising AND, OR, XOR, NOT, NAND, NOR and XNOR. Such elementary operations can be assumed to take a constant amount of time on a given processing unit and may change only by a constant factor when run on a different processing unit 21 or parallel processing system 2.

Building on the concept of microcode instructions, the design of integrated circuits such as Field-Programmable Gate Arrays (FPGAs) and Application-Specific Integrated Circuits (ASICs) involves several levels of abstraction, from the high-level algorithmic description down to the low-level hardware description. These descriptions are either written in a Hardware Description Language (HDL), which allows designers to define the functionality and behavior of their circuits at a very low level, or more and more often the process of High-Level Synthesis (HLS) is applied to describe the behavior of a digital system using a high-level language, such as C or C++. The logic synthesis tool is similar to a compiler for hardware and maps HDL code onto a library of gates called standard cells to minimize area while meeting some timing constraints. This generates a Register Transfer Level (RTL) description of the system, which defines how data flows between registers and how computations are performed using Arithmetic Logic Units (ALU) or even just logic gates that implement Boolean functions or arithmetic. The RTL description is then synthesized onto gates and flip-flops to generate a Gate-Level Synthesis (GLS) netlist. The netlist is the lowest level of abstraction and represents the actual hardware implementation of the digital system.

As computation block nodes group these essential logic operations, the logic gate layout can be derived from the computation block nodes, as each is composed of basic gates like NOT, AND, OR, XOR, NAND, NOR, and XNOR, or more complex gates like multiplexers, decoders, adders, subtractors, shifters, multipliers, and dividers. From the fact that computation block nodes are already a series of elementary operations, they can also be seen as a sequence of Boolean functions and/or arithmetic.

In a first step, described more detailed below, the present inventive system transforms a source code into a sequence or code 32 of elementary operations 321,...,325 structured in loops, branches, and sequences. It is independent from platform and compiler optimization level, and hence the same transformation can be used to optimize execution time on any platform.

The present approach is based on decomposing a piece of source code 31 written in a programming language to elementary operations 32/321,...,325, i.e. distinct transformed parts of the source code 31. The set of elementary operations is finite for each processing unit with several subsets: integer, floating point, logic, and memory operations. These sets are corelated to parts of the architecture of a processor and the memory data-paths. The elementary operations, as used herein, can e.g. be classified in various levels as follows: The top level contains four operation classes: INTEGER, FLOATING POINT, LOGIC, and MEMORY. Second level of classification can be based on the origin of operands (i.e. location in memory space): local, global or procedure parameters. Each group can show different timing behavior: local variables, being heavily used, are almost always in cache, while global and parameter operands must be loaded from an arbitrary address and can cause a cache miss. Third level of classification is by operand type: (1) scalar variables and (2) arrays of one or more dimensions. Pointers are treated as scalar variables when the value of pointer is given using a single variable, or as arrays when the value of pointer is given using multiple variables. Operations which belong to INTEGER and FLOATING POINT classes are: addition (ADD), multiplication (MUL) and division (DIV). LOGIC class contains logic operations (LOG): (i.e. AND, OR, XOR and NOT) and shift operations (SHIFT): operations that perform bitwise movement (e.g. rotation, shift, etc.). Operations in MEMORY class are: single memory assign(ASSIGN), block transaction (BLOCK) and procedure call (PROC). MEMORY BLOCK represents a transaction of a block of size 1000 and it can only have array operands. MEMORY PROC represents a function call with one argument and a return value. Arguments can be variables and arrays, declared locally or given as parameters of the caller function, but not global.

### (viii) "Processor" - "Cores"

To define the term "core", as e.g. a "multi-core processor", as used herein, a definition of the term "processor" (or "microprocessor") has to be given as well. In computing terms, a processor is a component that reads and executes program instructions. Processor cores are processors, i.e. individual processing units, within a computer's central processing unit (CPU). The instructions for processors are technical signals to a processor/core 2102/2103 telling the processor/core 2102/2103 what to do, such as reading data from memory or sending data to an output bus. A common type of processor is the Central Processing Unit (CPU). A multi-core processor is generally defined as an integrated circuit to which two or more independent processors (called cores) are attached. It is to be noted, that this term is distinct from but related to the term multi-CPU, which refers to having multiple CPUs which are not attached to the same integrated circuit. In the prior art, the term uniprocessor generally refers to having one processor per system [Uniprocessor], and that the processor has one core. The term is used to contrast with multiprocessing architectures, i.e. either multi-core, multi-CPU, or both. Multi-core processors emerged in the computing industry from uniprocessor technology as a method to achieve greater performance through parallelism rather than raw clock speed. For years, the computer industry developed faster and faster uniprocessors, though this pursuit is drawing to a close due to the limits of transistor scaling, power requirements, and heat dissipation. Because single-threaded cores are reaching a plateau of clock frequency, chip manufacturers have turned to multi-core processors to enhance performance using parallelism.

### (ix) Parallelization types and performance in multi-core CPU

Because multi-core CPUs fundamentally rely on parallelism to enhance performance, an understanding of the key types of parallelism is important to analyzing performance and understand the technical problems associated with auto-parallelization systems. Modern multi-core processors without code parallelization does not make sense. However, parallelism is a technically extremely challenging and complex object, however, in the context of the present invention, an understanding of three basic types of parallelism is sufficient here. Instruction-level parallelism, thread-level parallelism, and data-level parallelism are all employed by various multi-core CPU architectures, and have different impacts on performance that must be understood to conduct thorough performance analysis.

***Instruction-level parallelism (or ILP)*** is a first type of parallelism, which involves executing certain instructions of a program simultaneously which would otherwise be executed sequentially, which may positively impact performance depending on the instruction mix in the application. In the prior art, many CPUs utilize instruction-level parallelization techniques such as pipelining, superscalar execution, prediction, out-of-order execution, dynamic branch prediction or address speculation. However, only certain portions of a given program's instruction set may be suitable for instruction-level parallelization, as the example illustrates below in the following table 2.

| **Sequential Execution** | **Instruction-Level Parallelization** |
|---|---|
| 1. a=10+5 | 1. a=10+5 |
| 2. b = 12 + 7 | 1. b=12+7 |
| 3. c = A + B | 2. c=A+B |
| Instructions: 3 | Instructions: 3 |
| Cycles: 3 | Cycles: 2(-33%) |

Because steps 1 and 2 of the sequential operation are independent of each other, a processor employing instruction-level parallelism can run instructions 1.A. and 1.B. simultaneously and thereby reduce the operation cycles to complete the operation by 33%. The last step must be executed sequentially in either case, however, as it is dependent on the two prior steps. It is clear, that this example is an oversimplification. However, for the auto-parallelization system, the key is to extract which portions of an application have instructions that could run in parallel.

***Thread-Level (respectively Task-Level) Parallelization (TLP)*** is a second type of parallelism involving executing individual task threads delegated to the CPU simultaneously. Thread-level parallelism can substantially impact multi-threaded application performance through various factors, ranging from hardware-specific, thread-implementation specific, to application-specific, and consequently a basic understanding is important for this type of parallelization. Each thread maintains its own memory stack and instructions, such that it may be thought of as an independent task, even if in reality the thread might not really be independent in the program or operating system. Thread-level parallelism is used by programs and operating systems that have a multi-threaded design. Conceptually, it is straightforward to see why thread-level parallelism can increase performance. If the threads are truly independent, then spreading out a set of threads among available cores on a processor reduces the elapsed execution time to the maximum execution time of any of the threads, compared to a single threaded version which would require additive execution time of all of the threads. Ideally, the work would also be evenly divided among threads, and the overhead of allocating and scheduling threads is minimal. In the real-world, this simplistic ideal model of thread-level parallelism performance is complicated by several technical factors, such that the ideal scenario is rarely observed in real applications. Performance-impacting factors include the load balance, level of execution independence, thread-locking mechanisms, scheduling methods, and thread memory required. Further, data-level parallelism among the distributed threads may impact performance. The thread implementation library in both the operating system and the specific application will also impact performance.

***Data-Level Parallelization (DLP)*** is a third type of parallelism involving sharing common data among executing processes through memory coherence, improving performance by reducing the time required to load and access memory. Typically, identifying application areas utilizing data-level parallelism will assist in understanding performance characteristics on multi-core processors.

***Loop-Level Parallelization (LLP)*** is a fourth type of parallelism where if iterations of loops have no dependencies, they are executed in parallel. If all loop iterations require the same execution time, the distribution can be performed by a static distribution with a fixed number of iterations to each computing unit.

In the context of a multi-core CPU, data-level parallelism in the cache memory shared by cores can have a substantial impact on performance. Here, the executing processes running on multiple cores will be called threads. Performance gains are expected when the threads read from the same data in the shared memory. This scenario allows one copy of the data to be used by the multiple threads, reducing the number of copy operations and thus execution time. When the threads have no data in common, each thread must maintain a copy of its data and no gains are available. However, if the multiple requests to this memory exceed its bandwidth, increasing threads may produce negative performance impacts. Further performance impacts may also occur during write operations. Multiple threads attempting to write to the same memory location at the same time must wait to resolve conflicts. To cope with this problem, schemes to handle such situations are needed, such as spin-locks. The performance impact depends upon the penalties involved with the scheme employed and how often such conflicts occur. Generally speaking, having threads write to different areas of shared memory would be preferable in lessening the likelihood of incurring these penalties. Non-Uniform Memory Architecture (NUMA) can help, as it places data used by one particular core physically closer to that core in memory. Further, bandwidth is here also an important factor as the number of threads increases on a multi-core processor. Limited cache size (cache misses), limited bandwidth, off-cache latency, and other aspects will have impacts on performance, though data-level parallelism can improve performance in certain situations. Further, the interaction between instruction-level and data-level parallelism affects performance. Flynn's taxonomy provides a technical framework to analyze these interactions. In summary, observations about data-level parallelism in a particular application can be important to analyzing its performance on multi-core CPUs because memory is frequently the limiting factor.

### (x) P and NP complete auto-parallelization measure

In the field of computer technology, code parallelization, and processor architecture, a large numbers of systems and method deal with the technical problem of improving speed and memory space taken to compute codes and algorithms, as faster algorithms give extra time for more computations, and less space taken may further enhance computing, in particular parallel computing. As mentioned above, the time it takes a computer to compute a problem is called its "*time complexity*", while the space taken is called its "*space complexity*". The time and space taken to perform these algorithms are usually measured in the size of the input and the number of elements the algorithm has to manipulate. There is another measure linked to the two mentioned. The so called "*computational complexity*" is a measure for classifying computational problems according to their resource usage, and relating these classes to each other. A computational problem is a task solved by a computer and its processors, respectively. A computation problem is a technical problem solvable by mechanical application of processing steps by data processing means as processors and data repositories.

A computational problem is regarded as inherently difficult if its solution requires significant resources, whatever the processing steps or algorithm used. To provide the measure, inter alia, models of computation are used to quantifying the computational complexity, i.e., the amount of resources needed to solve a certain problem, such as time and storage. Other measures of complexity are also used, such as the amount of communication (used in "*communication complexity*"), the number of gates in a circuit (used in "*circuit complexity*") and the number of processors (used in parallel computing).

One of the roles of the computational complexity is to provide a measure for the practical limits of a computers or a parallelization. On the other side, if a computational problem is regarded as easy to be solved, it means that the problem (here auto-parallelization) can be quickly solved using the computer means. The term quickly, used above, means the existence of a processing code or algorithm solving the task runs in polynomial time, such that the time to complete the task varies as a polynomial function on the size of the input to the algorithm (as opposed to exponential time). The general class of questions for which some algorithm can provide a solution in polynomial time is called "P", for polynomial. Thus a parallelization problem where the time to find a solution (i.e. a parallelized code) increase in time and space polynomial to the input, n, such as e.g. n¹, n² or n⁹⁹ etc., where n is being raised to a power, belongs to the class of "P". On the other hand, for the class of parallelization problems, for which the time to provide a solution increases exponentially, i.e. not in polynomial time is called "NP" (Nondeterministic Polynomial time). NP parallelization problems, unlike parallelization problems in P, are parallelization problems that take computers an extremely long time and space to solve; time that grows exponentially as the number of elements in the input increases. This exponential time is described as any number is raised to the n^{th} power, such as 2^{N}.

In this context, it is to be noted that for some problems, there is no known way to find a solution quickly, but if one is provided with information showing what the answer is, it is possible to verify the answer quickly. In terms of the measure of the computational complexity, such a technical problem is called NP-complete ("Nondeterministic Polynomial-time complete") where "nondeterministic" refers to nondeterministic Turing machines, "complete" refers to the property of being able to simulate everything in the same complexity class, and "polynomial time" refers to an amount of time that is considered "quick" for a deterministic method to check a single solution, or for a nondeterministic Turing machine to perform the whole search, respectively. That means, a computational problem is NP-complete, if (i) it is a technical problem for which the correctness of each solution can be verified quickly (namely, in polynomial time) and a solution can be found by using a brute-force search by trying all possible solutions; and (ii) the problem can be used to simulate every other problem for which it is possible to verify quickly that a solution is correct. In this sense, NP-complete problems are the hardest of the problems to which solutions can be verified quickly. If a system or algorithm is able to find solutions of some NP-complete problem quickly, this system or algorithm is able to quickly find the solutions of every other problem to which a given solution can be easily verified. In the computational technology, this problem here is called "*P versus NP problem*" which is whether problems that can be verified in polynomial time can also be solved in polynomial time. The problem has, inter alia, profound technical implications for parallelization of code and powerfulness of a system or method used for the parallelization. In particular, if a parallelization system and/or method is able to provide parallelization of a certain code or code structure, where this code or code structure is a NP-complete problem, all other similar NP-complete codes and code structures can be parallelized with this parallelization system or method to the same extent, with the exception of the polynomial reduction time. It is clear, that for parallelization of a code, in principle always brute force can be used for the search of the best optimized parallelization by generating all possible permutations of all possible basic blocs or computational block nodes or tasks or threads comprising all possible permutation of instructions in parallel and test it. However, using brute force, the complexity of code parallelization often becomes exponential having the result of being not any more scaling to the computational capacity of applied computer means. Some prior art solutions try to do branch and bound with different tasks or threads taking different choices or assumptions. But coordinating the tasks/threads becomes more difficult, and it becomes technically challenging to derive and/or verify the best optimized parallel code.

### (xi) Pipelines

In Von Neumann architecture, the process of executing an instruction involves several steps like fetch, decode, execute, and store. First, a control unit of a processor fetches the instruction from the cache (or from memory). Then the control unit decodes the instruction to determine the type of operation to be performed. When the operation requires operands, the control unit also determines the address of each operand and fetches them from cache (or memory). Next, the operation is performed on the operands and, finally, the result is stored in the specified location. An instruction pipeline increases the performance of a processor by overlapping the processing of several different instructions. Often, this is done by dividing the instruction execution process into several stages. Typically, three 3 stages are distinguished: (i) fetch: Load data from memory; (ii) decode: Data translation and interpretation; and execute: Processing and termination. To design the pipeline, a sequential process is decomposed into several sub processes, called stages or segments. A stage performs a particular function and produces an intermediate result. It consists of an input latch, also called a register or buffer, followed by a processing circuit. A processing circuit can be a combinational or sequential circuit. The processing circuit of a given stage is connected to the input latch of the next stage (see Figure 123). A clock signal is connected to each input latch. At each clock pulse, every stage transfers its intermediate result to the input latch of the next stage. In this way, the final result is produced after the input data have passed through the entire pipeline, completing one stage per clock pulse.

### Detailed Description of the Preferred Embodiments

Figures 123 to 125 schematically illustrate an architecture for a possible implementation of an embodiment of the computer-aided IC design and manufacturing system 0 for optimized generation of a multi-core and/or multi-processor integrated circuit 2 architectures or layouts, integrated circuit 2 performance and integrated circuit 2 manufacturing yield. The multi-core and/or multi-processor integrated circuit 2 has a plurality of processing units and/or processing pipelines 21 simultaneously processing instructions on data by executing a parallelized processing machine code 32. The execution of the parallelized processing code 32 by the parallel processing multi-core and/or multi-processor integrated circuit 2 comprises the occurrence of latency times 26. The latency times being given by idle time of a processing unit 21 between transmitting data back after having processed a specific block of instructions of the processing code 32 on the data by the processing unit 21 and receiving data necessary for execution of a consecutive block of instructions of the processing code 32 by said processing units 21.

The computer-aided IC design and manufacturing system 0 comprises an auto-parallelization compiler system 1 comprising means for transforming a serial source code 31 of the program code 3 written in a programming language into a parallel processing machine code 32 comprising a number of instructions executable by the plurality of processing units 21 of the multi-core and/or multi-processor integrated circuit 2 or controlling the operation of the plurality of processing units 21. The auto-parallelization compiler system 1 is combined with the IC-layout system 5 for generating a parallel processing IC layout 54 with a plurality of integrated circuit layout elements 51 at least comprising elements denoting memory units 22 and elements denoting processing units 21 and/or processing pipelines. The compiler system 1 comprises a parser module 11 for translating the serial source code 31 into a code 32 with a flow of elementary instructions executable by the processing units 21, the elementary instructions selectable out of a limited, processing-unit-specific set of elementary instructions and the elementary instructions comprising exclusively elementary arithmetic and logic operations 321/322 and/or elementary control and memory operations 325 for the number of processing units 21.

The parser module 11 comprises means for partitioning the code 32 of said elementary instructions into computation block nodes 333, each computation block node 333 consisting of the smallest possible segmentation of a non-further decomposable sequence of elementary instructions of the code 32 processable by a single processing unit 21. The smallest possible segmentation of the elementary instructions is characterized by a sequence of elementary instructions framed by consecutive read and write instructions, said sequence being not further decomposable by smaller sequences of elementary instructions between consecutive read and write instructions, and the read and write instructions needed to receive data required for processing said sequence of elementary instructions by the processing unit 21 and transmit back data after processing by the sequence. The compiler system 1 comprises a matrix builder 15 for generating matrices 151,...,153 out of computation chains 34 portioned from the code 32. The matrices 151,...,153 comprise computation matrices and transfer matrices 151/152 and task matrices 153, wherein each column within a computation matrix 151 comprises computation block nodes 333 being simultaneously processable based on executability of read and write instructions transferring data required for processing of the computation block nodes 333. The transfer matrix contains to each computation block nodes 333 transfer and process properties at least characterizing data transfer properties from one to a consecutive computation block node 333 at least comprising data size of transmitted data and identification of a source computation block node 333 and target computation block node 333 of the data transfer and/or process characteristics on one of the plurality of processing units 21. Tasks 56 of a task matrix 153 are formed by the matrix builder 15 wherein in case of computation block nodes 333 each having a different read associated, the tasks 56 are formed by splitting the computation block nodes 333 of a column of the computation matrix 151 evenly to the number of the plurality of symmetric processing units 21 forming for each of the plurality of processing unit 21 per column of the computation matrix 151 one task 56, and splitting remaining computation block nodes 333 based on a predefined scheme to at least a part of said tasks 56. In case of computation block nodes 333 at least partially having a read with identical data transferred, the tasks 56 are formed by minimizing the number of reads uniformly or essentially uniformly over the number of processing units 21 and/or if a predefined offset value is exceeded by minimizing an integrated processing time uniformly over each of the processing units 21. The compiler system 1 comprises an optimizer module 16 using a matrix optimization technique minimizing an aggregated occurring latency time 26 integrating all occurring latency times 261. To provide an optimized structure of the tasks 56 within the task matrix 153 different combinations of rows from the computation and the transfer matrices are built by the optimizer module 16, each of the different combinations of rows from the computation and the transfer matrices representing a possible machine code 32 as parallel processing code providing its properties on the hardware of the parallel processing system 2. Each column of the task matrix 153 forms a computation chain 34 by one or more tasks 333 creating an ordered flow of computation block nodes 333 to be executed by one of the plurality of processing units 21, and wherein the aggregated occurring latency time 26 integrating all occurring latency times is minimized by the optimizer module 16. The compiler system 1 comprises a code generator 17 for generating the parallel processing machine code 32 for the plurality of processing units 21 with an optimized aggregated latency time 26 based on the computation chains 34 given by the optimized task matrix 153.

The IC-layout system 5 comprises a netlist generator 52 for generating a layout netlist 521 being composed of a plurality of integrated circuit layout elements 51 of an integrated circuit 2, the integrated circuit layout elements 51 comprising electronic components of the integrated circuit 2 at least comprising transistors 511, resistors 512, capacitors 513 and interconnections 514 of these components onto a piece of semiconductor 515. The layout netlist 521 comprise a plurality of parallel pipelines 53, each pipeline 53 comprising an input latch 531 and a processing circuit 532, wherein each input latch 531 comprises the integrated circuit layout elements 51 for a buffer or register, and a processing circuit 532 comprises integrated circuit layout elements 521 for processing the data of an associated input latch 531 by a set of basic set of elementary instructions 322. A processing stage 534 is given by a particular data processing by one of the plurality of parallel pipelines 53 producing an intermediate result 5341, wherein the input latch 531 and the processing circuit 532 of a given stage 534 is connected to the input latch 531 of a next stage 534. A clock signal 533 is connected to each input latch 531, wherein a clock signal 533 comprises the integrated circuit layout elements 521 for generating a clock pulse 5331, wherein at each clock pulse 5331 each of the plurality of parallel stages 534 transfers an intermediate result 5341 to the input latches 531 of the next stages 534, and wherein input data are passed through the plurality of parallel pipelines 53 completing one stage 534 per clock pulse 5331 until a final result 5342 is reached by completing all stages 534. The number 535 of the plurality of parallel pipelines 53 of a generated layout netlist 521 corresponds to the number of computation chains 34 given by the optimized task matrix 153, wherein the layout netlist 521 comprises a plurality of position variables 5211 generated and allocated to a plurality of layout elements 51 by the netlist generator 52, wherein position variables 5211 represent the location of edges or points of the plurality of layout elements 5212, and wherein an IC layout 54 is generated by the netlist generator 52 from the position variable values 5211 of the generated layout netlist 521.

Figures 12 and 13 schematically illustrate an architecture for a possible implementation of an embodiment of the compiler system 1 for optimized compiling of a program code 3 for execution by a parallel processing system 2 having a plurality of processing units 21. It has to be noted that, herein, when an element is referred to as being "connected to" or "coupled to" another element, it can be directly connected or coupled to the other element or intervening elements may be present. In contrast, when an element is referred to as being "directly connected to" or "directly coupled to" another element, there are no intervening elements present. Further, some portions of the detailed descriptions which follow are presented in terms of procedures, logic blocks, processing, and other symbolic representations of operations on data bits within a computer memory. These descriptions and representations are the means used by those skilled in the data processing arts to most effectively convey the substance of their work to others skilled in the art. In the present application, a procedure, method, logic block, process, or the like, is conceived to be a self-consistent sequence of steps or instructions leading to a desired result. Embodiment variants described herein may be discussed in the general context of processor-executable instructions residing on some form of non-transitory processor-readable medium, such as program codes or code blocks, executed by one or more processors or other devices. Generally, program codes include routines, programs, objects, components, data structures, etc., that perform particular tasks or implement particular abstract data types. The functionality of the program codes may be combined or distributed as desired in various embodiments. The techniques described herein may be implemented in hardware, software, firmware, or any combination thereof, unless specifically described as being implemented in a specific manner. Any features described as modules or components may also be implemented together in an integrated logic device or separately as discrete but interoperable logic devices. If implemented in software, the techniques may be realized at least in part by a non-transitory processor-readable storage medium comprising instructions that, when executed, performs one or more of the methods described above. The non-transitory processor-readable data storage medium may form part of a computer program product. For a firmware or software implementation, the methodologies may be implemented with modules ( e.g., procedures, functions, etc.) having instructions that perform functions described herein. Any machine readable medium tangibly embodying instructions may be used in implementing methodologies described herein. For example, software codes can be stored in a memory and executed by one or more processors. Memory can be implemented within the processors, as e.g. registers, or external to the processors.

The various exemplary logical blocks, modules, circuits and instructions described in connection with the embodiments disclosed herein may be executed by one or more processors or processor units 21, such as one or more Central Processing Units (CPU) 210, e.g. comprising a control unit 2101, a processor 2102 with registers 21021 and combinational logic 21022, and/or Graphics Processing Units (GPU) 211, and/or Sound chips 212 and/or Vision Processing Unit (VPU) 213, and/or Tensor Processing Units (TPU) 214 and/or Neural Processing Units (NPU) 215, and/or Physics Processing Units (PPU) 216, and/or Digital Signal Processors (DSP) 217, and/or Synergistic Processing Units (SPU) 218 and/or Field-Programmable Gate Arrays (FPGA) 219 or any other processor units 21 known in the art as e.g. motion processing units (MPUs) and/or general purpose microprocessors and/or Application Specific Integrated Circuits (ASIC) and/or Application Specific Instruction Set Processors (ASIP), or other equivalent integrated or discrete logic circuitry. The term "processor" or "processor unit" 21 as used herein may refer to any of the foregoing structure or any other structure suitable for implementation of the techniques described herein. In addition, in some aspects, the functionality described herein may be provided within dedicated software modules or hardware modules configured as described herein. Also, the techniques could be fully implemented in one or more circuits or logic elements. A general purpose processor 21 may be a microprocessor, but in the alternative, the processor may be any conventional processor, controller, microcontroller, or state machine. In the described embodiments, processing elements refers to a plurality of processors 21 and the associated resources such as memory or memory units 22. Some example methods and apparatuses disclosed herein that may be implemented, in whole or in part, to facilitate or support one or more operations or techniques for processing code in a plurality of processors. The multi-processing system 2 can also comprise processor arrays comprising a plurality of processors 21. Each processor 21 of the processor array may be implemented in hardware or a combination of hardware and software. Processor arrays can be representative of one or more circuits capable of performing at least a portion of information computing technique or process. By way of example but not limitation, each processor of a processing array can include one or more processors, controllers, microprocessors, microcontrollers, application specific integrated circuits, digital signal processors, programmable logic devices, field programmable gate arrays, or the like, or any combination thereof. As mentioned, the processors 21 can be any of general purpose Central Processing Unit (CPU), or special purpose processors such graphics processing unit (GPU)s, Digital Signal Processors (DSP), video processors or any other special purpose processors.

The invention comprises a compiler system 1 with sub-systems 11,...,16. In a non-limiting embodiment, the sub-systems comprise at least lexer/parser 11 and/or an analyzer 12 and/or a scheduler 13 and/or a matrix module 14 and/or an optimizer module and/or a code generator 16. Further, they can also comprise processor arrays and/or memory. Compiler 1 segments code into code blocks. For the described embodiments, block or code blocks refer to a section or portions of code grouped together. Grouping enables groups of statements/instructions to be treated as if they were one statement, and to restrict the scope of variables, procedures and functions declared in a block so that they do not conflict with variables having the same name used elsewhere in a program for different purposes.

The above-mentioned memory or memory units 22 of the parallel processing system 2 can comprise any memory to store code blocks and data. Memory 22 may represent any suitable or desired information storage medium. Memory may be coupled with processor units 21 and/or processing array. As used herein the term "memory" 2 refers to any type of long term, short term, volatile, nonvolatile, or other memory and is not to be limited to any particular type of memory or number of memories, or type of media upon which memory is stored. Memory 2 can e.g. comprise primary storage units 211 as processor registers 2111 and/or processor caches 2112 comprising multi-level caches as L1-cache 21221, L2-cache 21222, etc. and/or Random Access Memory (RAM) units 2113. In respect to this application, it has to be noted that the issue of the multi-level caches lies in the tradeoff between cache latency and hit rate. Larger caches have better hit rates but longer latency. To address this tradeoff, multiple levels of cache can be used, with small fast caches backed up by larger, slower caches. Multi-level caches generally operate by checking the fastest, level 1 (L1) cache first. If it hits, the processor can proceed at the higher speed. If that smaller cache misses, the next fastest cache (level 2, L2) is checked, and so on, before accessing external memory. Cache access cannot be controlled directly by a programmer. It can be influenced by data locality and / or by compiler hints. As the latency difference between main memory and the fastest cache (cf. figure 1) has become larger, some processors have begun to utilize as many as three levels of on-chip cache. The memory 2 can further e.g. comprise secondary storage units 212 and/or third storage units 213 (e.g. tape backup etc.), the secondary storage units 212 comprising e.g. Hard Disk Drives (HDD) 2121 and/or Solid-State Drives (SSD) 2122 and/or Universal Serial Bus (USB) memory 2123 and/or flash drives 2124 and/or optical storage devices (CD or DVD drives) 2125 and/or floppy disk drives (FDD) 2126 and/or RAM disks 2127 and/or magnetic tapes 2128 etc. In at least some implementations, one or more portions of the herein described storage media may store signals representative of information as expressed by a particular state of the storage media. For example, an electronic signal representative of information may be "stored" in a portion of the storage media (e.g., memory, register, flip-flop, etc.) by affecting or changing the state of such portions of the storage media to represent information. As such, in a particular implementation, such a change of state of the portion of the storage media to store a signal representative of information constitutes a transformation of storage media to a different state or thing. As mentioned above, memory 2 can e.g. comprises random access memory (RAM) such as synchronous dynamic random access memory (SDRAM), First-In-First-Out (FIFO) memory, or other known storage media.

(Micro-) processors are based on integrated circuits, which makes it possible to do arithmetic and logical operations based on (two) binary values (in the simplest 1 / 0). For this, the binary values must be available for the processor's calculating unit. A processor unit needs to get the two binary value to calculate the result of an expression a = b operand c. The time it takes to retrieve the data for these operations is known as the latency time. There is a wide hierarchical range for these latency times from the register, L1-cache, memory access, I/O Operation, or a network transfer, as well as processor configuration (e.g. CPU vs. GPU). As every single component has a latency time, the overall latency time for the calculation is a combination mainly of hardware components needed to get the data from one location to the other in a modern computation infrastructure. The difference between fastest location for a CPU (or GPU) to get data and the slowest can be huge (in the range of factor >10^9).

Latency from a general point of view is the time delay between the cause and the effect of some physical change in a system being observed or measured. The latency, as used herein, is directly related to the physical structure of the multi-processing system 2. Multi-processing systems 2 comprise processor units 21 based on integrated circuits, which makes it possible to do arithmetic and logical operations based on (two) binary values (in the simplest 1 / 0). Those binary values must be available for the processor's calculating unit. A processor unit needs to get the two binary value to calculate the result of an expression a = b operand c. The time it takes to retrieve the data for these operations is known as the latency time. There is a wide hierarchical range for these latency times from the register, L1-cache, memory access, I/O Operation, or a network transfer, as well as processor configuration (e.g. CPU vs. GPU). As every single component has a latency time, the overall latency time for the calculation is a combination mainly of hardware components needed to get the data from one location to the other in the multiprocessing system's infrastructure. It is worth noting that the speed of microprocessors has increased by more than a factor of ten per decade, but the speed of commodity memories (DRAMs) has only doubled, i.e., access time is halved. Therefore, the latency of memory access in terms of processor clock cycles grow by a factor of six in 10 years. Multiprocessor systems 2 intensify the problem. In bus-based systems, the establishment of a high-bandwidth bus between the processor and the memory tends to increase the latency of obtaining the data from the memory. When the memory is physically distributed, the latency of the network and the network interface is added to that of the accessing the local memory on the node. Latency usually grows with the size of the multiprocessing machine 1, as more nodes imply more communication relative to computation, more jump in the network for general communication, and likely more contention. The main goal of parallel computing hardware design is to reduce the overall used latency of the data access by maintaining high, scalable bandwidth while the main goal of parallel processing coding design is to reduce the overall idle time of the processor units 21. In general, idle time of the processor units 21 may have several causes, as the latency of memory access, deadlocks, or race conditions, e.g. if the sequence or timing of the code blocks or threads processed by the processor units 21 depend mutually, i.e. depend on the relative timing between interfering threads. As used herein, deadlock is a state in which a member of the processor units 21 is waiting for another member's output, e.g. the output of an instruction block processed by another processor unit 21, to take action. Deadlock is a common problem in multiprocessing systems 1, parallel computing, and distributed systems, where software and hardware locks are used to arbitrate shared resources and implement process synchronization. Thus, a deadlock, as used herein, occurs when a process or thread enters a waiting state because a requested system or data resource is held by another waiting process or not yet achieved by the process, which in turn can be waiting for another resource or data held by another waiting process. If a processor unit 21 is unable to further process because the resources requested by it are being used by another waiting process (data access or output of a not yet finished process of another processor unit 21), then this is denoted herein as a deadlock leading to idle time of the respective processor unit 21.

The compiler system 1 comprises means for translating a source programming language 31 of the computer program 3 into a machine code 32 as target programming language generating a processing code 3.1, ... , 3.n comprising a number of instructions executable by the plurality of processing units 21 of the parallel processing system 2 or controlling the operation of the plurality of processing units 21. The source programming language can e.g. be a high-level programming language 31. The high-level programming language 31 can e.g. comprise C and/or C++ 311 and/or python 312 and/or Java 313, Fortran 314, OpenCL (Open Computing Language) 315 or any other high-level programming language 31. It is important to note, that the auto paralleling compiler system 1 can also be applied to machine code 31 or assembler code 31 as source code to achieve parallelization of the code. In this case, the translation of the high-level language to machine code instructions does not have to be performed by the compiler system 10.

The parallel processing system 2 comprise memory units 22 comprising at least main execution memory units 221/2212 comprising a plurality of memory banks for holding data of at least parts of the processing code 32, and transition buffer units 221/2211 comprising high speed memory for storing starting locations of the processing code 32 and data segments at least comprising branch or jump instructions and/or used memory references and data values, wherein the main execution memory units 2212 provide a slower access time than the transition buffer units 2211. The transition buffer units 2211 can e.g. comprise cache memory modules 2211 and/or L1-cache 22121.

The execution of the processing code 32 by the parallel processing system 2 comprises an occurrence of latency times 26, the latency times being given by idle time of a processing units 21 for retrieving and/or saving data necessary for execution of a specific block of instructions of the processing code 32 by the processing units 21. The latency time can e.g. comprise register 2211 access time and/or L1-cache 22121 access time and/or memory 2213 access time and/or I/O operation time and/or data network transfer time and/or processor configuration time.

The compiler system 1 comprises a parser module 11 for translating the source programming language 31 into a code 32 of elementary instructions directly executable by the processing units executable by the number of processing units 21, the elementary instructions selectable out of a processing unit specific set of elementary instructions comprising arithmetic operations 321 and/or logic operations 322 and/or control operations and/or I/O operations, in particular variable and array declarations instructions 323, compare operation instructions 324, and code flow instructions 325, for the number of processing units 21. The arithmetic operations 321 can e.g. comprise the operations addition, subtraction, multiplication, and division. The logic operations 322 can e.g. comprise a number of logical expressions like equal, not equal, greater than, less than, greater than or equal, less than or equal. The control operations can e.g. comprise a "branch expression" and/or a "loop expression".

As an embodiment variant, at least two of the processing units can e.g. have different sets of elementary instructions. The different processing units having different sets of elementary instructions can e.g. comprise Central Processing Units (CPU) 210, Graphics Processing Units (GPU) 211, sound chips 212, Vision Processing Unit (VPU) 213, Tensor Processing Units (TPU) 214, Neural Processing Units (NPU) 215, Physics Processing Units (PPU) 216, Digital Signal Processors (DSP) 217, Synergistic Processing Units (SPU) 218, Field-Programmable Gate Arrays (FPGA) 219 etc.

The parser module 11 comprises means for partitioning the code of elementary instructions into computation block nodes 333 each consisting of a smallest possible segmentation of non-further decomposable units each comprising a sequence of the elementary instructions requiring the same input data. Two or more computation block nodes 333, each with chains of elementary instructions, form a computation chain 34 creating an ordered flow of operations/instructions on the input data. The chains in the computation block nodes 333 (sequence of the elementary instructions) are built by a fixed rule: The instruction is placed at the position in the chain 34 where the new elementary instruction READs after the elementary instruction that WRITES the data point. This automatically forms a chain 34, which is data centered and maps the necessary, physically limited READ and WRITE operations in a computational register 2211, L1-cache 2212, network I/O or similar of a CPU 21.

The compiler system 1 comprises a matrix builder 15 for generating a number of numerical matrices 151,...,15i out of the computation chains 34 depending on the latency times 26. In the graph from the computation chains 34, the dependencies of the system can be assessed, however they cannot simply be broken down into individual independent chains. There exist fusion and split situations of computation block 333 chains in the chains 34, resulting from data dependencies and/or code branches. The latency to distribute information in the hardware system is introduced as a physical time. By assigning each computation block node 333 at least this time interval length, each computation block node 333 in the graph or tree structure can be numbered according to its position in the graph and given a block number and therefore giving computation block nodes 333 with same "temporal position" in the graph the same number. If a computation block node 333 has to be at least the length of the time it would take to distribute information in the system and should as many as instructions as possible have to be calculated during this time and each computation block node 333 has a number based on its position in the graph depending on the program flow, a set of matrix 151, ..., 15i can be build.

The matrix 151,...,15i also shows that they can be mathematically captured (a graph model based on CBs, CCs, etc. is not simply captured as a table/matrix). Thus, the data operations and communication are given and build numerical matrices, which can be optimized (changed) e.g. by using ML or Al, depending on the target platform and/or hardware setup.

The compiler system comprises a numerical matrix optimization module 16 using a numerical matrix optimization technique minimizing an overall occurring latency time as aggregated latency times 26 by providing an optimized structure of computational chains 34 being processed by the plurality of processing units 21, wherein by means of a code generator 17 an optimized machine code is generated for the plurality of processing units of the parallel processing system having an optimized overall latency times 26. The optimization can now be applied to the hardware infrastructure. The quantities that are important for the optimization are known in numerical form in the matrices 151,...,15i for each time unit and for each independent chain and branch: E.g. from the contents in the matrices: (i) number of elementary instructions, which must be sequential, (ii) size of the data transfer from the computational block x in computation chain u and when this transfer is needed again on computational block y in computation chain v (where y > than x) (e.g. possible via network or combine computation blocks to let data be on the same cacheline). As an example: for a GPU the data should be copied from memory to GPU memory in one process step and then all elementary instructions with the same properties should be executed at once, but on CPU, operations with the same data should be on the same cache-line (CPU dependent) or operations of specific data types can be calculated on the corresponding CPUs with the necessary better instruction sets. In the inventive system, this always leads to a parallel code even without optimization, because the elementary elements are grouped in sequential groups in the CBs.

In summary, since (micro-) processors understand only elementary instructions, the source code 31 is split into these elementary instructions in order to achieve the most basic level of parallelization. (It is to be noted, that the present invention is also applicable to the technical problem of optimization of (micro-) processors being based on the principle of integrated circuits (IC), which are a set of electronic circuits. The mentioned instructions are linked with the configuration of the electronic circuits on the (micro-) processor and therefore the following topics are also applicable to any form of integrated circuits or vis-versa can be used to derive optimized integrated circuits (or configuration of electronic circuits or directly electronic circuits) for a given code, as a instruction can be seen as a form of a configuration of an electronic circuit representing a computation operation (e.g. +, -, manipulate data, etc.)). The following core points are key to the inventive system: (1) Elementary instructions of a processor system are combined according to their unique "READ" and "WRITE" behavior, i.e. forming a chain of instructions according to the rule: "*an instruction writes to X1, a new instruction which reads to X1 is appended after the last instruction which writes to X1",* in a chain of nodes and links to computation blocks 333; (2) If it is necessary to propagate an information/data in the multiprocessor system 2, a new *computation block* 333 starts; (3) Each computation block 333 has a minimum time length. This is proportional to the length of time (latency), which is needed to propagate information (data or signal) to/from the *block* 333 in the hardware system; (4) In case of a graph model with two read data nodes, instruction node, and one write data node, which are connected by links, chains from the computation blocks 333 have places where two chains: (a) meet (e.g. because an instruction reads from two data points, which are written in two different *computation blocks* 333 or because a *branch* exists), (b)occur, e.g. if two computation blocks 333 can be started by reading simultaneously. If necessary, a graph model could e.g. also be based on more than 2 read nodes and several write nodes or combining several instructions in one operation/instruction node; and (5) These chains 34 can be broken down and the instructions and the necessary information transfers per discrete time interval could be captured in matrices. For example, each row is divided into columns (time interval one column) and contains the independent chains of instructions and the necessary information transfers to others. These are thus tangible for auto-optimization processes, in particular numerical optimization processes. This provides the basis for a fully automatic parallelization of source code. It has to be noted, that in the present auto-parallelization system 1, the graph model is not just based on a matrix or table representation but provides, inter alia, a multi-dimensional nested tree structure of a computation block graph, as task graph, associated to computation parallel chains 34, allowing the system 1 to assess properties that can be exploited for auto-parallelization, code optimization, computation block 333 scheduling, and even automated cost estimation or automatic mapping to different architectures of multi-processing system 2.

As mentioned, in the computation matrix, the cells containing the chain 34 of instructions given by the sequence of computation block nodes 333 forming the chain 34, and in the transfer matrix, the cells contain the transfer properties, i.e. the needed transfers to and from other computation block node 333. It is to be noted, that the transfer properties comprise of what information is needed in another computation block node 333. Depending on the level of the target infrastructure, this can be solved by classical compilation/controlled by the processor = transfer in cache (classic compiler distribute the data to register and try to exploit data locality to use cache-levels efficiently) or explicitly shared by shared memory and guarded by a lock or explicitly send and received from/to different nodes in a cluster using e.g. the Message Passing Interface (MPI) protocol or send and received by a socket in a multicore InterProcess Communication (IPC), etc.. The transfer properties may have any form of communication, ranging from handled by the processor (cache) or explicit by a communication pattern (e.g. IPC via queue, MPI, etc.). This makes the inventive method scalable to a wide range of platforms and/or infrastructures. Thus, the transfer properties, for example, may comprise information as send data %1 (integer) to cell (1,7). Transfers and/or communications need a certain time, which typically directly dependent on the (transfer/communication) latency times in a particular system. Finally, it has to be noted, that, as mentioned, in a specific row of the computation matrix, the column cells comprise the flow or sequence of instructions wherein each column cell of the row comprises one computation block node 333 of the sequence of computation block nodes 333, forming the chain 34 of the specific row. However, in specific embodiment variants, not each cell of a row necessarily needs to comprise a sequence of instructions or an instruction. One or more of the cells of one or more specific rows of a computation matrix can also be empty. This is also true for the transfer matrix. Computation matrix and transfer matrix are normally equal in their size, i.e. number of rows and columns. The computation matrix and the matrix and transfer matrix providing a possible technical structure for the auto-parallelization.

Technically, the matrix builder connects the computation block nodes 333 according to the program flow (e.g. fig. 35) and/or the code 32, respectively, from the parser module 11. The program flow is represented by connecting the computation block nodes 333 (similar to basic blocks), e.g. when adding a new instruction (=operation node), a new computation block node 333 can e.g. be generated, where, in general, there is no clear dependency (cf. figure 21), the new computation block node 333 being positioned after another computation block node 333 or under a branch node. After adding all instructions, it is possible to numbering each computation block node 333 along the program flow forming the sequence of the so generated chain 34. These numbers (block numbers) are equal to the column of the matrix. Computation block nodes 333 with same block numbers are distributed to different rows in the same column of the computation matrix.

### Generation of tasks and gamma structure/graph

Up to here, it is explained how to group basic instructions from sequential source code (a list of serial instructions) into the herein defined computation block (CBs = list of instructions preferred to run in serial) and indexing the resulting groups to retrieve groups of instruction to run in parallel including the needed transfers to run on different computing units. The method is built on a systemic perspective of modern computing platforms, which still are limited by binary computing steps. This basic concept, how a mathematical operation, such as +, -, *, /, etc. is computed on a binary computing system, i.e. a digital processor 2102/2103, results in some physical constraints and dependencies: (i) To compute a statement of a = b <op> c, the bit-pattern b and c each representing a number of corresponding accuracy (int to double precision) must be physical available to a binary computing unit in the moment of the calculation; (ii) To transfer a bit-pattern a, b or c on a platform or a system, a latency time Δ*t*_{transfer} arises; (iii) This Δ*t*_{transfer} is at least a power higher than computing several instructions in serial on one computing unit, i.e. on one processor 2102 or processor core 2103. The grouping bases on data-dependency extractions, resulting in grouping of instruction in computation blocks (CB). Each of them consists of one chain of sequential instructions. All needed data transfers between the CBs are kept. This composition makes it possible to optimize and auto-parallelize source code to be processed on parallel computing units, i.e. processors 2102 and processor cores 2103, respectively without any programmer's hint in a hardware-agnostic manner.

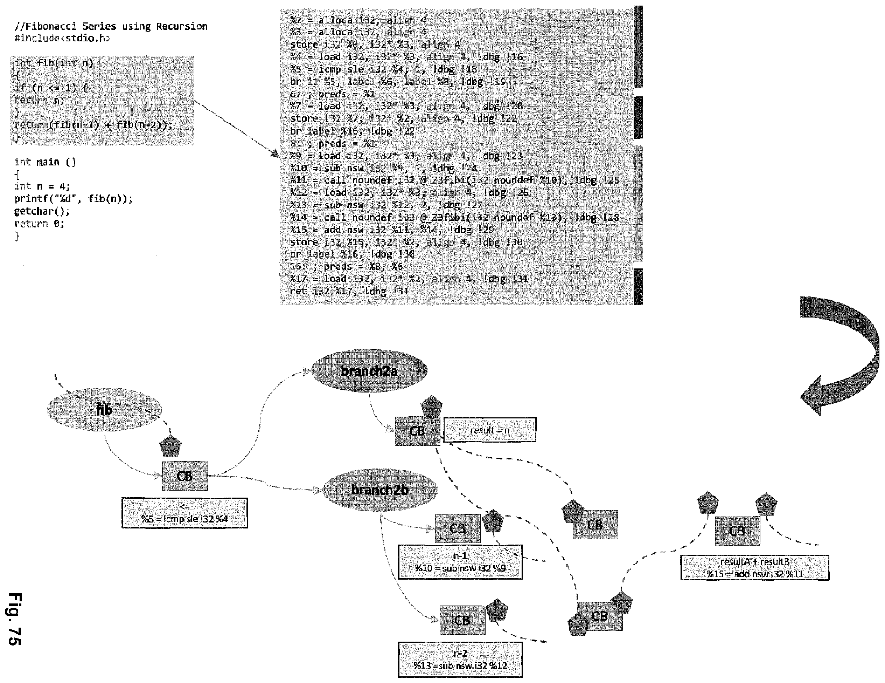

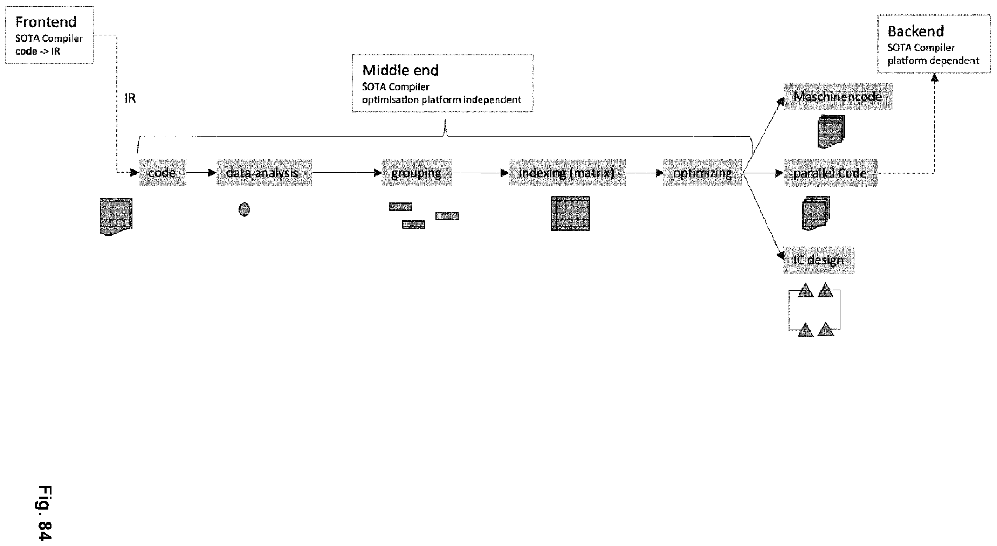

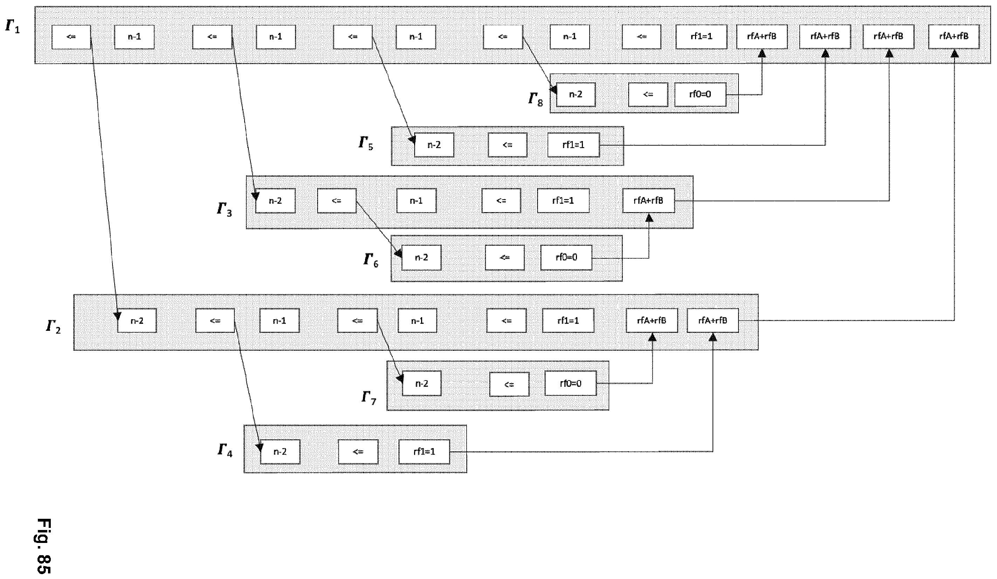

An embodiment variant uses the system and method is in the middle end of an auto-parallelization compiler, see figure 84. The generated result can be given out as a tensor or a graph, depending on the form of representation, see figure 85. If the code is represented by a tensor (or matrices), one consists of the computation block with their chain of instructions in each cell. Each row represents a series of instruction groups to be computable independently from the grouped instructions in the other rows of the same column. In a second matrix the corresponding data transfers are gathered between the instruction groups. Figure 80 also illustrates how tensor entries can be represented as a graph. It has to be noted, that as a CB A is positioned in a row and column to the segment number earliest possible after the read data is available in CB B with a segment-number A=B+1 (1 CB correspond to a potential transfer time), continuous entries in computation matrix belonging to the same condition, are based on the same read-data. These continuous segments can be called compute segment and indicate the continuous CBs can be computed without the need of other information. In case between two gamma-nodes 1 edge exist, the gamma-nodes can be combined to one gamma-node (Γ_{3*a*}+ Γ_{3*b*} => Γ_{3*b*}). This makes it possible to combine them in the same gamma-node, as they base on the same data in the same way as continuous CBs on the same row if belonging to the same branch node. Such compute segments are by definition a computation block node 333, as they enclose an arbitrary series of sequential instructions not sharing any data dependencies. Applied to the Fibonacci case, this is visible in figure 85, and leads to the computation graph as in *"Fundamentals of parallel programming module parallelism*" V. Sarkar. The indication of the compare instruction in the example for the "unrolled case" is for illustrative purposes to illustrate how the method applied to LLVM-IR in figure 75 forms to a gamma-graph. In figure 30 is shown how the method form at least one continuous series of CB over different branch nodes, keeping the program-flow from calling a program (indicated with main()) to the end of a program (indicated with return(0)). This is also visible in figure 85. Interpreting this gamma-graph in a multithreaded platform, each edge means to introduce a latency time for a context switch.

### (α) Combining rows/CBs to Tasks

As by the indexed version, the CBs which can be computed in parallel are in the same column, which means they have the same segment number. It is possible to combine CBs with same segment numbers (see figure 39). In this step the instructions in the new computation segment add up and possible transfers between the units vanish, see Figure 11. This has an influence on the time to compute a CB in parallel or in serial.

Another representation is in form of a computation or task graph, which is called herein "gamma-graph". To distinguish:
(i) A ***Computation Graph*** is used in reference to (cf. Fundamentals of parallel programming module 1 parallelism, V. Sarkar; see above) where nodes consist of arbitrary sequential instructions in the field of ideal parallelism;
(ii) A ***task graph*** is a generic graph with tasks, independent how these tasks are formed (e.g., as a computation graph or in the sense of function in the field of functional programming or otherwise);
(iii) A ***gamma-graph*** is a graph where each node is one CB or a combination of CBs. A gamma-graph is a task graph and in initial-granularity a computation graph. A gamma-node represents a compute segment, see above.

Each node represents one or more CBs. If in a row of the tensor representation (meaning on one unit) if there are no entries for transfers between columns, the computation blocks can be combined to one compute segment. For each row a distinct compute and communicate sequence evolve. A gamma-node consists at least of one computation block node (CB) or a composition of several with the same segment number and or with the same compute segment. From this, a physically based, unique dynamic task-granularity of the code can be gained by the inventive system and method, as described below.

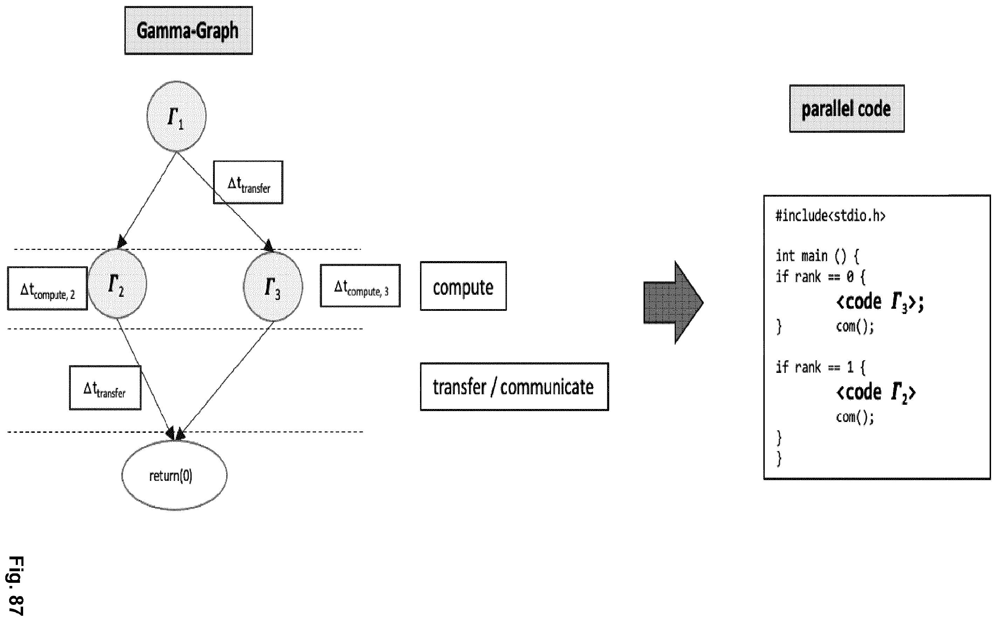

Further, as consequence of the decomposition with the method is getting in each row (see tensor representation) or nodes (see in the gamma-graph) distinguished segments to compute and communicate. From the gamma-nodes corresponding parallel code can be generated, see Figure 87. Δ***t_{compute}*** is the computing time and Δ***t**_{t**ransfer**}* the communication/transfer time. Figure 87 shows distinguished computing and transfer / communication sections. Both the computing time Δ***t_{compute}*** nor communication/transfer time Δ***t_{transfer}*** are easily to get nor must be fixed for a platform, but it is a unique feature of the method to be able to extract these two distinguished properties from code during compilation. This makes it possible to optimize the distribution of the nodes (code-chunks) to available computing units by using available frameworks, e.g. openMP, MPI or others.

In summary, the inventive auto-parallelization method and system groups and indexes instructions in a sequential code and provides the code in form of grouped instructions computing and resulting communication (transfer of data) sections representable as a tensor or graph. The computation sections can be seen as tasks with corresponding transfers/communication to other tasks. The building of the tasks follows the fundamental physical based principle that distributing data (bit-information) on different computing units introduce transfer and can reduce the computing time. It is a method to generate physically based data chunks in different granularity from code. By the ability to combine only parallel CBs the method makes it possible to generate task graphs with different task granularity. The ability to generate for a given code such task graphs introduce new opportunities to automatically optimize/parallelize code to a given hardware consisting of more than one computing unit. Combined with a solution approach to solve the potential occurring NP-complete problem of job/task scheduling on a parallel machine, the inventive method is a generic method to distribute code to homogeneous or heterogeneous platforms.

The granularity of each task can be expressed as G = Δ***t_{compute}***/ Δ***t_{transfer}***. For example, see "Evaluation of parallel programs by measurement of its granularity", J. Kwiatkowski. Granularity is linked to the levels of parallelism. There are several levels of parallelisms (see above): (a) Instruction parallelism: Instruction level parallelism (ILP) results in very fine-grained parallelism and is exploited by analyzing the instruction dependencies. The ILP is also implicitly exploited by the hardware scheduler of the microprocessor, i.e. the microcontroller; (b) Data parallelism: A lot of programs operations are applied to elements of larger data structures. The operations can be executed on parallel or distributed systems; (c) Loop-parallelism: If iterations of loops have no dependencies, they can be executed in parallel. If all loop iterations require the same execution time, the distribution can be easily performed by a static distribution with a fixed number of iterations to each computing unit; and (d) Task (or thread) Parallelization, which defines parallelization more in the sense of functional parallelism. Massively simplified, SOTA compilers are based on ILP and for some extend for loop-parallelism. It is one of the first steps in a SOTA compiler to decompose a code into Basic Blocks. A basic block (BB) is a code sequence of instructions without interruption of jumps. Meaning there are no branches in except one for the entry and out at the exit (cf: Hennessy, John L.; David A. Patterson, Computer architecture: a quantitative approach, Elsevier, 2011). The inventive method extends the Basic Block concept and extracts for each BB possible parallel instructions and corresponding transfer options to and from other BBs in the corresponding Control Flow Graphs (CFG).

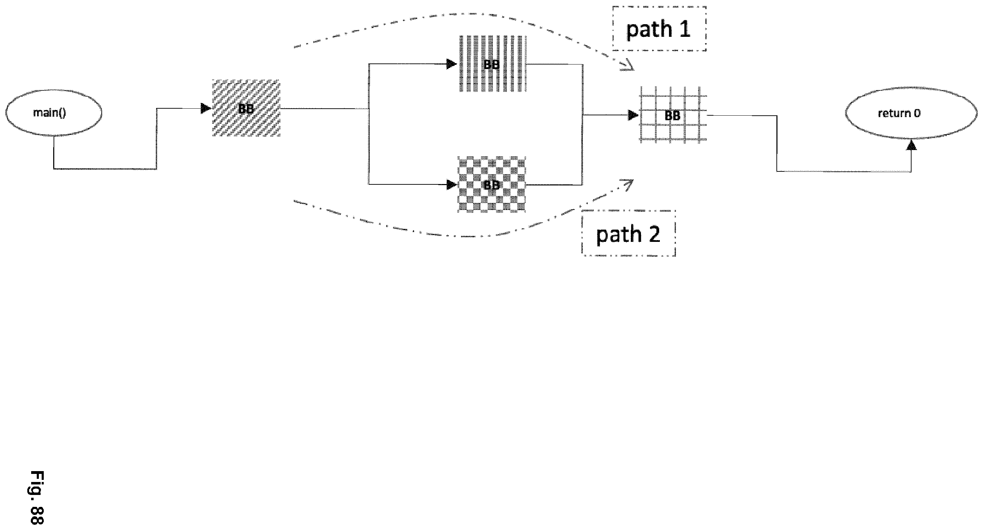

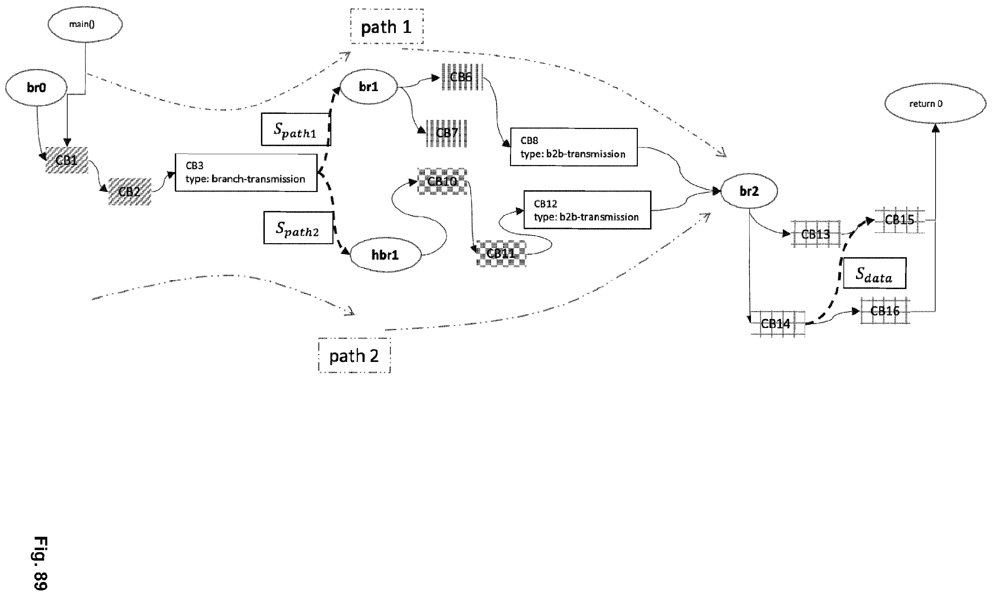

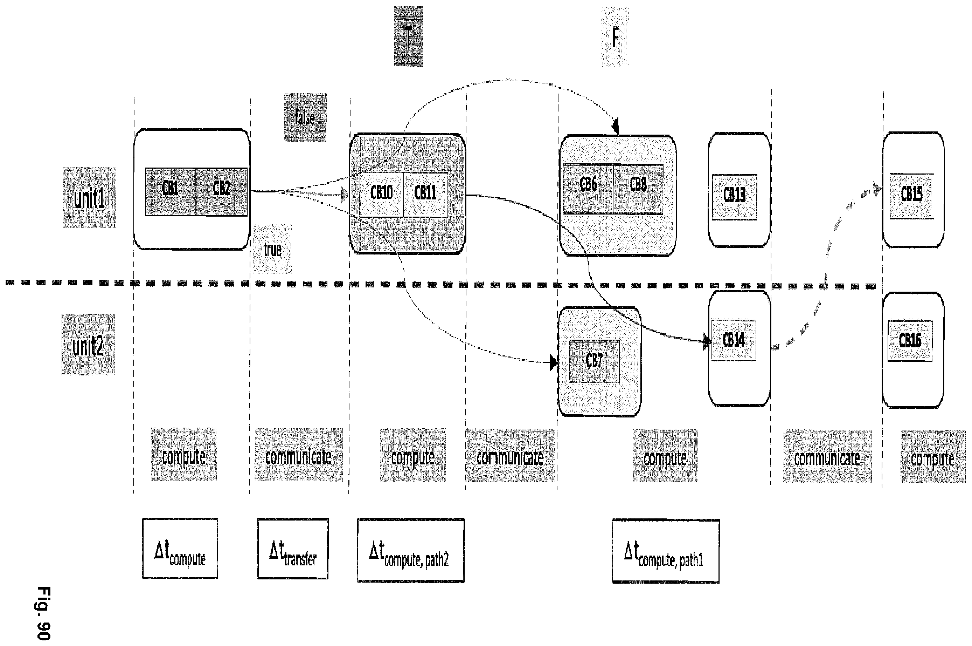

In the following, it is shown how the concept of Basic Blocks interact with the inventive method. Figure 88 shows schematically a code in form of BB and CFG. A corresponding graph representation of potential computation blocks (CBs) after applying the method to the code is illustrated in Figure 89. The grouping and sequence of the CBs is depending on the instruction data dependency within the BB. After indexing the CBs the computation and communication segments evolve for 2 units visible in Figure 90. T and F show the segments depending on the condition leading to a branch in Figure 89. The branching forms a transfer time Δ***t_{transfer}*** visible in the first communication step in Figure 90, in case there are possible parallel instruction opportunities to parallelize the computation in the BB.

For each path (one possible order of nodes through code based on one specific combination of conditions) corresponding transfer sizes *Sₚₐₜₕ₁, Sₚₐₜₕ₂* and *S_{data}* are extracted, see figure 89. In a resulting parallel code, each branch transition, respectively change of Basic Block has corresponding transfers, depending on the instruction parallelism possibilities within each Basic Block. It is important to annotate, that by combining CBs, also these transfer properties may vanish, resulting in an optimization problem best optimizable by SOTA compiler methods targeting one computing unit. The computation segments can be seen as tasks and the transfers as communication. A code or program code is a sequence of operations with well-defined total order, where parallelism can be expressed as a partial order. A computation graph, as used herein, is what is called a Direct Acyclic Graph (DAG), where each node is a chain of sequential instructions (=task) and the edge are the ordering constraints. The inventive auto-parallelization method, inter alia, is able to extract a certain Computation Graph (CG) G from code (for Computation Graph see e.g. *"Fundamentals of parallel programming module parallelism*" V. Sarkar) automatically. Several properties are associated with a computation graph G, where ***t***_{runtime,p} is the execution time in parallel and P the number of computing units. If it is assumed that the execution time *time(N)* is known and it is an uninterrupted sequential computation, this does not depend on the scheduling on a parallel machine:
- Sum of execution times of nodes in G: Work(*G*) = Σ*_{node N in G} time* (*N*)
- Longest path in G (critical paths) -> Critical path length: *CPL*(*G*)
- Most optimized (ideal) parallelism of a given computation graph G: *Work(G)*/*CPL(G)*

For the scheduling, i.e. the action to distribute computational tasks to resources, the knowledge about length of each task and how they are linked to each other can be essential to fulfil their constraints and optimally schedule them. This can be particularly true for symmetric parallel architecture under the assumption that the computation time of a CB is small in respect to the transfer time. Here, the critical path (longest path in G = CPL) is an important property, providing a measure how well a given code can be parallelized, as it is not possible scheduling to compute or process the CG G in less than this time.

For the execution of G on a parallel processor machine with P processors (independent of the scheduling): (1) The capacity bound is at least ***t***_{runtime,p} ≥ Work(*G*)/P. This means, a runtime less than ***t***_{runtime,p} is not possible on P processors (even when divided perfectly); (2) The critical path bound is at least ***t***_{runtime,p} ≥ *CPL*(*G*)/P. This means, it is not possible for a certain code to schedule a parallelization in less than ***t***_{runtime,p}, as each scheduler must obey the dependencies in the critical path. Thus, a runtime in parallel ***t***_{runtime,p} is given by: ${t}_{runtime , p} = max \left(\frac{WORK \left(G\right)}{p , CLP \left(G\right)}\right)$

In summary, the present inventive system and method provides a new technical approach to extract a computation graph for a given code. With EV3 this is also possible for loop-sections without explicitly resolve every data-dependencies between the instructions. This enables new opportunities to auto-parallelization of source codes to a hardware depending on its latency characteristics. The present invention, in particular, shows is immense potential by being applied to the technical problem of loop-level parallelization, which is the central aspect in high performance computing (HPC) applications as loop-sections can introduce large computing demands. Opportunities to exploit the inventive highly optimized parallelization is particularly given in application where data are stored in random access data structures. In this context, a well-known technical example to benchmark auto-parallelization is the recursive or loop implementation to generate Fibonacci numbers, which is discussed below. Further, the present auto-parallelization compiler is able to form task graphs as a function of a given transfer time (TT), when seeing the transfer time as the overhead for a parallel machine to run an application in parallel (e.g. context switch in a threaded environment). I.e. the present inventive system is able to provide a specifically auto-parallelization generating an optimized parallel code optimized on hardware specific characteristic to run tasks in parallel of the parallel-processing system used, in particular a specific architecture of one or more multi-core central processing units (CPU).

### (b) Transfer-Matrix Elements and Computational Length of Tasks

In general, the method can be used to get from code a computational graph as defined in the field of ideal parallelism, compare *"Fundamentals of parallel programming module parallelism*" V. Sarkar. This enables to deduct some code characteristics when applying the assumptions the execution time is known for all nodes with uninterrupted sequential computations and this time is not depending on the scheduling and there are no limits in processors. As discussed above, for the optimal scheduling, i.e. the action to distribute computational tasks to resources, the knowledge about length of each task and how they are linked to each other can be essential to fulfil their constraints and optimally schedule them, i.e. achieve best optimization.

To measure the performance and hardware-specific parameters of a processor 2102 or processor core 2103 or parallel processor architecture measuring clock speed frequencies is not enough for the present inventive auto-parallelization system 1, but there are more accurate parameters needed to measure performance. It is important to understand that, nowadays, there are a significant number of processor types and brands in the market differing significantly in their hardware properties and characteristics: Intel, AMD (Advanced Micro Devices, Inc.), and ARM (Acorn RISC Machines or Advanced RISC Machines) are examples. There are multiple different architecture types and tiers of processors for each company, which complicates things even more. For to best optimization of the parallelization, an accurate way is needed to compare these processors computing power. One possibility to measure processor performance is measuring Instructions per Second (IPS). Thus, IPS, today typically measured in MIPs (million instructions per second) or GIPs (billion instructions per second), can e.g. be used as a measure of a speed of a processor 2102/2103, and can be regarded as a general measurement or benchmark of how many instructions a processor 2102/2103 can handle in a single second. However, for example, for complex instruction set computers (CISCs), different instructions take different amounts of time, so the value measured depends on the instruction mix. Even for comparing processors in the same family the IPS measurement can be problematic. Many reported IPS values have represented "peak" execution rates on artificial instruction sequences with few branches and no cache contention, whereas realistic workloads typically lead to significantly lower IPS values. Memory hierarchy also greatly affects processor performance, an issue which is not proper considered by classic IPS measurements. Thus, there is no proper way of measuring MIPs, and MIPS measurements cannot be used as a measure of instruction execution speed as required by the present inventive system 1, but at the most as a task performance speed compared to a reference. In summary, the speed of a given processor depends on many factors, such as the type of instructions being executed, the execution order and the presence of branch instructions (problematic in processor pipelines) as well as different cache-levels.

It is to be noted again that processor instruction rates are different from clock frequencies, as each instruction may require several clock cycles to complete or the processor may be capable of executing multiple independent instructions simultaneously. MIPS can be useful when comparing performance between processors made with similar architecture (e.g. Microchip branded microcontrollers), but they are difficult to compare between differing CPU and processor 2102/2103 architectures. In particular, a MIPs measurement with a higher number does not mean much for the real-world situation of the operation of the present system 1 requiring exact hardware-specific measuring parameter values. Regarding the processor architecture, the design process involves choosing an instruction set and a certain execution paradigm (e.g. VLIW or RISC) and results in a certain microarchitecture, which is typically described in e.g. VHDL or Verilog. For microprocessor design, this description is then manufactured employing some of the various semiconductor device fabrication processes, resulting in a die which is bonded onto a chip carrier. This chip carrier is then soldered onto, or inserted into a socket on, a printed circuit board (PCB). The mode of operation of any processor is the execution of lists of instructions. Instructions typically include those to compute or manipulate data values using registers, change or retrieve values in read/write memory, perform relational tests between data values and to control program flow. The already mentioned clock speed of a processor is another measure typically measured in megahertz and gigahertz. However, as also discussed above, clock speed by itself is also not an accurate way to gauge processor performance for the present invention. Finally, FLOPs (floating-point operations per second) are still another factor to measure the performance of a processor. A floating point number is a number that has floating decimal points, such as 0.008. However, a FLOPs benchmark only measures the floating point operations and not the integers, which means it too cannot solely gauge processor performance.

Measuring the execution time of single CBs alone is therefore not effective nor practicable. But SOTA compiler methods are built to optimize a series of instruction on a given processor, a NP-complete optimization. The presented inventive system does not change any indication on the scale how to schedule instructions on a processor. For the inventive system the relative computation time of CBs is much more relevant than the absolute compute time for one particular instruction or one CB. The goal is more to determine the relative duration of different CBs and split the computing time from data loading and storing (affected by memory hierarchies e.g., cache-accesses), which is expressed as transfers in method (e.g. in a multicore architecture data between computing units can be shared by L2 or L3 caches and the optimization of the inventive system is to distribute the CBs in the form the transfer occur over L2 / L3 caches). SOTA compiler methods can be used to compile the code in a CB to machine code. Modern SOTA compiler methods are targeted to exploit processors characteristics, such as exploiting instruction parallelism by using e.g. appropriate specific registers (e.g. XMM registers), use floating-point units, out-of-order execution, etc. for a given series of instructions (mostly in the scope of a Basic Block). This results in optimized machine code for a target computing unit. As noted, established method exist to determine cycle duration of single machine instruction, which are a function of the processor clock speed, see A. Fog, "Instruction tables", Technical University of Denmark, 2022. Based on these tabled values for these machine instructions and the available latency times as a function of data size to data hierarchies (e.g. cache-level, memory, etc.), relative duration to compute a CB can be derived. The optimal use of scheduling single instructions is covered in this way with the well-known SOTA compiler method, which are very well established and cover the NP-complete problem of scheduling instructions for one computing unit / processor. Such a step also derives the relation of a series of arbitrary sequential instructions and the needed data size S_{comp} to compute this set of instruction on a given hardware. In conjunction with clock speed frequencies, this allows to model compute time differences between distinct CBs (=series of sequential instructions). As CBs in the same column represent unique distinct set of instruction-chains and without any data dependency the relative runtime can be approximated by number of instructions, specific cycle number per instruction and access to memory. It has to be annotated, that instruction-chains in continuous CBs base always on the same unique first "read" information (within the CB, the read value for the next instruction is located directly after the write instruction = definition of a computation block node 333). Any other information needed to compute in a CB is gathered by transfers in the transfer matrix. This fundamental characteristic of data locality makes it possible to derive if this data could be on different memory hierarchies (cache, memory or disc or network, etc.). This differs for combination of CBs in the same column, as this indicates data dependencies exploitable, e.g. by cache-levels. This effect can be detected by cumulating data size of all parallel CBs, as this is the minimal size of data needed to be loaded to registers and the latency to corresponding cache-levels, which can hold the information, can be derived. As data is loaded in chunks (e.g. page-size, cache line size, etc.), the number of minimal loads to a given data level can be derived and used to write parallel code with optimized data locality.

The methods do not imply to provide better approaches to optimize instructions on one processor, but to exploit over different levels (ILP to LLP) and provide a structured way to build up physical based chunks of instruction based on their data locality. Based on these distinct instruction chunks (CBs) a generic optimization problem can be deducted to optimize (a) to the physical relations (b) - referenced as rel1:
I. the method obtains a computation graph and therefore for every level in the graph the maximal number of parallel unique chains of arbitrary sequential instructions (CBs) are known as a function of runtime-parameters.
II. a computing unit / processor has a:
   i. set of latency times to retrieve data of a given size of (data size match into register, Ln-cache, memory, disc, etc.)
   ii. for a given series of instructions, a minimal data size / input-bit-size *S_{comp}* is needed to compute a series of given instructions on a given processor or a combinational circuit.
   iii. for a given series of instructions, a distinct time of computation is given on a processor / combinational circuit by the corresponding way of computing this series of sequential instructions (instruction set, processor architecture, cache and memory layout, or combinational circuit vs. sequential circuits)

This means for every gamma-graph-level (a) the number of different CBs, (b) per CB the minimal size to compute the instructions in the CB and (c) the needed "read" and "write" data sizes expressed as data transfers are known during compile time as a function of runtime-parameter. idl-points represents a gamma-node where a processor would idl e.g. see figure 80 return(0) when Γ₂ and Γ_{3*b*} have not the same runtime to conduct the transfer of all *S_{transfer,i}* and calculation of problem size *S*_{*comp,*2*,and* 3*,a*}. This information is extracted in a generic form from any given code, as the information of the data relations must be in any form of runnable code.

Summarized, along a gamma-graph with initial granularity = computational graph, see II above - referenced as rel2:
(1) each level give1s the number of parallel gamma-nodes. Each CB consists of a unique chain of instructions (fig 80: Γ₂, Γ_{3*a*}, Γ₄)
(2) each node has for a given platform a distinct data size *S_{compute,CB}* needed to compute the instructions (function of variable types, processor properties and available SOTA compile methods)
(3) a unique transfer in and out ${S}_{transfer , \frac{in}{out}}$ of the gamma-node is known

The same information is contained in the tensor notation. *S_{compute}* and *S_{transfer}* extracted by the method gives a) the problem size per graph-level (sum of all parallel compute sizes in parallel CBs *S_{compute} =* Σ *S_{compute,Cb i}* ) b) the set of unique series of instructions runnable in parallel c) needed size to compute *S_{compute,CB,i}* for every gamma-node. Therefore, *S_{compute,CB,í}* defines the minimal register size (or use of higher memory hierarchies) on a given platform to compute the series of instruction in the CB and in case CBs are seen as combinational circuits, a distinct minimal area needed on a silicon wafers. In combination with the *S_{transfer}* the number of loads to an available fastest memory hierarchy (memory, flip-flops, etc.) is known. These size properties are known with EV3 as a function of loop-variables and loop-header-definitions. Based on this EV1 and the method enables to bring (1), (2), (3) (see rel2) in relation to (i), (ii), (iii) (see rel1) and therefore numerical optimizable.

This builds a base for a wide range of different optimization approaches for real applications, as in real application ideal parallelism assumptions are not given.

### Optimized scheduling for loop-sections - loop level parallelization

Loop-level parallelization is one of the central aspects in High-Performance computing (HPC) applications and High-Performance Technical Computing (HPTC) applications, as loop-section codes may introduce large computing demands. HPC and HPTC uses supercomputers and computer clusters to solve advanced computation problems. In particular, with the increasing complexity of integrated circuit (IC) designs at Nano-Tera scale, multi-core CPUs and multi-core GPUs have become ideal hardware platforms for emerging parallel algorithm. Today, multi-core processors are widely used across many application domains, including general-purpose, embedded, network, digital signal processing (DSP), and graphics (GPU). Core count goes up to dozens, and for specialized chips over 10,000, and in supercomputers (i.e. clusters of chips) the count can go over 10 million. To use such platforms efficiently, parallelization, in particular optimized loop-parallelization, is technically absolute essential. However, one of the technical problems of parallelization also arises from the fact, that it has become extremely challenging to leverage parallel hardware platforms at extreme scale beyond 22nm and 60GHz where complex source codes and algorithms, such as circuit simulation, show strong data dependencies. The inventive auto-parallelization system provides, inter alia, data dependency elimination in parallelization of complex codes, such as technical circuit simulation e.g. parasitic extraction, transient simulation, and periodic-steady-state (PSS) simulation, which paves the way towards unleashing the underlying power of parallel hardware platforms. The improvement in performance gained by the use of parallel-processing systems, such as a multi-core processor, depends strongly on the level of parallelization achieved. In particular, possible gains are limited by the fraction of the parallelized code that can run in parallel simultaneously on the multiple cores or processors; this effect is described by Amdahl's law. In the best case, so-called embarrassingly parallel problems may realize speedup factors near the number of cores, or even more if the problem is split up optimized enough to fit within each processor's or core's cache(s), avoiding use of much slower main-system memory. In the prior art, most applications, are not accelerated as much even refactoring is used. The present inventive auto-parallelization system allows to achieve the possibly highest optimization, where data dependency in the column of the computations matrices vanish.

Loop-level parallelization in computer architecture is complex. The technical object of loop-level parallelization is to take out parallel tasks within the loops in order to speed up the process. The need for this parallelism, in particular, arises where data is stored in random access data structures like arrays. A program that runs in sequence will iterate over the array and perform operations on indices at a time, a parallelized code that has loop-level parallelism e.g. will use multi-task/multi-threads/multi-processes that operate on the indices at the same time or at different times. As discussed before, opportunities to exploit parallelism is mostly in application where data are stored in random access data structures. In a loop, data dependencies can be classified, as follows:

**Table: The table illustrates the "read" and "write" dependencies captured as well by the inventive system and method**

| ***type*** | ***example*** | ***notation*** | ***description*** |
|---|---|---|---|
| True(Flow) Dependence | S1: int a, b; | S1 → T S2 | A true dependence between S1 and S2 means that S1 writes to a location later read from by S2 |
| | S2: a = 2; | | |
| | S3: b = a + 40; | | |
| Anti-Dependence | S1: int a, b=40; | S1 → A S2 | An anti-dependence between S1 and S2 means that S1 reads from a locatio0n later written to by S2 |
| | S2: a = b - 38; | | |
| | S3: b = -1; | | |
| Output Dependence | S1: int a, b=40; | S1 → O S2 | An output dependence between S1 and S2 means that S1 and S2 write to the same location |
| | S2: a = b - 38; | | |
| | S3: a = 2; | | |
| Input Dependence | S1: int a, b, c=2; | S1 → I S2 | An input dependence between S1 and S2 means that S1 and S2 read from the same location |
| | S2: a = c - 1; | | |
| | S3: b = c + 1; | | |

An important distinction is "loop-carried" versus "loop-independent" dependencies. In the case of "loop-independent" dependencies, there is no dependency between the statements in each iteration, for example:

| |
|---|
| ``` for (int i = 1; i < n; ++i) { S1: tmp = a[i]; S2: a[i] = b[i]; S3: b[i] = tmp; } ``` |

In contrast is loop-carried dependence, for example:

| |
|---|
| ``` for (int i = 1; i < n; ++i) { S1: a[i] = a[i-1] + 1; ``` |

For the present application, the following classification can be used: (1) DISTRIBUTED Loop: Statements can be extracted which are not dependent and can be computed in separated loops and in this way distributed;

| | |
|---|---|
| for (int i=1; i<n; ++i) { | loop1: for (int i=1; i<n; ++i) { |
| S1: a[i] = a[i-1] + b[i]; | S1: a[i] = a[i-1] + b[i]; |
| S2: c[i] += d[i]; | } |
| } | Loop2: for (int i=1; i<n;++i) { |
| | S2: c[i] += d[i]; |
| | } |

(2) DO-ALL parallelism (Independent multi-threading (IMT)): Statements can be extracted within loop executable independently. So all statements in the loop-core can be executed independently;

| | |
|---|---|
| for (int i=1; i<n; ++i) { | begin_parallelism(); |
| S1: a[i] = b[i] + c[i]; | for (int i=1; i<n; ++i) { |
| } | S1: a[i] = b[i] + c[i]; |
| | end_parallelism(); |
| | } |
| | block(); |

(3) DO-ACROSS parallelism (Cyclic multi-threading (CMT)): Statements, respectively calculations can be extracted that can be performed independently and running simultaneously;

| | |
|---|---|
| for (int i=1; i<n; ++i) { | for (int i=1; i<n; ++i) { |
| a[i] = a[i-1] + b[i] + 1; | S1: a[i] = a[i-1] + b[i]; |
| } | post(i); |
| | } |
| | for (int i=1; i<n; ++i) { |
| | wait(i); |
| | S2: c[i] += a[i]; |
| | } |

(4) DO-PIPE parallelism (Pipelined multi-threading (PMT)): Parallelism is exploited when a loop iteration is distributed over synchronized loops.

| | |
|---|---|
| for (int i=1; i<n; ++i) { | for (int i=1; i<n; ++i) { |
| S1: a[i] = a[i-1] + b[i]; | S1: a[i] = a[i-1] + b[i]; |
| S2: c[i] += a[i]; | post(i); |
| } | } |
| | for (int i=1; i<n; i++) { |
| | wait(i); |
| | S2: c[i] += a[i]; |
| | } |

DISTRIBUTED Loop parallelization is the simplest one and does not have to be explained further. In DO-ALL parallelization, every iteration of the loop is executed in parallel and completely independently with no inter-thread/inter-task communication, as done in DISTRIBUTED Loop parallelization. The iterations can be assigned to threads/tasks in a round-robin fashion. The round-robin method is a scheduling method that processes queues, among other things. For example, the round-robin method can be used as a process scheduler, where it allocates limited execution resources to several competing processes or, in parallelization, processing units as processors. The round-robin procedure grants all processes successively allocation to one or more executing units for a short period during a time slot. In the technical field, this process is also called arbitration. In parallelization, round-robin can e.g. be used for load balancing of the processing units. DO-ALL parallelization and DISTRIBUTED Loop parallelization are possible only when the loop does not contain loop-carried dependencies or can be changed so that no conflicts occur between simultaneous iterations that are executing. Loops which can be parallelized by DO-ALL parallelization are likely to experience speedups since there is no overhead of inter-thread communication. However, the lack of communication also limits the applicability of this technique as many loops will not be amenable to this form of parallelization.

In DO-ACROSS parallelization, like independent multi-threading, iterations are assigned to threads/tasks in a round-robin manner. Optimization techniques described to increase parallelism in independent multi-threading loops are also available in cyclic multi-threading. In this technique, dependencies are identified by the compiler and the beginning of each loop iteration is delayed till all dependencies from previous iterations are satisfied. Like this, the parallel portion of one iteration is overlapped with the sequential portion of the subsequent iteration. As a result, it ends up in parallel execution. Once all cores have started their first iteration, this can approach linear speedup if the parallel part of the loop is very large to allow full utilization of the cores.

DO-PIPE parallelization is the way for parallelization of loops with cross-iteration dependencies. Here, the loop body is divided into a number of pipeline stages with each pipeline stage being assigned to a different core. Each iteration of the loop is then distributed across the cores with each stage of the loop being executed by the core which was assigned that pipeline stage. Each individual core only executes the code associated with the stage which was allocated to it. However, there is no consistent way in the prior art as now provided by the inventive system, to handle and automate loop-level parallelization, in particular not on auto-parallelization level.

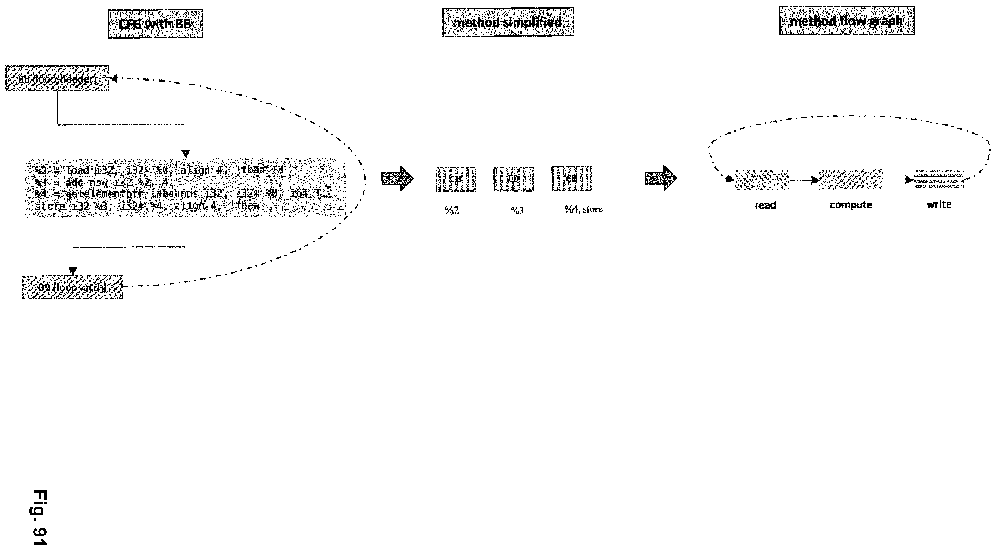

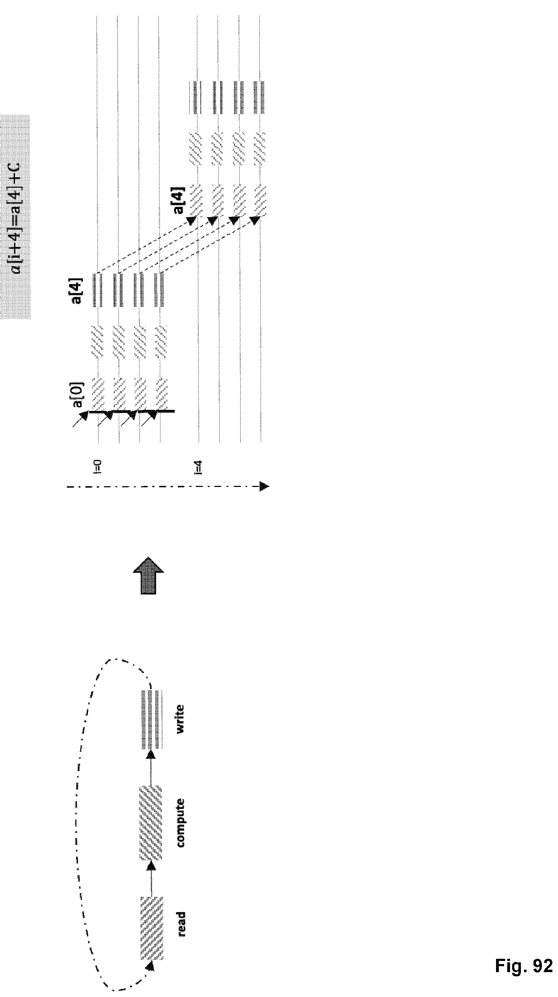

In the compiler technology, loops are represented as different nodes in the control flow graph (CFG), e.g. for Low Level Virtual Machine (LLVM). It is to be noted, that a CFG, as used herein, is not only a graphical representation, but accurately represent the flow inside of a program unit, which is the reason that it is used in complier technology and systems. Loop-definitions and their influence on an induction variable during runtime are often depending on runtime-parameters. As the location of the change is known in the code, the "***reading***" and "***writing***" concept of the inventive system and method can be applied to array expressions in the loop-bodies. Therefore, the influence on array expressions with dependencies to loop-variables can be determine during compiling as described in above for the Basic Blocks in body/bodies of loop-sections by distinguish in different computation blocks (CBs): (1) Reading data from random-access data structure (e.g. an array); (2) computing statement; (3) Writing data back to the data structure. This is illustrated in figure 91, where a simple loop section in Control Flow with a loop body with LLVM IR code is shown and how this leads to ***"read",* "*compute*"** and "***write***" computation blocks (CBs) with the inventive method. With a simple example of the form a[i + Δ*iw*] = a[i + Δ*ir*] + C with Δ*iw* = 4 and Δ*ir* = 0 the CBs in the loop, e.g. from i=0-7, this can be represented as illustrated in figure 92.

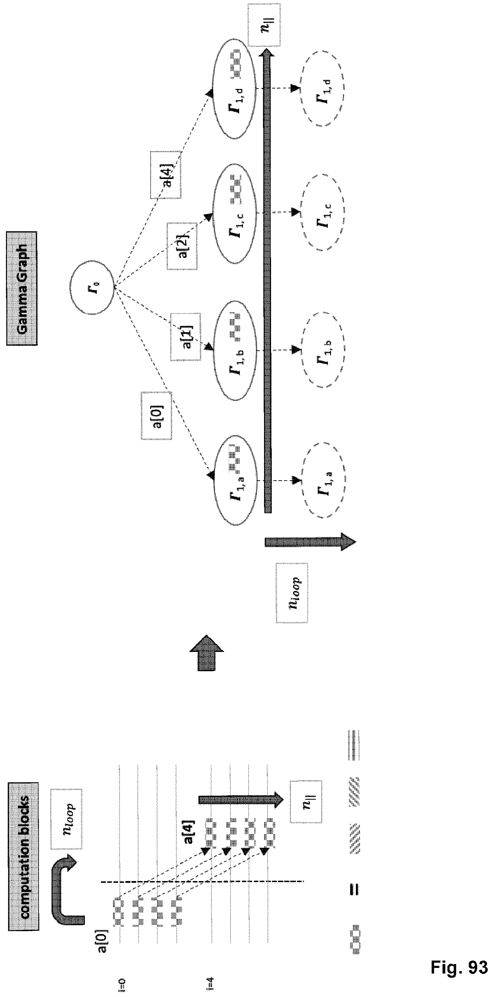

As discussed above, the loop section can be represented by a Gamma-graph with parallel task-nodes, each with one or more combined computation blocks (*n*_{| |}) and a correlated number of iterations (*n*ₗₒₒₚ). Figure 93 illustrated such loop-sections with parallel CBs and explicit loop iterations.

In this form the method, transfers bodies of (nested-) loop sections into DISTRIBUTED or DO-ACROSS/DO-PIPE loop-parallelism setups. As discussed above, two different cases can occur when building gamma-nodes from (nested-) loop sections:
- ***case 1*** - generic CB with 1-read-write, which leads to a DISTRIBUTED loop-parallelism
- ***case 2*** - generic CB with K-read-write, which leads to a DO-ACROSS/DO-PIPE loop-parallelism

### Hardware parallel processing architectures with limited resources

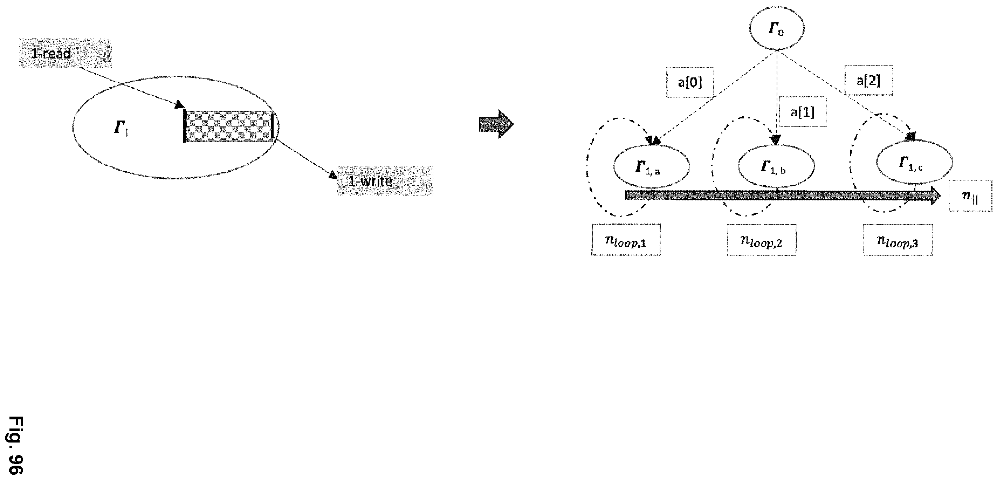

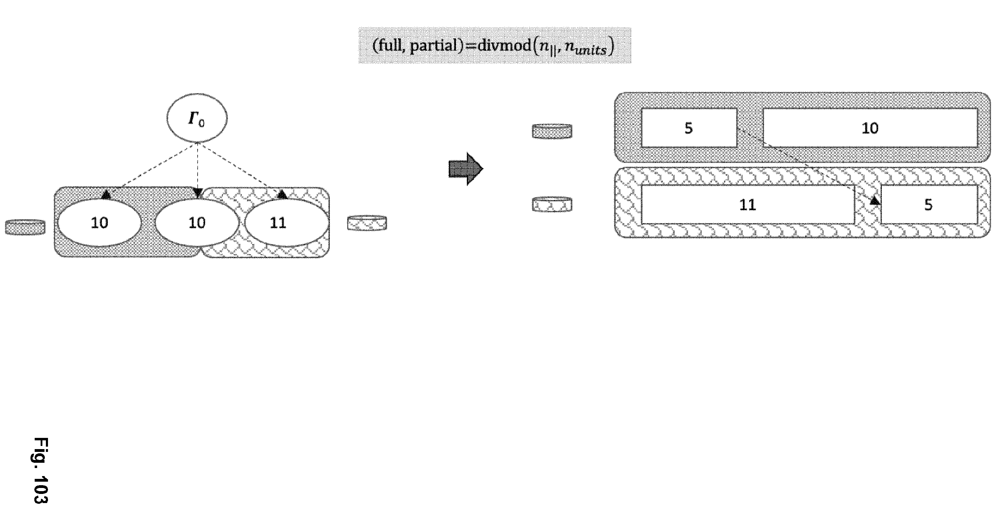

For the case of hardware parallel processing architectures with limited resources, there can be the case that, due to the limited resources, i.e. the number of available computation units *n*ᵤₙᵢₜₛ < *n* _{| |}, the optimization step of the inventive method to schedule the gamma-nodes to the different *n*ᵤₙᵢₜₛ differs between the two cases:
- ***case 1** -* ***1-read-write-case*:** indicated in figure 80 gamma-nodes connected with 1 edge (or CBs on one row with no entries in the transfer matrix and with the same branch node) can be combined, meaning the CBs building a chain again of a clear "read" and "write". Following the example in figure 96, the loop is represented as *n* _{| |} gamma-nodes in the level, each with a length *n*ₗₒₒₚ. The optimization in case of limited resources is to distribute these *n*_{| |} gamma-nodes evenly. As a gamma-node consists of CBs with sequential instructions, it is possible to split a gamma-node between one of the sequential instructions, to split the gamma-node to two different units, see figure 103. On each unit *n*_{evenCBs} are scheduled and the remaining gamma-nodes *n* _{partialCBs} (*n* _{evenCBs}, *n* _{partialCBs}) = divmod(*n*_{∥}, *n*ᵤₙᵢₜₛ) evenly to the units by adding transfers. This is beneficial, as long as the added latency times by the additional transfers is sufficient smaller than the corresponding distributed computations.
- ***case* 2 *- k-read-write-case*:** The optimization is to combine computation blocks (resulting in sum up the computation and vanish of transfers) to evenly distribute the CBs to the available *n*ᵤₙᵢₜₛ units. In this case the combination of the CBs should minimize the resulting transfers.

It can be shown, that both optimization steps are under the given assumptions solvable by an analytic engine (i.e. a system being based on at least an arithmetic logic unit, a control flow in the form of conditional branching and loops, and integrated memory. Method solving a certain problem and being processable by a finite analytic engine within a finite time are also called Turing-complete. With other words, the present inventive auto-parallelization system and method provides a Turing-complete system since every auto-parallelization of any possible source code is computable with the inventive method on a computational system with respect to the class of auto-parallelization problems. This is not given for all known prior art auto-parallelization systems), which proves the novelty of the inventive system and method to parallelize loop-section during runtime, since this imposes the highest technical hurdle in prior art auto-parallelization systems. In fact, it is important to note, that the present inventive hardware-architecture specific optimized parallelization of a source code achieved by the inventive system and method does not only work for loop-level parallelization, but is generally applicable to the parallelization of source code. Under the assumption that *t_{computation}* of a computation block (CB) is small in respect to *t*_{*data*-*transfer*}, the computation blocks within a column of the computational matrix can be evenly distributed to form even long tasks distributed to the parallel processing units/processors/cores. Still under the assumption that *t_{computation}* < *t_{data-transfer}*, the number of CBs do not have to be even distributable to the parallel processing units/processors/cores available in a specific hardware, since the number or CBs in a task may vary at most by the number of 1, if this embodiment variant is used. This holds when all parallel processing units/processors/cores have similar performance characteristics and the transfer latencies are of the same magnitude.

As an embodiment variant, a "symmetrical hardware platform" serves as basis, where the source code is to be auto-parallelized by the auto-parallelization system hardware-specific and hardware-optimized. A symmetric hardware platform has computing units (processors/cores), of which all units have approximately the same computational power and the same transfer properties between each other. This is often given, at least approximately, for the cores of multi-core CPUs. In this setting the inventive method allows to optimize the scheduling of the gamma-nodes in a Turning-complete manner, in the case the overall computing time on one unit is not faster, than the overhead to run the problem on more than one unit. This is possible as all parallel CBs have the same computation demand and therefor have the same computational effort and all computing units can solve these computations at the same time.

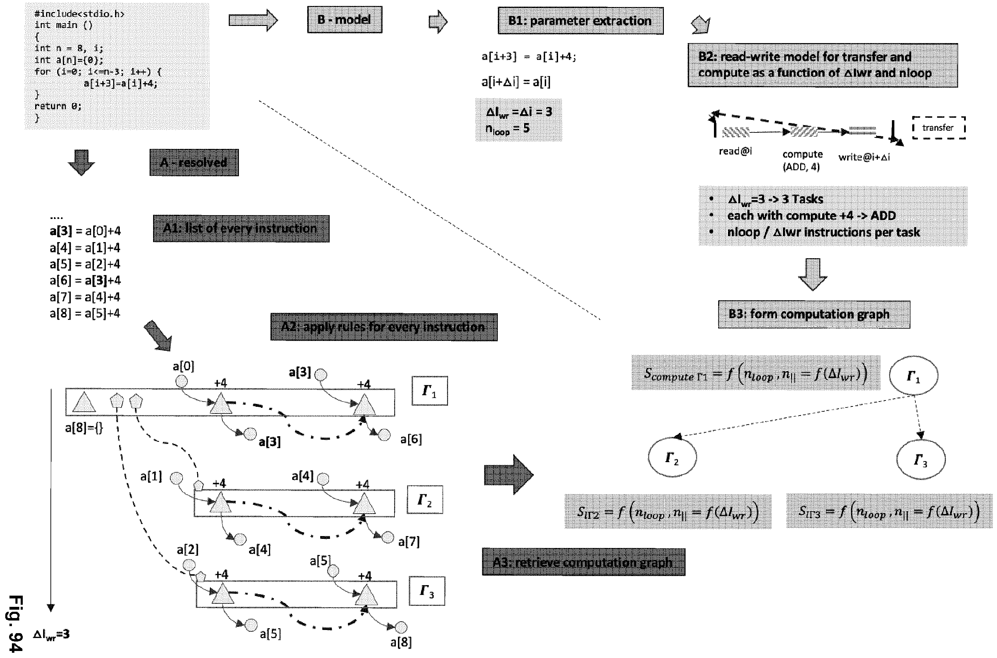

The inventive auto-parallelization system and method further allows to introduce a new structure how to handle (nested) loop-sections in a code in BB and to build the tasks depending on the number of processing units *n*ᵤₙᵢₜₛ of a specific hardware architecture. As analyzing all data dependencies in loops is not practical (i.e. using a brute-force method by trying all possible solutions is typically not applicable to NP-complete problems like the loop-parallelization), the inventive method is used to break or structure loop-section according to figure 94. Thus, the inventive system and method allows to form gamma-graphs solely depending on the loop-sections in a CFG with BB without unrolling and analyzing all correlated data-relations (brute-force). The inventive system and method build a generic loop-structure formed from the CBs for a loop-section.

When distributing a gamma-node of a loop-section to computing units, the following phases need to be differentiated:
(i) ***initial phase*:** get data from the location (computing unit) where last writing occurred before the loop-start
(ii) ***computation phase*:** compute parallel *n*_{| |} CBs on a given computing unit *n*ₗₒₒₚ times
(iii) ***inner-loop-mapping* phase:** transfer data for next loop iteration on all involved computing units
(iv) ***result phase*:** when *n*ₗₒₒₚ-iterations on all computing units are finished, data could have to be transferred back to a host

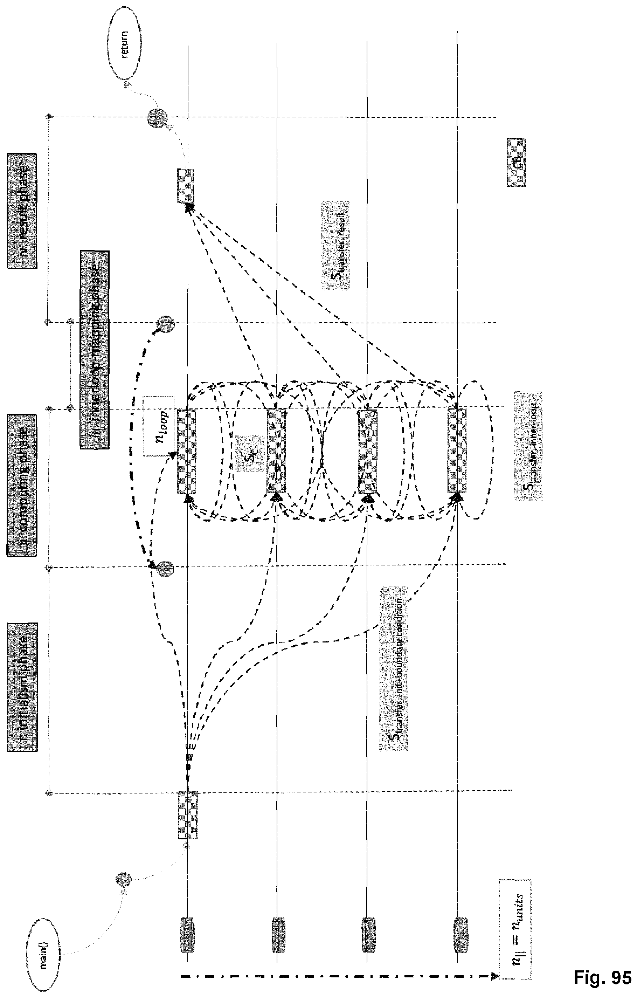

Depending on a target platform, the different sections can be shaped accordingly. E.g., for a cluster configuration, where local stored data is stored on disc and synced by the filesystem, the result-part is not necessary to explicitly applied. Another example is in a multicore environment, where data is shared in memory. There, the transfers are not explicit, but inner-loop-mapping can be used as barrier in accordance to avoid race-conditions (see above). Figure 95 illustrates the 4 phases for an example, where *n*ᵤₙᵢₜₛ = 4.

As *n* _{| |} is a function of the inherent read and write constraints in a statement of the form *a*[*i +* Δ*iw*] *= a*[*i + Δir*], it is possible for the inventive method to derive *n* _{| |} by analyzing the array expression in the loop-body and find a minimal read-write distance Δ*I*_{rw}. This must be possible, as array indices must be in the range of the array definition and must be of positive natural numbers otherwise access on the array is not possible. The change of the indices is analytically derivable during static-compiling as the step, when a loop-variable changes (is written) and must be retrievable in any code. This position in code defines when this information is available during runtime and therefore when depending parallel opportunities can be exploited. Knowing *n* _{| |} the iterable-loop variable-limit *n*ₗₒₒₚ can be derived from the loop-definition, respectively during compile-time the numeric relation between run-time parameters and *n* _{| |} and *n*ₗₒₒₚ can be extracted. The system can analyze the reading and writing of an array-expression during static compiling and generate a gamma-graph as a function of *n* _{| |} (which can be a function of loop-parameter) and *n*ₗₒₒₚ resulting in distributed loops with *n*ₗₒₒₚ iterations, see figure 93. This can be done without resolving every data-dependency. *n* _{| |} and *n*ₗₒₒₚ are in most cases depending on loop-parameters and therefore not known until runtime. If all parameters are known, the scheduling of the gamma-nodes can be optimized analytically during compile-time. In case the parameters are runtime-depending, on the defined symmetrical platforms the inventive system and method can be used to solve scheduling analytically during runtime. To optimize the gamma-nodes to computing units, there are two cases.

### Case 1: Generic CB with 1-read-write

In the case there is only one read-write dependency in the array expression(s), the corresponding gamma-node has the form in Figure 96 with the example of *a*[*i +* 3] = *f*(*a*[*i*]). There is no inner-loop mapping phase, and the inventive system 1 results in DISTRIBUTED-parallelism. The computational load nₗₒₒₚ, _{Γi} for each gamma-node is depending on the loop-parameters and therefore in most cases runtime-dependent. But *S*_{*compute*Γ*ᵢ*} and *S*_{transferΓ*ᵢ*→Γ*ⱼ*} are computable with simple arithmetic processes: the *n*_{loop,dist}, *n*_{loop,reminder} = *divmod*(*n*ₜₒₜ, *n* _{| |}) where each gamma-node receives CBs - grouped together in one gamma-node - as CB connected with 1 edge (= transfer) and they build an arbitrary sequence of sequential instructions *n*_{loop,i}= *n*_{loop,dist} + *n*_{loop,reminder,j}, j ∈ [*n*_{loop,reminder}] otherwise j=0.

### Case 2: Generic CB with K-read-write

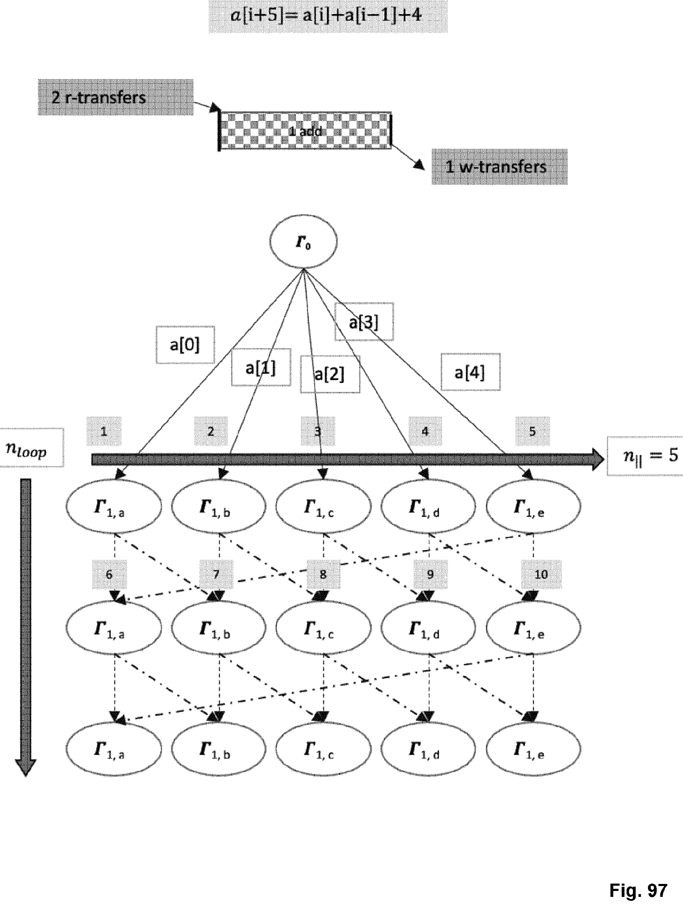

In the case there are K reads to the write dependency in the model CB, the corresponding gamma-node has the generic form illustrated according to the example in figure 97 with the example of *a[i+5]* = *f(a[i], a[i-1])*. There is an inner-loop mapping phase and the inventive system results in DO-ACROSS/DO-PIPE loop-parallelism. Thus, the inventive system 1 and method derives:
- Maximal parallel CBs per iterable loop step: *n* _{| |} = *f*(Δ*I*_{rw}) = *min*(Δ*iw -* Δ*ir*) = Δ*I*_{rw} = 5
- Transfers between each CB to the next iteration in case of *n* _{| |} = *n*ᵤₙᵢₜₛ : *n*_{transfers} = 1
- Initial granularity: ${G}_{0} = \frac{Δ {t}_{comp}}{Δ {t}_{comm}} ∼ \frac{{S}_{compute {Γ}_{i}}}{{S}_{transfer {Γ}_{i} \to {Γ}_{j}}}$

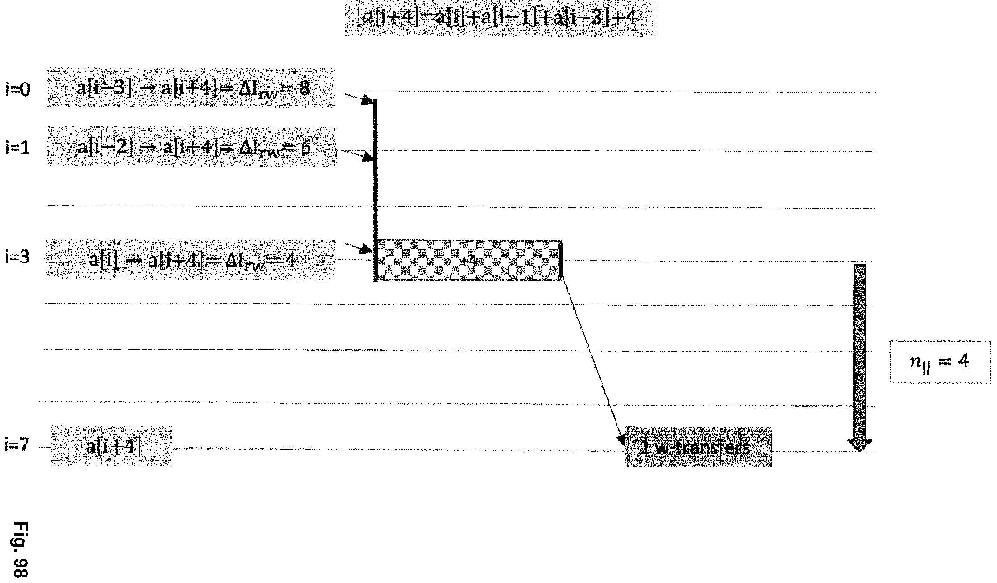

With this, *S*_{*compute*Γ*ᵢ*} and *S*_{*transfer*Γ*ᵢ*→Γ*ⱼ*} per gamma-graph can be deducted as a function from loop-parameters by analyzing the code. Each read has in the next iteration a transfer from other CBs, except one write->read dependency, which can vanish by *n* _{| |} = Δ*iw* - Δ*ir* as it is computed on the same computing unit. In case of several reads, *n*_{∥} is the minimal distance of all read-write-differences, as illustrated in figure 98.

### Distribute load in computing section on symmetrical parallel processing machines

The runtime to execute one iteration of the iterable-loop with *n*ₗₒₒₚₛ is then minimal, when all uniform computing units have an equal amount of CBs. This means all parallel computation blocks (*n* _{| |}) can then be distributed according to a relation, where G is a graph which consists of a set of independent nodes with weights {*w₁*, ...,*wₙ*}, and k is the number of available processors. Then ${CT}_{PS} \left(G, k\right) = max \left\{{w}_{1},…,{w}_{n},{\sum }_{i = 1}^{n} {w}_{i} / k\right\}$

For the above scheduling of real time tasks on multiprocessor systems, it is clear that the above given computation time cannot be improved upon by any system since the schedule must be at least as long as the largest task and cannot be more efficient than to keep all the processors continuously busy. The number of parallel CBs *n* _{| |} have an initial-granularity ${G}_{0} = \frac{Δ {t}_{comp}}{Δ {t}_{comm}}$ with Δ*t*_{comp} and needed transfers with Δ*t*_{comm} in the inner-loop mapping. Distributing the *n* _{| |} to available number of same units *n*ᵤₙᵢₜₛ is a simple analytical correlation. By combining the CBs, the inventive system is able to generate a task-graph with a corresponding *G*ₙᵤₙᵢₜₛ, where three cases can be differentiated:
- *n* _{| |} > *n*ᵤₙᵢₜₛ: Optimize and combine parallel CBs to get *G*('()"*
- *n* _{| |} = *n*ᵤₙᵢₜₛ: there are exact resources available and gamma-node with GC can be used
- *n* _{| |} < *n*ᵤₙᵢₜₛ: there are more resources available than can be used → use *n*ᵤₙᵢₜₛ = *n* _{| |} and run with *G*₀.

The optimization steps, performed by the inventive system 1, are then to distribute the parallel CBs following the relation (see above) to generate an optimal task-granularity *G*ₙᵤₙᵢₜₛ:
(a) Distribute *n* _{| |} CBs to *n*ᵤₙᵢₜₛ to get approximately an equally distributed Δ*t*_{comp} on each computing unit
(b) minimizing transfers between the gamma-node with granularity *G*ₙᵤₙᵢₜₛ to minimize Δ*t*_{comp}

It is to be noted that step (a) is a step, which can be performed arithmetically by the inventive system 1, in contrast to step (b), where the system 1 must optimize the inner-loop-mapping. Below, it is shown that this mapping can also be performed analytically by the inventive system by combining only CBs which minimizing the transfers as they vanish when the CBs are combined on one computing unit.

### Inner-loop-mapping optimization for Gₙᵤₙᵢₜₛ

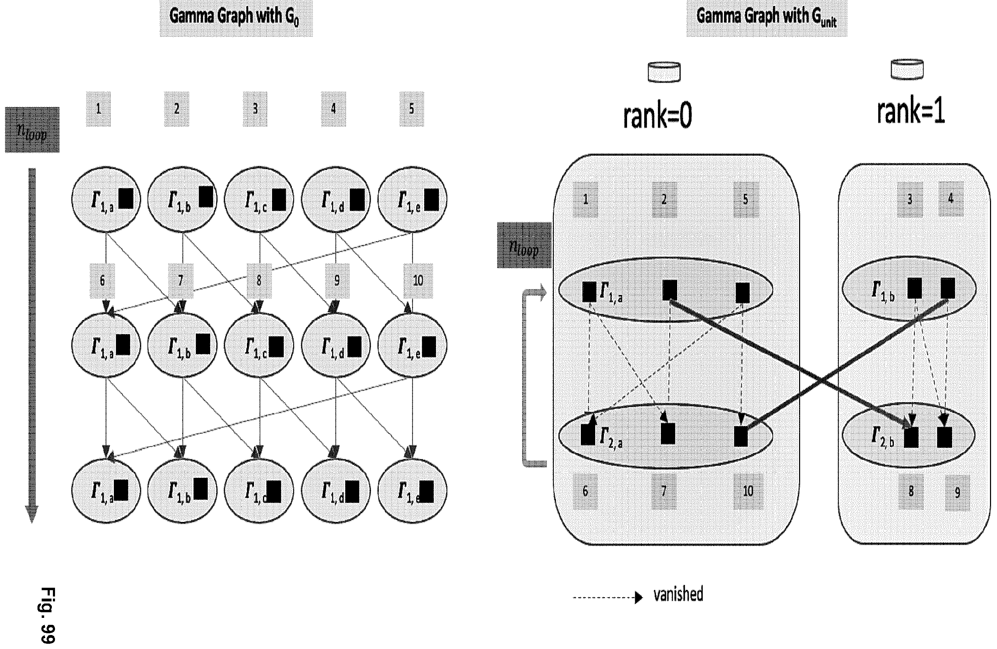

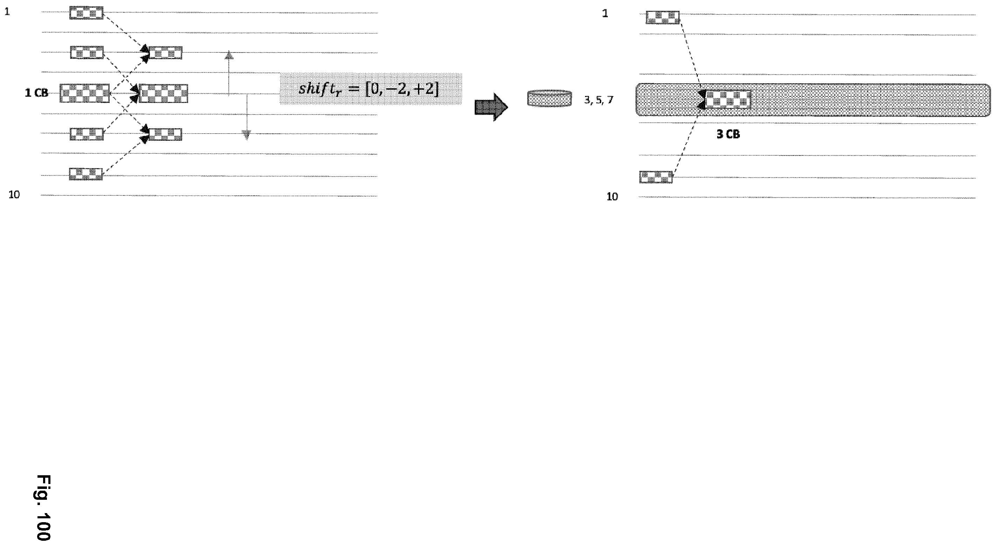

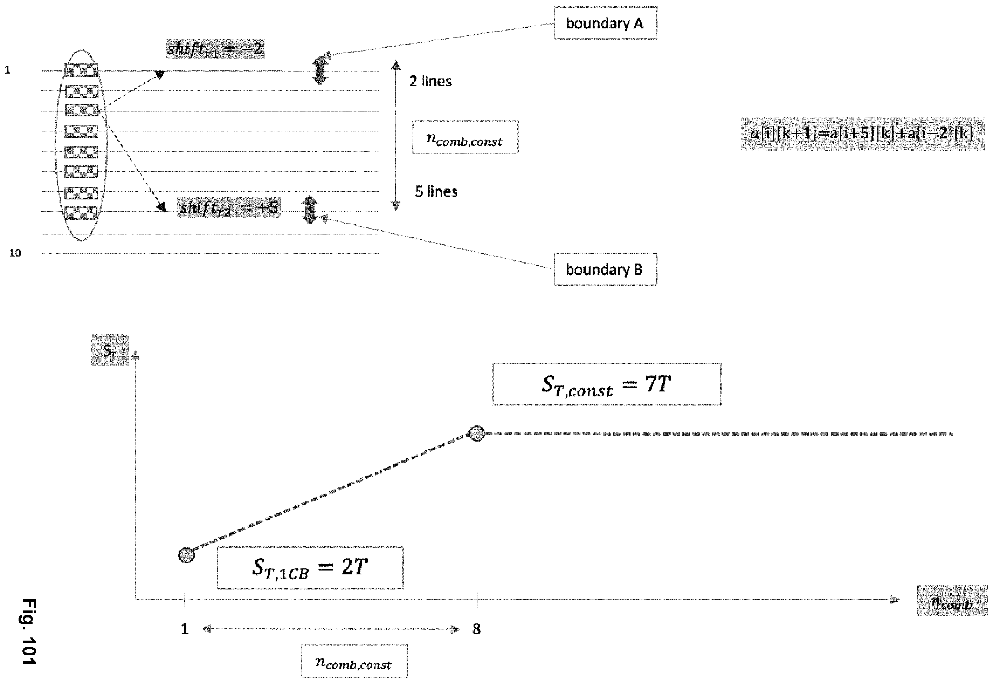

When combining parallel CBs to gamma-nodes (with a resulting granularity *G*ₙᵤₙᵢₜₛ, transfers on the same unit vanish and computations sum up, see figure 99. With a very simple illustration, it can be shown that only combinations with one of the read-write distances is minimizing the number of transfers between gamma-nodes in each iteration of the iterable-loop (*n*ₗₒₒₚ). This can be summarized as illustrated by figure 100 by:
- Reading accesses (right site of a statement or load in an IR) and the number of reads is extractable and the number of read-accesses is denoted as *n*_{shifts}.
- Number of transfers per CB: *n*_{transfers} = *n*_{shifts} - 1 as 1 write-read can be vanished by optimization to run on same unit in the next iteration.
- Size of transfer per CB with *S*_{T} is the size of one transfer: *S*_{transfer} = *n*_{transfers} • *S*_{T}
- For the example in figure 101 this results in *S*_{transfer} = 2 . *S*_{T}
- Combined CBs not along read-shifts: *S*_{transfer,combo}(*n*_{comb}) = *n*_{comb} · *n*_{transfers} · *S*_{T}
- Combined CBs along read-shifts: *S*_{transfer,combo}(*n*_{comb}) = *n*_{transfers} · *S*_{T} = const

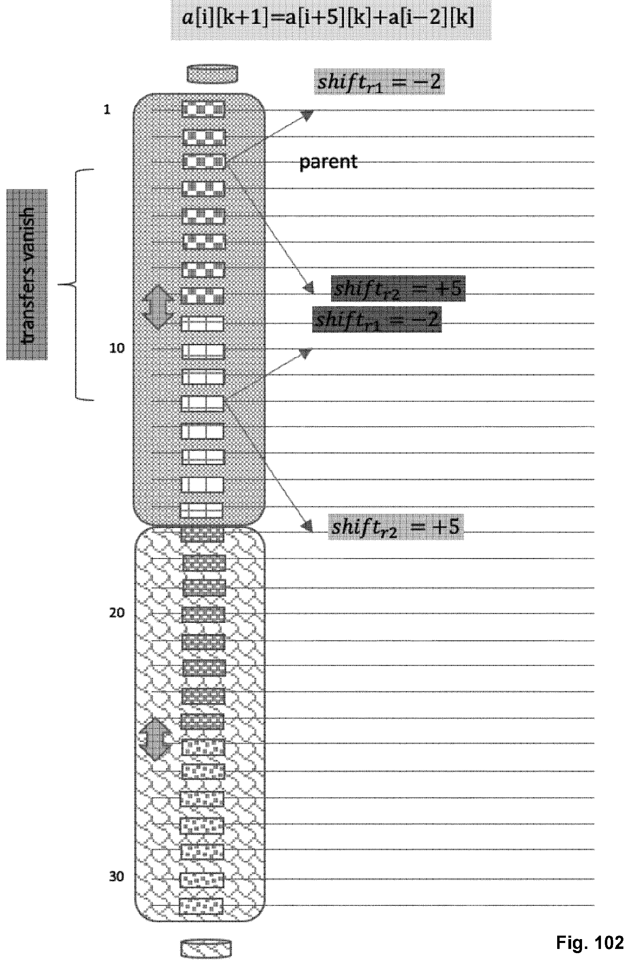

As illustrated in figure 101, depending on *n*_{transfers} any combination will lead to a fixed *S*_{transfer,combo}, as the reading is in the iteration from the same computation unit when combining more than *n*_{comb} CBs to one gamma-node. Illustrating with the statement *a*[*i*][*k*] = *a*[*i* -2][*k*] *+ a*[*i* + 5][*k*], some interesting properties can be observed (cf. figure 102):
- With T, one transfer of the size *S*_{T} can be labeled, which is depending on the array-type 'a'
- With *read - shift* = -2 origin from the expression part ([*i* - 2][*k*]) and *read -shift* = +5 as a result of the expression part (*a*[*i* + 5][*k*]), the iteration distance with a loop-iteration-step-size of 1 is *n*_{comb,const} = *max*(*read - shift*) *- abs*(*min*(*read -shift*)) *=* 7
- There evolve 2 boundaries: boundary A and boundary B, when combining these to one gamma-node based on *n*_{comb,const}.
- Combining more than *n*_{comb,const} does not increase/decrease the number of transfers.
   ∘ Transfer over boundary A: min(read-shift): 2 · *S*_{T}
   ∘ Transfer over boundary B: max(read-shift): 5 · *S*_{T}
   ∘ Total Transfer from Gamma-node to Gamma-node at boundary A and boundary B: *S*_{T,const} = (2 + 5) · *S*_{T} = 7 · *S*_{T}
- Gamma-node with one CB has two transfers: *S*_{T,1CB} = 2 · *S*_{T}

When combining *n*_{comb} CBs with *n*_{comb} > *n*_{comb,const} the number of transfers get constant, *S*_{T,const}, as illustrated by figure 103. This effect is visible also in the computations. Finding the combinations for the range 1 < *n*_{comb} > *n*_{comb,const} in Figure 101, the CBs must be combined according to the write-read distances, what leads to a linear increase of transfers.

### Scheduling for case 1 - generic CB with 1-read-write

If there are limited resources *n*ᵤₙᵢₜₛ in the 1-read-write cases, it can happen that there is a partial left when distributing gamma-nodes to *n*ᵤₙᵢₜₛ: (*n*_{full} *n*ₚₐᵣₜᵢₐₗ) = divmod(*n*_{| |}, *n*ᵤₙᵢₜₛ). In this case the *n*ₚₐᵣₜᵢₐₗ gamma-nodes have to be split evenly to the available *n*ᵤₙᵢₜₛ, which is illustrated by figure 103. This can be done by adding additional transfers as a function of (*n*_{full} *n*ₚₐᵣₜᵢₐₗ). Adding additional splits makes only sense as long as distribution of the partial CBs by adding additional transfer is no longer than without splitting. As the gamma-nodes (one or more CBs) contain arbitrary sequential instructions, the place where to split has no significant influence on Δ*t*_{comp} and can be defined by *partial*/*n*ᵤₙᵢₜₛ. As an example, in case of a[i + 3] = *a*[*i*] on *n*ᵤₙᵢₜₛ = 2 this leads to (1,1) = divmod(3,2) leads to adding one additional transfer by splitting one gamma-node.

### Scheduling for case 2 - generic CB with K-read-write

In case the resources are limited and (*n*_{full} *n*ₚₐᵣₜᵢₐₗ) = divmod(*n*_{| |}, *n*ᵤₙᵢₜₛ)*n*ₚₐᵣₜᵢₐₗ = 0, then the computational effort can be balanced out with minimizing the transfers. If there is a partial result *n*ₚₐᵣₜᵢₐₗ > 0 it is not feasible to schedule in the form all units are balanced out perfectly. This will lead to idle of the other units, but there is no possibility to balancing this inequality out, as all units have the same performances, transfers have all the same properties and the read-shifts does not make it possible to reduce any transfer.

### Gaps in nested loops

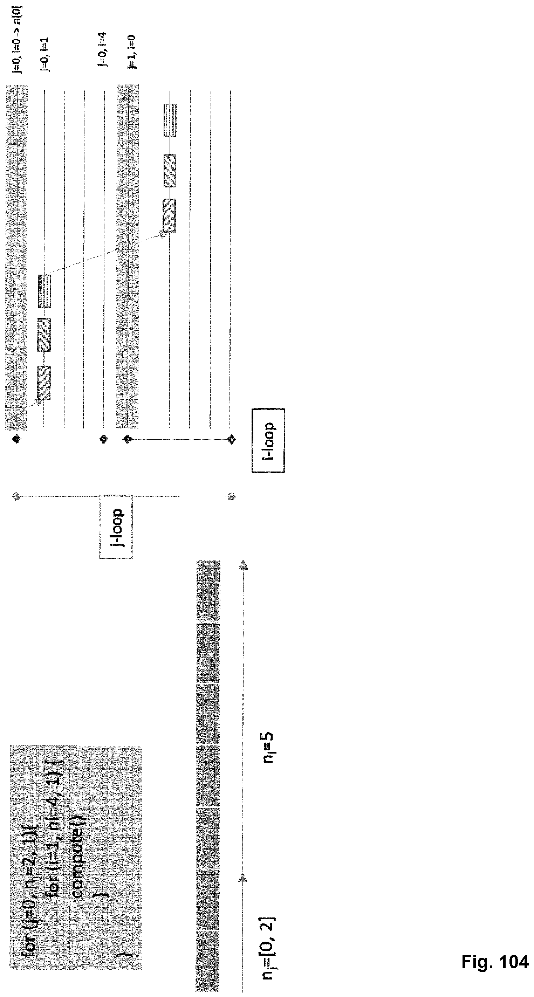

Gaps in iterations occur when start value and/or iteration step size is not equal 1 in (nested-) loops and a read (or write) is from/to a gap. That means in the data structure, some values are never written within the loop, or some data is being read from CBs before the loop in each iteration step (e.g., boundary condition in a 2d heat equation). Figure 104 structured data index and resulting gaps when not iterated over the whole array.

### Mapping and indexing for Gamma-nodes

There are different approaches to implement the mapping. One is to generate a global index for the unrolled loop [0, *n* _{| |}] that can be generated for all nested loops start-, end- and inter-step-size marked as gaps. Then the number of combined CBs per Gamma-node can be used to map the gamma-nodes to the global index and a local-data-index can be computed. By getting unique elements in each gamma-node the communication links for each phase comprise:
- initialism,
- boundary-condition (reading from gaps during compute phase)
- inner-loop-mapping
- result

They can easily be found by computable array-arithmetic steps. Other options are to use bit-arrays or computing the global indices at the boundary A and B, see figure 102 depending on the read-shifts for each gamma-node, as illustrated by figure 103. Another approach is to compute the reduced iteration steps nₗₒₒₚ for each computing unit as a function of the runtime parameter. This is practicable during runtime and therefor makes it feasible to use the method to optimize loop-section on symmetric parallel machines during runtime based on a model build during compile-time.

### Further embodiment variants and applications of the inventive system

As illustrated by figure 106 known technical problems in the field of parallel processing can be solved by means of the inventive system and method. In particular, figure 106 illustrates the different embodiments EV1 to EV5 of the inventive system 1. EV1 of figure 106 shows the most fundamental embodiment variant and the basis of all other embodiment variant of the inventive system 1 and method, where EV1 provides auto-parallelization of code by optimizing the overall latency time to a minimum. In case there are limits by the number of parallel processors (single-core 2103 and/or multi-core 2102) available, (ii) the latency time for memory access and data transfer to and from a processor 2102/2103 to the processing time needed to compute a computation block node 333 on a processor 2102/2013 is not small, the embodiment variant EV1 is based on some fundamental assumptions, which are, inter alia, To reduce the row dimensionality to the number of the limited resource nᵤₙᵢₜₛ the rows can be combined. This form of optimization is bounded with the assumptions (i) any transfer introducing a significant latency time compared when a transfer in the transfer matrix vanishes Δ*t_{transfer}* » Δ*t_{transfer}* ≈ 0. (ii) variations between transfers are small Δ*t_{transfer,i}* ≅ Δ*t_{transfer,j}*, meaning all transfers have approximate equal latency times. Assuming (i) and (ii), the maximal row-dimension in the compute and transfer matrix define the combinatorial complexity of the system (several CB per BB). This can lead to potential limits for the combinatorial complexity, especially for the loop-sections and / or if (iii) the units have similar computing performances and transfer latencies among themselves is not given. Combined with EV3 the possibility is introduced to optimize for a generic code to a (not-) symmetrical parallel machine. The following is a non-conclusive list of optimization options the tensor / gamma-graph. For each option it is annotated how to estimate compute and transfer times:
I. For EV3 / loop-sections on symmetrical platforms: the optimization step is to distribute parallel n _{| |} gamma-nodes to available units evenly. There is no need to know of specific compute / transfer times to distribute n _{| |} to parallel units nᵤₙᵢₜₛ. For distributing on a multicore with cache-latency awareness, the access latency to shared memory hierarchies (cache-levels and memory) as a function of data size for each nᵤₙᵢₜₛ must be known. This is possible, as all n _{| |} parallel CBs have the same properties in the computation and transfer matrix cells. This means each CB has the same read, write and compute properties. Therefore, (i) a distinct chain of sequential instructions is known for each CB (ii) corresponding data size needed to compute this set of instructions with a given processor is known. EV3 comprise the process of building tasks out of computation block node 333 belonging to the same column in the computational matrix, i.e. executable in parallel due to the available data. Building tasks allows for a processor-architecture specific and/or system-architecture specific optimized auto-parallelization where the number of processors 2102/2103, the performance of the different processors/cores 2102/2103 and/or processor units 21, the differences in size and response time of the different memory units 22, in particular the different processor registers 2211 and/or processor caches 2212 and/or RAM units 2213.
II. Following Wall, David W., "Limits of instruction-level parallelism." Proceedings of the fourth international conference on Architectural support for programming languages and operating systems, 1991 the ILP dimensionality in basic blocks is around 3-4 on average and this is a bounded combinatorial problem when assuming the fundamental assumptions in EV1. By applying EV3 and distributing to all available units nᵤₙᵢₜₛ, the restriction for loop-sections can be solved. When all units are used per loop-section, it makes it possible to optimize the other non-loop sections. This reduces the combinatorial complexity to schedule the remaining Basic Blocks, respectively the row dimensionality of the computation and transfer matrix without the loop-sections. To approximate the runtime of CBs, either a model based on relative computing times from tabled cycles and access latencies to memory hierarchies can be used or the different row combinations can be profiled.
III. by traversing the gamma-graph: starting from a parent gamma-node, continuously combining children-nodes till a target granularity is reached. Then compose from the combined nodes a task 36 resulting in a task graph forming equally length tasks. This results in a task graph with a fixed granularity and therefore optimizing the scheduling of targeted for a given hardware granularity *G* = Δ*t_{compute}*/Δ*t_{transfer}*. The granularity can be estimated by # instructions, cumulative cycles of the instructions and corresponding data loads of the combined CBs. In this case only the relative computational length between different CBs is important obtainable by tabled instruction values, see A. Fog, "Instruction tables", Technical University of Denmark, 2022. This reduces the effort to scheduling tasks as they can be distributed evenly as they have an optimized task-granularity for a given platform. This is a bounded problem, but the approach could miss some overall optimization opportunities.
IV. In context of EV2 it is possible to associate a fixed value transfer time (TT) by a given input to the compiler for all transfers (edges in the gamma-graph). In this form the gamma-graph can be formed by combining parallel gamma-nodes till their approximated computation time (e.g. derived by tabled values) is beneficial over the computation in parallel than in serial. The implementability of this approach in auto-parallelization was proven in a pre-study by the Institute Reconfigurable & Embedded Digital Systems (REDS Institute) in Lausanne, Switzerland. It could be shown that it is possible to build depending on a given latency time TT adapt a gamma-graph to generate a latency adapted task graph with corresponding task granularity. For this pre-study the assumptions were, that all parameters are known (without the use of E3).
V. Using the gamma-graph as an input to form a (Mixed) Integer Linear Programing Problem: Building a linear optimizable set of equation, where the gamma-graph EV2 represents a similar complexity as the PCGmTSP. To estimate for the different m gamma-node-groups either tabled or profiled approaches can be chosen. Combined with EV 3 loop-section can be associated with distinct number of used units (m), depending on the parallel groups per gamma-graph level.

Finally, the embodiment variant EV4 of figure 106 (see also figure 110) shows the inventive system used for optimization of integrated circuit (IC) or chip design solving electronics engineering technical problem if IC design by encompassing logic and circuit design required to design integrated circuits, or ICs. In particular, the IC design provided by the embodiment variant EV4 provides digital IC design which can be used to produce components such as microprocessors, in particular multi-core microprocessors, field-programmable gate arrays (FPGAs), memories (cache, RAM, ROM, and flash architectures) and digital application-specific integrated circuits (ASICs). ICs comprise miniaturized electronic components built into an electrical network on a monolithic semiconductor substrate by photolithography. The digital design achieved by the embodiment variant EV4 provides highly optimized IC architecture in regard to logical correctness, maximizing circuit density, and placing circuits so that clock and timing signals are routed most efficiently.

Below, some application of the inventive system 1 and method are discussed in more detail.

### (i) Auto-parallelization of source code for generating Fibonacci series

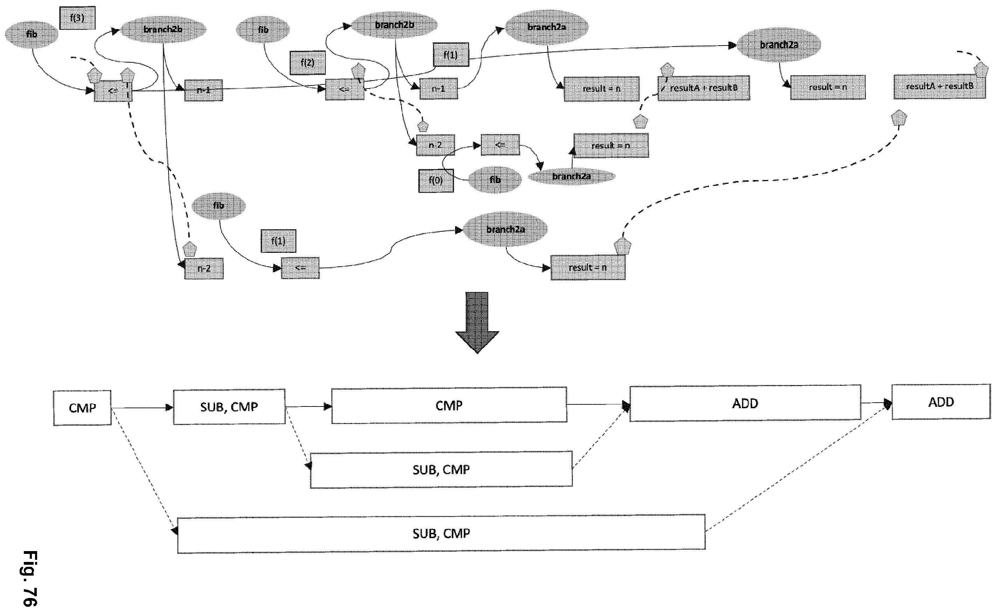

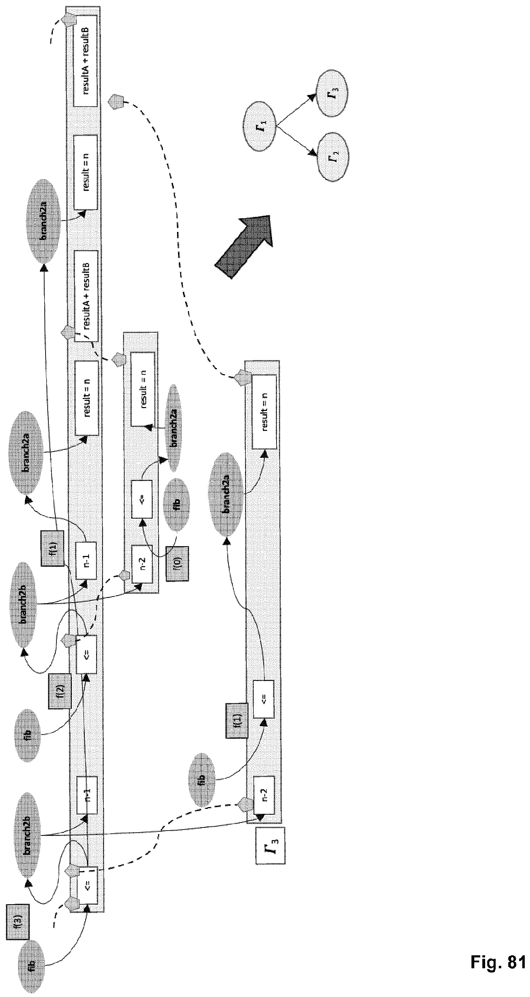

Figure 75 shows exemplary the construction of the CBs out of instructions (CMP, SUB, ADD) visible in figure 76 and as a gamma-graph in figure 81. This is the representation for a recursive call f(3) of the code in figure 75. A similar graph can be retrieved when applying the method on the loop-implementation of the Fibonacci series.

To generate and compute the Fibonacci series, different parallel-processing implementations with different performance properties are known. In the following, it is illustrated how the invention is applied to an implementation using a) recursive functions calls and b) loops. Both implementations show different performances. For understanding the processing problem, reference can, for example, be taken to https://www.geeksforgeeks.org/program-for-nth-fibonacci-number/. Below, there is an example of a processing (source) code generating Fibonacci series using recursion.

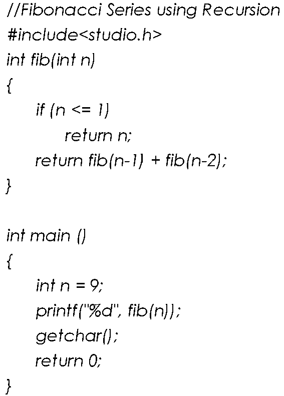

The parsing the function code of the fib(n) declaration results in a pseudo token language, with the function code of the fib(n), given by 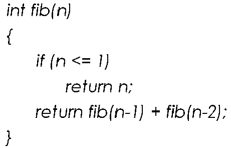 and the pseudo token language given by the following table 1:

**(table 1)**

| | |
|---|---|
| n, -, -, cfuncdef | cfuncdef (gid1, -, -) |
| n, 1, cmpV, <= | <= (gid1, 1, gid2) |
| cmpV, -, -, if | if (gid2, -, -) |
| n, -, -, return | return (gid1, -, -) |
| t1, n, 1, - | - (gid3, gid1, 1) |
| t1, 'fib', t2, callf | callf(gid3, tcbid, gid4) |
| t3, n, 2, - | - (gid5, gid1, 2) |
| t3, 'fib', t4, callf | callf(gid5, tcbid, gid6) |
| t2, t4, t5, + | - (gid4, gid6, gid7) |
| t5, -, -, return | return(gid7, -, -) |
| -, -, -, efuncdef | efuncdef(-, -, -) |

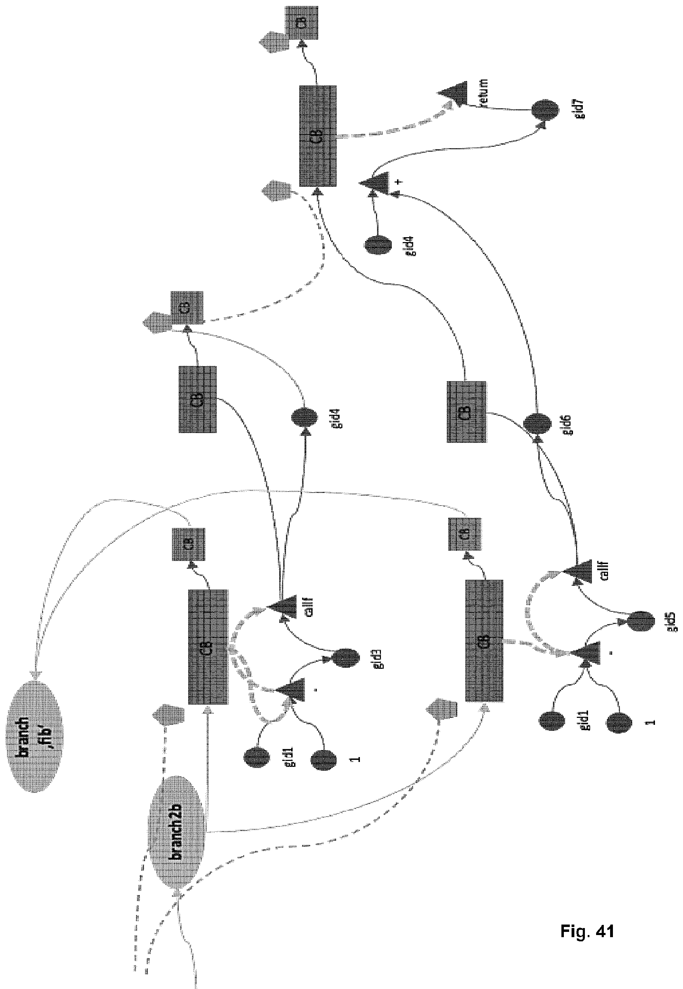

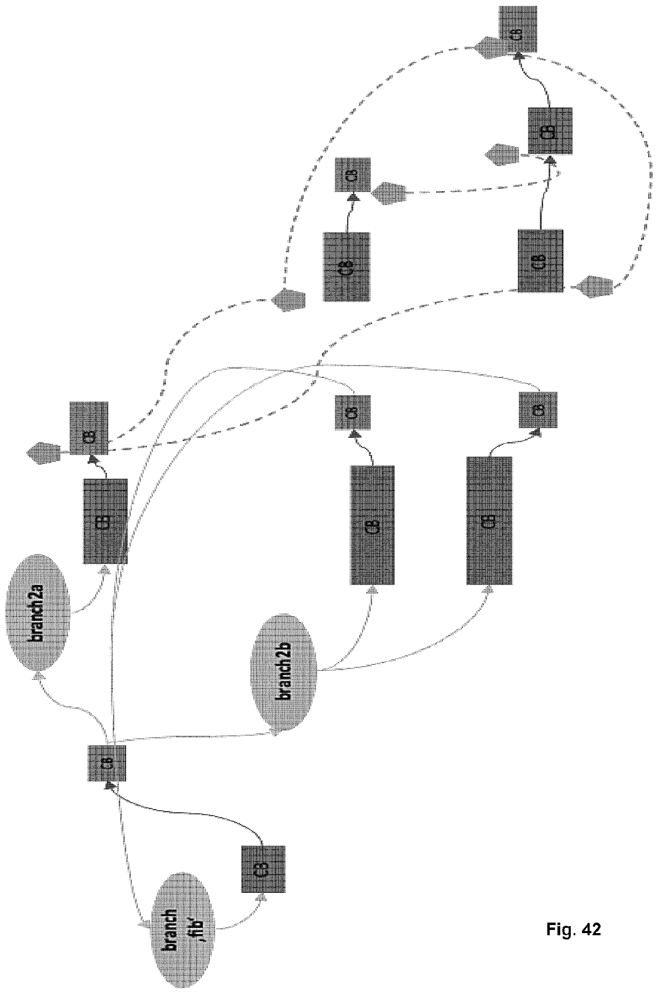

Figures 41 and 42 show schematically the computation block nodes (CB) with the operation and corresponding data nodes (similar to the token in table 1 above). The icons 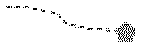 indicates a transfer to the location in the computation block node (start- or end-point of the computation block node). The recursive call of the functions results in additional transfers, as can be seen in figure 42.

The next step is to number the computation block nodes depending on their call-position in the code. This results in a pseudo graph like schematically represented in figure 43, which in return results in the computation and transfer matrix as shown in figures 44 and 45.

By combining start- and end-communication cells in the transfer matrix and eliminating empty cells in the computation matrix and bring them back to different code segments, results in Fig. 46. Based on this code segments a code can be generated directly (as a compiler) or transferred back to code and then using a SOTA compiler to generate machine code (as a transpiler).

To show how the inventive system and method brings advantages to the compiling of a recursive implementation according to the Fibonacci series, the following passages explain how the inventive method maps and/or optimize the code in a more concurrent solution than the input code. As indicated to optimize the code it is the combination between the rows, the graph is shown with the combination of the cbn in the branch node marked as branch2b (see figure 43) and combine them, see figure 48. Calling a function is in the method placing the computation block nodes to the correct location in the matrices, respectively to apply the corresponding transfers as indicated in figure 47. With this in mind, the recursive call of the function can be seen with the inventive method as a transfer and 'read' and 'write' of the function parameters and result variables in a return statement, figure 48.

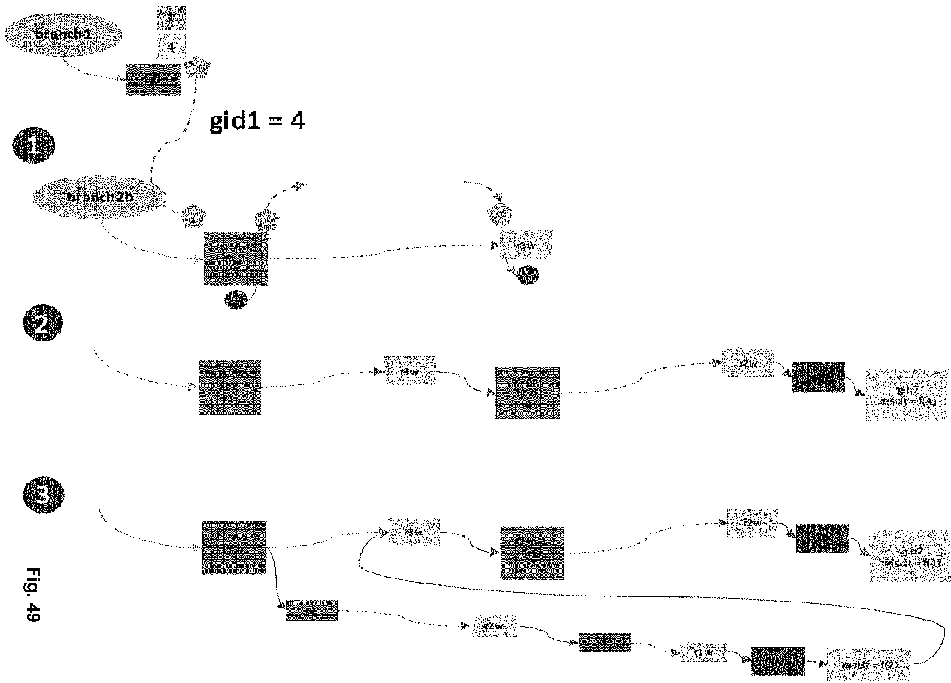

According to the example of fib(4), figure 49 shows step-by-step how additional computational block nodes and the reducing of the transfers (as all is on one computation-chain) results in a more optimized source code.

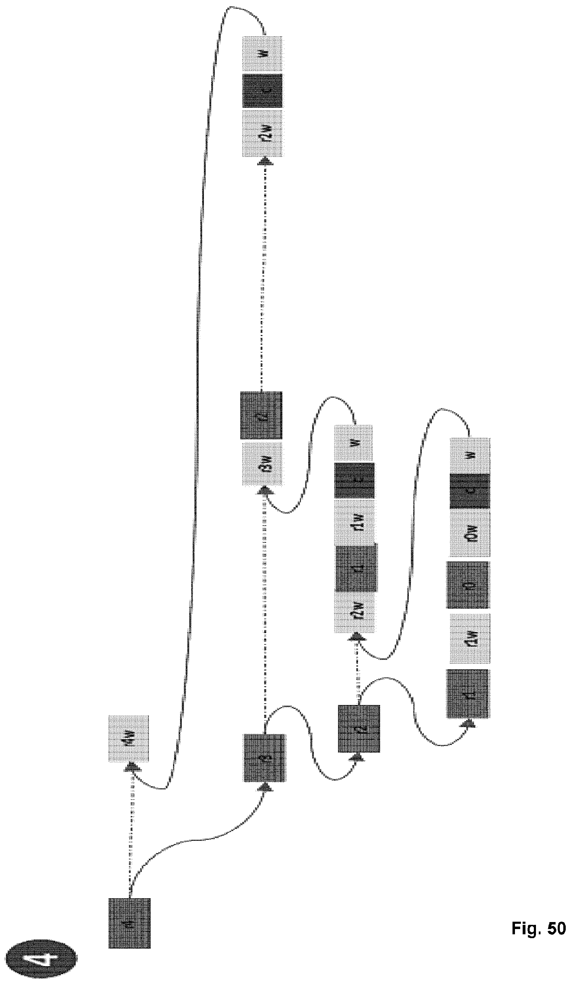

The depth of this chain depends directly on the number n in fib(n). As recursive calls can be very simply detected in the code, it is easy to not implement a recursive call in full dimension in a final application. To make it understandable, figure 50 shows this with some simplification. Step 4 shows the cbns for a call with 'n=4'.

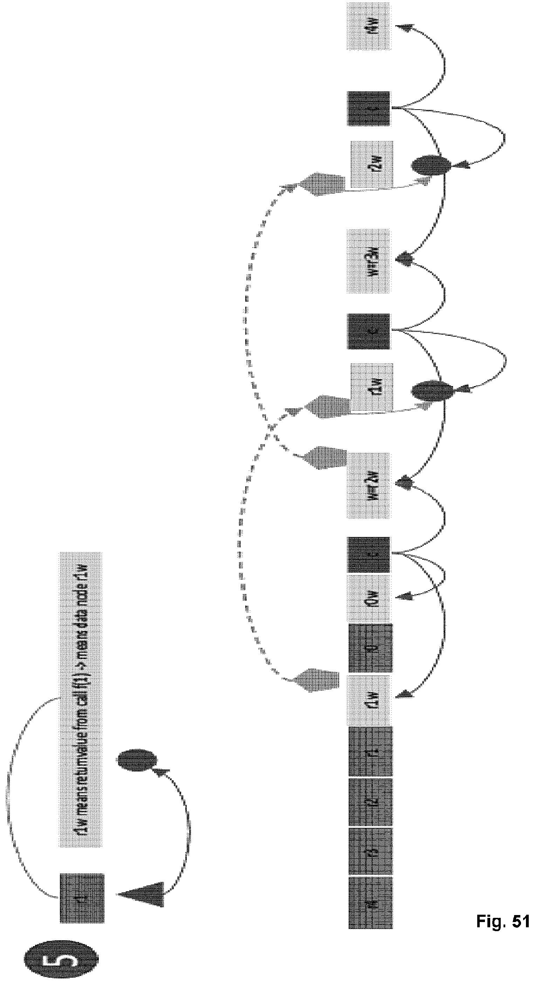

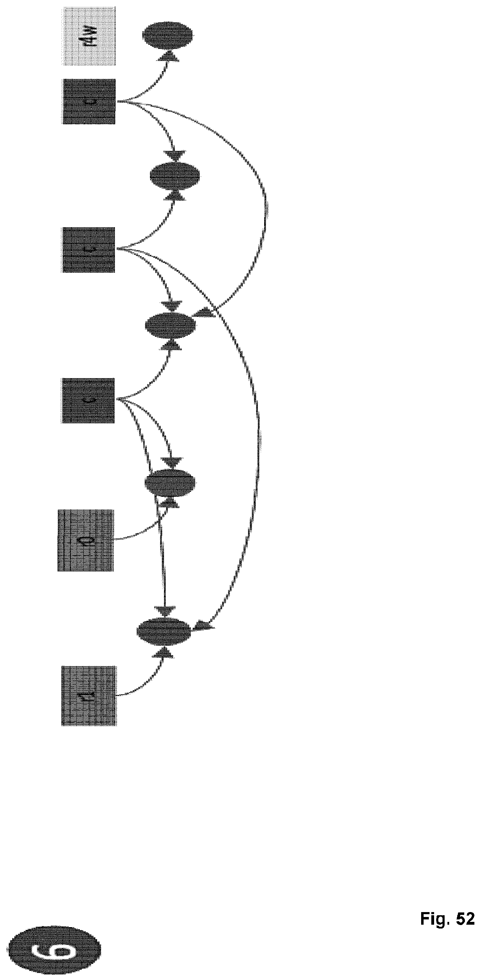

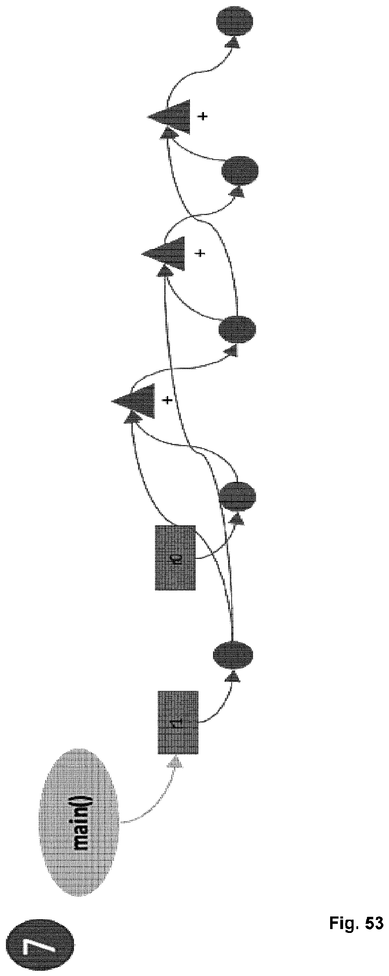

The next step in figure 51 shows the transfer, which will be occur (transport the information of the last "write" to a data node to the place where the "read" of a data node occurs and remember this information in the corresponding computation block nodes). As all computations are on one chain, the transfers will vanish, as can be seen in figure 52. When resolving every step, this leads to a program of the form in figure 53.

Bring this using the matrix representation back to code, it can be seen as a result the code below. This results in a more efficient code, than the original fib(n=4) implemented by table 1, above. Respectively compiling this code with a SOTA compiler will result in a better optimized code, than without applying the method.

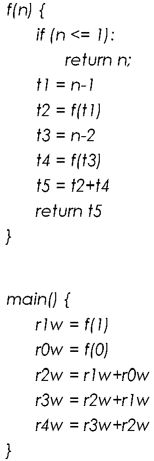

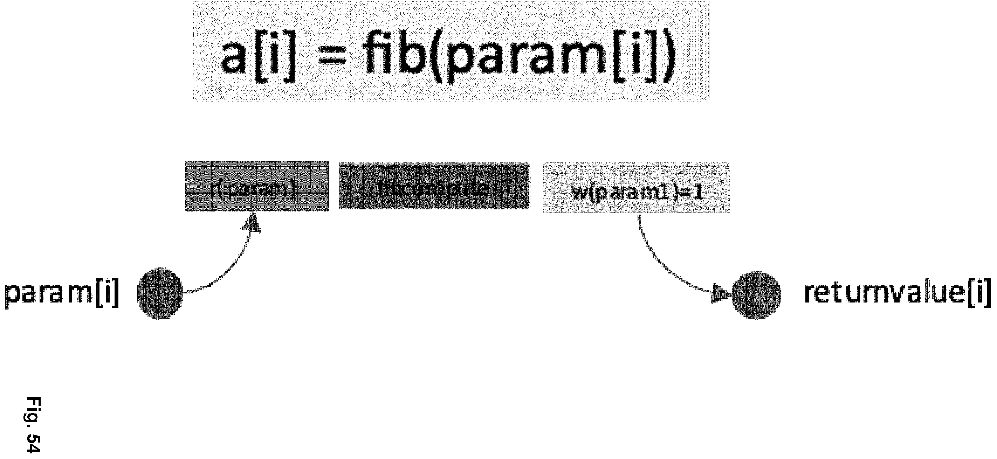

The recursive call can also be interpreted like an array operation applying the inventive method, as it is transferring an information (function parameter param[i]) to the corresponding cbns in the branch node of the function declaration and then transfer back the return value(s) to a[i], see figure 54. This would lead to a perspective seen also in partial differential equation. This form of the implementation of the Fibonacci series will be references more below. However, as a next step, the next paragraphs will show the handling of Partial Differential Equation, which mostly result in nested loops and heavy use of array operations.

### (ii) Partial Differential Equation (PDE)

With the rule to place an operation node in dependency of the "reading" and "writing" pattern and resolving not clear dependencies by a transfer, according to the patent application, it is possible to derive a compute- and communication-model $\frac{\partial u}{\partial t} - α \left(\frac{{\partial }^{2} u}{\partial x}+\frac{{\partial }^{2} u}{\partial y}\right) = 0$ for a freely given discretized implementation of a PDE. The PDE of a 2D heat equation will be used herein, with the 2D heat equation given by:
Using a finite difference scheme to discretization: ${u}_{i , j}^{k + 1} = γ \left({u}_{i + 1 , j}^{k}+{u}_{i - 1 , j}^{k}+{u}_{i , j + 1}^{k}+{u}_{i , j - 1}^{k}-4{u}_{i , j}^{k}\right) + {u}_{i , j}^{k}$

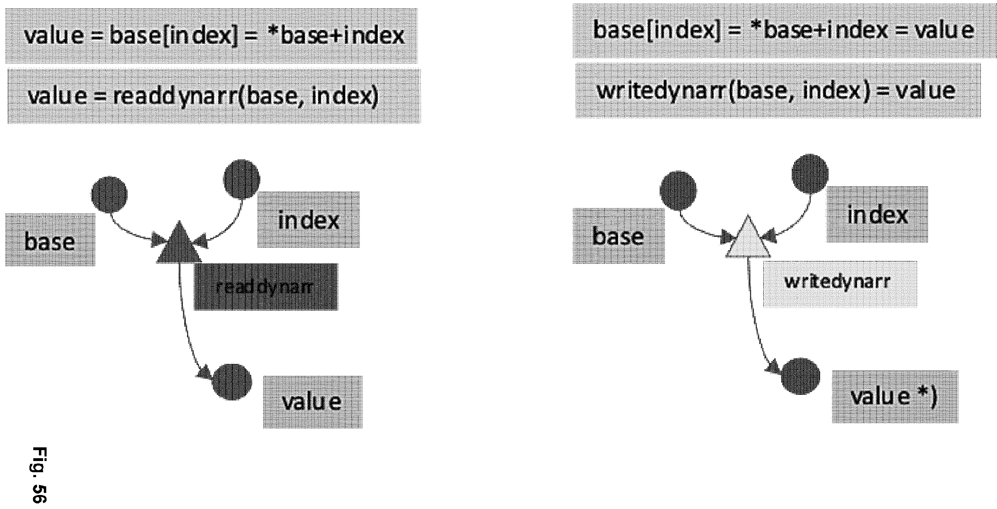

Figure 55 shows part of an implementation in python. Each entry in an array is a data node. Reading from an array index is in the method an operation node with data node of the index and the base address of the array. Array operations can be seen as operation nodes with corresponding data nodes, see figure 56.

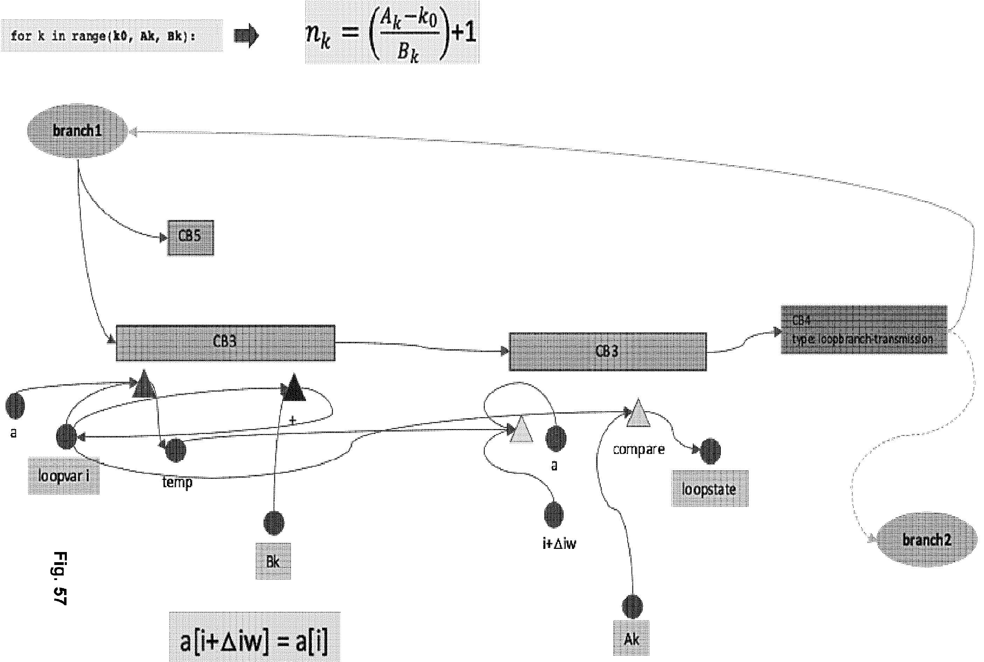

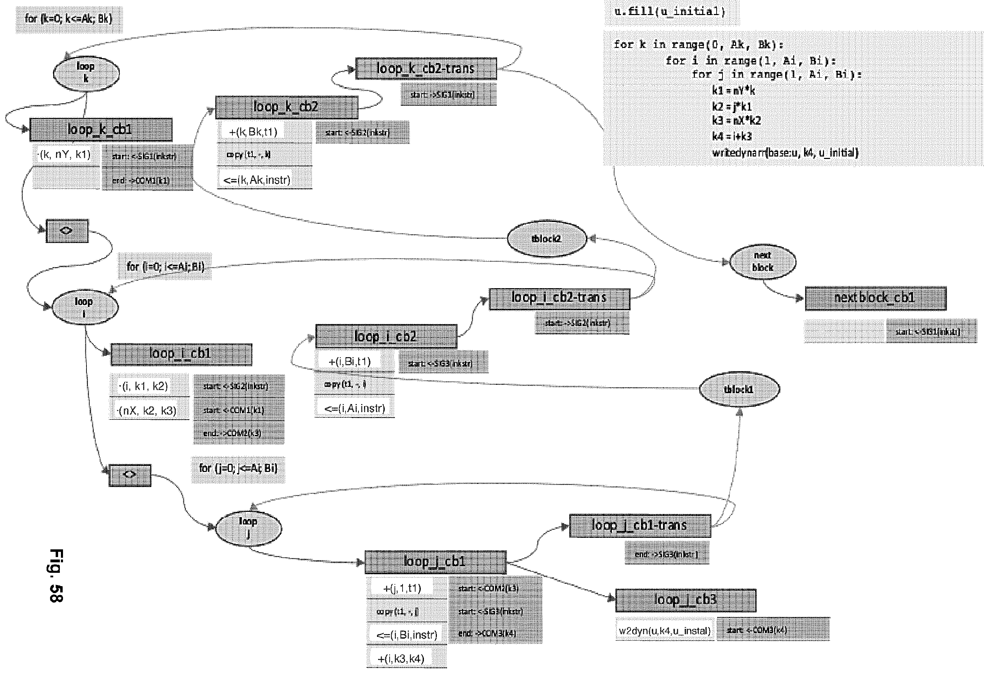

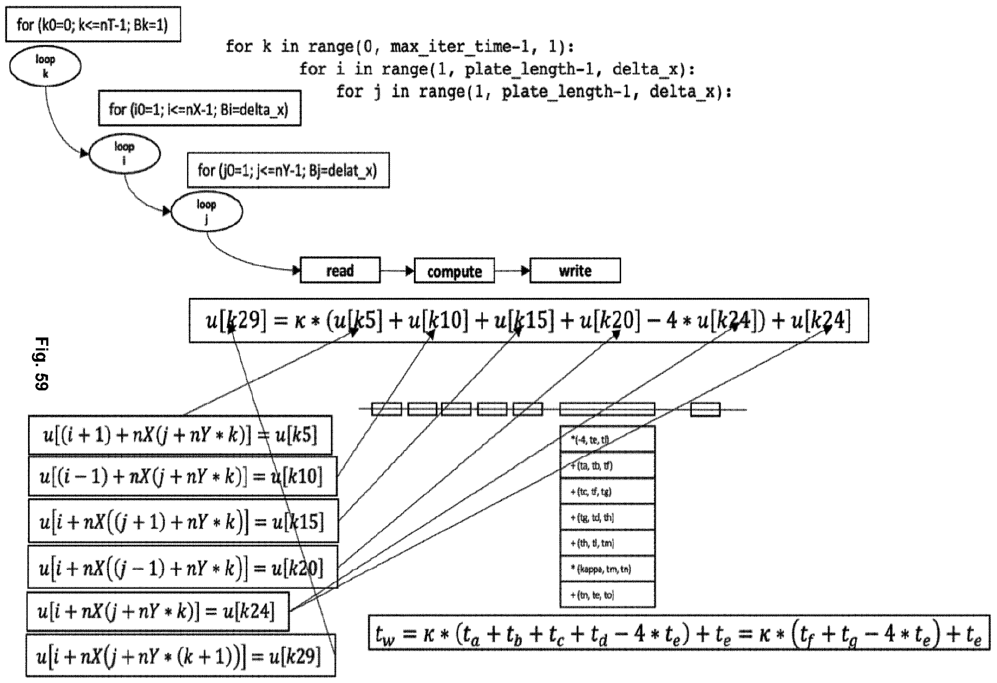

For the example of a loop array with an array operation a [i+Δiw] = α[i] figure 57 shows the corresponding computation block nodes. With this in mind, the initial block (figure 55) can be expressed in detail in the graph like in figure 58. All computations in the computation block (see figure 55) happen in the j-loop. By using a 1D array notation and applying the fundamental rules of the method, a schematic form for the computation block node in the loop is derived as indicated in figure 59.

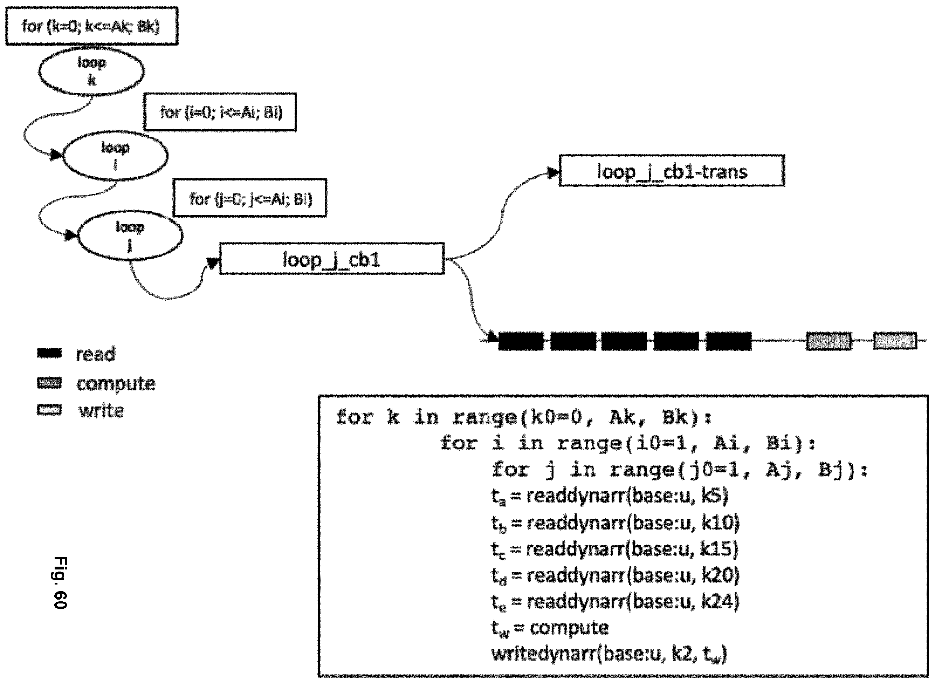

An array read (e.g. u[k][i+1][j]) would create a computation block node and the meta-data to transfer of the value to this index would be added to both cbns, the one which the "reading" node and the one where the last time this data node was written (e.g. at α[k+1][i][j]). This leads to the fact, that a statement such as the array operations in the j-loop (figure 55), result in 5 computation block nodes, representing "reading" operations of the array, then a computation block node which computes the arithmetic solution and then a computation block nodes with the write to the array at the position [k+1][i][j]. This form of representation is a schematic perspective to show more clearly how the method take such array operations into account. This leads to a situation indicated in figure 60.

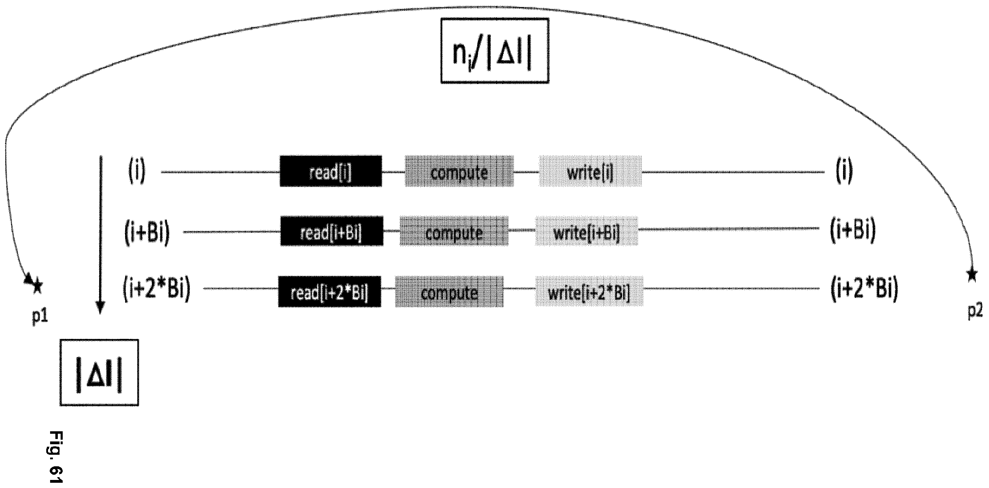

One of the most fundamental principles of the inventive method is to find the last operation node A, which "writes" to a data node B, and then place a new operation node C, which "reads" from B, after the operation node A. If it is not a clear 0- or 1-dependency, add a transfer to the computation block nodes containing the operation node A, respectively C. Therefore, α[i1] = α[i2] is "reading" of data node with base-address 'a' and index 'i2' and "writing" to data node with base-address 'a' and index 'i1', see figure 56. Each loop creates therefore new computation block nodes with a "reading" or "writing" operation node and the corresponding transfers. It can be derived the following scheme, figure 61.

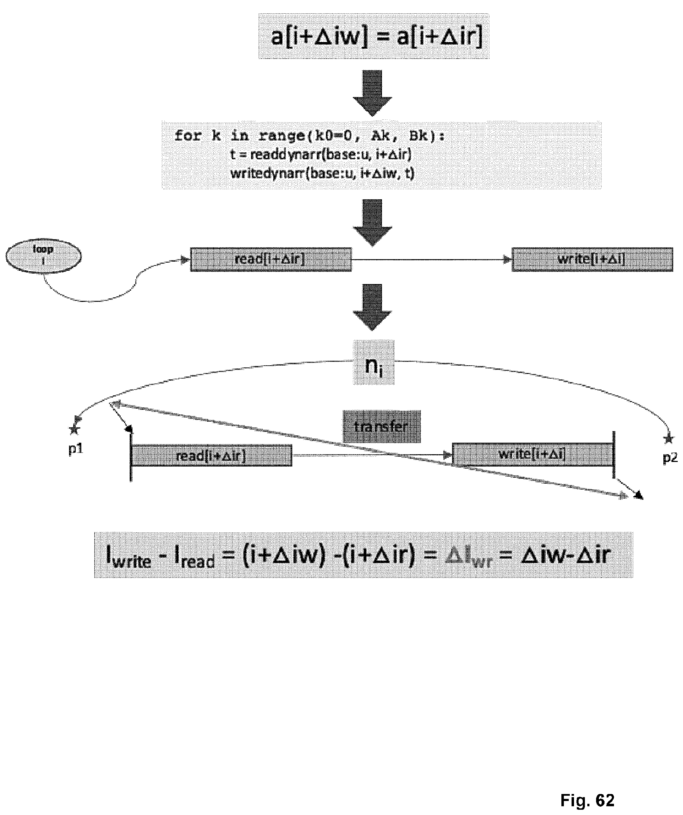

As a loop can be seen as in figure 61, showing that every loop passage is a new computation block node on a new computation-chain (row in matrix). As long as there are no transfers, these computation block nodes will be at the same time (results in the same block or segment number in the numbering process step), as empty computation block nodes and entries in the transfer matrix vanish. If a transfer occurs, the cbns-numbers would be different, and they would not be computable in the same step. An offset in the index of the "reading", respectively "writing" operation can lead to a transfer between the computation block nodes containing the "reading", respectively "writing" operation nodes as can be seen in figure 62.

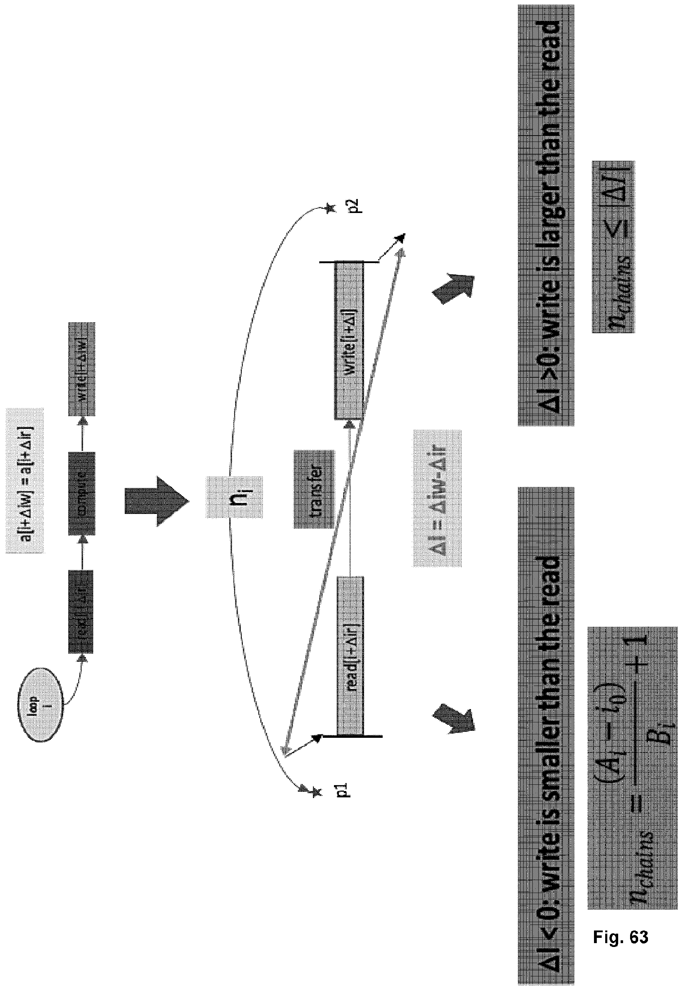

The dependencies in "reading" and "writing" of the indices in a loop leads to the conclusions in figure 63. If ΔI is smaller than 0, shows that the loop can be enrolled on as many computation block nodes as the loop is long. Long meaning the number of iterations defined by the start value 'i0' and the maximal value 'Ai' as well as the increment value 'Bi' in a loop definition, e.g. 'for i=i0; i <> Ai; Bi'. if ΔI is larger than 0, only ΔI computation block nodes can be run in parallel. If less than this number are used, transfer will occur. If the loop is resolved on more than ΔI units, the computation block nodes would not be parallel (meaning have the same number in the flow graph). Therefore, ΔI is a unique number to decide how a "reading", meaning using the information in an array at an index, but not change it, can be distributed on different computation units.

This has some important consequences: It is possible to extract from nested loops one single dimension to decide for each "reading" to an array, which of these readings lead to a "writing" within the loop, and which values are "readings" from data nodes before the loop. Therefore, for each "reading" it can be derived if there is a transfer to the computation block node (=computation-chain) of the "writing" part. This can be implemented as a model and leads to a new, pretty generic perspective on arrays in nested loops. Furthermore, it can be derived which of the nested loops can be resolved, means in the method to be computed parallel, because there is no transfer between a "reading" and a "writing" data node, according to the concept in figure 63. For the 2D heat equation with Central Difference Scheme, this results in the dependencies shown in figure 64. This means, that the i and j loop can be resolved, as ΔI are always smaller or equal than the number of iteration in the i- and j-loop, but not in the k-loop. Meaning the i- and j-loop can be resolved in the method. This means the "reading" and "writing" in the array will be distributed in computation block nodes, which can run parallel, but the k-loop has to be iterative. And after each k-loop transfers between the units will occur. At this point, keep in mind, that the method eliminates transfers in the mapping / optimization step, if they are on the same unit.

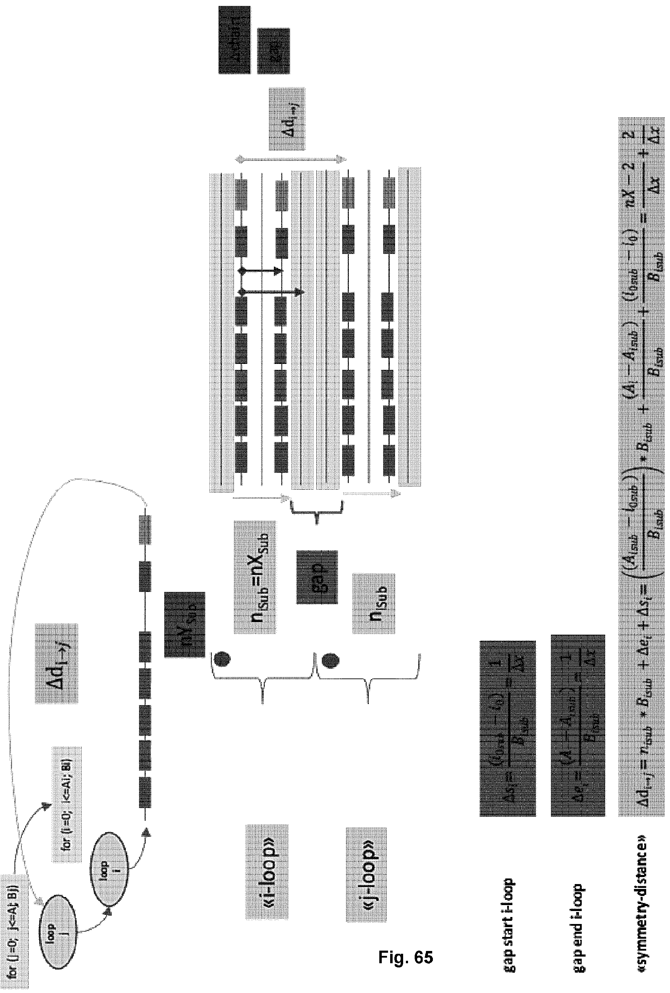

In most implementation to solve a PDE, computations occur only on a subset of an array (e.g. by handling boundary conditions differentially), what makes this step a bit cumbersome. With the example of two nested loops, for each loop-nest a rule can be derived to handle the gaps and the consequence to the "transfers" in the proposed model, as shown in figure 65. The const values are values from computations or definitions of operations before the loops in the "computation block" (see figure 55). Incorporating the gaps occurring by the looping over a subset of the array, the transfer pattern of a discretized equation can be derived and a model for the transfers, depending on the gap-sizes, sizes of the loops (= in this case meshes) results and represents the computation block nodes of the method, as in figure 66. Showing with a very small example of nX=5 and nY=4, this leads to the computation and transfer matrices as in figure 67. In the transfer matrix the arrows '->' indicate getting information and '<-' indicating sending data to other computation block nodes.

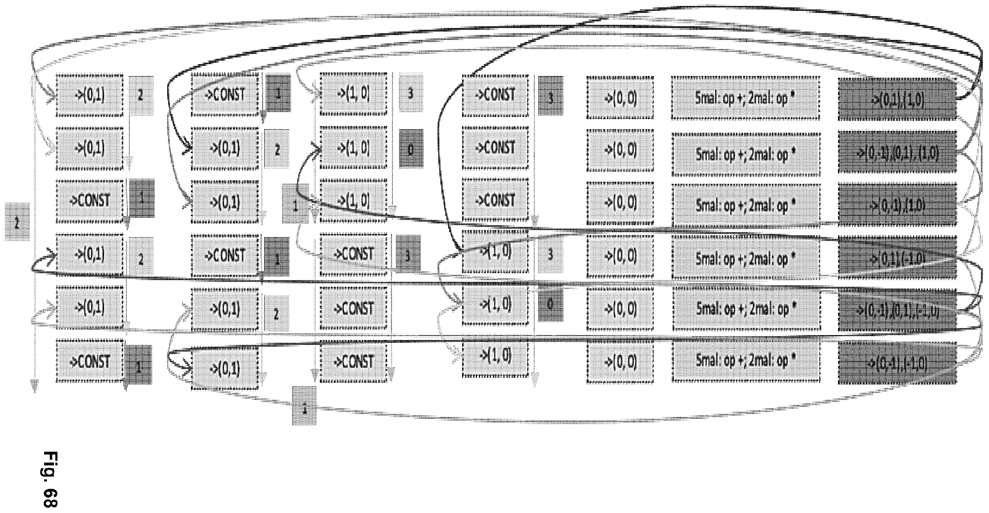

The inventive method brings out all the necessary transfers/communication between the grid elements in the grid needed for the discretized PDE. Figure 68 shows the occurring transfers between the units, as each unit is represented by one row in the matrices. In figure 68 it can be seen an extract of the transfer- and the computation-matrix, with dark grey the "receiving" side of a transfer and light grey the "sending" part of the transfer. It is important to note at this point, that this does NOT mean it has to be sent and received, it also can be e.g. shared by a shared memory segment and guarded by a barrier or lock or vanish as it is shared by cache and therefore handled by a CPU - it depends on the used transfer/communication mechanisms. This can be transferred to a model, respectively leads to a code of the form as shown in figure 69. It has to be noted, that the computations between p0 und p1 evolve, because the method is defined to add transfer from the "written" data nodes to the "reading" data nodes and as the array operations in the nested loop start with a "reading" operation node, this situation happens.

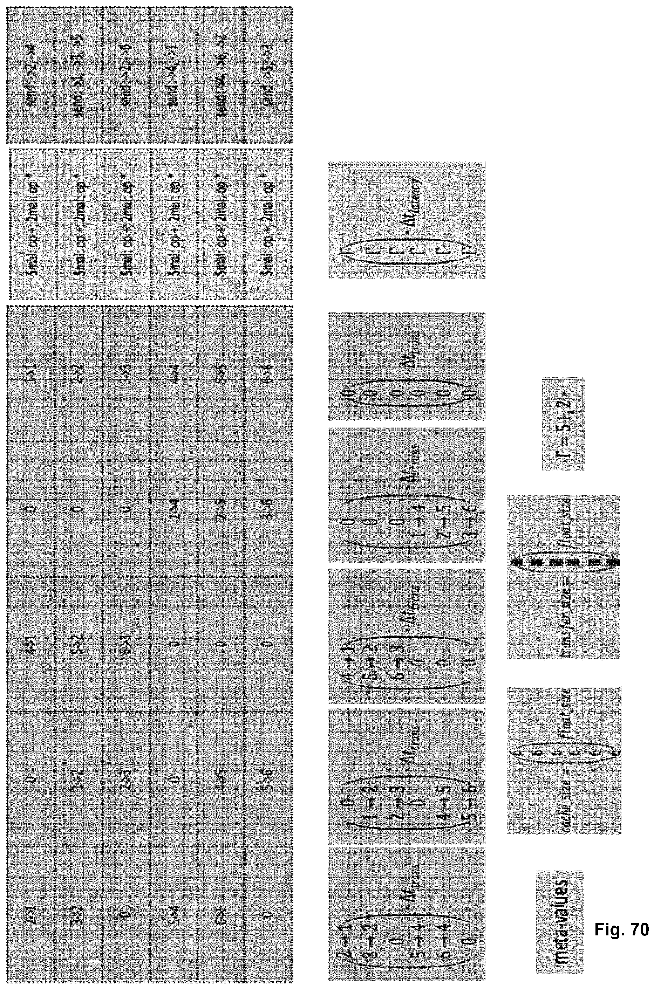

Figure 70 shows how the transfers can be used to create a time model. Grey are the meta values (e.g. known from variable type definitions or similar), which also can be used to map/optimize the matrices to a given hardware infrastructure.
3 procs *→ (1,2),(3,4),(5,6)* $\begin{matrix}Δ t = \left(0 \begin{matrix}3 \to 2 \\ 5 \to 4 \\ 0\end{matrix}\right) ⋅ Δ {t}_{trans} + \left(\begin{matrix}0 \\ 2 \to 3 \\ 4 \to 5\end{matrix} 0\right) ⋅ Δ {t}_{trans} + \left(\begin{matrix}4 \to 1 & 5 \to 2 \\ 0 & 6 \to 3 \\ 0 & 0\end{matrix}\right) ⋅ Δ {t}_{trans} \\ + \left(\begin{matrix}0 & 0 \\ 0 & 1 \to 4 \\ 2 \to 5 & 3 \to 6\end{matrix}\right) ⋅ Δ {t}_{trans} + \left(\begin{matrix}Γ & Γ \\ Γ & Γ \\ Γ & Γ\end{matrix}\right) ⋅ Δ {t}_{latency}\end{matrix}$ $Δ t = \left(\begin{matrix}3 \\ 4 \\ 3\end{matrix}\right) ⋅ Δ {t}_{trans} + \left(\begin{matrix}2 ∗ Γ \\ 2 ∗ Γ \\ 2 ∗ Γ\end{matrix}\right) ⋅ Δ {t}_{latency} cache _ size = \left(\begin{matrix}8 \\ 9 \\ 8\end{matrix}\right) float _ size$ $transfer _ size = \left(\begin{matrix}3 \\ 4 \\ 3\end{matrix}\right) float _ size$

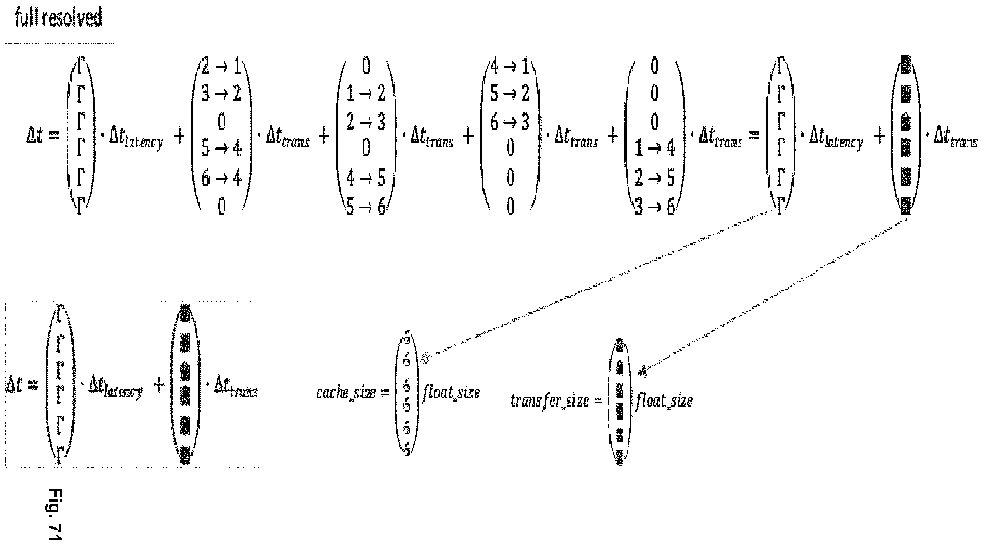

These values are not used in this example. To illustrate possible optimizing steps, a very simple model is shown fully resolved in the following Figure 71, where a combination of row (1,2), (3,4) and (5,6) resulting in 3 units computing:
a combination of row (1,2,3) and (4,5,6) resulting in 2 units computing:
   2 procs *→ (1,2,3),(4,5,6)* $\begin{matrix}Δ t = \left(\begin{matrix}0 \\ 0\end{matrix}\right) ⋅ Δ {t}_{trans} + \left(\begin{matrix}0 \\ 0\end{matrix}\right) ⋅ Δ {t}_{trans} + \left(\begin{matrix}4 \to 1 & 5 \to 2 & 6 \to 3 \\ 0 & 0 & 0\end{matrix}\right) \\ ⋅ Δ {t}_{trans} + \left(\begin{matrix}0 & 0 & 0 \\ 1 \to 4 & 2 \to 5 & 3 \to 6\end{matrix}\right) ⋅ Δ {t}_{trans} + \left(\begin{matrix}Γ & Γ & Γ \\ Γ & Γ & Γ\end{matrix}\right) ⋅ Δ {t}_{latency}\end{matrix}$ $Δ t = \left(\begin{matrix}3 \\ 3\end{matrix}\right) ⋅ Δ {t}_{trans} + \left(\begin{matrix}3 ∗ Γ \\ 3 ∗ Γ\end{matrix}\right) ⋅ Δ {t}_{latency} transfer _ size = \left(\begin{matrix}3 \\ 3\end{matrix}\right) float _ size$ $cache _ size = \left(\begin{matrix}11 \\ 11\end{matrix}\right) float _ size$
and a combination of all rows (resulting in a 1 unit computing without any transfers):
   *1* procs *→ (1,2,3,4,5,6)* $Δ t = \left(0\right) ⋅ Δ {t}_{trans} + \left(6∗Γ\right) ⋅ Δ {t}_{latency} transfer _ size = \left(0\right) float _ size$ $cache _ size = \left(16\right) float _ size$

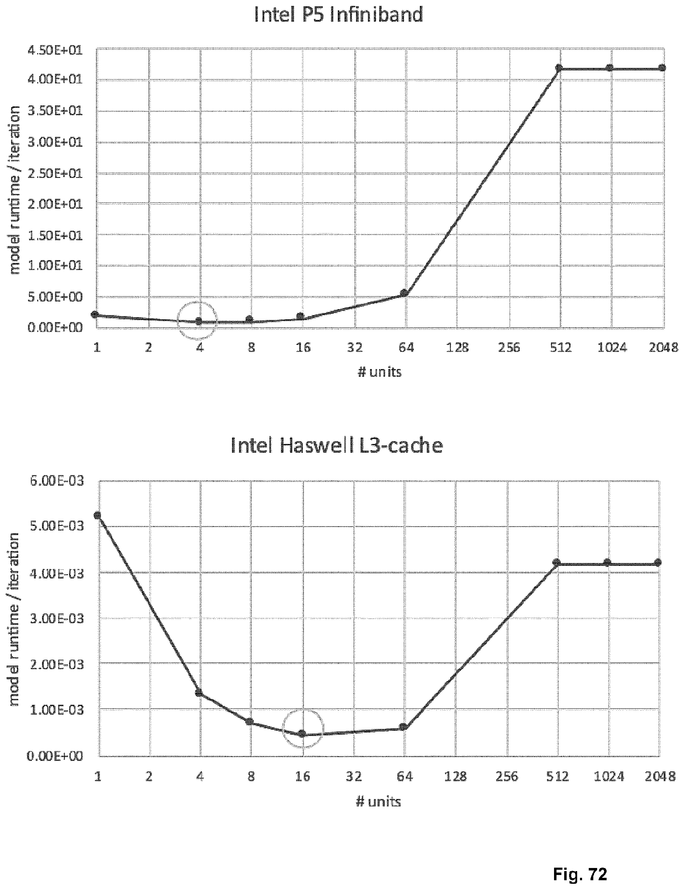

These steps show exemplary how the method creates different ratios between computing and communications and how depending on the combination the transfers are reduced and the computations per unit are getting higher. To make this more illustrative, a very simple model of computing and communicating can be used and some "real values" for the times assumed. Two generation of Intel CPUs with according to performance values for their floating point capabilities per cycle (FP) and their frequency leads to a power value for these to compute floating point arithmetic (like T in the model). A P5 FP32: 0.5 and a Haswell FP32: 32 can e.g. be used with a frequency for the cycles of 66MHz and 3.5GHz and for addition and multiplication of a float value 4 cycles. To get a value for the Δtransfer, representing the communication latency in the network (the author knows that there were made a lot of assumptions and the latency is not the only key value for a network), two types of latencies are used: 1ns for an infiniband type and 50ns for a cache latency. The behavior in figure 72 can be derived for a grid of nX=2048 and nY=1024 by Δt = number of combined cbn * cpu+number of transfers*network latency.

It is always straight forward to get code back from the method, respectively the two matrices, adapted to the available IPC options. This generic form of optimizing code brings a novelty to the field of automatic code parallelization. For example, the code can be optimal mapped e.g. to an MPI-cluster infrastructure or with some more fine grained tuning applying a Hybrid approach by combining MPI (shared memory) and threading locally on nodes. By different combinations (e.g. combine the first x cbns in i-direction and the y cbns in j-direction) it is possible to get an optimal ratio between "computation" and "communication" for any given discretized PDE but depending on the available hardware infrastructure. This can be done without any by-hand interaction as the necessary properties can also be tested, or computed for an available hardware infrastructure, solving real technical problems of the prior art.

### (iii) Pointer disambiguation

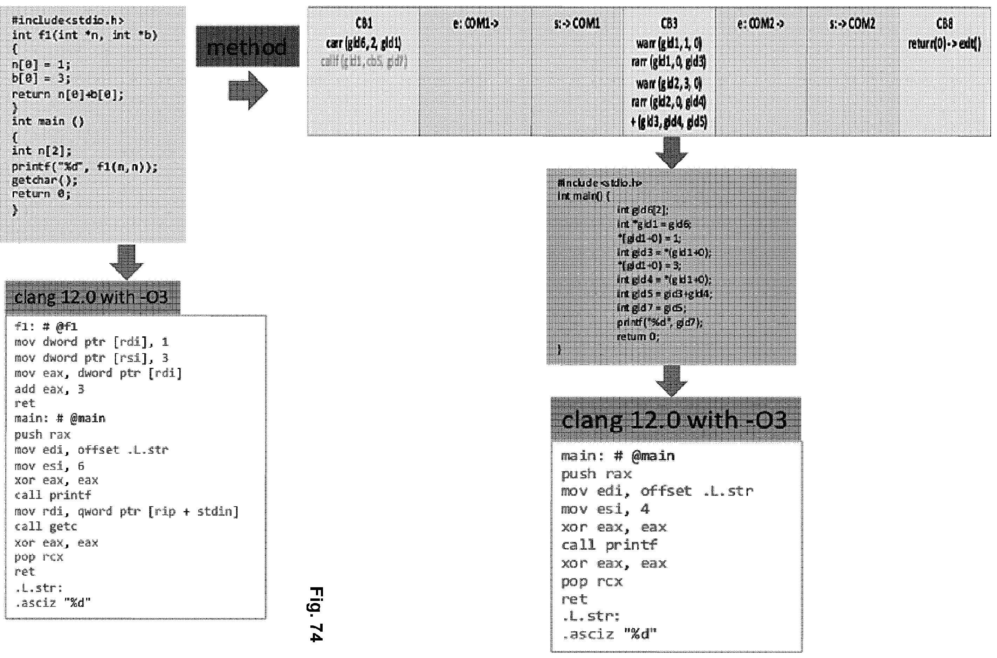

Pointer disambiguation is also a technical problem not solved completely (see e.g. *Runtime pointer disambiguation* by P. Alves). Applying the inventive system and method, it can be shown, that the inventive methodology technically resolves the disambiguation occurring by passing function parameters as pointers, because it takes the pointer as an information and this disambiguation will be resolved in the step of the transfer vanishing, as illustrated by figure 74.

### (iv) Fibonacci using loop

The Fibonacci source can also be implemented using loops.

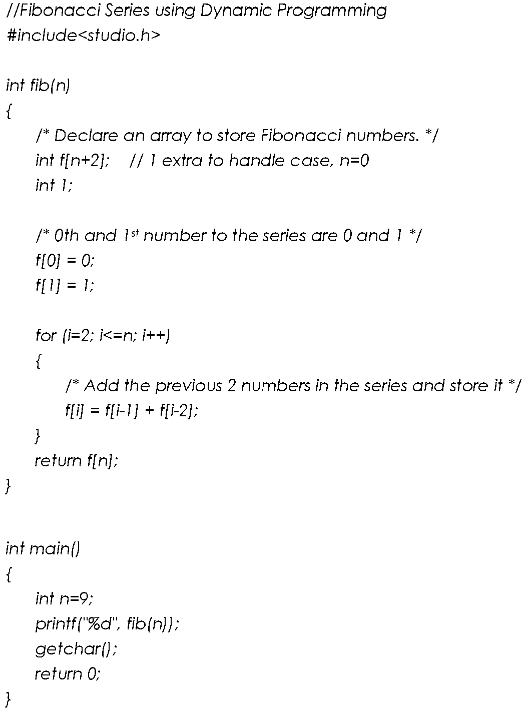

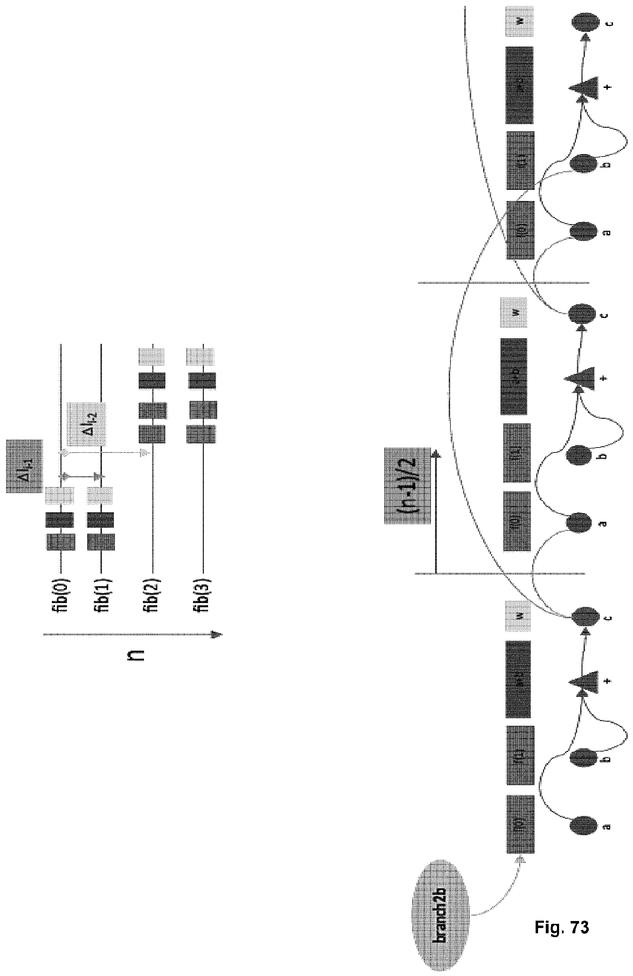

According to the example with the 2D heat equation, this leads to the result in figure 73, and, in return, results in a source code of the form:

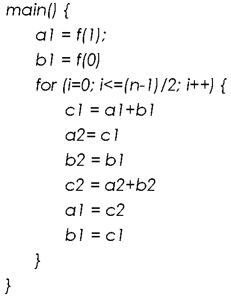

This has the similar performance properties as the result the code of figure 53, shown above.

To proof of actual efficiency of the inventive system and to benchmark the performance of the inventive system, the above-mentioned recursive Fibonacci example can be used, which, in the technical field of auto-parallelization systems, is often used as proof-of-function and benchmark study (see e.g. V. Sarkar "Fundamentals of parallel programming module 1 parallelism", p. 60ff). Based on the simple example of the recursive implementation to generate Fibonacci numbers, it is possible to show "if", "how", and "how good" an auto-parallelization system and compiler is able to optimize a code for a given platform's transfer-time and processing-time. Figure 75 shows the recursive implementation, the LLVM IR in Basic Block form and how the system handles the grouping in the method. Figure 75 shows LLVM IR and grouping of instructions in computation blocks (CBs).

Two simple strategies are discussed in the following:
a) ***Optimize with latency* times:** calculate all approximated runtimes for combinations for a given number of units. This references to the II. of the listed optimization strategies.
b) ***Optimize for different transfer times* TT:** form different task graphs as a function of a given transfer time (TT). The different TT representing hardware platforms with different transfer latency times. This references to the III. of the mentioned listed strategies.

### Optimization approach a): Optimization with latency times

To demonstrate the effect of the method along a well-known and studied example, the recursive implementation of the Fibonacci series can e.g. be used, see figure 75. $\begin{matrix}Δ {t}_{end , u 1} \\ Δ {t}_{end , u 2} \\ Δ {t}_{end , u 3}\end{matrix} = Δ {t}_{c 1} + Δ {t}_{c 7} + \left[\begin{matrix}Δ {t}_{c 2} + Δ {t}_{c 3} + Δ {t}_{c 6} \\ 2 ⋅ Δ {t}_{t} + Δ {t}_{c 4} \\ 2 ⋅ Δ {t}_{t} + Δ {t}_{c 5}\end{matrix}\right] = \left[\begin{matrix}0 \\ 2 \\ 2\end{matrix}\right] ⋅ Δ {t}_{t} + \left[\begin{matrix}2 + 4 \\ 2 + 2 \\ 2 + 2\end{matrix}\right] ⋅ \left[\begin{matrix}{p}_{unit 1} \\ {p}_{unit 2} \\ {p}_{unit 3}\end{matrix}\right]$

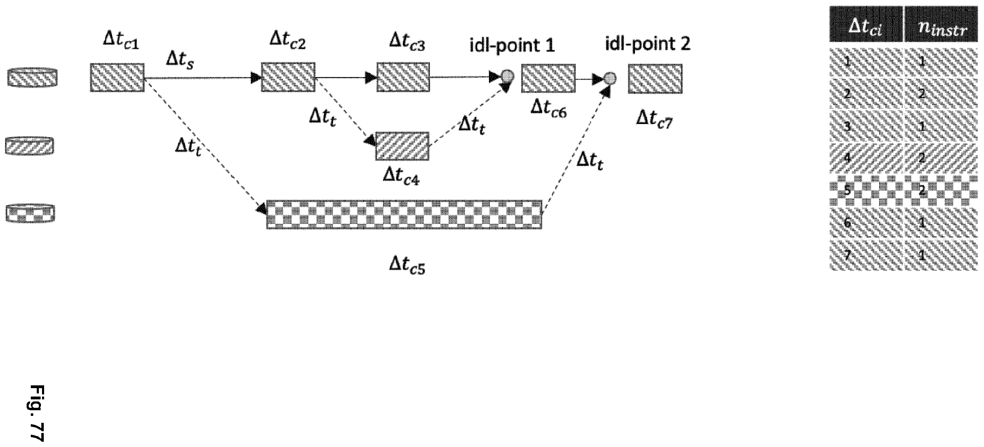

To illustrate the method: all instructions in the code are unrolled and the method creates different gamma-graph nodes and corresponding transfers, as visible in Figure 6 for a call of fib(3). Figure 75 shows the forming of compute and transfer segments. From the computation and communication segments the corresponding computing times Δ*t*ₜᵢ and communication times Δ*t*ₜᵢ can be distinguished. The computing time can be seen, e.g. as a function of number of instructions nᵢₙₛₜᵣ and computing unit performance pᵤₙᵢₜ Δ*t*_{ci} = *f*(nᵢₙₛₜᵣ, pᵤₙᵢₜ). Each chain of computing segments is associated to one computing unit. For three units *n*ᵢₙₛₜᵣ = 3. Figure 77 shows a time model structure for compute and transfer segments. A simple set of linear equation can be built to generate the runtime Δ*t*_{end} with Δ*t*ₛ = 0. The latency times for the units are:
The runtime is the maximal runtime of each of the units and is a function of the hardware-transfer time Δ*t*ₜ and the performance of the units *p̅_{unít}*:
The idle-times are on: $Δ {t}_{end , nunits = 3} \left(Δ{t}_{t},{\overline{p}}_{unit}\right) = max \left(\begin{matrix}Δ {t}_{end , u 1} \\ Δ {t}_{end , u 2} \\ Δ {t}_{end , u 3}\end{matrix}\right)$
- unit 1 or 2: Δ*t*_{idl1} = [Δ*t*_{c3}] - [2 - Δ*t*ₜ + Δ*t*_{c4}]
- unit 1 or 2: Δ*t*_{idl2} = [Δ*t*_{idl1} (Δ*t*ₜ) + Δ*t*_{c6}] - [2 - Δ*t*ₜ + Δ*t*_{c5}]

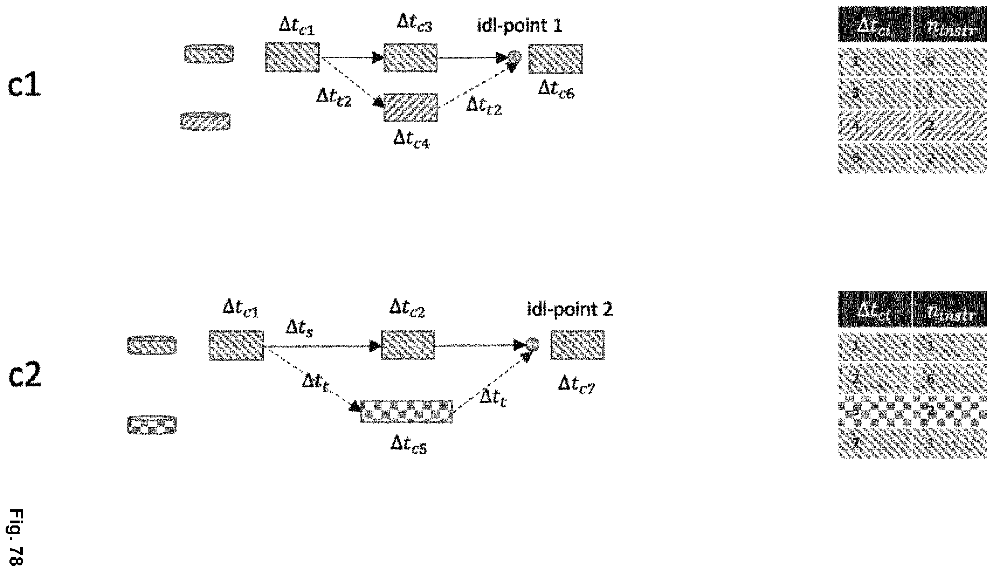

For two units: nᵤₙᵢₜₛ = 2. Figure 78 shows an option for 2 units, marked as combination (c1) and combination (c2). The latency times for the units are either for combination 1: $\begin{matrix}Δ {t}_{end , u 1 , c 1} \\ Δ {t}_{end , u 2 , c 1}\end{matrix} = \left[\begin{matrix}Δ {t}_{c 1} + Δ {t}_{c 3} + Δ {t}_{c 6} \\ 2 ⋅ Δ {t}_{t} + Δ {t}_{c 4}\end{matrix}\right] = \left[\begin{matrix}0 \\ 2\end{matrix}\right] ⋅ Δ {t}_{t} + \left[\begin{matrix}5 + 6 + 8 \\ 2\end{matrix}\right] ⋅ {\vec{p}}_{unit}$ or for combination 2: $\begin{matrix}Δ {t}_{end , u 1 , c 2} \\ Δ {t}_{end , u 2 , c 2}\end{matrix} = Δ {t}_{c 1} + Δ {t}_{c 7} + \left[\begin{matrix}Δ {t}_{c 1} + Δ {t}_{c 2} + Δ {t}_{c 7} \\ 2 ⋅ Δ {t}_{t} + Δ {t}_{c 5}\end{matrix}\right] = \left[\begin{matrix}0 \\ 2\end{matrix}\right] ⋅ Δ {t}_{t} + \left[\begin{matrix}1 + 6 + 1 \\ 2\end{matrix}\right] ⋅ {\vec{p}}_{unit}$

The runtime is the maximal runtime of each of the units of both combinations: $Δ {t}_{end , nunits = 2} \left(Δ{t}_{t},{\vec{p}}_{unit}\right) = max \left(max\left(\begin{matrix}Δ {t}_{end , u 1 , c 1} \\ Δ {t}_{end , u 2 , c 1}\end{matrix}\right),max\left(\begin{matrix}Δ {t}_{end , u 1 , c 2} \\ Δ {t}_{end , u 2 , c 2}\end{matrix}\right)\right)$

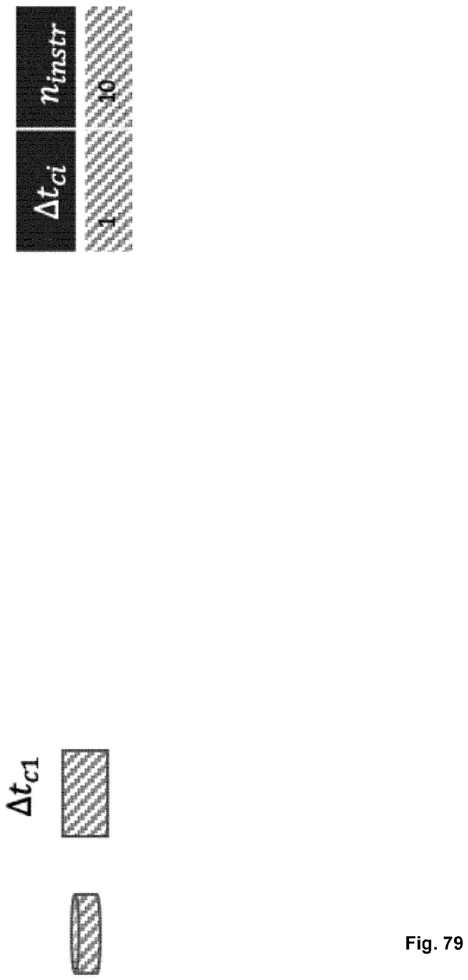

For one unit: nᵤₙᵢₜ= 1, which is illustrated in figure 79. The latency time for one unit is Δ*t*_{end,u1} = [0] · Δ*t*ₜ + [10] · pᵤₙᵢₜ.

For the overall optimization: In this form Δ*t*_{end} is a function of Δ*t*_{ci}, Δ*t*ₜᵢ and *n*ᵤₙᵢₜₛ. This can be expressed directly by Δ*t*_{end} = *f*(Δ*t*_{ci}, Δ*t*ₜᵢ, *n*ᵤₙᵢₜₛ). So the optimization is for a given set of hardware with Δ*t*ₜ, *p̅ᵤₙᵢₜ* is: $Δ {t}_{end , optional} \left(Δ{t}_{t},{\vec{p}}_{unit}\right) = min \left\{\begin{matrix}Δ {t}_{end , nunits = 3} \\ Δ {t}_{end , nunits = 2 , c 1} \\ Δ {t}_{end , nunits = 2 , c 2} \\ Δ {t}_{end , u 1}\end{matrix}\right\}$

This illustrates the effect of the new technical optimization approach differing completely from the known prior art SOTA approach (cf. V. Sarkar *"Fundamentals* of parallel programming module 1 parallelism", p. 58ff).

### Optimization approach b): Building gamma-graphs following task parallelism

According to the disclosure of the present invention, the result of the system can be illustrated as a tensor or a graph, depending on the form of representation, see Figure 80. If all instructions in the code are unrolled, the method creates different gamma-graph nodes and corresponding transfers, as visible in figure 81 for a call of fib(3).

Now, for each node in the gamma-graph, the system 1 computes whether the overhead of running a child-node in parallel by paying the prize of *"transferring the* data" (this can also be seen as time of a context switch) is beneficial.
- serial effort: *t*_{*Serial*Γ} = Σ*Δtᵢₙₛₑᵣ*
- parallel effort: *t*_{*parallel*Γ2} = *t*_{*serial*Γ*parent*} - *t*_{*serial*Γ*child*} + *t_{contextsw}*
- time overhead: $Δ {r}_{a} \left({t}_{contextsw}\right) = \frac{{t}_{serial Γ parent}}{{t}_{parallel Γ parent}}$

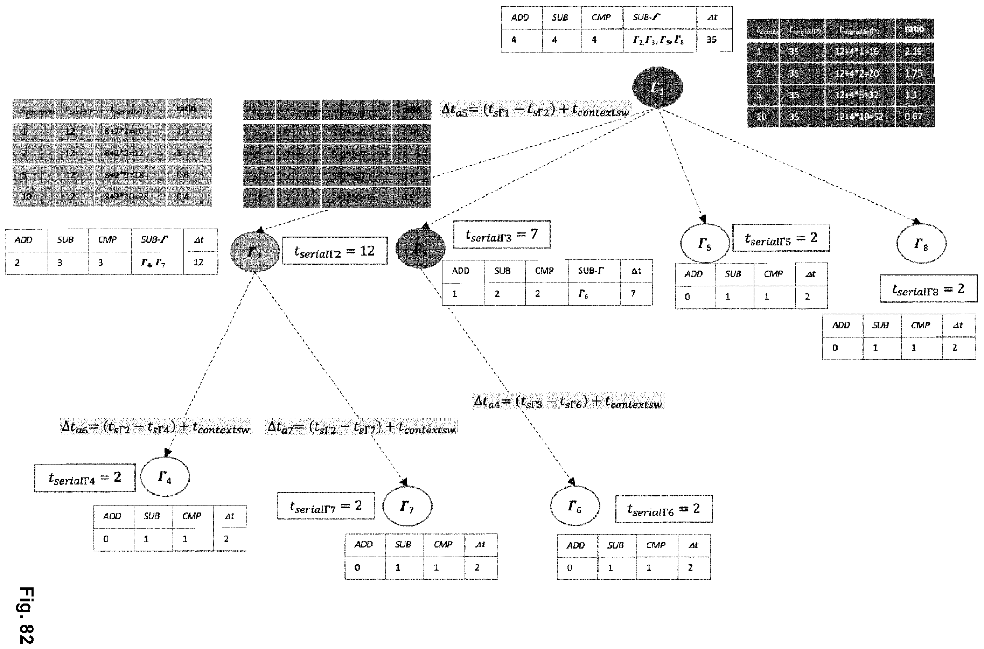

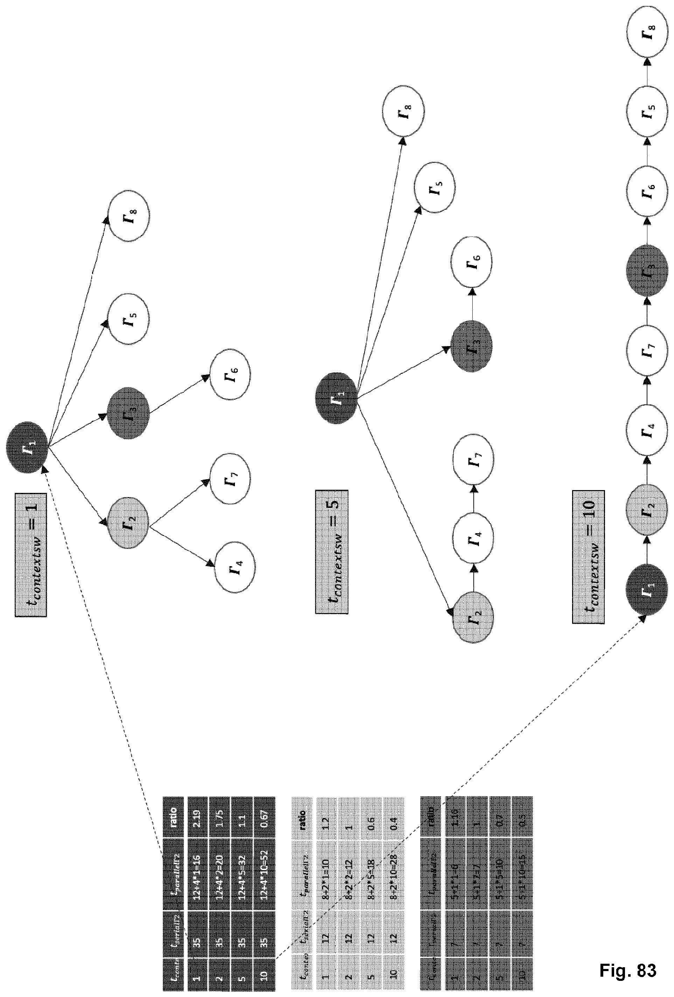

Following the Fibonacci example, this leads to the computation graph with corresponding tₛₑᵣᵢₐₗ and tₚₐᵣₐₗₗₑₗ times for each node as indicated in figure 82. In a compiler, this can be seen as given the compiler a transfer time (TT) for a platform and the compiler is capable of forming a Π-agnostic computation graph. For example by computing a computation graph for the Fibonacci code fib(5) with 3 different transfer times = 1, 5, 10, the method is capable of forming the different computation graphs for corresponding platform (for n=5 and Π = 1, 5, 10 are so low to be able to easier show the effect graphically). Figure 83 shows exemplary three different computation graphs for TT = 1, 3, 10. For a low TT = 1 it is beneficial to compute all gamma-nodes in parallel. For a higher value of Π, e.g. TT = 5, gamma node 4 and 5 are in serial with gamma-node 2 and 5, 6, 8 with 3, but these two can be run in parallel. These results correspond well with results e.g. shown in V. Sarkar *"Fundamentals* of parallel programming module 1 parallelism".

### (v) IC-design using the inventive system 1

The inventive system 1 can be applied (see figure 106/110) for both designing and optimizing VLSI designs. Circuit design is about arranging transistors to perform a particular logic function. From the design the delay and power can be estimated. Every circuit can be represented as a schematic or in textual form as a netlist. Simply illustrated (see Fig. 111a), digital logic can be divided into combinational circuits (Boolean logic), whose outputs depend only on the present inputs (series of logic gates), and sequential circuits, whose building blocks are registers (flip-flops) and latches.

The Inventive System 1 can be used to determine the computation block nodes. The computation block nodes in turn can be used to determine the digital logic, which will be illustrated by the example of the 2D heat equation. Fig. 67 shows that a computation block node for this algorithm consists of 5 reads, 1 compute and 1 write (Fig. 111b). The result of a simple circuit is shown in Fig. 111c. The reads become the sequential circuits consisting of 5 flip-flops (together they form the register, though, the effective register size is determined by the bit length of the individual data). A rising-edge of the clock (time k) can be assumed, where for the required hold-time is waited to be sure that the correct values (logical 0 or 1) for ∪[k] [i+1][j], ∪[k][i-1] [j], ∪[k][i][j+1], ∪[k][i][j-1] and ∪[k][i] [j] are present at the output of the flip-flops. This is basically our read. The data can now propagate through the combinational circuit (computational block), which results from the arithmetic consisting of the required adder, shifter (multiplication by 4), subtractor (inverter and adder combined) and multiplier. At the output of the computational block the value ∪[k+1] arises (equivalent to the write operation) after the setup time, which is the amount of time required for the input of a flip-flop to be stable before a next clock edge.

The register on the right side is nothing else than the value at the next time k+1, which is needed for the next iteration on the left side. From this results that the values can be written directly into the same register. This thought experiment can now be carried out for each point on the computation matrix. Already for two points on the matrix (Fig. 111d) it becomes obvious that data are now written crosswise or that only one register per matrix point is needed. The computational block (CB) always consists of the same combinational circuit, although in the electronic implementation the propagation delays will never be the same. It is therefore important to keep an eye on the critical paths that limit the operating speed of the system and require attention to timing details.

Real world settings are always limited in space with VLSI design. An infinite parallizability is not possible, so certain (not all) computational blocks are combined and processed sequentially. To make this possible for a finite number of registers, a multiplexer is connected between the output of the registers and the input to the CB. A multiplexer chooses the output from among several inputs based on a select signal. At the same time, a demultiplexer is connected between the output of the CB and the register input (see Fig. 111e) to feed the data back correctly, whereby the design optimization process might show that the demultiplexer is not always need. What is processed per clock rate on the ideal, parallel circuit is now processed in several clock cycles in the more realistic circuit (Fig. 111f/g) - as much parallel as possible in as many cycles until a complete iteration is completed. Using the 4x5 matrix from Fig. 67 as an example, this would mean: With 6 parallel CBs: 1 cycle to calculate k+1, with 3 parallel CBS: 2 cycles (2x3 parallel) including a higher delay do to multiplexing.

VLSI designers always must make trade-offs between area, throughput, latency, power consumption and energy of executing a task. The optimal circuit is always located somewhere on an inverse curve (see Fig. 111h). If There is a lot of area available, parallelization can be done well. If there is less area available, the system must multiplex, which leads to a higher delay. Somewhere in between lies the optimal point between area and number of parallel CBs. Since the Inventive System 1 can give the optimal code for a given unit, it can also be used to find the optimal circuit for a given area, helping in the iterative design process refined as actual module sizes and critical paths become known.

There is to say that the exact implementation of the parallelization on an FPGA or of an ASICs would depend on the specifics of the problem and the design requirements. It may require careful consideration of the memory and especially the communication requirements between systems, as well as the previous stated trade-offs between area, throughput, latency, power consumption, and energy that are common in VLSI design.

Hence, the Inventive System 1 employs a set of heuristics and algorithms to identify and manipulate patterns in the design space to generate novel and non-obvious solutions. The potential design solutions are evaluated based on a set of predetermined metrics, such as power consumption, area, and performance, and the optimal design solution is selected. The selected design solution is further optimized through a series of iterative steps, using the Inventive System 1 to explore and manipulate the design space.

In the method for optimizing the parallel VLSI design process, registers and clocks play a crucial role in ensuring the proper functioning of the circuit. The Inventive System 1 considers the read and write operations of the registers, as well as the clock timing constraints, to generate a design that meets the desired performance and functionality requirements.

Furthermore, the Inventive System 1 considers the propagation delay through the arithmetic logic to optimize the timing of the circuit. This includes considering the delay in each logic gate and the routing between the gates to minimize the overall delay of the circuit. The Inventive System 1 employs a variety of techniques, such as pipelining and parallelism, to minimize the propagation delay and maximize the performance of the circuit.

However, while optimizing the design for performance, the Inventive System 1 also considers the area constraints of the target implementation platform, such as FPGA cells. The method ensures that the resulting design fits within the available resources of the implementation platform, while also meeting the desired performance and functionality requirements.

In summary, the method for optimizing the parallel VLSI design process using inventive system 1 considers the read and write operations of registers, clock timing constraints, propagation delay through the arithmetic logic, and area limitations of the implementation platform. This results in a highly efficient and scalable VLSI design that meets the desired performance and functionality requirements, while also being feasible for implementation in the target platform. Thus, the parallelization system 1 allows to group instructions from sequential code (a list of serial instructions) into so called computation block (CBs = list of instructions preferred to run in serial) and indexing the resulting groups to retrieve groups of instruction to run in parallel including the needed transfers to run on different computing units. The method is built on a systemic perspective of modern computing platforms, which still are limited by binary computing steps. One embodiment variant uses the method to build tasks with a target granularity ${G}_{target} = \frac{{t}_{compute}}{{t}_{communicate}} ,$ which is a function of the target hardware to compute and transfer data. By building tasks with a certain granularity, the scheduling of the tasks at least on symmetrical (in this context units with same or at least similar performance properties to compute and transfer data between each other) platforms will be trivialized, which is for state-of-the-art method a NP-hard problem. The benefit is the methods capability to use the Read-after-read (RAR) dependencies to create groups of Read-after-read (RAW) chains and connect the groups by potential transfers. The method is capable of extracting more information to build parallel code than state-of-the-art methods by using these not utilized RAR dependencies. Parallel computation blocks can be combined to optimize the code for a target hardware, consisting of different independent units, which can interchange data. This methods enables to reach new limits for generic auto-parallelization of software, for compiled languages, such as C, C++, etc. as well as for interpreted languages, such as python, java, etc.. Additionally, it is possible to create hardware designs based on the novel segmentation.

### (A) FPGA-Design for loop-sections

The method enables to segment a code in a base granularity *G*₀, see figure 126 (a). The result can be illustrated as a graph, with computation blocks (CB) as nodes and transfers as edges. They build a sequence of distinct compute -> transfer segments. By combining the segments on each level different granularities *G* can be build iteratively with different ratios between computing and transferring, respectively communicating in a generic way.

Loop sections can contain large computational efforts. There exist different approaches to extract Instruction Level Parallelism (ILP) from loop-sections, such as vectorization or unrolling the loop - but with known limits. The new method enables to extract a gamma-graph without unrolling the loop, based on the simple rules to build computation blocks. This results in a gamma-graph described by the following key parameters:
a) *n*_{∥}: the number of parallel computation block nodes per needed iteration
b) *nₗₒₒₚ*: the number of iterative iterations, meaning inevitable inter-loop transfers occur
c) Nodes: CBs in the loop: sequential instructions - instructions with RAW dependencies.
d) Edges: data transfers between CBs

This can be achieved without unrolling loops and only doing static code analysis. *n*_{∥} is a function of runtime-parameters *n*_{∥} = *f*(*params*) and *nₗₒₒₚ* = *f*(*n*_{∥},*nᵤₙᵢₜₛ*) is a function of the used parallel running units *nᵤₙᵢₜₛ.* This segmentation is possible compared to state-of-the-art methods by including the Read-after-Read dependencies to extract potential transfers and group instructions to computation blocks, which hold instructions with Read-after-write dependencies.

From a code in Control Flow Graph (CFG) with Basic Blocks (BB), the novel method can generate a gamma-graph with 4 phases, describing the parallel / distributed computation of the loop sections including needed data transfers, see figure 127:
- Initialization: data from CBs before the loop have to be distributed to all parallel CBs *n*_{∥}
- Computing: each unit computes one (or more) of the *n*_{∥} CBs iteration-by-iteration for *nₗₒₒₚ* iteration to complete the loop section.
- Inter-loop transfer & gap / boundary transfers: Needed transfer between the units must be communicated / synchronized for each iteration between the *n*_{∥} CBs and data, e.g. from gap in nested loop-definitions, have to be loaded to the units.
- Result: After computing *nₗₒₒₚ* iterations, the results have to be transferred (not in any case!) to the main process, respectively to CBs after the loop.

Each node in the gamma-graph represents a Computation Block (CB) and the edges represent potential transfers.

### (i) Deriving IC-designs by the inventive system

This section introduces how an IC-design can be derived from a gamma-graph. In a first step the corresponding elements in the gamma-graph and their relation to RTL-elements / IC-elements are explained. In a second step, two applications of the method are proposed to use the method to generate corresponding IC-designs customed to the input code as a generic method:

### a) IC-designs for loop sections - optimised for speed

The inventive system allows to exploit more parallelism in loop-sections than state-of-the-art methods and enables to derive gamma-graphs with code segments containing series of instruction with RAW dependencies (computable with a combinational logic in *t_{pg}*). These can be used to create automatically (parallel) instances on FPGA's to speed up computations in loop-sections. The optimisation-step includes option to generate an optimised design for fixed runtime-parameters or a generic for codes with unknown runtime-parameters. This introduces novel limits to fully, automatically generate synchronous, synthesisable und runnable IC-designs from static code analysis. Therefore, this approach is useful for any compiled or interpreted language.

### b) Static multi-issue CPU -designs with known IP-blocks optimised for given code:

The novel method generates gamma-graphs from code in Control Flow Graph (CFG) with Basic Block by building Computation Blocks (CB). They comprise a series of Read-after-write dependent instructions. Parallel CBs are differentiable over the CFG. This enables to generate a multi-issue CPU pipeline design optimized to the gamma-graph. The gamma-graph can then be used to generate high-performed assembly-code runnable on the corresponding optimised multiple issue CPU design.

### (ii) Gamma-graph and link to IC-design components

The segmentation of code with the novel method results in a gamma-graph, which consists of Computation Block as nodes and edges as potential data transfers between the blocks. Each computation block contains a series of Read-after-write (RAW) instructions. The instructions by RAW dependencies in the CBs build a combinational circuit, meaning with given input the computation can be performed in one step / cycle. This computation takes *t_{propagation}*. (see figure 128)

The size of the needed registers for a synchronous design, are defined by the data nodes used in the instruction in the block. The size of the data nodes is defined by the data types of used variables, which are defined by the Instruction Set Architecture (ISA). This connects the amount of data nodes, data type definition and the number of instructions to the needed register size: ${S}_{reg} = f \left({S}_{data nodes}, {n}_{data nodes in CB}, ISA\right)$ and the size of the data nodes are a function of data types: ${S}_{data nodes} ∝ {S}_{data types} = f \left(ISA\right)$

The wire-width is also a function of the data type and the number of to transfer data nodes. This defines the bit-width of each transfer, which is defining the size of the wires: ${S}_{wire} = f \left({S}_{data types}, {n}_{data}\right)$

Therefore, 1 Byte is equal 8 bits, what results in a register (to compute) or wire (to transfer) size of 8 bits. The MIPS ISA definitions defines then an Integer variable as 8 bits (1 byte), 16b (half) and 32b (word) and 64b (long). Instructions in high level programming languages are then linked by compilers to the used Instruction Set Architecture (ISA), which abstracts the hardware properties linked with the ISA, such as:
a) data types and sizes *S_{datas node}*: signed or unsigned, integer or floating point and bit-sizes.
b) Instructions and their logic.

Each instruction can be represented by a given Boolean Algebraic expression, respectively by an asynchronous computation. This conversion is already known to be generically implementable and from an arithmetic expression with the basic +, -, * and / by synthesized fully automatically to a combination of digital logic gates. In this context, handling of floating point numbers must be mentioned: Floating point numbers can be represented and converted into fixed-point representation. Addition is then straight forward as for integer types. Using two's complement fixed-point representation of numbers enables generic handling of negative number and therefore also for subtraction. Multiplication and division can be notated - with some loss of resolution - as well as easy than integer arithmetic. This definition also is comprised in the ISA. The propagation time *t_{propagation}* for a combinational computation of logic gates can be derived by state-of-the-art synthesis tools. The chain of instructions can be expressed in Verilog on RTL-level as every component is known, see figure 129:
- size of registers in and out
- Arithmetic for the asynchronous part - are simple assign-statements in Verilog between the known arithmetic operation: +, -, * and /. Handling of floating-point variables can be handled using two-complement fixed-point representation.

Therefore, a gamma-node = Computation Block (CB) contains all information to form RTL-code for an asynchronous design to compute the instructions contained in the CB. The edges in the graph, the transfers, contain the size of the register between each combinational computation, what enables to form synchronous designs. The CBs, the nodes in the graph, contains the assignment definitions between the registers of each level of the graph. In this form all instructions in a CB are computed in the fastest possible form by combinational logic and synchronized in a synchronous design, see figure 130. Between two levels in the gamma-graph *Sᵢₙ* and *Sₒᵤₜ* can congregate, see figure 129. In figure 130, for each level *Sᵢₙ* and *Sₒᵤₜ* are illustrated separately, as well as register transferred from earlier registers, see *S*_{*reg*,Γ13}. If the design is on one device, the in and out register will be combined to one register. In case Γ_{2,*a*} and Γ_{2,*b*} would be computed on different devices, both in register would be needed. This has an influence on the optimization step, see below "Base case A - *All* parameters are known" and "*Base case B* - *unknown run parameters*". Every component: register, wire and logic use a certain amount of silicon area *A_{silicon}*. Computations formed from parallel gamma-nodes must be present in the design and cannot be reused to reach the physical limited combinational computation only limited by the propagation time *t_{propagation}* defined by the needed operation and the physical limits computing binary operations.

Each component needs some silicon area:
- Logic: The needed area is a function of how the data size of the computations are represented as logical gates *S_{logic}*, which is a function of the complexity of the operations (logic) and the data types. This can be gained by synthesis using state-of-the-art tools. ${S}_{logic} = f \left({n}_{instructions}, {S}_{data nodes}\right)$
- Registers: The register *S_{reg}* are needed for the synchronisation and stabilise the transfers between the logical instances. They use silicon area depending on the number of data nodes and their types. ${S}_{reg} = f \left({n}_{data nodes}, {S}_{data types}\right)$
- Wires: they needed to connect the cells in form of wires *S_{wire},* where wire are depending on the amount of data notes to transfer and their data type.
${S}_{wire} = f \left({n}_{data nodes}, {S}_{data types}\right)$

Therefore, the total used area is defined as: ${A}_{silicon , total} \approx \sum {A}_{reg} \left({S}_{reg}\right) + \sum {A}_{logic} \left({S}_{logic}\right) + \sum {A}_{wire} \left({S}_{wire}\right)$

These values can e.g. be derived by state-of-the-art synthesis-tools based on RTL code. They also include place and routing on a target device, e.g. FPGA or ASIC. In addition, they can model the different propagation times per combinational step *t_{prob}* with high resolution.

***Finite states:*** Each level in the Gamma-Graph corresponds with a well-defined state, therefore each step is distinguishable, see figure 131.

***Including I*/*O:*** The states include the option to use communication via I/O or available RAM cells to communicate with other platform components, see figure 132.

**Clocking:** The clock driving, respectively synchronise the logic steps and the I/O operation is a function of the optimal choice as a function of the different propagation times *t_{pb,i}* of the levels in the gamma-graph, see figure 133. The *t_{prob,i}* can be modelled and estimated quite exactly during synthesis. All the synthesis step from RTL definitions to *t_{prob,i},* place and route steps are fully automatically by state-of-the-art tool-chaines. This results to be able to generate needed Phase-locked loop (PLL) signals, respectively adjust the clock frequencies needed for the different cell types, see CLK1, CLK2, CLK3 in figure 133.

***Summarize:*** The gamma-graph defines all properties needed to transfer a given code from a high programming language to a synchronous IC-design, usable e.g. on a FPGA. The up till now introduced designs with each state transferred into cells would be not practicable, respectively a waste of the available area by using for each stage distinguished registers. The schematics are needed to illustrate the principle of transferring a gamma-graph into a synthesizable RTL-design.

***Applications:*** The gamma-graph can now be used in two different applications:
I. Use the area (e.g. on a FPGA) to compute how many parallel CBs are possible. This means to apply parallel instances for parallel CBs on one level in the gamma-graph. By this, a parallel execution of the CBs can be reached having an optimal propagation time per level *t_{prob,i}* and depending on place and route, which is given from available state-of-the-art tools (and reachable optimisation possibilities) an optimal execution time for the complete gamma-graph. This can improve the parallelisation and exploiting of ILP especially for loop-sections, which have often high parallel computational demand. The information contained in the parallel CBs are transferred in a corresponding RTL-code, which includes the following steps:
   a. In a loop, parallel CB(s) with the same logic are built and this defines an instance per CB
   b. The instance (= 1 CB) is initiated as many times as possible only limited by the available cells, respectively silicon area *A_{silicon}* on the target device
   c. Each cycle computes the instances in parallel and generate from the defined input register a corresponding result in the output register.
   d. This register can be used (i) for the next loop or in case of limited area (ii) transferred to other units or a host platform to reorder and saving data.
II. Build an optimised static multiple issue CPU pipeline design with IP-blocks based on a given input code fully automatically. The number of parallel pipelines and corresponding register-sizes is optimised according to the code by distributing the available area between area needed for parallel pipelines and area for register / cache registers. As input is used the code as well as the choice of ISA. The ISA abstracts hardware properties (such e.g. the size of needed pipeline registers, wiring between the components, e.g. Program counter, Registers, ALUs, needed functions in form of opcodes for the hardware defining logical operations on registers for given instructions, etc.). This includes:
   a. Defining from gamma-graph optimal number of pipelines and register sizes
   b. Creating a design formed by available known basic components: Program Counter, Instruction memory, Registers, ALUs and data memory. These components are today available as IP-cores. These IP-cores define also already the needed area on a target device (FPGA or ASIC).
   c. Defining the compiler definitions for the backend
   d. Producing static, optimised assembler code for the custom multi-pipeline CPU

### (B) IC-design with maximal parallel CBs

In loop sections the method provides a series of parallel, equal CBs, see figure 126 (b) for each *nₗₒₒₚ* iterations. Figure 134 illustrates getting from gamma-graph to an RTL-definition. Gamma-graph in loop sections are completely defined by different states and corresponding transfers, see figure 127. These transfers resulting in different wiring for different phases in the gamma-graph of loop sections, see figure 135 illustrating phases in gamma-graphs of loop-sections and correlating unrolled RTL-design.

The graph illustrates the different types of transfer within a loop and the different wiring in a corresponding IC-design.

It is not given, that a given loop-section can be mapped on the available area *A_{silicon}.* In such situations, different cases have to be distinguished. The main are:
- Base case A - All parameters in the code are known - there are no not-known runtime-parameters during compile time:
   In this case an optimised design with *A_{silicon,optimal}* between area for register and cells used for logic computations can be derived. This area can be on one device or on several connected by I/O-communication.
- Base case B - There are unknown runtime-parameters during compile time: The area can be used to provide as many as possible parallel instances to solve the parallel CBs. This intends to use the area to optimally solve as many as possible parallel CBs. The data mapping must be provided by a driver application, which also feeds the execution and handles data mapping, in case the amount of parallel computation blocks is higher than in one step can be solved on the FPGA. This needs additional silicon area.

From the previous sections it is known that computation blocks define the logical effort and therefore the delay by *t_{propagation}.* The target device (FPGA or ASIC) defines the physical properties reachable for a given resolution *λ*. This defines then the capacity of the gates *C_{g}* in one instance and the needed area.

There are more cases with other optimisation target functions, which are a mixture of above basic cases, e.g.:
- Case C - Hybrid Parameters with partially known parameters:
   In some designs, certain parameters may be known ahead of time, while others vary at runtime. This scenario requires a hybrid approach, where static optimization is applied where possible, but dynamic allocation strategies are also implemented, in case the reconfiguration of the FPGA during runtime is beneficial.
- Case D - Adaptive designs:
   Reconfigurable Computing: FPGAs are inherently adaptable. Designs might leverage partial reconfiguration, where parts of the FPGA are reconfigured on-the-fly to better suit the changing computational needs or to pivot between different types of computation blocks based on runtime data.
- Case E - Performance vs. power consumption - balancing efficiency:
   Another case involves balancing performance with power consumption. Depending on the application's requirements, it might be necessary to sacrifice some computational speed for lower power consumption, or vice versa, influencing how the silicon area is utilized.
- Case F - Fault tolerance and redundancy - reliability considerations:
   For critical applications, some portion of the FPGA might be dedicated to fault tolerance mechanisms, such as redundant computation blocks or error correction codes, which affects how the available area is allocated.

### Base case A - All parameters are known

In this case *n*_{∥} can be calculated during compile-time based on static code analysis and is constant. The maximal parallel instances useable on a target device can be found iteratively by synthesizing first one instance, then e.g. 5 and extrapolate the resulting statistic of the synthesis-tool to define what the maximal possible number of parallel instances on a given device *n*_{max∥*device*} are.

In case *n*_{max∥*device*} ≤ *n*_{∥} the "data in" registers can be optimised only containing the unique input data, see figure 136. If parallel CBs can be combined, their register size can be reduced, but their combinational complexity benefits only minimally from combining the instances. The reason is that each parallel CB is needed and at the same time are independent computations and therefore, cannot be reused (under the here defined targets of an optimised design for speed). In such situations, each clock cycle leads to computed one *nₗₒₒₚ*-iteration and all parallel CBs per iteration are computed in one step / cycle.

### Base case B - unknown run-parameters

In contrast to situation when n_{max∥*device*} > *n*_{∥}. In this case either an additional buffer-register is introduced to save the first part-iteration with two CBs here and then compute the one remaining CB and compose to the result. In this case the result of the first two parallel CBs must be kept in a buffer-register with *S_{reg,Buffer}.*

Or use a host, e.g. a CPU with memory, where after each cycle the host coordinates the results per cycle using local memory to store the results and provide correct "data in" and "data out". A compiler must do a remapping depending on *n*_{max∥*device*} and the reduction of the sizes of each in-registers per CB cannot be done. The IC-design comprises the maximal number of parallel instances, each with a separate register to hold all needed data per CB / instance. In the first solution (figure 137), the additional latency is Δ*t_{delay} =* 2 · (*t_{propagation}*). This solution needs additional buffer-registers with size *S_{reg,Buffer}.* In the second solution (figure 138), there is no need for additional buffer-registers, but an additional *Δt_{delay}* = 2 · (*t_{propagation}*) + 4 · Δ*t_{bus-transfer}* occurs.

This shows how the inventive system and method is able to relate additional silicon area A_{Silicon} for buffer-registers S_{reg,Buffer} to latency times for data transfer Δt_{delay}.

There is a link between the buffer-register size and the number of parallel CBs *n*_{∥}. The needed buffer-size is: ${S}_{reg , Buffer} = {n}_{∥} - {n}_{\left.max\right‖ instances} = {n}_{buffer - register} ⋅ {S}_{data type}$

This is a crucial dependency between the area used by the logic of an instance *A_{logic}* compared to the size of *A_{silicon,reg}* = *f*(*n_{buffer-registers}*) to balance / optimise / minimizing used silicon area *A_{silicon}* between speed and power as a function of the target device (FPGA-types or ASIC). This enables to optimize the needed area for a buffer-register A_{silicon,buffer-reg} compared to an additional istance A_{logic} and to the latency times to a host platform or inter-device connection Δt_{transfer}.

In case the size for a buffer register is smaller than one instance *A_{Buffer} < A_{instance},* the delay can be reduced by: $Δ {t}_{delay} = Δ {t}_{delay , no buffer} - Δ {t}_{delay , buffer} = 2 ⋅ Δ {t}_{bus - transfer}$

FPGAs can be programmed to use their I/O pins to build a cluster or to communicate with each other by using from serial buses to Peripheral Component Interconnect (PCI) to proprietary Serial Digital Interfaces (SDI), etc, see figure 139. In this form there is a big flexibility to build an optimal *A_{silicon}* for a given number of parallel CBs *n*_{∥}.

### Example

The parallel CBs for the three-level-nested loop are used to calculate a discretized 2d diffusion equation can be derived using the novel method. Each CB has 5 reads and 1 write to compute the stencil for one mesh node: ${t}_{f} = γ ⋅ \left({t}_{a}+{t}_{b}+{t}_{c}+{t}_{d}-4⋅{t}_{e}\right) + {t}_{e}$

Each CB computes this equation to derive a result *t_{f}* which is the evolution of the diffusion in time over the spatial mesh.

Figure 140 shows the "*in_memory*", which is filled up with values from a host platform using the Universal Asynchronous Receiver Transmitter (UART) protocol to transfer the start values to the FPGA via serial connection. A CB can be transpiled e.g. to a Verilog code describing how data is transformed as it is passed from register to register (i.e. RTL description), see figure 141. The RTL definition of the CB results in a logic description of the computations, see figure 142. Depending on the number of mesh points, the gamma-graph can be used to derive the corresponding needed transfers between the registers "ff1_in", "ff1_out" and the wires after each iteration. Each output of an instance is routed to the correct input "ff1_in" with assignment of ff1_in[N] <-> tf_cmpN, see figure 143. The input of the instances (.ta, .tb, .tc, .td, .tf, .te) and the output (.tf) are placed according the "inner-loop mapping phase", see figure 127, respectively figure 135. Following figure 136, the parallel CBs for the 2d heat equation were tested on an iCESugaer v1.5 device, which has an "iCE40UP5K-SG48 FPGA" with 5280 Logic Cells. Four different meshes with increasing resolution *nₓ* x *n_{y}*: 5x5, 7x7, 9x9 were computed. For precision a 1 byte = 8 bit fixed point representation was used and to transfer data to and from the FPGA, an UART implementation via serial USB connection was implemented. This demonstrates the linear dependency of increasing of number used cells for logic and routing with increasing mesh resolution, respectively needed instances. AI 4 implementation have the same, constant computing time - the propagation time *t_{propagation}* to compute one stencil on this FPGA, see figure 144. Each iteration of the needed *nₗₒₒₚ* was solved by one cycle. The results (figure 145) correspond with the values computed with the same resolution on a CPU.

### Benefits and new limits

There is physically not possible to compute a sequential series of instructions faster than with an optimised combinational logic without sequential steps for storing data, which needs a clock and transfers by additional wiring. Therefore, the code represented in a gamma-graph formed by the novel method is a representation / segmentation of the code, which groups the fastest form of computing instructions in the CB segmentation (RAW) and provide information of the needed data / signal transfer between these CBs. Additionally, this implies also, that this segmentation - when enough silicon area is available for the logic - represents the grouping of instructions with the minimal energy consumption possible - under the premise the chain of RAW instructions is synthesised to an optimal gate logic concerning energy and the frequency and voltages are chosen accordingly. This leads to some advantages compared to state-of-the-art methods in synthesising code from high program to synchronous FPGA designs fully automatically:
- A gamma-graph in granularity *G*₀ is like a blueprint for an RTL description for a synchronous IC-design, where the combinational part are the CBs with instructions with Read-after-Write dependencies, what enables a physical computation in the propagation time *t_{propagation}* of the logic in the CB.
- The graph represents finite states in repeating order: compute -> transfer -> ....
- An optimal clocking is defined by the *t_{propagation,i}* of i stages
- If there are too large differences in *t_{propagation,i}* they can be homogenised by adding sequential steps in the CBs -splitting a chain of RAW instructions is trivial / makes no difference where to split
- By using the maximal amount of parallel instances on a given device (FPGA or ASIC), the corresponding mapping of the potential remaining parallel CBs can be done by a driver software on a host-platform.

### (C) Custom static multiple issue CPU Design

### CPU components

This section introduces the basic components for state-of-the-art pipelined CPUs. Modern CPU have multiple issue (meaning parallel pipelines, mostly separated for Floating Point Units, Integer Units, Load and Store, etc.) and a pipeline-depth / pipeline-stages of 6-14 stages. The more steps, the higher the frequency can be reached, as each step has a lower propagation time, but especially branch miss lead to longer stalls.

The next sections introduce shortly how the three basic instruction types (i) reg-instruction to load and store data from memory to / from registers, (ii) ALU-instruction to compute arithmetic instructions, and (iii) branch instructions can be implemented in 5-step pipelines, rely on work described by. This approach enabling out-of-order execution, are in many different realizations incorporated in state-of-the-art superscalar CPUs. This enables to demonstrate how these basic components can be used to compose a "cell-based-design" based on available commercial / licensed IP-blocks for a given code fully automatically. These blocks have a known size and functionable design (successfully synthesized and tested intensively). Based on these "predefined components", the gamma-graph derived with the novel method can be used to compose a custom multiple issue CPU based on an input code written in a high programming language automatically with a generic, implementable process. This enables a custom static multiple issue CPU design optimised to one code.

The gamma-graph is used to define:
a) The optimal number of parallel computing - pipelines compared to available area. Therefore, the available parallelism in code is used to balance between latency of computing and latency for caching / data memory access, see section Base case B - unknown run-parameters.
b) The ideal size of registers for each pipeline
c) The size of buffer registers, meaning additional registers
d) Using extensively the forwarding from the stage after the ALU operation to use the result directly again for the next ALU operation, as all Computation Blocks have RAW dependency
e) Lower needed silicon area for needed hardware components in today's CPUs for exploiting ILP by the hardware:
   a. dynamic instruction scheduling hardware components, as no single instructions are scheduled, instead Computation Blocks. These blocks can be statically scheduled by the compiler.
   b. Generic cache structures, as the compiler-backend is able to optimise the code on the available registers / buffers. Each Computation block defines a pre-defined register-association. This enables to precompute the register naming during compile-time for the optimised multiple pipeline design.

The novel method enables to build static multiple issue CPU designs with an optimised number of parallel computing pipelines *n*_{∥}*ₚᵢₚₑₗᵢₙₑₛ,* where the silicon area needed in state-of-the-art CPUs for dynamic scheduling and caching can be replaced with more pipelines to compute faster and / or minimize energy consumption. Using the gamma-graph to define the corresponding backend of a compiler enables to generate assembler-code by statically scheduling Computation Blocks. This has a lower complexity than scheduling single instructions, which is already a NP-hard problem for a few different units. This leads to a custom static multiple issue CPU design with automatic adapted compiler-backend and enables to generate optimise multiple issue CPU designs, customized to an input code from higher programming language (compiled and interpreted).

### Cell-based design

"Cell-based design uses a standard cell library as the basic building blocks of a chip". These basic building blocks provide functional synthesized layouts with a known area *A_{silicon,cell}* , optimal frequency *f_{sw}* and voltage *V_{DD}.* They can be used to create pipelines with appropriate ALUs, registers and preferred designs for target I/O connections.

### (i) Theory

Using multiple issue CPU without dynamic scheduling hardware support (e.g. Tomasulo's algorithm), means that the scheduling must be done by the compiler. But as the novel method is able to exploit more ILP than state-of-the-art compilers, the method enables to form Computation Blocks, which form of scheduled instructions. This leads that not a single instruction scheduling is needed, instead the CBs have to be scheduled. It is known for codes in Basic Block notation that Basic Blocks not in loop sections, not more than 3-4 parallel instruction are in parallel [Limits of instruction level parallelism, D.W. Wall.pdf]. Therefore, segmented codes do not contain more than 3-4 parallel CBs. For loop-section the parallel CBs are described by properties: parallel CBs *n*_{∥}, needed sequential loop iterations *nₗₒₒₚ* and instructions in the (constant) CBs. So, for all code sections (Basic Blocks in a Control Flow Graph) it is feasible to create a gamma-graph with the novel method. Multiple issues CPUs are CPUs with multiple pipelines. This enables to compute instructions superscalar. (Cycle Per Instruction CPI < 1). Data and control dependencies are a problem to run instructions in parallel. The novel method is grouping instructions to Computation Blocks and the compiler has to schedule the groups of RAW-instructions, which has not the same complexity than scheduling single instructions. If a compiler takes care about the scheduling of the instruction, this is called static (multiple issue CPUs). The compiler can detect and avoid hazards and therefore the novel method provides CPU designs not needing hardware support for dynamic instruction scheduling nor complex cache structures. This frees silicon area useable to add more parallel pipes or larger register per pipeline enabling to store and load parallel executable instructions faster. By this, more parallel CBs can be solved in parallel. Computing instructions in a CB is on a pipelined CPU a consecutive computing one (some instructions need more than 1 cycle - what is known during compile time) instruction per cycle. Instructions in parallel CBs can be therefore computed in parallel. The novel method allows to generate multiple issue CPU pipelines from IP-cores and compile then the code accordingly (static). As more information about parallelism in code is gained during static compiling more instructions can be scheduled optimised by the novel method. Also to get an optimal number of parallel pipelines, corresponding ALUs and register-sizes, the analysis of the gamma-graph stays bounded, especially as the CBs in loops, as well as how many parallel CBs can be computed can be gained as a function of the distance vector *̅r̅w̅*̅ of a statement and linked to loop-parameters.

### (ii) Example MIPS instruction set

To command a computer, the language must be understood by the hardware. The words are called instruction sets. Their definition links directly to some hardware components. E.g. to fetch an instruction line in a pipelined CPU, the register between the fetch and decode stage must be at least of the size of the instruction line length. A popular instruction set is the Microprocessor without Interlocked Pipelined Stages (MIPS). This is instruction set architecture (ISA) of the reduced instruction set computer (RISC). The following descriptions assume the use of the MIPS ISA.

### (iii) 5-stage pipeline

The novel method has no direct influence on branching, respectively on the effectiveness of branch prediction. As it bases on static compiling, the novel method enables to reduce some potential load and stores compared to other designs, but stalls on false predicted branches and the needed flushing of the pipelines stays as a problem like in state-of-the-art designs. Therefore, in the next paragraphs only the r-instructions and I/s instructions are shown. They are needed to show why register-size per pipeline *S_{reg}* is a crucial property extractable from the gamma-graphs. (see figure 146 showing storing (and loading) as (a) IC-design (b) pipelines version.) Storing data needs to calculate the address in the data memory from offset in the instruction to the register-number $t1. The data is accessible in minimal 2 cycles (using the forwarding of the MEM/WB -> MUX -> reg 2 ALU). Storing is the same process, but is less latency sensitive, as stored data is by the rules of the novel method not been used immediately after the storing. The methods take a store and an immediately as a transfer and therefore is covered in the gamma-graph. It is important how many cycles are needed to load the data from a memory bank to the register. In state-of-the-art CPUs a cache-layer is placed between the pipeline and the physical memory. This can significantly reduce the data access latency and inter-CPU-core transfer, but cache miss still then escalate through all cache-levels and lead to longer latencies. Furthermore, cache is loaded in chunks of the cache-line-length - so a cache manipulation / miss relates to a store, respectively load latency for data with cache-line-length - this can have negative impact e.g. when addressing (or allocate) arrays in loop not relative to the cache-line. (see figure 147 showing arithmetic (R) operation as (a) IC-design (b) pipelined version. Indicated Forwarding to use results from a previous instruction in the next cycle.) Important to note here is that for the novel method a "Forwarding" option for R-instructions is crucial, as the instructions in the Computation Blocks have RAW dependency, what means the result of the proceeding instruction is always needed in the next instruction. The forward unit enables using hardware by comparing the rd-field in the MEM/WB-stage with the rs and *rt* field in the ID/EX-stage. In case both are the same - this means instruction in MEM stage wants to write to register *rd* and instruction in EX wants to read rd with rs or rt connect the ALU correctly. This can be implemented by hardware component Fordward Unit and by logic comparing the bits from the entry in the instruction and comparing instructionbits->EX/MEM[15:11] = instruction bits->ID/EX[25:21] @ Reg1 ALU and = instructionbits->ID/EX[20:16] @ Reg2 ALU. For this the *rs* and rt fields in the instruction must be passed along the stage registers.

### (iv) Cache vs. buffer

In modern state-of-the-art CPUs, different layers of cache are between the pipeline and the external memory. This cache needs additional silicon area *A_{silicon,cache},* but can reduce the latency to load data, which is reused compared to a full load using I/O bus to external memory drastically. The cache latency is beneficial, when the register sizes are too small to keep repeated used data. Therefore, the register size are critical properties as they have the lowest load and store latency characteristics in the pipelined CPU but are limited in space. In each Computation Block, the instructions are known, and the register order can be specified during compile time during the static scheduling. This can be done, when the number of parallel pipelines *n*_{∥*pipelines*} and the available register size *S_{reg}* are known. As the dependencies between ILP and runtime-parameters can be determined during compile time and block of instructions are scheduled by the compiler in this novel approach, the focus is on finding an optimal size of buffer-registers. Therefore, the approach is primarily not using cache (or not only), instead optimises the data access by making additional buffer-registers available. The size of these special registers is optimised to the latency time to store and load data, respectively to the I/O characteristics of the target platform. Stores of data nodes which are been used in a later stage on the same pipeline (on the same row but in a later column in the matrix) can been stored in these additional buffer-registers. This enables a faster access to these elements than the store and load to external cache / memory. The gamma-graph can be used to optimise the size of such buffer-elements as a function of the number of parallel pipelines *n*_{∥*pipelines*} and the latency time characteristics to external memory as a function of runtime variables params.

### Gamma-graph and use of the pipelines

For non-loop CBs and the known limits of ILP in Basic Blocks, the gamma-graph with granularity *G*₀ defines a first solution. The maximal parallel CBs per level define *n*_{∥*pipelines optimal*} and the maximal number of data nodes in CBs defines *S_{reg}*. This register size is needed to compute in parallel the CBs on one pipeline. The power efficiency can be taken into account to only schedule CBs in parallel, which have enough parallel instructions. This can be derived by the difference in number of instructions of parallel CBs per level. Such optimisation steps are in the gamma-graph bounded, as level for level (except for loop-sections, where the CBs per level can be expressed by parameters) can be analysed.

In case there is not enough silicon area *A_{silicon}* to implement *n*_{∥}*_{pipelines optimal},* the maximal number *n*_{∥}*ₚᵢₚₑₗᵢₙₑₛ < n*_{∥}*_{pipelines optimal}.* In non-loop sections, branching prevents an efficient preloading over many basic blocks due to the sensitivity to the pipeline-length [bp.pdf]. After a wrong preloaded branch, all the already processed pipeline-stages must be emptied. Longer pipelines enable higher frequencies, as their propagation time is lower, but introduce more latencies in case of wrong branch prediction. In contrast are loop-section. Therefore, the pipeline-stages are an optimisation step depending on the complexity of the ALU, which can also be a function of the code and parallel instructions available. This is covered by state-of-the-art methods to produce corresponding ALUs, respectively is covered in the selection process of the IP-cores.

For loop-sections which often also depend on runtime-parameters, the optimal parallel pipelines *n*_{∥*pipelines optimal*} can be large. Therefore, the *n*_{∥*pipelines*} is defined by the balance between accessing data, respectively store and load data to the pipelines and the number of *n*_{∥}*ₚᵢₚₑₗᵢₙₑₛ.* Buffer-register are introduced for code sections with more parallel CBs *n*_{∥} than can be scheduled to different pipelines in parallel. In this case, the novel method enables to find an optimal size of buffer registers (register accessible in one cycle for the pipelines) as a function of the latency to external, much slower memory (I/O) and the amount of needed, parallel computing effort defined in the code and expressed as parallel CBs. The novel method can exploit more ILP than state-of-the art methods during static compiling. This additional information can be used to optimise the buffer-size as a function of runtime parameters in the input code to the available silicon area *A_{silicon}.* Furthermore, complex hardware for dynamic scheduling is not needed and the buffer registers can replace cache-approaches, respectively reduce the size of cache-areas. When an optimal buffer-size compared to latency to load data from external memory was found, the static scheduling of the CBs allows to schedule load and store data instructions in balance with the parallel computing times to registers and keeping the buffer available for short load and stores.

By the inventive system and method (creating gamma-graphs) an optimised balance between register-size, the number of parallel pipelines can be defined as a function of available silicon area and latency to external memory for a given software code written in a high programming language in bounded / analytical optimization-steps. With state-of-the-art CPUs with different levels of cache, this can be reached by cache-conscious programming. The novel method enables to find a balance automatically with numerical methods based on the input code and available silicon area. This includes four steps:
1. Define a minimal register size *S_{reg,min}*
2. Define a minimal amount of parallel useful pipelines *n*_{*min*∥*pipelines*} for a given parallel efficiency *ε* factor for CBs not in loop-sections. By the efficiency factor the balance between speed and power can be adjusted to the target goals.
3. In case there is free silicon area available and loop-sections in the code with potential high computational demand, the free area can be optimised as a function of number of parallel pipelines *n*_{∥}*ₚᵢₚₗᵢₙₑₛ,* register size *S_{reg}* and latency to external memory.
4. This results in fixed parameters *n*_{∥*piplines*} and *S_{reg}* for the available silicon area *A_{silicon}.* which enables to schedule the computation blocks optimally to these parallel pipelines *n*_{∥*piplines*} and using the registers *S_{reg}* optimally.

### (i) Pipeline register size

It is possible to derive over all levels of the gamma-graph the maximal register-size needed to compute the instructions for all parallel CBs of a level. This defines the minimal size of the register for each pipeline. This guarantees that all instructions in one CB can be computed without stalls: ${S}_{reg , min} = {max}_{i ϵ \left[0, {n}_{CB}\right]} \left({S}_{data type}⋅\left({n}_{datanode , CB , i}+1\right)\right)$

In case all pipelines have access to the registers and all pipelines have the same ALU, the optimal scheduling of the CBs stays numerical bounded. For scheduling it is important, that for one CB, all data is available in the registers of the pipeline. And each CB produce 1 output after calculated all RAW-dependent instructions, see figure 148: ${S}_{reg , stage , out , Γ 2} = {S}_{data type , 2 a} + {S}_{data type , 2 b}$

### (ii) Estimate buffer size

Parallel gamma-nodes have to be scheduled to the available pipelines; each CB needs a register-size *s_{reg,in,CB}* = *f*(*n_{data nodes}, S_{data types}*). Computing the instructions in a gamma-node / CB leads to one defined new data node as a result *S_{reg,out,CB} = f*(*S_{data type}*). If it is possible to compute all CBs of a level on parallel pipelines then each CB is run in parallel, there is no more optimisation possible for a pipelined CPU. For CBs not in a loop section, branching limits mostly loading and storing static optimization strategies, respectively known method solve this already very effective with software and hardware for branch prediction. This contrasts with the case, when not all CBs can be computed in parallel due to limited parallel pipelines *n*_{∥}*ₚᵢₚₗᵢₙₑₛ.* In this case, the optimisation step - in our case - the compiler needs to find a balance between loading data and computing. Because some (or all) of the data nodes computed in parallel could be needed in the CBs of the next gamma-graph-level, but as not all CBs are computed in parallel, the interim-results must be kept. This is in case of loop-CBs for example in the next iteration for the interloop-transfers, see figure 149. Based on the number of parallel CBs *n*_{∥} on one gamma-graph level, a relation to the number of parallel pipelines can be derived: ${n}_{buffer reg} \left({n}_{∥}\right) = {S}_{data type} ⋅ {n}_{∥}$

This equation links the size of needed buffer-register to prevent stores and load via cache / memory in sections where *n*_{∥} *= f(params) > n*_{∥*pipelines*}. The value *n*_{∥} is mostly depending on runtime-variables. There will be also a free silicon area limit for buffer-registers. This limit can be balanced against the latency to load and store data to external memory.

### (iii) Computation effort

Each CB contains a series of instructions with Read-after-write dependencies. Each cycle at least one instruction (or also instruction with more than one cycle) in the CB can be computed without any stall. Forwarding is important, as after each cycle the result is needed in the following instructions. The number of *n*_{∥} CBs per level defines therefore the maximal optimal number of parallel pipelines *n*_{*max*∥}*ₚᵢₚₑₗᵢₙₑₛ.* (see figure 150 illustrating scheduling Computation Blocks to parallel pipelines). By comparing on each level of the gamma-graph the difference number of operations *n_{op,CB}* between parallel CBs, CBs with a minimal parallel efficiency *ε* can be selected: ${n}_{∥ CB , eff} ∈ \frac{{n}_{op , CB}}{\left(max {n}_{op , CB , level}-{n}_{op , CB}\right)} \geq ε$

To automatically select an optimal parallel efficiency *ε*, the available frequencies (cycles per time unit defines *nₒₚ* per time unit) of parallel pipelines result in a speed-increase using a given *ε* directly. Using these speed-ups as a function of different *ε*-levels in contrast to unused pipelines define an optimal efficiency *ε* in the balance between speed (*ε*=1) and power efficiency. See Delay and power dynamics in transistors, the static power loss is a function of the current and voltage *Pₛₜₐₜᵢₑ*(*Iₛₜₐₜᵢₑ, V_{DD}*). The switch power (dynamic power) is a function of capacity, voltage, and frequency: ${P}_{switch} = C ⋅ {V}_{DD}^{2} ⋅ {f}_{sw}$

Capacity is directly influenced by the gate configuration in the stages and wires. This let balance numerically the efficiency *ε* between unused pipelines (known from gamma-node) and maximal speed-up with *ε*=1 and *n*_{∥*pipeline*} = max*n*_{∥}.

### (iv) Define optimal parallel pipelines

Defining the optimal *n*_{∥}*ₚᵢₚₗᵢₙₑₛ.* two steps are needed:
In a *first step:* for CBs not in loop-sections (parallelism by ILP is limited) the *n*_{∥*CB,eff*} can be defined an: ${n}_{∥ piplines , min} \left(ϵ\right) = {n}_{∥ CB , eff} \left(ϵ\right)$ *n*_{∥*piplines,min*} defines the optimal parallel pipelines to exploit ILP in Basic Blocks not in loop-sections, in case of *ε* = 1 optimally. Additionally, to the area for the pipeline components, the register size is defined by *S_{reg,min}*. The available area *A_{silicon}* limits the final number of possible parallel pipelines *n*_{∥*piplines*} with needed register size *S_{reg,min}*. In case there is free *A_{silicon}* with *n*_{∥*piplines,min*} and *S_{reg,min}* and the minimal needed components (Program Counter, Hardware Forwarding, branch support, registers, data and instruction memory), the design can be optimised for loop-sections where more parallel CBs can be used than the minimal parallel pipelines *n*_{∥} *> n*_{∥*piplines,min*}. In this case a second optimisation step can is needed:
In a second step: Balance between adding buffer-register *n_{buffer,req}*, latency times to load / store data nodes in memory and increasing *n*_{∥*piplines*} to lower the sequential computing time. This is the same as in section Base case B - unknown run-parameters and mostly only the case for loop-sections. (see figure 151 illustrating the distribution of parallel CBs and link to needed registers and compute time.) The number of parallel CBs per level in a loop is mostly a function of runtime-parameters *n*_{∥} = *f*(*params*). Based on *n*_{∥} the number of needed operations in parallel can be derived:
${n}_{total op ∥} = {\sum }_{i = 0}^{{n}_{∥}} {n}_{op , i}$

The average number of operations is a function of available parallel pipelines *n*_{∥*pipelines*}: ${t}_{compute} \left[cycle\right] ≅ {n}_{average op per pipeline} \left({n}_{∥ pipelines}\right) = \frac{{n}_{total op ∥} \left(params\right)}{{n}_{∥ pipelines}}$

This gives an approximated function about the runtime, respectively cycles to compute the parallel CBs *n*_{∥} as a function of the number of parallel pipelines *n*_{∥*pipelines*}. The number of parallel pipelines *n*_{∥*pipelines*} define the needed additional registers - each parallel CB results in one additional register space with size *S_{data type}*: ${S}_{+ bufferreg} \left(params, {n}_{\left‖pipelines\right.}\right) = {S}_{data type} ⋅ \frac{{n}_{∥} \left(params\right)}{{n}_{\left‖pipelines\right.}}$

The store-load-time *t_{memory}* for this data size can be approximated: ${t}_{memory} \left[cycle\right] ≅ f \left({S}_{+ bufferreg}\right)$

This time is depending on the hardware characteristics of the I/O communication by bus to and from memory. The optimisation for the number of parallel pipelines is given with the optimisation function: ${t}_{compute} \left[cycle\right] \geq {t}_{memory} \left[cycle\right]$

This relates the data size *S_{data type},* params, the number of operation in each CB *n_{op,i}* (combinational effort) to the number of optimal, respectively critical pipelines *n*_{∥}*_{pipelines critical}.* More parallel pipelines than *n*_{∥*pipelines critical*} do not improve the efficiency of using the silicon area to compute CBs in parallel for the given code and constraints in I/O properties. There will also introduce a critical problem size *params_{critical}* by the corresponding parameters, respectively number of loop-iterations. Above the critical size, the multiple issue CPU will be bounded by I/O to external memory, optimal is the area used for the problem-size with *params_{critical}*.

### (v) Load / store as a function of buffer-register-size for static compiling

The gamma-graph enables to schedule of Computation Blocks, instead of instructions. Each CB contains a series of RAW dependent instructions, which can be computed without any stall. To optimally schedule the latency of store it is crucial that the hardware enables as derived in the last section: ${t}_{compute} \left({n}_{op , {stage}_{k}}\right) \geq {t}_{transfer} \left({n}_{load , {Γ}_{stage , k + 1}}\right)$

The load of the data needed in Γ_{2,*a*} should be transferred during computing Γ_{*stage*,*k*}, see figure 152.

Correct handling the load and store for each CB are important. The more the available registers can be used, the faster the code. Each CB knows the number of instructions to compute *n_{op,CB}.* Defined by the transfers (edges in the gamma-graph) for each data node is known from to where the data has to be transferred. Based by the constraint, that the design is targeted that loading a CB before to use the time to compute to load the data from external memory in case needed, the step for the compiler is to decide if the data to load is already on a register or not. Furthermore, when stored, to store on a register and / or to store at a memory location. By this procedure, it can be prevented that scheduled CBs stall because of latency to load data. Transfers between CBs can lead to:
- Store to memory -> load from memory -> smem / Imem
- Store to register -> load from register -> sreg / Ireg

Each data node of an actual CB has enough space in register, which is a constraint of the proposed design. It is for example possible to decide CB by CB (in loop-CBs - there this is *n*_{∥} given by a function and in case needed as a function of runtime parameters *n*_{∥} *= f*(*params*)) to define the read and write register for the instructions and add load and store according to the register size.

### I. Approach I - dynamic adapted multiple issue CPU

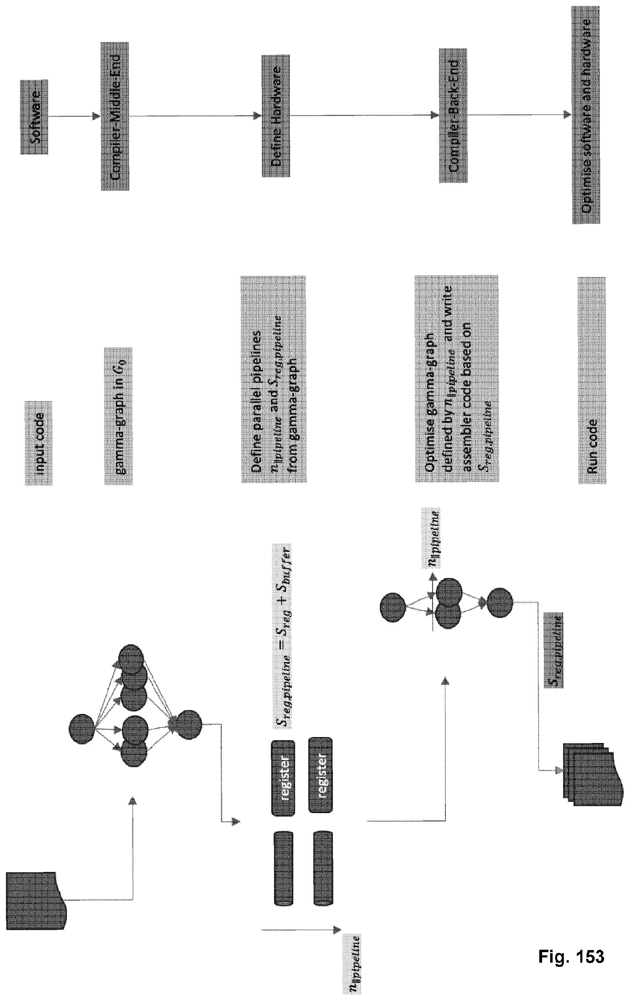

In five steps the novel method can be used to create a multiple issue CPU design using cell-based designs and adapt the backend of a compiler framework to create optimised assembler code for the specific design, see figure 153. In this form, the novel method creates a fully automatically design and corresponding compiler for a given input code based on the CPU-design principle of a static multiple issue CPU architecture. This can target FPGA and ASIC applications. The five steps are:
1. A given input code is analysed by the novel method
2. A gamma-graph in granularity *G*₀ is created and can be analysed with bounded numerical methods
3. Based on the choice of an ISA: available components for a pipelined CPU design (cell-based design) can be selected and composed to reach a) needed register-sizes per pipeline, and an optimal number of parallel pipelines *n*_{∥*pipeline*} is computed.
4. Based on this configuration, the code can be compiled by a corresponding backend-end in the compiler
5. This results in compiled code for an optimised multiple pipeline-CPU: static multiple issue CPU.

### II. Approach II - A generic static multiple issue CPU design

Another use-case is to combine the method to optimise any given code to a generic multiple issue CPU design with special pipeline configuration. The method

enables to extract more information from source code to use for auto-parallelizing than SOTA methods. Therefore, more scheduling work can be done by the compiler and has not to be covered by any hardware components. The following points prevent to static schedule instructions for SOTA compilers:
I. Cache misses: predict for stalls not possible.
   → Solution: hardware components for dynamic scheduling to hide this problem from compiler
II. *Order* of *instructions* by branching: Miss of a branch makes it necessary to flush pipelines.
   → Solution: hardware support for dynamic branch prediction
III. *Pipeline latencies:* Each modern CPU differs both in issue width and latency.

Dynamic scheduling, branch prediction and complex cache-hierarchies are important hardware-side components in modern CPUs to exploit Instruction Level Parallelism (ILP). As the method exploits more ILP than SOTA methods, the three topics I) - III) can be addressed different by a fixed generic multiple issue CPU design with static scheduling by the method. This enables to free silicon area needed today for branch prediction, dynamic scheduling and complex cache hierarchies and be used to improve the compute performance.

### (vi) Instruction Scheduling

The inventive system and method enable to schedule Computation Blocks (chains of arbitrary sequential instructions - instructions with a RAW data dependency) as a non-NP-hard problem compared to scheduling single instructions - in case the target platform has symmetrical characteristics. Therefore, a specific generic design can enable to use the method to distribute a given code to different pipelines / cores / cluster-nodes. Each Basic Block is segmented in parallel chains of Computation blocks, see figure 154. Visible are a code with a conditional branch depending on the variable z. The gamma-graph is retrieved for both branches and parallel opportunities including data addressing are known during compile time, depending on the condition, which is a function of the value of z.

The generic multiple issue CPU design adapted to the method has no need for hardware support for Out-Of-Order execution. This makes hardware components for dynamic instruction / pipeline scheduling or complex cache-hierarchies obsolete.

For the generic multiple issue CPU design adapted to the method there is no need for hardware support for Out-Of-Order execution, meaning for dynamic instruction / pipeline scheduling or complex cache-hierarchies.

### (vii) Generic Design

The generic design consists of:
- Number of parallel pipelines: *n*_{∥*pipelines*}
   o These pipelines can have all the same characteristics or different, like separated to Integer and Floating-Point pipelines and / or separate load and store pipelines, etc.
- A region with a certain number of buffer registers *n_{bufferreg}*
   o They are register (SRAM) with names, replacing cache-hierarchies and enabling storing temporary data known to be reused lower the latency time to store and load from external memory (DRAM)

All the characteristics of the pipelines (stage-register size, clocking, stage width, etc.) are i.a. a function of a chosen Instruction Set, which influences definitions for pipeline stages sizes, stage-registers, buffer-sizes, etc.. For illustration purposes, figure 155 shows a standard 5-stage pipeline. This base pipeline design is used to illustrate the needed add-ons for optimising the pipeline to the method. To make the standard pipeline design suitable for the method, the following additional hardware support has to be added:
a) Forwarding (prevent data hazard by forward data from the MEM stage (EX/MEM-stage-register) to the EX stage (ID/EX-stage-register))
b) Exchanging (enable exchange between pipelines by make EX/MEM-stage-register results available to the EX stage of a parallel pipeline)
c) Branch pipeline flushing (control hazard: enable to only flush certain pipelines depending on one pipeline computing the condition and executes the branch address calculation)
   a) Forwarding: All instructions in a computation block have a Read-after-write (RAW) data dependency. Therefore, forwarding on 1 register for the ALU must be provided, see figure 156. The support for "Forwarding" on at least one input register for the ALUs is needed to exploit the direct read after write data dependencies in each computation block. This enables to retrieve Δ*t_{compute}* for each computation block during compile time, as the cycles needed are known.
   b) Exchange: Furthermore, the exchange between two pipelines without a register store and load support the transfer between different rows in the matrix, see figure 157. In figure (a) the transfer between two computation blocks on two rows is illustrated. Using a MUX, the transfer can be detected to compare same register, respectively use a dedicated exchange name register in both instructions, which the exchange control unit can detect.
   c) Branching: In this case the computation blocks can be distributed according to their rows to the corresponding pipelines. In case of a conditional branch, the concept can be extended. Adding branching instructions as in figure 154, with a compare between a register on each pipeline, only the pipelines are flushed, which are not taken. This enables to improve conditional branch handling with only one bubble step. Figure 158 illustrates parallel pipelines with control hazard support by enabling the hardware to flush more than one pipeline (which was not taken). The compiler can mark on all parallel rows the branching step, and like in one pipeline configuration, the registers are compared in the ID-stage and either next instruction is run or a 'nop' is added by flushing the IF/ID-stage and set the control flags to 0 flushing the remaining stages. Using on all the parallel pipelines also a corresponding branch-instructions, when on row1 the compare is done, the correct pipelines can be flushed, respectively used.

### (viii) Buffer-register and latency to DRAM

Instead of cache-levels, additional buffer-registers (e.g. SRAM) can be added. The size of the buffer register has to be optimised to the speed and number of parallel pipelines. The static pipelining enables to use load / store instructions optimal to balance transfer times to external memory.

### (ix) Optimisation and runtime-variables

In case the number of parallel CBs on one level of the gamma-graph is higher than the available parallel pipelines *n*_{∥} > *n*_{∥*pipelines*}, the gamma-graph must be optimised. This can be done by combining as many parallel CBs as needed to reduce the number of parallel computation blocks. In case the number of parallel computation blocks, e.g. in a loop-section, is depending on runtime-variables, the compiler has to introduce the proper data mapping as additional code, which computes the data mapping during runtime. For example, for the 2d heat example the method knows the number of parallel computation blocks in the loop section is *n*_{∥} = (*nₓ* - 2)(*n_{y}* - 2). Given a generic multiple issue CPU with *n*_{∥*pipelines*} = 3 is shown in figure 159. With a simple example, it can be shown how from a given number of parallel CBs *n*_{∥} the mapping of data from the memory can be mapped during runtime to the given number of parallel pipelines. In the example always 5 CBs are distributed to one pipeline (combined following the optimization step of the method) and get corresponding subloop-indexes to define the data to be loaded to the different pipelines. Based e.g. on the indexed in a CB the unique data per pipeline can be obtained. A CB has a fixed register naming, given by its definition. The mapping between memory and register is then given and computable during runtime by adding the mapping code by the compiler. This enables the compiler to handle the runtime depending on number of parallel computation block *n*_{∥} = *f(params).* Therefore, the data can be mapped during runtime, based on the static code analysis and the resulting computation blocks. Each computation block has specified computations on fixed register numbers / names and are scheduled to different pipelines. The corresponding data mapping can be done by computing these addresses during runtime.

### (x) Scaling by multicore-CPUs and Cluster

The method enables to schedule CB on symmetrical platforms in an analytic step. Therefore, the proposed generic multiple issue CPU design can be extended to build up a multicore design with many cores of multiple issue CPUs. To reach a symmetrical extension, the based design can be extended by vertical and horizontal scaling.

### Example

### (i) Demonstration code

To demonstrate how the gamma-graph can be used to schedule code to a multiple issue CPU with two pipelines, the following demonstration code is used. The code is only to demonstrate the novel method and has no practical purpose. It corresponds with the code in the technical note. Classical compiling to an x68_64 platform with clang creates 5 Basic Blocks from the code in figure 160, see figure 161.

The inventive system and method create 15 CBs distributed to four different branch nodes. The edges indicate the potential transfers. In branch br1b the gamma-graph has 4 parallel CBs *n*_{∥} = 4. Figure 162 illustrates a demonstration code with 1 branch, some ILP in BB1 and more in BB3 in branch br1b. Further analysis of the gamma-graph leads to:
- Minimal CB register size: *S_{reg} =* 4
- Maximal parallel CBs: *n*_{∥} = 4
- Fixed parallel pipelines (e.g. given as an internal constraint limited by available silicon area *A_{silicon}*): *n*_{∥*pipelines*} = 2
- Therefore, needed buffer register size per pipeline: *S_{Buffer-Reg pipeline}* = 1 (combination of 2 CBs per pipeline for parallel CBs in branch *br1b*)

This enables to generate a machine code for the above multiple issue CPU with 2 similar, parallel five staged pipelines. The buffer size of 1 is not depending on runtime variables, as the novel method detects that parallel CBs are limited by the index distance of 4 by the relation g[i+4] = g[i]. There is no influence of the parallelism by the choice of runtime-variable N in this code. Improving could be to use *n*_{∥*pipelines*} = 4, with loss in energy efficiency for branch *br1a* and in br_main, but not in *br1b*, where *n*_{∥*pipelines*} = 4 would lead to an optimal speed, more needed silicon area, an similar energy efficiency. Based on the hardware specifications, the code can be compiled, see figure 163, figure 164 and figure 165. This leads to pseudo machine code for the two-pipeline CPU with scheduled Computation blocks and optimised load and store instructions. Indicated are the moved load instructions to compensate longer latency to external memory than R-instructions on the ALUs (see figure 166).

### (ii) Neuronal Network applications

In neuronal networks, the dot-product of matrices / vectors is the elementary operation, which needs the high computational power of Neuronal-Network applications at several positions in the corresponding source codes - a base technology for Artificial Intelligence applications. The dot-product of a vector with n elements and a matrix with mxn is: $\vec{a} ⋅ \vec{b} = {\sum }_{i = 1}^{n} {a}_{i} ⋅ {b}_{i}$

This leads for example with $a \left[ \right] = \left[ \right] = {\to }^{12} and b = \left[ \right] = 12 ↓$. Below, a simple code function to compute the dot-product between two vectors a and b is given:

```
                    #define N 12
                           int square(int *a, int *b) {
                           int sum = 0;
                           for (int i=1; i<N; i++) {
                                  sum += a[i]*b[i];
                           }
                    return sum;
```

Producing the Computation Blocks from code in Figure 46 results for the complete loop with N=12 in figure 167. For the CBs in figure 167 the parallel CBs over the loop are *n*_{∥} = 1, based for the addition of the multiplications. This addition introduces a potential transfer each iteration. The multiplication statement alone has parallel CBs as a function of the size of the vectors N, which leads to *n*_{∥} = N. According to the rules to optimize code to reduce parallel units of the inventive system and method, the combination is on the transfer-periods 0,-1.

Along this example the following two application can be shown:
a) Ideal IC-design
   Assuming the silicon area *A_{silicon}* is large enough to synthesis all CBs. The resulting design would be a combinational step needing all data in registers with size reg[WIDTH-1:0] data_in [2*N] and reg[WIDTH-1:0] data_out [0].
b) On a 5-stage 2-multiple issue CPU
   The dependency-relation between combined CBs and parallel operations *n*_{*op*∥} and read and write transfers *n_{transfers}*:
   - comb 2 iterations: *n*_{*comb*∥} = 2; *n*_{*op*∥} = 4; *n_{transfers,init,r}* = 4 and *n_{transfers,result,w}* = 1 transfers
   - comb 3 iterations: *n*_{*comb*∥} = 3 ; *n*_{*op*∥} = 6 ; *n_{transfers,init,r}* = 6 and *n_{transfers,result,w}* = 1 transfers
   - comb 4 iterations: *n*_{*comb*∥} = 4; *n*_{*op*∥} = 8; *n_{transfers,init,r}* = 8 and *n_{transfers,result,w}* = 1 transfers
   - comb K iterations: *n*_{*comb*∥} = *K* ; *n*_{*op*∥} = *K* * 2 ; *n_{transfers,init,r}* = K · 2 and *n_{transfers,result,w}* = 1 transfers
   Assuming the latency to access external memory is Δ*t_{memory}* ≈ *t_{compute}* = *6 instructions,* this results in scheduling always *n*_{*comb*∥} = 3 on each of the parallel pipelines with additional 3-buffer-registers, see figure 168.

### Inventive system 1 and inventive method in the context of other prior art systems

It is to be noted that the various approaches, known the prior art, differ essentially from the present invention by their technical approach. In the following, the essential difference to three of the prior art systems are detailed explained in order to further illustrate the inventive system and method: (a) *Slicing based* code parallelization *for minimizing inter-process* communication by M. Kandemir et al. (hereafter Kandemir) discloses a method for scalable parallelization that minimizes inter-processor communication distributed memory multi-core architectures. Using the concept of iteration space slicing, Kandemir discloses a code parallelization scheme for data-intensive applications. This scheme targets distributed memory multi-core architectures, and formulates the problem of data-computation distribution (partitioning) across parallel processors using slicing such that, starting with the partitioning of the output arrays, it iteratively determines the partitions of other arrays as well as iteration spaces of the loop nests in the application code. The goal is to minimize inter-processor data communications based on this iteration space slicing based formulation of the problem. However, Kandemir does this with the portioning of output array, by iteratively determining the partition of other arrays in the application code (see p. 87). This is a different approach, because the inventive method, disclosed herein, does not include an iterative determination of array parts, which are combined. The inventive method gets this information directly from the code. As disclosed on p. 88 Kandemir, program slicing was originally introduced by Weiser in a seminal paper. Slicing means extracting statements form a program that potentially have an influence on a specific statement of interest, which is the slicing criterion (cf. Advanced *slicing* of *sequential and* concurrent programs by J. Krinke). Slicing techniques showing similar effects as the well-known points data/control dependences (cf. Computer *architecture* by D. Patterson, p. 150ff) and data flow analysis (e.g. [8]). Our method resembles on the first impression these methods. This comes from the fact, that statements, blocks in programs, data dependencies are one of the most central points in programing and compiling, but the inventive method, disclosed herein, has a different perspective. The novelty is in this new approach providing a new perspective, respectively the definition of the computation block nodes, as indicated by the report. The inventive method explicitly takes each variable as a unique information (represented by one particular bit-pattern) and as the computing instruction (= statement) can only be performed with available bit-patterns (in accessible storages, e.g. in CPU registers), the inventive method extracts the time between the modification and the use of a variable at a "location" (e.g. a register). No SOTA compiler known extracts this time out of the (source) code nor focus on the single data entities (bit-pattern) in a statement - all known prior art systems use always as a focus the result of a complete statement. As Kandemir discloses (p. 89), using iteration space slicing, one can answer questions such as *"Which iterations* of *which statements might affect the values* of a *given set* of elements from *arrayA".* This shows a different perspective, where the inventive method derives exactly this affection in a generic form of finding the «read» and «write» on each element of the array and brings this delay time of "reading" and "writing" in correlation to the time needed to transfer an element. It finds this »affect» and do not try to find it by «simulating» the interaction with linear algebra methods, respectively by iterative methods. On p. 91, Kandemir summarizes the function that returns the set of loop iterations to be assigned to processor p from loop nest s, where Zp,r is the set of data elements accessed by processor p from array Ar. In contrast to this, the inventive system and method is not based on this approach: the inventive method and system derives first all dependencies of the code (also in the nested loops), then it creates matrices for all code in the program and at the end the system maps/optimizes by combining of the matrices all operations of a program. Kandemir's method creates a matrix for the array loop index dependencies and derives by assigning them to processors and then finds (see Kandemir p. 92) how very iterative this approach is needed to be by taking the Presbuerger set and then generating a code as output "(a series of potentially nested loops)" and then iterates over the unknowns. Kandemir's approach does not take hardware specification into account either; (b) Automatic Parallelization: Executing Sequential Programs on a Task-Based Parallel Runtime by A. Fonseca (hereafter Fonseca) discloses another system of the prior art for automatically parallelizing sequential code in modern multicore architectures. Fonseca discloses a parallelizing compiler that analyses the read and write instructions, and control-flow modifications in programs to identify a set of dependencies between the instructions in the program. Afterwards, the compiler, based on the generated dependencies graph, rewrites, and organizes the program in a task-oriented structure. Parallel tasks are composed by instructions that cannot be executed in parallel. A work-stealing-based parallel runtime is responsible for scheduling and managing the granularity of the generated tasks. Furthermore, a compile-time granularity control mechanism also avoids creating unnecessary data-structures. Fonseca focuses on the Java language, but the techniques could possibly be applied to other programming languages. However, in contrast to the inventive method, discloses in this application, in Fonseca's approach, in order to automatically parallelize the program, it is necessary to analyze the memory accessed to understand dependencies between parts of the program (cf. p. 6, Fonseca). The inventive method, disclosed herein, is different: Fonseca uses data-groups and memory layouts and then it checks the dependencies. This is not the same scope as the inventive method, since as Fonseca explicitly holds that it is task parallelism. For instance in the Fibonacci example, as discussed above, the cost of creating a new task is higher than the cost of executing the method for a low input number (see Fonseca p. 7). This shows that this is not the same approach, as the inventive method handles this example completely different. On the other side, this also directly the prove for a technical problem which can be solved by the inventive method. Further, Fonseca (see p. 9) has to define the main requirements for the position of the future creation. In contrast, the inventive method knows where to place each instruction, respectively statement, depending on the data dependency of the single information / variable. Fonseca (see p. 9) also discloses that an algorithm 18 has to be used to find the best position to create the future. The inventive method, in contrary, exactly places the instructions to the position based on the new scope. In Fonseca (see p. 10), the used operations that are commutative and associative. The inventive method does not base its approach on this form, because it excludes e.g. division (used in a lot of mathematical models). This limitation is also typically for map-reduce approaches (as discussed herein); (c) The publication US 2008/0263530 A1 discloses a system for converting application code into optimized application code or into execution code suitable for execution on an architecture comprising at least a first and a second level of data memory units. The method obtains application code, the application code comprising data transfer operations between the levels of memory units. The method further comprises converting at least a part of the application code. The converting of application code comprises scheduling of data transfer operations from a first level of memory units to a second level of memory units such that accesses of data accessed multiple times are brought closer together in time than in the original code. The converting of application code further comprises, after the scheduling of the data transfer operations, deciding on layout of the data in the second level of memory units to improve the data layout locality such that data which is accessed closer together in time is also brought closer together in the layout than in the original code. US 2008/0263530A1 allows improving layout locality (see US 2008/0263530A1 p. 4, para. 0078). In contrast, the inventive method, disclosed herein, has a different scope, since the inventive method finds this form of "locality" and orders the instructions in a way that instructions are grouped, which must be "local" - then this inherent form of the code is placed in matrices and then there can be a generic, not-iterative, respectively by combining elements and then set the optimal mapping to a given hardware, which leads always in a concurrent form of the code. Iterative solution methods can miss solutions and end with a non-clear result. Further, US 2008/0263530A1 (p. 6, para. 0092) discloses that it can be regarded as a complex, non-linear problem, for which a reasonable, near-optimal, and scalable solution is provided. In contrast, the inventive method is not a non-linear problem, rather it prevents to get a complex, non-linear problem, which needs an iterative, numerical solution / optimization approach / algorithm. US 2008/0263530A1 (p. 6, para. 0093) holds that its access locality is improved by computing the reuse vectors and applying them to find an appropriate transformation matrix T. In contrast, the inventive method, disclosed herein, does not need a transformation matrix, nor computing of such one. It reads the inherent logic connection between the array operations based on the given code (in form of loop-definition or loop blocks in compiler IR languages or jump definitions in assembler code). Finally, US 2008/0263530A1 (p. 6, para. 0093) holds that having fixed T, thereafter the placement M for the arrays accessed in the loop-nest is fixed, whose placement is not already fixed. This discloses an iterative and numerical solver based approach. The inventive method, disclosed herein, reads this dependencies in the code, without an iterative solving technique using linear algebraic methods to finding solution of systems of equations.

### List of reference signs

0 Computer-aided IC design and manufacturing system
1 Auto-parallel-compiler system
   11 Lexer/Parser
   12 Analyzer
   13 Scheduler
   14 Computational block chains module
   15 Matrix builder
      151 Computation matrices
      152 Transfer matrices
      153 Task matrices
   16 Optimizer module
   17 Code generator
2 Parallel processing system/Multi-processer system
   21 Processor units
      210 Central Processing Units (CPU)
         2101 Control Unit
         2102 Processor (Single-core micro-controller CPU)
            21021 Register
            21022 Combinational logic
         2103 Core/Processor (Multi-core micro-controller CPU)
      211 Graphics Processing Units (GPU)
      212 Sound chips
      213 Vision Processing Unit (VPU)
      214 Tensor Processing Units (TPU)
      215 Neural Processing Units (NPU)
      216 Physics Processing Units (PPU)
      217 Digital Signal Processors (DSP)
      218 Synergistic Processing Units (SPU)
      219 Field-Programmable Gate Arrays (FPGA)
   22 Memory units
      221 Primary storage units
         2211 Processor registers
         2212 Processor caches
            22121 L1-cache
            22122 L2-cache
            ........
            2212x Lx-cache
         2213 Random Access Memory (RAM) units
      222 Secondary storage units
         2221 Hard Disk Drives (HDD)
         2222 Solid-State Drives (SSD)
         2223 Universal Serial Bus (USB) memory
         2224 Flash drives
         2225 Optical storage devices (CD or DVD drives)
         2226 Floppy disk drives (FDD)
         2227 RAM disks
         2228 Magnetic tapes
      223 Tertiary storage units (tape backup etc.)
   23 Memory bus
      231 Address bus
      232 Data bus
   24 Memory Management Unit (MMU)
   25 Input/Output (I/O) interfaces
      251 Memory-mapped I/O (MMIO) or port-mapped I/O (PMIO) interfaces
      252 Input/Output (I/O) channels (processors)
3 Program code
   31 Serial source code
      311 High level language
         3111 C/C++
         3112 phyton
         3113 Java
         3114 Fortran
         3115 OpenCL (Open Computing Language)
      3112 Parallel programming language
         31121 Apache Beam
         31122 Apache Flink
         31124 Apache Hadoop
         31125 Apache Spark
         31126 CUDA
         31127 OpenCL
         31128 OpenHMPP
         31129 OpenMP for C, C++, and Fortran (shared memory and attached GPUs)
      3113 Low-level language (machine code/assembly language)
   32 Auto-parallelized target code
      321 Low-level language (assembly language)
      322 Machine language (computer's instruction set (code directly executed by central processing units))
      322 Basic set of elementary instructions
         3221 Arithmetic operation instructions
         3222 Logical operation instructions
         3223 Variable and array declarations operations
         3224 Compare operation instructions
         3225 Code flow instructions/Memory operation/I/O operation
   33 Nodes
      331 Data nodes (holding certain data values)
         3311 Input data node for READ (Datanodeᵢₙ (read access))
         3312 Output data node for WRITE (Datanodeₒᵤₜ, write access))
      332 Operation nodes (performing an operation)
      333 Computation block nodes (CB1, CB2,...,CBx)
      334 Control flow nodes
         3341 Branch nodes
         3342 Hidden branch nodes
         3343 Loop branch nodes
      335 Condition nodes
      336 Gamma nodes (tasks)
   34 Chains
      341 Computational chains (chains of computation block nodes)
      342 Operational chains (chains of operation nodes)
   35 Latency time Δt (time to transfer data from one process to another)
      351 Δt_{readwrite} = time between a write and a read access to a data node
      352 Δt_{computation} = time to compute all operation nodes in a computation block node
      353 Total (aggregated) latency time Δtₜₒₜₐₗ
   36 Tasks
      36i Number of computation block nodes in a task i
4 Network
   41 Network controller
5 IC-layout system
   51 Integrated circuit layout elements
      511 Transistors
      512 Resistors
      513 Capacitors
      514 Interconnections of IC layout elements
      515 Semiconductor
   52 Layout netlist generator
      521 Layout netlist
      5211 Position Variables
      5212 Location of edges of a layout element on the IC-layout
   53 Parallel Pipelines
      531 Input Latch
      532 Processing Circuit
      533 Clock Signal
         5331 Clock Pulse
      534 Stages
         5341 Intermediate Results
         5342 Final Result
         5343 Number of stages to be performed for the Final Result
      535 Number of Parallel Pipelines
   54 IC-Layout
   6 IC manufacturing system

## Claims

1. A design and manufacturing system (0) for optimized generic multi-core and/or multi-processor integrated circuit (2) architecture with static scheduling of multiple processing pipelines (53), the multi-core and/or multi-processor integrated circuit (2) having a plurality of processing pipelines (53) simultaneously processing instructions on data by executing a parallelized processing machine code (32),
wherein the execution of the parallelized processing code (32) by the parallel processing multi-core and/or multi-processor integrated circuit (2) comprises the occurrence of latency times (26), the latency times being given by idle time of a processing unit (21) between transmitting data back after having processed a specific block of instructions of the processing code (32) on the data by the processing unit (21)and receiving data necessary for execution of a consecutive block of instructions of the processing code (32) by said processing units (21),
in that the design and manufacturing system (0) comprises an auto-parallelization compiler system (1) comprising means for transforming a serial source code (31) of the program code (3) written in a programming language into a parallel processing machine code (32) comprising a number of instructions executable by the plurality of processing units (21) of the multi-core and/or multi-processor integrated circuit (2) or controlling the operation of the plurality of processing units (21), combined with an IC-layout system (5) for generating a parallel processing IC layout with a plurality of intearated circuit lavout elements (51) at least comorising elements denoting memory units (22) and elements denoting processing units (21) and/or processing pipelines,
in that the compiler system (1) comprises a parser module (11) for translating the serial source code (31) into a code (32) with a flow of elementary instructions executable by the processing units (21), the elementary instructions selectable out of a limited, processing-unit-specific set of elementary instructions and the elementary instructions comprising exclusively elementary arithmetic and logic operations (321/322) and/or elementary control and memory operations (325) for the
in that the parser module (11) comprises means for partitioning the code (32) of said elementary instructions into computation block nodes (333), each computation block node (333) consisting of a smallest possible segmentation of a non-further decomposable sequence of elementary instructions of the code (32) processable by a single processing unit (21), the smallest possible segmentation of the elementary instructions being **characterized by** a sequence of elementary instructions framed by consecutive read and write instructions, said sequence being not further decomposable by smaller sequences of elementary instructions between consecutive read and write instructions, and the read and write instructions needed to receive data required for processing said sequence of elementary instructions by the processing unit (21) and transmit back data after processing by the sequence,
in that the compiler system (1) comprises a matrix builder (15) for generating matrices (151,...,153) out of computation chains (34) portioned from the code (32), the matrices (151,...,153) comprising computation matrices and transfer matrices (151/152) and task matrices (153), wherein each column within a computation matrix (151) comprises computation block nodes (333) being simultaneously processable based on executability of read and write instructions transferring data required for processing of the computation block nodes (333), wherein the transfer matrix contains to each computation block nodes (333) transfer and process properties at least characterizing data transfer properties from one to a consecutive computation block node (333) at least comprising data size of transmitted data and identification of a source computation block node (333) and target computation block node (333) of the data transfer and/or process characteristics on one of the plurality of processing units (21),
in that tasks (56) of a task matrix (153) are formed by the matrix builder (15) wherein in case of computation block nodes (333) each having a different read associated, the tasks (56) are formed by splitting the computation block nodes (333) of a column of the computation matrix (151) evenly to the number of the plurality of symmetric processing units (21) forming for each of the plurality of processing unit (21) per column of the computation matrix (151) one task (56), and splitting remaining computation block nodes (333) based on a predefined scheme to at least a part of said tasks (56), wherein in case of computation block nodes (333) at least partially having a read with identical data transferred, the tasks (56) are formed by minimizing the number of reads uniformly or essentially uniformly over the number of processing units (21) and/or if a predefined offset value is exceeded by minimizing an integrated processing time uniformly over each of the processing units (21),
in that the compiler system (1) comprises an optimizer module (16) using a matrix optimization technique minimizing an aggregated occurring latency time (26) integrating all occurring latency times (261), wherein to provide an optimized structure of the tasks (56) within the task matrix (153) different combinations of rows from the computation and the transfer matrices are built by the optimizer module (16), each of the different combinations of rows from the computation and the transfer matrices representing a possible machine code (32) as parallel processing code providing its properties on the hardware of the parallel processing system (2), wherein each column of the task matrix (153) forms a computation chain (34) by one or more tasks (333) creating an ordered flow of computation block nodes (333) to be executed by one of the plurality of processing units (21), and wherein the aggregated occurring latency time (26) integrating all occurring latency times is minimized by the optimizer module (16),
in that the compiler system (1) comprises a code generator (17) for generating the parallel processing machine code (32) for the plurality of processing units (21) with an optimized aggregated latency time (26) based on the computation chains (34) given by the optimized task matrix (153),
in that the IC-layout system (5) comprises a netlist generator (52) for generating a layout netlist (521) being composed of a plurality of integrated circuit layout elements (51) of an integrated circuit (2), the integrated circuit layout elements (51) comprising electronic components of the integrated circuit (2) at least comprising transistors (511), resistors (512), capacitors (513) and interconnections (514) of these components onto a piece of semiconductor (515)
in that the layout netlist (521) comprises a plurality of parallel pipelines (53), each pipeline (53) comprising an input latch (531) and a processing circuit (532), wherein each input latch (531) comprises the integrated circuit layout elements (51) for a buffer or register, and a processing circuit (532) comprises integrated circuit layout elements (521) for processing the data of an associated input latch (531) by a set of basic set of elementary instructions (322),
in that a processing stage (534) is given by a particular data processing by one of the plurality of parallel pipelines (53) producing an intermediate result (5341), wherein the input latch (531) and the processing circuit (532) of a given stage (534) is connected to the input latch (531) of a next stage (534),
in that a clock signal (533) is connected to each input latch (531), wherein a clock signal (533) comprises the integrated circuit layout elements (521) for generating a clock pulse (5331), wherein at each clock pulse (5331) each of the plurality of parallel stages (534) transfers an intermediate result (5341) to the input latches (531) of the next stages (534), and wherein input data are passed through the plurality of parallel pipelines (53) completing one stage (534) per clock pulse (5331) until a final result (5342) is reached by completing all stages (534),
in that the parallel pipelines (53) comprise means for
(i) exchanging by providing result exchange between pipelines by making a stage register results accessible to the stage of a parallel pipeline (53), and
(ii) branch pipeline flushing by providing a control hazard by flushing only those pipelines (53) depending on one pipeline (53) by computing condition based on branch addresses,
in that the layout netlist (521) comprises a plurality of position variables (5211) generated and allocated to a plurality of layout elements (51) by the netlist generator (52), wherein position variables (5211) represent the location of edges or points of the plurality of layout elements (5212), and wherein an IC layout (54) is generated by the netlist generator (52) from the position variable values (5211) of the generated layout netlist (521).

2. The design and manufacturing system (0) for optimized generic multi-core and/or multi-processor integrated circuit (2) architecture with static scheduling of multiple processing pipelines (53) according to claim 1 wherein instead of cache-levels additional buffer-registers are added, wherein the size of the buffer register is adaptedly optimized to the speed and number of parallel pipelines (53).

3. The design and manufacturing system (0) for optimized generic multi-core and/or multi-processor integrated circuit (2) architecture with static scheduling of multiple processing pipelines (53) according to one of the claims 1 or 2, in wherein the parallel pipelines (53) comprise means for forwarding by providing data forwarding from a stage register to another stage register.

4. The design and manufacturing system (0) for optimized generic multi-core and/or multi processor intergrated circuit (2) architecture with static cheduling of multiple processing pipelines (53) according to claim 3, wherein the parallel pipelines (53) comprise means for forwarding by providing data forwarding from a MEM stage as EX/MEM register to EX stage as ID/EX-stage register.

5. The design and manufacturing system (0) for optimized generic multi-core and/or multi-processor integrated circuit (2) architecture with static scheduling of multiple processing pipelines (53) according to one of the claims 1 to 4, wherein the parallel pipelines (53) comprise means for exchanging by providing result exchange between pipelines by making Ex-MEM-stage register results accessible to the EX stage of a parallel pipeline (53).

6. The design and manufacturing system (0) for optimized generic multi-core and/or multi-processor integrated circuit (2) architecture with static scheduling of multiple processing pipelines (53) according to one of the claims 1 to 5, wherein in case that the number of computational blocks (333) on one stage is higher than the available parallel pipelines (53), the computational matrix (151) is optimized in respect to this number of computational blocks (333).

7. The design and manufacturing system (0) for optimized generic multi-core and/or multi-processor integrated circuit (2) arhitecture with static scheduling of multiple processing pipelines (53) according to one of the claims 1 to 6, wherein the plurality of parallel pipelines (53) are all exactly or essentially exactly the same giving a symmetric multi-core and/or a multi-processor IC-layout (54).

8. The design and manufacturing system (0) for optimized generic multi-core and/or multi-processor integrated circuit (2) architecture with static scheduling of multiple processing pipelines (53) according to one of the claims 1 to 7, wherein the plurality of position variables are generated and allocated to the plurality of layout elements by the netlist generator (51) based on a constraint system comprising constraints represent relationships of edges or points of the plurality of layout elements in respect to fabrication process requirements, wherein the IC layout is generated from the adapted position variable values.

9. The design and manufacturing system (0) for optimized generic multi-core and/or multi-processor integrated circuit (2) architecture with static scheduling of multiple processing pipelines (53) according to claim 8, wherein each of the plurality of parallel pipelines (53) has the same storage architecture and technical processor characteristics.

10. The design and manufacturing system (0) for optimized generic multi-core and/or multi-processor integrated circuit (2) architecture with static scheduling of multiple processing pipelines (53) according to claim 9, wherein the technical processor characteristics at least comprise having the same processor (2102) or core (2103) performance with equal or essentially equal numbers of instructions per second processed.

11. The design and manufacturing system (0) for optimized generic multi-core and/or multi-processor intearated circuit (2) architecture with static schedulina of multiple processing pipelines (53) according to one of the claims 1 to 10, wherein the size of the buffer or register of an input latch (531) is set according to the data nodes used in the instructions in the block providing a synchronous IC layout design, wherein the size of the data nodes is defined by the data types of used variables.

12. The design and manufacturing system (0) for optimized generic multi-core and/or multi-processor integrated circuit (2) architecture with static scheduling of multiple processing pipelines (53) according to claim 11, wherein the data types of used variables are defined by the Instruction Set Architecture (ISA) connecting the amount of data nodes, data type definition and the number of instructions to the reguired reaister size *S_{reg}* by *S_{reg}* = *f*(*S_{data nodes}*, *n_{data nodes} in CB, ISA*), and the and the size of the data nodes being a function of data types by *S_{data nodes}* ∞ *S_{data types}* = *f*(*ISA*).

13. The design and manufacturing system (0) for optimized generic multi-core and/or multi-processor integrated circuit (2) architecture with static scheduling of multiple processing pipelines (53) according to one of the claims 11 or 12, wherein a wire-width is set as a function of the data type and the number of to transfer data nodes providing the bit-width of each transfer, which is defining the size of wires used for the IC layout.

14. The design and manufacturing system (0) for optimized generic multi-core and/or multi-processor integrated circuit (2) architecture with static scheduling of multiple processing pipelines (53) according to one of the claims 1 to 13, wherein a chain of instructions is captured using Verilog on RTL-level.

15. The design and manufacturing system (0) for optimized generic multi-core and/or multi-processor integrated circuit (2) architecture with static scheduling of multiple processing pipelines (53) according to claim 11, wherein the IC layout is provided as an asynchronous design, wherein the computation blocks (CB) contain all information to form RTL-code for said asynchronous design to compute the instructions contained in the CB.

16. The design and manufacturing system (0) for optimized generic multi-core and/or multi-processor integrated circuit (2) architecture with static sheduling of multiple processing pipelines (53) according to claim 15, wherein the IC layout is provided as a synchronous design, wherein the edges in the graph giving the transfers contain the size of the register between each combinational computation.

17. The design and manufacturing system (0) for optimized generic multi-core and/or multi-processor integrated circuit (2) architecture with static scheduling of multiple processing pipelines (53) according to one of the claims 1 to 16, wherein the static scheduling of the multiple processing pipelines (53) by the static auto-parallelized processing machine code (32) is realized such as no dynamic scheduling is required by the integrated circuit (2).

18. The design and manufacturing system (0) for optimized generic multi-core and/or multi-processor integrated circuit (2) architecture with static scheduling of multiple processing pipelines (53) according to one of the claims 1 to 17, wherein the integrated circuits (2) are manufactured and/or produced by an IC manufacturing system (6) of the design and manufacturing system (0) based on the generated IC layout (54).

19. A method for a design and manufacturing system (0) for optimized generic multi-core and/or multi-processor integrated circuit (2) architecture with static scheduling of multiple processing pipelines (53), the multi-core and/or multi-processor integrated circuit (2) having a plurality of processing units and/or processing pipelines (53) simultaneously processing instructions on data by executing a parallelized processing machine code (32),
wherein the parallelized processing code (32) is executed by the parallel processing multi-core and/or multi-processor integrated circuit (2) comprises the occurrence of latency times (26), the latency times being given by idle time of a processing unit (21) between transmitting data back after having processed a specific block of instructions of the processing code (32) on the data by the processing unit (21)and receiving data necessary for execution of a consecutive block of instructions of the processing code (32) by said processing units (21),
in that the design and manufacturing system (0) comprises an auto-parallelization compiler system (1) comprising means for transforming a serial source code (31) of the program code (3) written in a programming language into a parallel processing machine code (32) comprising a number of instructions executable by the plurality of processing units (21) of the multi-core and/or multi-processor integrated circuit (2) or controlling the operation of the plurality of processing units (21), combined with an IC-layout system (5) for generating a parallel processing IC layout with a plurality of integrated circuit layout elements (51) at least comprising elements denoting memory units (22) and elements denoting processing units and/or processing pipelines (21),
in that the compiler system (1) comprises a parser module (11) for translating the serial source code (31) into a code (32) with a flow of elementary instructions executable by the processing units (21), the elementary instructions selectable out of a limited, processina-unit-specific set of elementary instructions and the elementary instructions comprising exclusively elementary arithmetic and logic operations (321/322) and/or elementary control and memory operations (325) for the number of processing units (21),
in that the code (32) of said elementary instructions is partitioned into computation block nodes (333) by the parser module (11), each computation block node (333) consisting of a smallest possible segmentation of a non-further decomposable sequence of elementary instructions of the code (32) processable by a single processing unit (21), the smallest possible segmentation of the elementary instructions being **characterized by** a sequence of elementary instructions framed by consecutive read and write instructions, said sequence being not further decomposable by smaller sequences of elementary instructions between consecutive read and write instructions, and the read and write instructions needed to receive data required for processing said sequence of elementary instructions by the processing unit (21) and transmit back data after processing by the sequence,
in that matrices (151,...,153) are generated out of computation chains (34) portioned from the code (32) by a matrix builder (15), the matrices (151,...,153) comprising computation matrices and transfer matrices (151/152) and task matrices (153), wherein each column within a computation matrix (151) comprises computation block nodes (333) being simultaneously processable based on executability of read and write instructions transferring data required for processing of the computation block nodes (333), wherein the transfer matrix contains to each computation block nodes (333) transfer and process properties at least characterizing data transfer properties from one to a consecutive computation block node (333) at least comprising data size of transmitted data and identification of a source computation block node (333) and target computation block node (333) of the data transfer and/or process characteristics on one of the plurality of processing units (21),
in that tasks (56) of a task matrix (153) are formed by the matrix builder (15) wherein in case of computation block nodes (333) each having a different read associated, the tasks (56) are formed by splitting the computation block nodes (333) of a column of the computation matrix (151) evenly to the number of the plurality of symmetric processing units (21) forming for each of the plurality of processing unit (21) per column of the computation matrix (151) one task (56), and splitting remaining computation block nodes (333) based on a predefined scheme to at least a part of said tasks (56), wherein in case of computation block nodes (333) at least partially having a read with identical data transferred, the tasks (56) are formed by minimizing the number of reads uniformly or essentially uniformly over the number of processing units (21) and/or if a predefined offset value is exceeded by minimizing an integrated processing time uniformly over each of the processing units (21),
in that an aggregated occurring latency time (26) is minimized by an optimizer module (16) using a matrix optimization technique minimizing by integrating all occurring latency times (261), wherein to provide an optimized structure of the tasks (56) within the task matrix (153) different combinations of rows from the computation and the transfer matrices are built by the optimizer module (16), each of the different combinations of rows from the computation and the transfer matrices representing a possible machine code (32) as parallel processing code providing its properties on the hardware of the parallel processing system (2), wherein each column of the task matrix (153) forms a computation chain (34) by one or more tasks (333) creating an ordered flow of computation block nodes (333) to be executed by one of the plurality of processing units (21), and wherein the aggregated occurring latency time (26) integrating all occurring latency times is minimized by the optimizer module (16),
in that the parallel processing machine code (32) is generated by a code generator (17) for the plurality of processing units (21) with an optimized aggregated latency time (26) based on the computation chains (34) given by the optimized task matrix (153),
in that a layout netlist (521) being composed of a plurality of integrated circuit layout elements (51) of an integrated circuit (2) is generated by a netlist generator (52), the integrated circuit layout elements (51) comprising electronic components of the integrated circuit (2) at least comprising transistors (521), resistors (522), capacitors (523) and interconnections (554) of these components onto a piece of semiconductor (555),
in that the layout netlist (521) comprise a plurality of parallel pipelines (53), each pipeline (53) comprising an input latch (531) and a processing circuit (532), wherein each input latch (531) comprises the integrated circuit layout elements (51) for a buffer or register, and a processing circuit (532) comprises the integrated circuit layout elements (51) for processing the data of an associated input latch (531) by the basic set of elementary instructions (322),
in that a processing stage (534) is given by a particular data processing by one of the plurality of parallel pipelines (53) producing an intermediate result, wherein the input latch (531) and the processing circuit (532) of a given stage (534) is connected to the input latch (531) of a next stage (534),
in that a clock signal (533) is connected to each input latch, wherein a clock signal (533) comprises the integrated circuit layout elements (51) for generating a clock pulse (5331), wherein at each clock pulse (5331) each of the plurality of parallel stages (534) transfers an intermediate result (5341) to the input latches (531) of the next stages (534), and wherein input data are passed through the plurality of parallel pipelines (53) completing one stage per clock pulse until a final result (5341) is produced,
in that the parallel pipelines (53)
(i) exchange data by providing result exchange between pipelines by making a stage register results accessible to the stage of a parallel pipeline (53), and
(ii) flush by branch pipeline flushing providing a control hazard by flushing only those pipelines (53) depending on one pipeline (53) by computing condition based on branch addresses,
and
in that the layout netlist (521) comprises a plurality of position variables (5211) generated and allocated to a plurality of layout elements (51) by the netlist generator (52), wherein position variables (5211) represent the location of edges or points of the plurality of layout elements (5212), and wherein an IC layout (54) is generated by the netlist generator (52) from the position variable values (5211) of the generated layout netlist (521).

20. The design and manufacturing method (0) according to claim 19, wherein the parallel pipelines (53) comprise means for forwarding by providing data forwarding from a stage register to another stage register.

21. The design and manufacturing method (0) according to claim 20, wherein the parallel pipelines (53) comprise means for forwarding by providing data forwarding from a MEM stage as EX/MEM register to EX stage as ID/EX-

22. The design and manufacturing method (0) according to one of the claims 19 to 21, wherein the parallel pipelines (53) comprise means for exchanging by providing result exchange between pipelines by making Ex-MEM-stage

## Patentansprüche

1. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53), wobei der integrierte Mehrkern- und/oder Mehrprozessor-Schaltkreis (2) mehrere Verarbeitungspipelines (53) aufweist, die gleichzeitig, durch Ausführen eines Maschinencodes (32) für parallelisierte Verarbeitung, Instruktionen bezüglich Daten verarbeiten,
wobei die Ausführung des Codes (32) für parallelisierte Verarbeitung durch den parallelverarbeitenden integrierten Mehrkern- und/oder Mehrprozessor-Schaltkreis (2) das Auftreten von Latenzzeiten (26) umfasst, wobei die Latenzzeiten durch die Leerlaufzeit einer Verarbeitungseinheit (21) zwischen dem Zurücksenden von Daten nach der Verarbeitung eines spezifischen Blocks aus Instruktionen des Verarbeitungscodes (32) bezüglich der Daten durch die Verarbeitungseinheit (21) und dem Empfangen von Daten, die für die Ausführung eines nachfolgenden Blocks aus Instruktionen des Verarbeitungscodes (32) durch die Verarbeitungseinheiten (21) benötigt werden, gegeben sind,
wobei das Design- und Herstellungssystem (0) ein Autoparallelisierungs-Compilersystem (1) umfasst, umfassend Mittel zum Umwandeln eines seriellen Quellcodes (31) des in einer Programmiersprache geschriebenen Programmcodes (3) in einen Maschinencode (32) für parallele Verarbeitung, der eine Anzahl von Instruktionen umfasst, die durch die mehreren Verarbeitungseinheiten (21) des integrierten Mehrkern- und/oder Mehrprozessor-Schaltkreises (2) ausführbar sind, oder zum Steuern des Betriebes der mehreren Verarbeitungseinheiten (21), kombiniert mit einem IC-Layout-System (5) zum Generieren eines IC-Layouts für parallele Verarbeitung mit mehreren Layout-Elementen (51) für integrierte Schaltkreise, die mindestens Elemente, die Speichereinheiten (22) bezeichnen, und Elemente, die Verarbeitungseinheiten (21) und/oder Verarbeitungspipelines bezeichnen, umfassen,
wobei das Compilersystem (1) ein Parser-Modul (11) zum Übersetzen des seriellen Quellcodes (31) in einen Code (32) mit einem Fluss von elementaren Instruktionen, die durch die Verarbeitungseinheiten (21) ausführbar sind, umfasst, wobei die elementaren Instruktionen aus einer begrenzten, Verarbeitungseinheit-spezifischen Menge von elementaren Instruktionen auswählbar sind und die elementaren Instruktionen ausschließlich elementare arithmetische und logische Operationen (321/322) und/oder elementare Steuer- und Speicheroperationen (325) für die Anzahl von Verarbeitungseinheiten (21) umfassen,
wobei das Parser-Modul (11) Mittel zum Partitionieren des Codes (32) der elementaren Instruktionen in Berechnungsblockknoten (333) umfasst, wobei jeder Berechnungsblockknoten (333) aus einer kleinstmöglichen Segmentierung einer nicht weiter zerlegbaren Sequenz von elementaren Instruktionen des Codes (32) besteht, die durch eine einzelne Verarbeitungseinheit (21) verarbeitbar sind, wobei die kleinstmögliche Segmentierung der elementaren Instruktionen durch eine Sequenz von elementaren Instruktionen gekennzeichnet ist, die durch aufeinanderfolgende Lese- und Schreibinstruktionen eingerahmt ist, wobei diese Sequenz nicht weiter durch kleinere Sequenzen von elementaren Instruktionen zwischen aufeinanderfolgenden Lese- und Schreibinstruktionen zerlegbar ist und die Lese- und Schreibinstruktionen benötigt werden, um Daten zu empfangen, die für die Verarbeitung dieser Sequenz von elementaren Instruktionen durch die Verarbeitungseinheit (21) erforderlich sind, und um Daten nach der Verarbeitung durch die Sequenz zurückzusenden,
wobei das Compilersystem (1) einen Matrix-Builder (15) zum Generieren von Matrizen (151, ..., 153) aus von dem Code (32) abgeteilten Berechnungsketten (34) umfasst, wobei die Matrizen (151, ...,153) Berechnungsmatrizen und Transfermatrizen (151/152) und Aufgabenmatrizen (153) umfassen, wobei jede Spalte innerhalb einer Berechnungsmatrix (151) Berechnungsblockknoten (333) umfasst, die auf der Grundlage der Ausführbarkeit von Lese- und Schreibinstruktionen, die Daten transferieren, die für die Verarbeitung der Berechnungsblockknoten (333) erforderlich sind, gleichzeitig verarbeitbar sind, wobei die Transfermatrix zu jedem Berechnungsblockknoten (333) Transfer- und Prozesseigenschaften enthält, die mindestens Datentransfereigenschaften von einem zu einem nachfolgenden Berechnungsblockknoten (333) charakterisieren, die mindestens die Datengröße von gesendeten Daten und die Identifikation eines Quell-Berechnungsblockknotens (333) und Ziel-Berechnungsblockknotens (333) des Datentransfers und/oder Prozesseigenschaften bezüglich einer der mehreren Verarbeitungseinheiten (21) umfassen,
wobei Aufgaben (56) einer Aufgabenmatrix (153) durch den Matrix-Builder (15) gebildet werden, wobei im Fall von Berechnungsblockknoten (333), denen jeweils ein anderer Lesevorgang zugeordnet ist, die Aufgaben (56) gebildet werden, indem die Berechnungsblockknoten (333) einer Spalte der Berechnungsmatrix (151) gleichmäßig auf die Anzahl der mehreren symmetrischen Verarbeitungseinheiten (21) aufgeteilt werden, wobei für jede der mehreren Verarbeitungseinheiten (21) pro Spalte der Berechnungsmatrix (151) eine einzelne Aufgabe (56) gebildet wird, und indem die verbleibenden Berechnungsblockknoten (333) auf der Grundlage eines vordefinierten Regimes auf mindestens einen Teil der Aufgaben (56) aufgeteilt werden, wobei im Fall von Berechnungsblockknoten (333), die mindestens teilweise einen Lesevorgang mit transferierten identischen Daten ausführen, die Aufgaben (56) durch Minimieren der Anzahl von Lesevorgängen gleichmäßig oder im Wesentlichen gleichmäßig über die Anzahl von Verarbeitungseinheiten (21) und/oder, falls ein vordefinierter Versatzwert überschritten wird, durch Minimieren einer integrierten Verarbeitungszeit gleichmäßig über jede der Verarbeitungseinheiten (21) gebildet werden,
wobei das Compilersystem (1) ein Optimierermodul (16) umfasst, das eine Matrixoptimierungstechnik verwendet, die eine aggregierte auftretende Latenzzeit (26) minimiert, die alle auftretenden Latenzzeiten (261) integriert, wobei zum Bereitstellen einer optimierten Struktur der Aufgaben (56) innerhalb der Aufgabenmatrix (153) verschiedene Kombinationen von Reihen aus der Berechnungs- und der Transfermatrix durch das Optimierermodul (16) erstellt werden, wobei jede der verschiedenen Kombinationen von Reihen aus der Berechnungs- und der Transfermatrix einen möglichen Maschinencode (32) als Parallelverarbeitungscode darstellt, der seine Eigenschaften auf der Hardware des Parallelverarbeitungssystems (2) bereitstellt, wobei jede Spalte der Aufgabenmatrix (153) eine Berechnungskette (34) bildet, indem eine oder mehrere Aufgaben (333) einen geordneten Fluss von Berechnungsblockknoten (333) erzeugen, die durch eine der mehreren Verarbeitungseinheiten (21) ausgeführt werden sollen, und wobei die aggregierte auftretende Latenzzeit (26), die alle auftretenden Latenzzeiten integriert, durch das Optimierermodul (16) minimiert wird,
wobei das Compilersystem (1) einen Codegenerator (17) umfasst, um den Maschinencode (32) für parallele Verarbeitung für die mehreren Verarbeitungseinheiten (21) mit einer optimierten aggregierten Latenzzeit (26) auf der Grundlage der durch die optimierte Aufgabenmatrix (153) gegebenen Berechnungsketten (34) zu generieren,
wobei das IC-Layout-System (5) einen Netzlistengenerator (52) umfasst, um eine Layout-Netzliste (521) zu generieren, die aus mehreren IC-Layout-Elementen (51) eines integrierten Schaltkreises (2) zusammengesetzt ist, wobei die IC-Layout-Elemente (51) elektronische Komponenten des integrierten Schaltkreises (2), die mindestens Transistoren (511), Widerstände (512), Kondensatoren (513) und Interconnect-Verbindungen (514) dieser Komponenten umfassen, auf einem Stück Halbleiter (515) umfassen,
wobei die Layout-Netzliste (521) mehrere parallele Pipelines (53) umfasst, wobei jede Pipeline (53) einen Eingangs-Latch (531) und einen Verarbeitungsschaltkreis (532) umfasst, wobei jeder Eingangs-Latch (531) die IC-Layout-Elemente (51) für einen Puffer oder ein Register umfasst, und ein Verarbeitungsschaltkreis (532) IC-Layout-Elemente (521) zum Verarbeiten der Daten eines zugehörigen Eingangs-Latches (531) durch einen Basissatz von elementaren Instruktionen (322) umfasst,
wobei eine Verarbeitungsstufe (534) durch eine spezielle Datenverarbeitung durch eine der mehreren parallelen Pipelines (53) gegeben ist, die ein Zwischenergebnis (5341) erzeugt, wobei der Eingangs-Latch (531) und der Verarbeitungsschaltkreis (532) einer gegebenen Stufe (534) mit dem Eingangs-Latch (531) einer nächsten Stufe (534) verbunden sind,
wobei ein Taktsignal (533) mit jedem Eingangs-Latch (531) verbunden ist, wobei ein Taktsignal (533) die IC-Layout-Elemente (521) zum Generieren eines Taktimpulses (5331) umfasst, wobei bei jedem Taktimpuls (5331) jede der mehreren parallelen Stufen (534) ein Zwischenergebnis (5341) zu den Eingangs-Latches (531) der nächsten Stufen (534) transferiert, und wobei Eingangsdaten durch die mehreren parallelen Pipelines (53) geleitet werden, wobei eine Stufe (534) pro Taktimpuls (5331) vollendet wird, bis durch Vollenden aller Stufen (534) ein Endergebnis (5342) erreicht ist,
wobei die parallelen Pipelines (53) Mittel umfassen zum
(i) Austauschen durch Bereitstellen eines Ergebnisaustauschs zwischen Pipelines, indem der Stufe einer parallelen Pipeline (53) Ergebnisse eines Stufenregisters zugänglich gemacht werden, und
(ii) Leeren von Verzweigungs-Pipelines durch Bereitstellen eines Steuerungskonflikts durch Leeren nur jener Pipelines (53), die von einer einzelnen Pipeline (53) abhängig sind, durch Berechnen einer Bedingung auf der Grundlage von Verzweigungsadressen,
wobei die Layout-Netzliste (521) mehrere Positionsvariablen (5211) umfasst, die durch den Netzlistengenerator (52) generiert und mehreren Layout-Elementen (51) zugeordnet werden, wobei die Positionsvariablen (5211) die Position von Kanten oder Punkten der mehreren Layout-Elemente (5212) darstellen und wobei durch den Netzlistengenerator (52) ein IC-Layout (54) aus den Positionsvariablenwerten (5211) der generierten Layout-Netzliste (521) generiert wird.

2. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach Anspruch 1, wobei anstelle von Cache-Ebenen zusätzliche Pufferregister hinzugefügt sind, wobei die Größe des Pufferregisters adaptiv auf die Geschwindigkeit und die Anzahl von parallelen Pipelines (53) optimiert wird.

3. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach einem der Ansprüche 1 oder 2, wobei die parallelen Pipelines (53) Mittel zum Weiterleiten durch Bereitstellen einer Datenweiterleitung von einem Stufenregister zu einem anderen Stufenregister umfassen.

4. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach Anspruch 3, wobei die parallelen Pipelines (53) Mittel zum Weiterleiten durch Bereitstellen einer Datenweiterleitung von einer MEM-Stufe als EX/MEM-Register zu einer EX-Stufe als ID/EX-Stufenregister umfassen.

5. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach einem der Ansprüche 1 bis 4, wobei die parallelen Pipelines (53) Mittel zum Austauschen durch Bereitstellen eines Ergebnisaustauschs zwischen Pipelines, indem der EX-Stufe einer parallelen Pipeline (53) Ergebnisse des Ex-MEM-Stufenregisters zugänglich gemacht werden, umfassen.

6. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach einem der Ansprüche 1 bis 5, wobei in dem Fall, dass die Anzahl von Berechnungsblöcken (333) in einer Stufe höher ist als die verfügbaren parallelen Pipelines (53), die Berechnungsmatrix (151) in Bezug auf diese Anzahl von Berechnungsblöcken (333) optimiert wird.

7. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach einem der Ansprüche 1 bis 6, wobei die mehreren parallelen Pipelines (53) alle exakt oder im Wesentlichen exakt gleich sind, was ein symmetrisches Mehrkern- und/oder Mehrprozessor-IC-Layout (54) erbringt.

8. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach einem der Ansprüche 1 bis 7, wobei die mehreren Positionsvariablen durch den Netzlistengenerator (51) auf der Grundlage eines Randbedingungssystems generiert und den mehreren Layout-Elementen zugeordnet werden, welches Randbedingungen, die Beziehungen von Kanten oder Punkten der mehreren Layout-Elemente darstellen, in Bezug auf Fertigungsprozessanforderungen umfasst, wobei das IC-Layout anhand der angepassten Positionsvariablenwerte generiert wird.

9. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach Anspruch 8, wobei jede der mehreren parallelen Pipelines (53) die gleiche Speicherarchitektur und die gleichen technischen Prozessoreigenschaften aufweist.

10. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach Anspruch 9, wobei die technischen Prozessoreigenschaften mindestens umfassen, die gleiche Leistung des Prozessors (2102) oder des Kerns (2103) mit gleichen oder im Wesentlichen gleichen Anzahlen verarbeiteter Instruktionen pro Sekunde aufzuweisen.

11. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach einem der Ansprüche 1 bis 10, wobei die Größe des Puffers oder Registers eines Eingangs-Latches (531) gemäß den Datenknoten festgelegt wird, die in den Instruktionen in dem Block verwendet werden, wodurch ein synchrones IC-Layout-Design erhalten wird, wobei die Größe der Datenknoten durch die Datentypen verwendeter Variablen definiert ist.

12. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach Anspruch 11, wobei die Datentypen der verwendeten Variablen durch die Instruktionssatzarchitektur (ISA), die die Anzahl von Datenknoten verbindet, die Datentypdefinition und die Anzahl von Instruktionen zur erforderlichen Registergröße S_{reg} nach S_{reg} = *ƒ*(S_{data nodes}, n_{data nodes} in CB, ISA) definiert sind und die Größe der Datenknoten eine Funktion der Datentypen nach S_{data nodes} α S_{data types} = *ƒ*(ISA) ist.

13. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach einem der Ansprüche 11 oder 12, wobei eine Drahtbreite als eine Funktion des Datentyps und der Anzahl von zu transferierenden Datenknoten festgelegt ist, wodurch die Bitbreite jedes Transfers erhalten wird, was die Größe der für das IC-Layout verwendeten Drähte definiert.

14. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach einem der Ansprüche 1 bis 13, wobei eine Kette von Instruktionen unter Verwendung von Verilog auf RTL-Ebene erfasst wird.

15. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach Anspruch 11, wobei das IC-Layout als ein asynchrones Design bereitgestellt wird, wobei die Berechnungsblöcke (CB) alle Informationen enthalten, um RTL-Code für das asynchrone Design zu bilden, um die in den CB enthaltenen Instruktionen berechnen.

16. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach Anspruch 15, wobei das IC-Layout als ein synchrones Design bereitgestellt wird, wobei die Kanten in dem Graphen, der die Transfers angibt, die Größe des Registers zwischen jeder kombinatorischen Berechnung enthalten.

17. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach einem der Ansprüche 1 bis 16, wobei die statische Ablaufplanung der mehreren Verarbeitungspipelines (53) durch den statischen Maschinencode (32) für eine auto-parallelisierte Verarbeitung so realisiert wird, dass keine dynamische Ablaufplanung durch den integrierten Schaltkreis (2) erforderlich ist.

18. Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53) nach einem der Ansprüche 1 bis 17, wobei die integrierten Schaltkreise (2) durch ein IC-Herstellungssystem (6) des Design- und Herstellungssystems (0) auf der Grundlage des generierten IC-Layouts (54) hergestellt und/oder produziert werden.

19. Verfahren für ein Design- und Herstellungssystem (0) für eine optimierte generische Architektur eines integrierten Mehrkern- und/oder Mehrprozessor-Schaltkreises (2) mit statischer Ablaufplanung mehrerer Verarbeitungspipelines (53), wobei der integrierte Mehrkern- und/oder Mehrprozessor-Schaltkreis (2) mehrere Verarbeitungseinheiten und/oder Verarbeitungspipelines (53) aufweist, die gleichzeitig, durch Ausführen eines Maschinencodes (32) für parallelisierte Verarbeitung, Instruktionen bezüglich Daten verarbeiten,
wobei der Code (32) für parallelisierte Verarbeitung durch den parallelverarbeitenden integrierten Mehrkern- und/oder Mehrprozessor-Schaltkreis (2) ausgeführt wird, was das Auftreten von Latenzzeiten (26) umfasst, wobei die Latenzzeiten durch die Leerlaufzeit einer Verarbeitungseinheit (21) zwischen dem Zurücksenden von Daten nach der Verarbeitung eines spezifischen Blocks aus Instruktionen des Verarbeitungscodes (32) bezüglich der Daten durch die Verarbeitungseinheit (21) und dem Empfangen von Daten, die für die Ausführung eines nachfolgenden Blocks aus Instruktionen des Verarbeitungscodes (32) durch die Verarbeitungseinheiten (21) benötigt werden, gegeben sind,
wobei das Design- und Herstellungssystem (0) ein Autoparallelisierungs-Compilersystem (1) umfasst, umfassend Mittel zum Umwandeln eines seriellen Quellcodes (31) des in einer Programmiersprache geschriebenen Programmcodes (3) in einen Maschinencode (32) für parallele Verarbeitung, der eine Anzahl von Instruktionen umfasst, die durch die mehreren Verarbeitungseinheiten (21) des integrierten Mehrkern- und/oder Mehrprozessor-Schaltkreises (2) ausführbar sind, oder zum Steuern des Betriebes der mehreren Verarbeitungseinheiten (21), kombiniert mit einem IC-Layout-System (5) zum Generieren eines IC-Layouts für parallele Verarbeitung mit mehreren Layout-Elementen (51) für integrierte Schaltkreise, die mindestens Elemente, die Speichereinheiten (22) bezeichnen, und Elemente, die Verarbeitungseinheiten und/oder Verarbeitungspipelines (21) bezeichnen, umfassen,
wobei das Compilersystem (1) ein Parser-Modul (11) zum Übersetzen des seriellen Quellcodes (31) in einen Code (32) mit einem Fluss von elementaren Instruktionen, die durch die Verarbeitungseinheiten (21) ausführbar sind, umfasst, wobei die elementaren Instruktionen aus einer begrenzten, Verarbeitungseinheit-spezifischen Menge von elementaren Instruktionen auswählbar sind und die elementaren Instruktionen ausschließlich elementare arithmetische und logische Operationen (321/322) und/oder elementare Steuer- und Speicheroperationen (325) für die Anzahl von Verarbeitungseinheiten (21) umfassen,
wobei der Code (32) der elementaren Instruktionen durch das Parser-Modul (11) in Berechnungsblockknoten (333) partitioniert wird, wobei jeder Berechnungsblockknoten (333) aus einer kleinstmöglichen Segmentierung einer nicht weiter zerlegbaren Sequenz von elementaren Instruktionen des Codes (32) besteht, die durch eine einzelne Verarbeitungseinheit (21) verarbeitbar sind, wobei die kleinstmögliche Segmentierung der elementaren Instruktionen durch eine Sequenz von elementaren Instruktionen gekennzeichnet ist, die durch aufeinanderfolgende Lese- und Schreibinstruktionen eingerahmt ist, wobei diese Sequenz nicht weiter durch kleinere Sequenzen von elementaren Instruktionen zwischen aufeinanderfolgenden Lese- und Schreibinstruktionen zerlegbar ist und die Lese- und Schreibinstruktionen benötigt werden, um Daten zu empfangen, die für die Verarbeitung dieser Sequenz von elementaren Instruktionen durch die Verarbeitungseinheit (21) erforderlich sind, und um Daten nach der Verarbeitung durch die Sequenz zurückzusenden,
wobei durch einen Matrix-Builder (15) Matrizen (151, ..., 153) aus von dem Code (15) abgeteilten Berechnungsketten (32) generiert werden, wobei die Matrizen (151, ...,153) Berechnungsmatrizen und Transfermatrizen (151/152) und Aufgabenmatrizen (153) umfassen, wobei jede Spalte innerhalb einer Berechnungsmatrix (151) Berechnungsblockknoten (333) umfasst, die auf der Grundlage der Ausführbarkeit von Lese- und Schreibinstruktionen, die Daten transferieren, die für die Verarbeitung der Berechnungsblockknoten (333) erforderlich sind, gleichzeitig verarbeitbar sind, wobei die Transfermatrix zu jedem Berechnungsblockknoten (333) Transfer- und Prozesseigenschaften enthält, die mindestens Datentransfereigenschaften von einem zu einem nachfolgenden Berechnungsblockknoten (333) charakterisieren, die mindestens die Datengröße von gesendeten Daten und die Identifikation eines Quell-Berechnungsblockknotens (333) und Ziel-Berechnungsblockknotens (333) des Datentransfers und/oder Prozesseigenschaften bezüglich einer der mehreren Verarbeitungseinheiten (21) umfassen,
wobei durch den Matrix-Builder (15) Aufgaben (56) einer Aufgabenmatrix (153) gebildet werden, wobei im Fall von Berechnungsblockknoten (333), denen jeweils ein anderer Lesevorgang zugeordnet ist, die Aufgaben (56) gebildet werden, indem die Berechnungsblockknoten (333) einer Spalte der Berechnungsmatrix (151) gleichmäßig auf die Anzahl der mehreren symmetrischen Verarbeitungseinheiten (21) aufgeteilt werden, wobei für jede der mehreren Verarbeitungseinheiten (21) pro Spalte der Berechnungsmatrix (151) eine einzelne Aufgabe (56) gebildet wird, und indem die verbleibenden Berechnungsblockknoten (333) auf der Grundlage eines vordefinierten Regimes auf mindestens einen Teil der Aufgaben (56) aufgeteilt werden, wobei im Fall von Berechnungsblockknoten (333), die mindestens teilweise einen Lesevorgang mit transferierten identischen Daten ausführen, die Aufgaben (56) durch Minimieren der Anzahl von Lesevorgängen gleichmäßig oder im Wesentlichen gleichmäßig über die Anzahl von Verarbeitungseinheiten (21) und/oder, falls ein vordefinierter Versatzwert überschritten wird, durch Minimieren einer integrierten Verarbeitungszeit gleichmäßig über jede der Verarbeitungseinheiten (21) gebildet werden,
wobei eine aggregierte auftretende Latenzzeit (26) durch ein Optimierermodul (16) unter Verwendung einer Matrixoptimierungstechnik minimiert wird, die durch Integrieren aller auftretenden Latenzzeiten (261) minimiert, wobei zum Bereitstellen einer optimierten Struktur der Aufgaben (56) innerhalb der Aufgabenmatrix (153) verschiedene Kombinationen von Reihen aus der Berechnungs- und der Transfermatrix durch das Optimierermodul (16) erstellt werden, wobei jede der verschiedenen Kombinationen von Reihen aus der Berechnungs- und der Transfermatrix einen möglichen Maschinencode (32) als Parallelverarbeitungscode darstellt, der seine Eigenschaften auf der Hardware des Parallelverarbeitungssystems (2) bereitstellt, wobei jede Spalte der Aufgabenmatrix (153) eine Berechnungskette (34) bildet, indem eine oder mehrere Aufgaben (333) einen geordneten Fluss von Berechnungsblockknoten (333) erzeugen, die durch eine der mehreren Verarbeitungseinheiten (21) ausgeführt werden sollen, und wobei die aggregierte auftretende Latenzzeit (26), die alle auftretenden Latenzzeiten integriert, durch das Optimierermodul (16) minimiert wird,
wobei der Maschinencode (32) für parallele Verarbeitung durch einen Codegenerator (17) für die mehreren Verarbeitungseinheiten (21) mit einer optimierten aggregierten Latenzzeit (26) auf der Grundlage der durch die optimierte Aufgabenmatrix (153) gegebenen Berechnungsketten (34) generiert wird,
wobei eine Layout-Netzliste (521), die aus mehreren IC-Layout-Elementen (51) eines integrierten Schaltkreises (2) zusammensetzt ist, durch einen Netzlistengenerator (52) generiert wird, wobei die IC-Layout-Elemente (51) elektronische Komponenten des integrierten Schaltkreises (2), die mindestens Transistoren (521), Widerstände (522), Kondensatoren (523) und Interconnect-Verbindungen (554) dieser Komponenten umfassen, auf einem Stück Halbleiter (555) umfassen,
wobei die Layout-Netzliste (521) mehrere parallele Pipelines (53) umfasst, wobei jede Pipeline (53) einen Eingangs-Latch (531) und einen Verarbeitungsschaltkreis (532) umfasst, wobei jeder Eingangs-Latch (531) die IC-Layout-Elemente (51) für einen Puffer oder ein Register umfasst, und ein Verarbeitungsschaltkreis (532) die IC-Layout-Elemente (51) zum Verarbeiten der Daten eines zugehörigen Eingangs-Latches (531) durch den Basissatz von elementaren Instruktionen (322) umfasst,
wobei eine Verarbeitungsstufe (534) durch eine spezielle Datenverarbeitung durch eine der mehreren parallelen Pipelines (53) gegeben ist, die ein Zwischenergebnis erzeugt, wobei der Eingangs-Latch (531) und der Verarbeitungsschaltkreis (532) einer gegebenen Stufe (534) mit dem Eingangs-Latch (531) einer nächsten Stufe (534) verbunden werden,
wobei ein Taktsignal (533) mit jedem Eingangs-Latch verbunden wird, wobei ein Taktsignal (533) die IC-Layout-Elemente (51) zum Generieren eines Taktimpulses (5331) umfasst, wobei bei jedem Taktimpuls (5331) jede der mehreren parallelen Stufen (534) ein Zwischenergebnis (5341) zu den Eingangs-Latches (531) der nächsten Stufen (534) transferiert, und wobei Eingangsdaten durch die mehreren parallelen Pipelines (53) geleitet werden, wobei eine Stufe pro Taktimpuls vollendet wird, bis ein Endergebnis (5341) produziert wird,
wobei die parallelen Pipelines (53)
(i) durch Bereitstellen eines Ergebnisaustauschs zwischen Pipelines Daten austauschen, indem der Stufe einer parallelen Pipeline (53) Ergebnisse eines Stufenregisters zugänglich gemacht werden, und
(ii) eine Leerung durch Leeren von Verzweigungs-Pipelines vornehmen, wodurch ein Steuerungskonflikt durch Leeren nur jener Pipelines (53), die von einer einzelnen Pipeline (53) abhängig sind, durch Berechnen einer Bedingung auf der Grundlage von Verzweigungsadressen bereitgestellt wird, und
wobei die Layout-Netzliste (521) mehrere Positionsvariablen (5211) umfasst, die durch den Netzlistengenerator (52) generiert und mehreren Layout-Elementen (51) zugeordnet werden, wobei die Positionsvariablen (5211) die Position von Kanten oder Punkten der mehreren Layout-Elemente (5212) darstellen und wobei durch den Netzlistengenerator (52) ein IC-Layout (54) aus den Positionsvariablenwerten (5211) der generierten Layout-Netzliste (521) generiert wird.

20. Design- und Herstellungsverfahren (0) nach Anspruch 19, wobei die parallelen Pipelines (53) Mittel zum Weiterleiten durch Bereitstellen einer Datenweiterleitung von einem Stufenregister zu einem anderen Stufenregister umfassen.

21. Design- und Herstellungsverfahren (0) nach Anspruch 20, wobei die parallelen Pipelines (53) Mittel zum Weiterleiten durch Bereitstellen einer Datenweiterleitung von einer MEM-Stufe als EX/MEM-Register zu einer EX-Stufe als ID/EX-Stufenregister umfassen.

22. Design- und Herstellungsverfahren (0) nach einem der Ansprüche 19 bis 21, wobei die parallelen Pipelines (53) Mittel zum Austauschen durch Bereitstellen eines Ergebnisaustauschs zwischen Pipelines, indem der EX-Stufe einer parallelen Pipeline (53) Ergebnisse des Ex-MEM-Stufenregisters zugänglich gemacht werden, umfassen.

## Revendications

1. Système de conception et de fabrication (0) pour une architecture de circuit intégré multicœur et/ou multiprocesseur (2) générique optimisée avec planification statique de multiples chaînes de traitement (53), le circuit intégré multicœur et/ou multiprocesseur (2) comportant une pluralité de chaînes de traitement (53) traitant simultanément des instructions sur des données en exécutant un code machine de traitement en parallèle (32),
dans lequel l'exécution du code de traitement en parallèle (32) par le circuit intégré multicœur et/ou multiprocesseur à traitement en parallèle (2) comprend l'apparition de temps de latence (26), les temps de latence étant donnés par le temps d'inactivité d'une unité de traitement (21) entre la retransmission des données après avoir traité un bloc d'instructions spécifique du code de traitement (32) sur les données par l'unité de traitement (21) et la réception des données nécessaires pour l'exécution d'un bloc d'instructions consécutif du code de traitement (32) par lesdites unités de traitement (21),
dans lequel le système de conception et de fabrication (0) comprend un système compilateur à parallélisation automatique (1) comprenant des moyens pour transformer un code source séquentiel (31) du code de programme (3), écrit dans un langage de programmation, en un code machine de traitement en parallèle (32) comprenant un nombre d'instructions exécutables par la pluralité d'unités de traitement (21) du circuit intégré multicœur et/ou multiprocesseur (2) ou commandant le fonctionnement de la pluralité d'unités de traitement (21), combiné à un système de topologie de circuit intégré (5) destiné à générer une topologie de circuit intégré à traitement en parallèle avec une pluralité d'éléments de topologie de circuit intégré (51) comprenant au moins des éléments désignant des unités de mémoire (22) et des éléments désignant des unités de traitement (21) et/ou des chaînes de traitement,
dans lequel le système compilateur (1) comprend un module d'analyse syntaxique (11) pour traduire le code source séquentiel (31) en un code (32) avec un flux d'instructions élémentaires exécutables par les unités de traitement (21), les instructions élémentaires étant sélectionnables parmi un ensemble limité d'instructions élémentaires spécifiques à l'unité de traitement et les instructions élémentaires comprenant exclusivement des opérations élémentaires arithmétiques et logiques (321/322) et/ou des opérations élémentaires de commande et de mémoire (325) pour le nombre d'unités de traitement (21),
dans lequel le module d'analyse syntaxique (11) comprend des moyens pour partitionner le code (32) desdites instructions élémentaires en nœuds de bloc de calcul (333), chaque nœud de bloc de calcul (333) consistant en une segmentation la plus fine possible d'une séquence non décomposable davantage d'instructions élémentaires du code (32) traitables par une unité de traitement individuelle (21), la segmentation la plus fine possible des instructions élémentaires étant **caractérisée par** une séquence d'instructions élémentaires encadrées par des instructions de lecture et d'écriture consécutives, ladite séquence n'étant pas décomposable davantage en séquences plus petites d'instructions élémentaires entre des instructions de lecture et d'écriture consécutives, et les instructions de lecture et d'écriture nécessaires pour recevoir des données requises pour le traitement de ladite séquence d'instructions élémentaires par l'unité de traitement (21) et retransmettre des données après le traitement par la séquence,
dans lequel le système compilateur (1) comprend un constructeur de matrices (15) destiné à générer des matrices (151,...,153) à partir de chaînes de calcul (34) découpées dans le code (32), les matrices (151,...,153) comprenant des matrices de calcul, des matrices de transfert (151/152) et des matrices de tâches (153), dans lequel chaque colonne au sein d'une matrice de calcul (151) comprend des nœuds de bloc de calcul (333) pouvant être traités simultanément sur la base de l'exécutabilité d'instructions de lecture et d'écriture transférant des données requises pour le traitement des nœuds de bloc de calcul (333), dans lequel la matrice de transfert contient, pour chacun des nœuds de bloc de calcul (333), des propriétés de transfert et de traitement caractérisant au moins les propriétés de transfert de données d'un nœud de bloc de calcul à un nœud de bloc de calcul consécutif (333) comprenant au moins la taille des données transmises et l'identification d'un nœud de bloc de calcul source (333) et d'un nœud de bloc de calcul cible (333) du transfert de données et/ou des caractéristiques de traitement sur une unité de la pluralité d'unités de traitement (21),
dans lequel les tâches (56) d'une matrice de tâches (153) sont formées par le constructeur de matrices (15), dans lequel, dans le cas où les nœuds de bloc de calcul (333) sont associés chacun à une lecture différente, les tâches (56) sont formées en divisant les nœuds de bloc de calcul (333) d'une colonne de la matrice de calcul (151) de manière égale selon le nombre d'unités de la pluralité d'unités de traitement symétriques (21) en formant, pour chaque unité de la pluralité d'unités de traitement (21), une tâche (56) par colonne de la matrice de calcul (151) et en divisant les nœuds de bloc de calcul restants (333) sur la base d'un schéma prédéfini pour au moins une partie desdites tâches (56), dans lequel, dans le cas où une lecture avec des données identiques est transférée au moins partiellement aux nœuds de bloc de calcul (333), les tâches (56) sont formées en minimisant le nombre de lectures de manière uniforme ou essentiellement uniforme sur le nombre d'unités de traitement (21) et/ou, si une valeur de décalage prédéfinie est dépassée, en minimisant un temps de traitement intégré de manière uniforme sur chacune des unités de traitement (21),
dans lequel le système compilateur (1) comprend un module optimisateur (16) utilisant une technique d'optimisation de matrice qui minimise un temps de latence apparu cumulé (26) intégrant tous les temps de latence apparus (261), dans lequel, pour fournir une structure optimisée des tâches (56) au sein de la matrice de tâches (153), différentes combinaisons de lignes provenant des matrices de calcul et des matrices de transfert sont construites par le module optimisateur (16), chacune des différentes combinaisons de lignes provenant des matrices de calcul et des matrices de transfert représentant un code machine possible (32) en tant que code de traitement en parallèle fournissant ses propriétés sur le matériel du système de traitement en parallèle (2), dans lequel chaque colonne de la matrice de tâches (153) forme une chaîne de calcul (34) par une ou plusieurs tâches (333), en créant un flux ordonné de nœuds de bloc de calcul (333) à exécuter par une unité de la pluralité d'unités de traitement (21), et dans lequel le temps de latence apparu cumulé (26) intégrant tous les temps de latence apparus est minimisé par le module optimisateur (16),
dans lequel le système compilateur (1) comprend un générateur de code (17) destiné à générer le code machine de traitement en parallèle (32) pour la pluralité d'unités de traitement (21) avec un temps de latence cumulé optimisé (26) sur la base des chaînes de calcul (34) données par la matrice de tâches optimisée (153),
dans lequel le système de topologie de circuit intégré (5) comprend un générateur de liste d'interconnexions (52) destiné à générer une liste d'interconnexions de topologie (521) composée d'une pluralité d'éléments de topologie de circuit intégré (51) d'un circuit intégré (2), les éléments de topologie de circuit intégré (51) comprenant des composants électroniques du circuit intégré (2) comprenant au moins des transistors (511), des résistances (512), des condensateurs (513) et des interconnexions (514) de ces composants sur un morceau de semi-conducteur (515),
dans lequel la liste d'interconnexions de topologie (521) comprend une pluralité de chaînes de traitement parallèles (53), chaque chaîne de traitement (53) comprenant un verrou d'entrée (531) et un circuit de traitement (532), dans lequel chaque verrou d'entrée (531) comprend les éléments de topologie de circuit intégré (51) pour un tampon ou un registre, et un circuit de traitement (532) comprend des éléments de topologie de circuit intégré (521) pour traiter les données d'un verrou d'entrée associé (531) par un ensemble de base d'instructions élémentaires (322),
dans lequel une étape de traitement (534) est donnée par un traitement de données particulier par une chaîne de la pluralité de chaînes de traitement parallèles (53) produisant un résultat intermédiaire (5341), dans lequel le verrou d'entrée (531) et le circuit de traitement (532) d'une étape donnée (534) sont connectés au verrou d'entrée (531) d'une étape suivante (534),
dans lequel un signal d'horloge (533) est connecté à chaque verrou d'entrée (531), dans lequel un signal d'horloge (533) comprend les éléments de topologie de circuit intégré (521) destinés à générer une impulsion d'horloge (5331), dans lequel, à chaque impulsion d'horloge (5331), chaque étape de la pluralité d'étapes parallèles (534) transfère un résultat intermédiaire (5341) aux verrous d'entrée (531) des étapes suivantes (534), et dans lequel les données d'entrée sont transmises à travers la pluralité de chaînes de traitement parallèles (53) accomplissant une étape (534) par impulsion d'horloge (5331) jusqu'à l'obtention d'un résultat final (5342) en accomplissant toutes les étapes (534),
dans lequel les chaînes de traitement parallèles (53) comprennent des moyens pour
(i) échanger en fournissant un échange de résultats entre chaînes de traitement en rendant les résultats d'un registre d'étape accessibles à l'étape d'une chaîne de traitement parallèle (53), et
(ii) purger les branches de chaîne de traitement en fournissant un risque de commande par la purge uniquement des chaînes de traitement (53) dépendant d'une seule chaîne de traitement (53) en calculant une condition sur la base d'adresses de branche,
dans lequel la liste d'interconnexions de topologie (521) comprend une pluralité de variables de position (5211) générées et attribuées à une pluralité d'éléments de topologie (51) par le générateur de liste d'interconnexions (52), dans lequel les variables de position (5211) représentent l'emplacement de bords ou de points de la pluralité d'éléments de topologie (5212), et dans lequel une topologie de circuit intégré (54) est générée par le générateur de liste d'interconnexions (52) à partir des valeurs de variable de position (5211) de la liste d'interconnexions de topologie générée (521).

2. Système de conception et de fabrication (0) pour une architecture de circuit intégré multicœur et/ou multiprocesseur (2) générique optimisée avec planification statique de multiples chaînes de traitement (53) selon la revendication 1, dans lequel, au lieu de niveaux de cache, des registres tampons additionnels sont ajoutés, dans lequel la taille du registre tampon est optimisée de manière adaptative à la vitesse et au nombre de chaînes de traitement parallèles (53).

3. Système de conception et de fabrication (0) pour une architecture de circuit intégré multicœur et/ou multiprocesseur (2) générique optimisée avec planification statique de multiples chaînes de traitement (53) selon l'une des revendications 1 et 2, dans lequel les chaînes de traitement parallèles (53) comprennent des moyens de transmission en assurant la transmission de données d'un registre d'étape à un autre registre d'étape.

4. Système de conception et de fabrication (0) pour une architecture de circuit intégré multicœur et/ou multiprocesseur (2) générique optimisée avec planification statique de multiples chaînes de traitement (53) selon la revendication 3, dans lequel les chaînes de traitement parallèles (53) comprennent des moyens de transmission fournissant une transmission de données d'un étage MEM en tant que registre EX/MEM à l'étage EX en tant que registre d'étage ID/EX.

5. Système de conception et de fabrication (0) pour une architecture de circuit intégré multicœur et/ou multiprocesseur (2) générique optimisée avec planification statique de multiples chaînes de traitement (53) selon l'une des revendications 1 à 4, dans lequel les chaînes de traitement parallèles (53) comprennent des moyens d'échange fournissant un échange de résultats entre les chaînes de traitement en rendant les résultats du registre d'étape EX/MEM accessibles à l'étape EX d'une chaîne de traitement parallèle (53).

6. Système de conception et de fabrication (0) pour une architecture de circuit intégré multicœur et/ou multiprocesseur (2) générique optimisée avec planification statique de multiples chaînes de traitement (53) selon l'une des revendications 1 à 5, dans lequel, dans le cas où le nombre de blocs de calcul (333) sur un étage est supérieur au nombre de chaînes de traitement parallèles disponibles (53), la matrice de calcul (151) est optimisée par rapport à ce nombre de blocs de calcul (333).

7. Système de conception et de fabrication (0) pour une architecture de circuit intégré multicœur et/ou multiprocesseur (2) générique optimisée avec planification statique de multiples chaînes de traitement (53) selon l'une des revendications 1 à 6, dans lequel les chaînes de la pluralité de chaînes de traitement parallèles (53) sont toutes exactement ou essentiellement exactement identiques, donnant une topologie de circuit intégré multicœur et/ou multiprocesseur symétrique (54).

8. Système de conception et de fabrication (0) pour une architecture de circuit intégré multicœur et/ou multiprocesseur (2) générique optimisée avec planification statique de multiples chaînes de traitement (53) selon l'une des revendications 1 à 7, dans lequel les variables de la pluralité de variables de position sont générées et attribuées à la pluralité d'éléments de topologie par le générateur de liste d'interconnexions (51) sur la base d'un système de contraintes comprenant des contraintes représentant les relations entre des bords ou des points de la pluralité d'éléments de topologie par rapport à des exigences du processus de fabrication, dans lequel la topologie de circuit intégré est générée à partir des valeurs de variable de position adaptées.

9. Système de conception et de fabrication (0) pour une architecture de circuit intégré multicœur et/ou multiprocesseur (2) générique optimisée avec planification statique de multiples chaînes de traitement (53) selon la revendication 8, dans lequel chaque chaîne de la pluralité de chaînes de traitement parallèles (53) possède la même architecture de stockage et les mêmes caractéristiques techniques de processeur.

10. Système de conception et de fabrication (0) pour une architecture de circuit intégré multicœur et/ou multiprocesseur (2) générique optimisée avec planification statique de multiples chaînes de traitement (53) selon la revendication 9, dans lequel les caractéristiques techniques des processeurs comprennent au moins le fait d'avoir les mêmes performances de processeur (2102) ou de cœur (2103) avec un nombre égal ou essentiellement égal d'instructions traitées par seconde.

11. Système de conception et de fabrication (0) pour une architecture de circuit intégré multicœur et/ou multiprocesseur (2) générique optimisée avec planification statique de multiples chaînes de traitement (53) selon l'une des revendications 1 à 10, dans lequel la taille du tampon ou du registre d'un verrou d'entrée (531) est définie en fonction des nœuds de données utilisés dans les instructions dans le bloc fournissant une conception de topologie de circuit intégré synchrone, dans lequel la taille des nœuds de données est définie par les types de données des variables utilisées.

12. Système de conception et de fabrication (0) pour une architecture de circuit intégré multicœur et/ou multiprocesseur (2) générique optimisée avec planification statique de multiples chaînes de traitement (53) selon la revendication 11, dans lequel les types de données des variables utilisées sont définis par l'architecture du jeu d'instructions, ISA (Instruction Set Architecture), en connectant la quantité de nœuds de données, la définition des types de données et le nombre d'instructions à la taille de registre requise S_{reg} selon la relation S_{reg} = f(S_{nœuds de données}, n_{nœuds de données} dans CB, ISA), et la taille des nœuds de données est une fonction des types de données selon la relation S_{nœuds de données} ∝ S_{types de données} = f(ISA).

13. Système de conception et de fabrication (0) pour une architecture de circuit intégré multicœur et/ou multiprocesseur (2) générique optimisée avec planification statique de multiples chaînes de traitement (53) selon l'une des revendications 11 et 12, dans lequel la largeur de fil est définie comme une fonction du type de données et du nombre de nœuds de données à transférer fournissant la largeur en bits de chaque transfert, qui définit la taille des fils utilisés pour la topologie de circuit intégré.

14. Système de conception et de fabrication (0) pour une architecture de circuit intégré multicœur et/ou multiprocesseur (2) générique optimisée avec planification statique de multiples chaînes de traitement (53) selon l'une des revendications 1 à 13, dans lequel une chaîne d'instructions est capturée en utilisant Verilog au niveau RTL.

15. Système de conception et de fabrication (0) pour une architecture de circuit intégré multicœur et/ou multiprocesseur (2) générique optimisée avec planification statique de multiples chaînes de traitement (53) selon la revendication 11, dans lequel la topologie de circuit intégré est fournie comme une conception asynchrone, dans lequel les blocs de calcul (CB - Computation Bloc) contiennent toute l'information pour former du code RTL pour ladite conception asynchrone afin de calculer les instructions contenues dans le CB.

16. Système de conception et de fabrication (0) pour une architecture de circuit intégré multicœur et/ou multiprocesseur (2) générique optimisée avec planification statique de multiples chaînes de traitement (53) selon la revendication 15, dans lequel la topologie de circuit intégré est fournie comme une conception synchrone, dans lequel les bords dans le graphe représentant les transferts contiennent la taille du registre entre chaque calcul combinatoire.

17. Système de conception et de fabrication (0) pour une architecture de circuit intégré multicœur et/ou multiprocesseur (2) générique optimisée avec planification statique de multiples chaînes de traitement (53) selon l'une des revendications 1 à 16, dans lequel la planification statique des multiples chaînes de traitement (53) par le code machine de traitement à parallélisation automatique statique (32) est réalisée de telle sorte qu'aucune planification dynamique n'est requise par le circuit intégré (2).

18. Système de conception et de fabrication (0) pour une architecture de circuit intégré multicœur et/ou multiprocesseur (2) générique optimisée avec planification statique de multiples chaînes de traitement (53) selon l'une des revendications 1 à 17, dans lequel les circuits intégrés (2) sont fabriqués et/ou produits par un système de fabrication de circuits intégrés (6) du système de conception et de fabrication (0) sur la base de la topologie de circuit intégré générée (54).

19. Procédé pour un système de conception et de fabrication (0) pour une architecture de circuit intégré multicœur et/ou multiprocesseur (2) générique optimisée avec planification statique de multiples chaînes de traitement (53), le circuit intégré multicœur et/ou multiprocesseur (2) comportant une pluralité d'unités de traitement et/ou de chaînes de traitement (53) traitant simultanément des instructions sur les données en exécutant un code machine de traitement en parallèle (32),
dans lequel le code de traitement en parallèle (32) qui est exécuté par le circuit intégré multicœur et/ou multiprocesseur de traitement en parallèle (2) comprend l'apparition de temps de latence (26), les temps de latence étant donnés par le temps d'inactivité d'une unité de traitement (21) entre la retransmission des données après avoir traité un bloc d'instructions spécifique du code de traitement (32) sur les données par l'unité de traitement (21) et la réception des données nécessaires pour l'exécution d'un bloc d'instructions consécutif du code de traitement (32) par lesdites unités de traitement (21),
dans lequel le système de conception et de fabrication (0) comprend un système compilateur à parallélisation automatique (1) comprenant des moyens pour transformer un code source séquentiel (31) du code de programme (3), écrit dans un langage de programmation, en un code machine de traitement en parallèle (32) comprenant un nombre d'instructions exécutables par la pluralité d'unités de traitement (21) du circuit intégré multicœur et/ou multiprocesseur (2) ou commandant le fonctionnement de la pluralité d'unités de traitement (21), combiné à un système de topologie de circuit intégré (5) destiné à générer une topologie de circuit intégré à traitement en parallèle avec une pluralité d'éléments de topologie de circuit intégré (51) comprenant au moins des éléments désignant des unités de mémoire (22) et des éléments désignant des unités de traitement et/ou des chaînes de traitement (21),
dans lequel le système compilateur (1) comprend un module d'analyse syntaxique (11) pour traduire le code source séquentiel (31) en un code (32) avec un flux d'instructions élémentaires exécutables par les unités de traitement (21), les instructions élémentaires étant sélectionnables parmi un ensemble limité d'instructions élémentaires spécifiques à l'unité de traitement et les instructions élémentaires comprenant exclusivement des opérations élémentaires arithmétiques et logiques (321/322) et/ou des opérations élémentaires de commande et de mémoire (325) pour le nombre d'unités de traitement (21),
dans lequel le code (32) desdites instructions élémentaires est partitionné en nœuds de bloc de calcul (333) par le module d'analyse syntaxique (11), chaque nœud de bloc de calcul (333) consistant en une segmentation la plus fine possible d'une séquence non décomposable davantage d'instructions élémentaires du code (32) traitables par une unité de traitement individuelle (21), la segmentation la plus fine possible des instructions élémentaires étant **caractérisée par** une séquence d'instructions élémentaires encadrées par des instructions de lecture et d'écriture consécutives, ladite séquence n'étant pas décomposable davantage en séquences plus petites d'instructions élémentaires entre des instructions de lecture et d'écriture consécutives, et les instructions de lecture et d'écriture nécessaires pour recevoir des données requises pour le traitement de ladite séquence d'instructions élémentaires par l'unité de traitement (21) et retransmettre des données après le traitement par la séquence,
dans lequel des matrices (151,...,153) sont générées à partir de chaînes de calcul (34) découpées dans le code (32) par un constructeur de matrices (15), les matrices (151,...,153) comprenant des matrices de calcul, des matrices de transfert (151/152) et des matrices de tâches (153), dans lequel chaque colonne au sein d'une matrice de calcul (151) comprend des nœuds de bloc de calcul (333) pouvant être traités simultanément sur la base de l'exécutabilité d'instructions de lecture et d'écriture transférant des données requises pour le traitement des nœuds de bloc de calcul (333), dans lequel la matrice de transfert contient, pour chacun des nœuds de bloc de calcul (333), des propriétés de transfert et de traitement caractérisant au moins les propriétés de transfert de données d'un nœud de bloc de calcul à un nœud de bloc de calcul consécutif (333) comprenant au moins la taille des données transmises et l'identification d'un nœud de bloc de calcul source (333) et d'un nœud de bloc de calcul cible (333) du transfert de données et/ou des caractéristiques de traitement sur une unité de la pluralité d'unités de traitement (21),
dans lequel les tâches (56) d'une matrice de tâches (153) sont formées par le constructeur de matrices (15), dans lequel, dans le cas où les nœuds de bloc de calcul (333) sont associés chacun à une lecture différente, les tâches (56) sont formées en divisant les nœuds de bloc de calcul (333) d'une colonne de la matrice de calcul (151) de manière égale selon le nombre d'unités de la pluralité d'unités de traitement symétriques (21) en formant, pour chaque unité de la pluralité d'unités de traitement (21), une tâche (56) par colonne de la matrice de calcul (151), et en divisant les nœuds de bloc de calcul restants (333) sur la base d'un schéma prédéfini pour au moins une partie desdites tâches (56), dans lequel, dans le cas où une lecture avec des données identiques est transférée au moins partiellement aux nœuds de bloc de calcul (333), les tâches (56) sont formées en minimisant le nombre de lectures de manière uniforme ou essentiellement uniforme sur le nombre d'unités de traitement (21) et/ou, si une valeur de décalage prédéfinie est dépassée, en minimisant un temps de traitement intégré de manière uniforme sur chacune des unités de traitement (21),
dans lequel un temps de latence apparu cumulé (26) est minimisé par un module optimisateur (16) en utilisant une technique d'optimisation de matrice qui minimise par l'intégration de tous les temps de latence apparus (261), dans lequel, pour fournir une structure optimisée des tâches (56) au sein de la matrice de tâches (153), différentes combinaisons de lignes provenant des matrices de calcul et des matrices de transfert sont construites par le module optimisateur (16), chacune des différentes combinaisons de lignes provenant des matrices de calcul et des matrices de transfert représentant un code machine possible (32) en tant que code de traitement en parallèle fournissant ses propriétés sur le matériel du système de traitement en parallèle (2), dans lequel chaque colonne de la matrice de tâches (153) forme une chaîne de calcul (34) par une ou plusieurs tâches (333) en créant un flux ordonné de nœuds de bloc de calcul (333) à exécuter par une unité de la pluralité d'unités de traitement (21), et dans lequel le temps de latence apparu cumulé (26) intégrant tous les temps de latence apparus est minimisé par le module optimisateur (16),
dans lequel le code machine de traitement en parallèle (32) est généré par un générateur de code (17) pour la pluralité d'unités de traitement (21) avec un temps de latence cumulé optimisé (26) sur la base des chaînes de calcul (34) données par la matrice de tâches optimisée (153),
dans lequel une liste d'interconnexions de topologie (521) composée d'une pluralité d'éléments de topologie de circuit intégré (51) d'un circuit intégré (2) est générée par un générateur de liste d'interconnexions (52), les éléments de topologie de circuit intégré (51) comprenant des composants électroniques du circuit intégré (2) comprenant au moins des transistors (521), des résistances (522), des condensateurs (523) et des interconnexions (554) de ces composants sur un morceau de semi-conducteur (555),
dans lequel la liste d'interconnexions de topologie (521) comprend une pluralité de chaînes de traitement parallèles (53), chaque chaîne de traitement (53) comprenant un verrou d'entrée (531) et un circuit de traitement (532), dans lequel chaque verrou d'entrée (531) comprend les éléments de topologie de circuit intégré (51) pour un tampon ou un registre, et un circuit de traitement (532) comprend les éléments de topologie de circuit intégré (51) pour traiter les données d'un verrou d'entrée associé (531) par l'ensemble de base d'instructions élémentaires (322),
dans lequel une étape de traitement (534) est donnée par un traitement de données particulier par une chaîne de la pluralité de chaînes de traitement parallèles (53) produisant un résultat intermédiaire, dans lequel le verrou d'entrée (531) et le circuit de traitement (532) d'une étape donnée (534) sont connectés au verrou d'entrée (531) d'une étape suivante (534),
dans lequel un signal d'horloge (533) est connecté à chaque verrou d'entrée, dans lequel un signal d'horloge (533) comprend les éléments de topologie de circuit intégré (51) destinés à générer une impulsion d'horloge (5331), dans lequel, à chaque impulsion d'horloge (5331), chaque étape de la pluralité d'étapes parallèles (534) transfère un résultat intermédiaire (5341) aux verrous d'entrée (531) des étapes suivantes (534), et dans lequel les données d'entrée sont transmises à travers la pluralité de chaînes de traitement parallèles (53) en accomplissant une étape par impulsion d'horloge jusqu'à ce qu'un résultat final (5341) soit produit,
dans lequel les chaînes de traitement parallèles (53)
(i) échangent des données en fournissant un échange de résultats entre chaînes de traitement en rendant les résultats d'un registre d'étape accessibles à l'étape d'une chaîne de traitement parallèle (53), et
(ii) purgent par la purge des branches de chaîne de traitement en fournissant un risque de commande par la purge uniquement des chaînes de traitement (53) dépendant d'une seule chaîne de traitement (53) en calculant une condition sur la base d'adresses de branche, et
dans lequel la liste d'interconnexions de topologie (521) comprend une pluralité de variables de position (5211) générées et attribuées à une pluralité d'éléments de topologie (51) par le générateur de liste d'interconnexions (52), dans lequel les variables de position (5211) représentent l'emplacement de bords ou de points de la pluralité d'éléments de topologie (5212), et dans lequel une topologie de circuit intégré (54) est générée par le générateur de liste d'interconnexions (52) à partir des valeurs de variable de position (5211) de la liste d'interconnexions de topologie générée (521).

20. Procédé de conception et de fabrication (0) selon la revendication 19, dans lequel les chaînes de traitement parallèles (53) comprennent des moyens de transmission en assurant la transmission de données d'un registre d'étape à un autre registre d'étape.

21. Procédé de conception et de fabrication (0) selon la revendication 20, dans lequel les chaînes de traitement parallèles (53) comprennent des moyens de transmission fournissant une transmission de données d'un étage MEM en tant que registre EX/MEM à l'étage EX en tant que registre d'étage ID/EX.

22. Procédé de conception et de fabrication (0) selon l'une des revendications 19 à 21, dans lequel les chaînes de traitement parallèles (53) comprennent des moyens d'échange fournissant un échange de résultats entre les chaînes de traitement en rendant les résultats du registre d'étape EX/MEM accessibles à l'étape EX d'une chaîne de traitement parallèle (53).
